(19) Europäisches Patentamt
European Patent Office
Office européen des brevets

(11) EP 2 991 128 B1

(12) **EUROPEAN PATENT SPECIFICATION**

(45) Date of publication and mention of the grant of the patent:
**12.04.2017 Bulletin 2017/15**

(51) Int Cl.:
***H01L 51/00*** $^{(2006.01)}$ ***H01L 51/50*** $^{(2006.01)}$

(21) Application number: **15182731.8**

(22) Date of filing: **27.08.2015**

(54) **ORGANIC LIGHT-EMITTING DEVICE**

ORGANISCHE LICHTEMITTIERENDE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.08.2014 KR 20140114518**

(43) Date of publication of application:
**02.03.2016 Bulletin 2016/09**

(73) Proprietor: **Samsung Electronics Co., Ltd.**
**Gyeonggi-do 16677 (KR)**

(72) Inventors:
- **LEE, Sangyeob**
  **16678 Gyeonggi-do (KR)**
- **KIM, Sangdong**
  **16678 Gyeonggi-do (KR)**
- **KIM, Jiwhan**
  **16678 Gyeonggi-do (KR)**
- **LEE, Banglin**
  **16678 Gyeonggi-do (KR)**
- **KWAK, Seungyeon**
  **16678 Gyeonggi-do (KR)**
- **CHOI, Hyeonho**
  **16678 Gyeonggi-do (KR)**

(74) Representative: **Zijlstra, Robert Wiebo Johan**
**Elkington and Fife LLP**
**Prospect House**
**8 Pembroke Road**
**Sevenoaks, Kent TN13 1XR (GB)**

(56) References cited:
**WO-A1-2013/154342**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 991 128 B1

## Description

FIELD OF THE INVENTION

The present disclosure relates to an organic light-emitting device.

BACKGROUND OF THE INVENTION

Organic light-emitting devices are self-emission devices that have wide viewing angles, high contrast ratios, short response time, and excellent brightness, driving voltage, and response speed characteristics, and produce multi-colored images.

As an example, an organic light-emitting device includes an anode, a cathode, and an organic layer that includes an emission layer and is disposed between the anode and the cathode. A hole transport region may be formed between the anode and the emission layer, and an electron transport region may be formed between the emission layer and the cathode. Holes provided from the anode may move toward the emission layer through the hole transport region, and electrons provided from the cathode may move toward the emission layer through the electron transport region. Carriers, such as holes and electrons, may be recombined in the emission layer to produce excitons. These excitons may change from an excited state to a ground state, thereby generating light.

An example of such device is disclosed in WO 2013/154342. The OLED according to WO 2013/154342 comprises a light emitting layer comprising a mixture of hole and electron transporting host materials and a light emitting dopant. The host materials are selected according to their electronic properties.

SUMMARY OF THE INVENTION

Provided is an organic light-emitting device characterized by low driving voltage, high efficiency, high brightness, and long lifespan.

Additional aspects will be set forth in part in the description which follows and, in part, will be apparent from the description, or may be learned by practice of the presented exemplary embodiments.

According to an aspect of an exemplary embodiment, an organic light-emitting device (OLED) includes:

a first electrode;
a second electrode;
an emission layer disposed between the first electrode and the second electrode;
a hole transport layer disposed between the first electrode and the emission layer and including a hole transport layer; and
an electron transport region disposed between the emission layer and the second electrode and including an electron transport layer,
wherein the emission layer includes an electron-transporting host and a hole-transporting host,
the hole transport layer includes a hole transport material,
the electron transport layer includes an electron transport material, and
the OLED satisfies <Equation 1 > and <Equation 2> below:

<Equation 1>

$$0.75\ \text{eV} \leq | LUMO_{H(ET)} - LUMO_{H(HT)} | \leq 0.90\ \text{eV}$$

<Equation 2>

$$| E(S_{1,\ H(ET)}) - E(S_{1,\ H(HT)}) | < 0.15\text{eV}$$

In <Equation 1 > and <Equation 2>,
$LUMO_{H(ET)}$ refers to a lowest unoccupied molecular orbital (LUMO) energy level of the electron-transporting host,
$LUMO_{H(HT)}$ refers to an LUMO energy level of the hole-transporting host,
$E(S_{1,\ H(ET)})$ refers to a singlet energy level of the electron-transporting host, and
$E(S_{1,\ H(HT)})$ refers to a singlet energy level of the hole-transporting host.

BRIEF DESCRIPTION OF THE DRAWINGS

These and/or other aspects will become apparent and more readily appreciated from the following description of the exemplary embodiments, taken in conjunction with the accompanying drawings in which:

FIG. 1 illustrates a schematic view of an organic light-emitting device according to an embodiment; and
FIGS. 2A and 2B illustrate photoluminescence spectra in films using predetermined compounds.

DETAILED DESCRIPTION

Reference will now be made in detail to exemplary embodiments, examples of which are illustrated in the accompanying drawings, wherein like reference numerals refer to like elements throughout. In this regard, the present exemplary embodiments may have different forms and should not be construed as being limited to the descriptions set forth herein. Accordingly, the exemplary embodiments are merely described below, by referring to the figures, to explain aspects. As used herein, the term "and/or" includes any and all combinations of one or more of the associated listed. Equations such as "at least one of," when preceding a list of elements, modify the entire list of elements and do not modify the individual elements of the list.

FIG. 1 illustrates a schematic cross-sectional view of an organic light-emitting device 10 according to an embodiment. Hereinafter, a structure and a preparation method of an organic light-emitting according to embodiments are described in detail with reference to FIG. 1 as follows. The organic light-emitting device 10 has a structure of a first electrode 11, a hole transport region 13, an emission layer 15, an electron transport region 17, and a second electrode 19 that are sequentially stacked in the stated order.

A substrate may be additionally disposed under the first electrode 11 or on top of the second electrode 19. For use as the substrate, any substrate that is used in general organic light-emitting devices may be used, and the substrate may be a glass substrate or a transparent plastic substrate, each of which has excellent mechanical strength, thermal stability, transparency, surface smoothness, ease of handling, and water proofness.

The first electrode 11 may be formed by, e.g., depositing or sputtering a material for forming the first electrode 11 on top of the substrate. When first electrode 11 is an anode, the material for forming the first electrode 11 may be selected from materials having a high work function to facilitate hole injection. The first electrode 11 may be a reflective electrode, a semi-transmissive electrode, or a transmissive electrode. Examples of the material for forming the first electrode 11 may include indium tin oxide (ITO), indium zinc oxide (IZO), tin oxide ($SnO_2$), and zinc oxide (ZnO). In an embodiment, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layer structure or a multi-layer structure including two or more layers.

The hole transport region 13, the emission layer 15, and the electron transport region 17 may be sequentially stacked in the stated order on top of the first electrode 11. The hole transport region 13 may include a hole transport layer, and the electron transport region 17may include an electron transport layer.

The emission layer 15 may include an electron-transporting host and a hole-transporting host. The hole transport layer included in the hole transport region 13 may include a hole transport material, and the electron transport layer included in the electron transport region 17 may include an electron transport material.

In an embodiment, the organic light-emitting device 10 may satisfy <Equation 1> and <Equation 2> below:

<Equation 1>

$$0.75\text{eV} \leq |\text{LUMO}_{H(ET)} - \text{LUMO}_{H(HT)}| \leq 0.90\text{eV}$$

<Equation 2>

$$|E(S_{1,\ H(ET)}) - E(S_{1,\ H(HT)})| < 0.15\text{eV}$$

In <Equation 1> and <Equation 2>,

$\text{LUMO}_{H(ET)}$ refers to a lowest unoccupied molecular orbital (LUMO) energy level of the electron-transporting host included in the emission layer 15,

$\text{LUMO}_{H(HT)}$ refers to a LUMO energy level of the hole-transporting host included in the emission layer 15,

$E(S_{1,\ H(ET)})$ refers to a singlet energy level of the electron-transporting host included in the emission layer 15, and

$E(S_{1,\ H(HT)})$ refers to a singlet energy level of the hole-transporting host included in the emission layer 15.

When the organic light-emitting device 10 satisfies <Equation 1> above, the electron-transporting host and the hole-transporting host included in the emission layer 15 may form an exciplex in an efficient manner, and accordingly, the organic light-emitting device 10 may have improved efficiency, brightness, and lifespan.

In addition, when the organic light-emitting device 10 satisfies <Equation 2> above, the stability of the exciplex formed by the electron-transporting host and the hole-transporting host included in the emission layer 15 is increased, and thus, upon non-radiative decay, cold excitons having excellent thermal stability may be produced. Accordingly, the organic light-emitting device 10 may be able to have a long lifespan.

In another embodiment, the organic light-emitting device 10 may further satisfy <Equation 3> and <Equation 4> below:

<Equation 3>

$$|HOMO_{H(HT)} - HOMO_{HTL}| < 0.3eV$$

<Equation 4>

$$0.15eV \leq |HOMO_{H(HT)} - HOMO_{H(ET)}| \leq 2.0eV$$

In <Equation 3> and <Equation 4>,
$HOMO_{H(HT)}$ refers to a highest occupied molecular orbital (HOMO) energy level of the hole-transporting host included in the emission layer,
$HOMO_{HTL}$ refers to a HOMO energy level of the hole transport material of the hole transport layer included in the hole transport region 13,
$HOMO_{H(ET)}$ refers to a HOMO energy level of the electron-transporting host included in the emission layer 15.

In another embodiment, the organic light-emitting device 10 may further satisfy <Equation 5> below.

<Equation 5>

$$|LUMO_{H(ET)} - LUMO_{ETL}| < 0.2eV$$

In <Equation 5>, $LUMO_{ETL}$ refers to a LUMO energy level of the electron transport material of the electron transport layer included in the electron transport region 17.

In another embodiment, the organic light-emitting device 10 may satisfy <Equation 6> and <Equation 7> below:

<Equation 6>

$$\min\{E(S_{1,H(HT)}), E(S_{1,H(ET)})\}-E(S_{1,EX}) > 0.15eV$$

<Equation 7>

$$E(S_{1,EX}) - E(T_{1,EX}) < 0.15eV$$

In <Equation 6> and <Equation 7>,
$E(S_{1,H(HT)})$ refers to a singlet energy level of the hole-transporting host included in the emission layer 15,
$E(S_{1,H(ET)})$ refers to a singlet energy level of the electron-transporting host included in the emission layer 15,
$\min\{E(S_{1,H(HT)}), E(S_{1,H(ET)})\}$ refers to the smallest value between values of $E(S_{1,H(HT)})$ and $E(S_{1,H(ET)})$,
$E(S_{1,EX})$ refers to a singlet energy level of the exciplex formed by the electron-transporting host and the hole-transporting host included in the emission layer 15, and
$E(T_{1,EX})$ refers to a triplet energy level of the exciplex formed by the electron-transporting host and the hole-transporting host included in the emission layer 15.

When the organic light-emitting device 10 satisfies <Equation 3> to <Equation 6>, the formation of the exciplex may be carried out in an efficient manner by the electron-transporting host and the hole-transporting host included in the emission layer 15.

In addition, when the organic light-emitting device 10 satisfies <Equation 7>, an overlapping between an $S_1$ orbital and an $S_0$ orbital of the exciplex, which is formed by the electron-transporting host and the hole-transporting host included in the emission layer 15, is reduced, and accordingly, decay time of the exciplex is increased, resulting in efficient energy transfer. Accordingly, the organic light-emitting device 10 may have improved lifespan.

For example, the organic light-emitting device 10 may satisfy, but not limited to, all of <Equation 3> to <Equation 7> in addition to <Equation 1> and <Equation 2>.

In the organic light-emitting device 10, the electron-transporting host included in the emission layer 15 may include a compound represented by Formula 1 below:

<Formula 1>

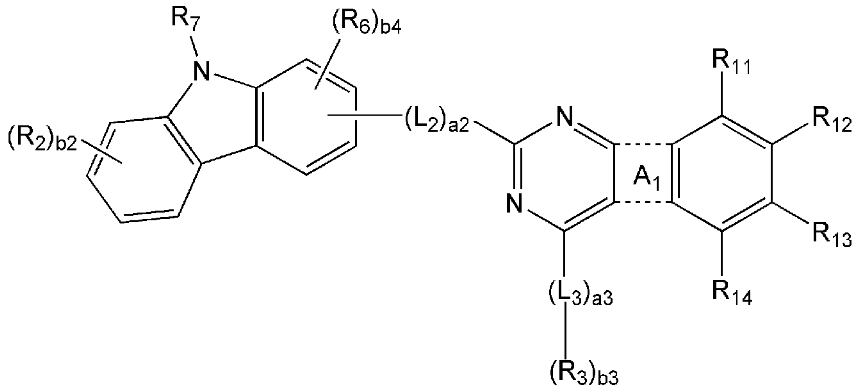

<Formula 1A>

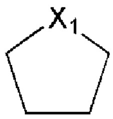

In Formula 1, a ring $A_1$ may be represented by Formula 1A above;
$X_1$ may be N-[$(L_1)_{a1}$-$(R_1)_{b1}$], S, O, S(=O), $S(=O)_2$, C(=O), $Si(R_4)(R_5)$, $P(R_4)$, $P(=O)(R_4)$, or $C=N(R_4)$;
$L_1$ to $L_3$ may be each independently selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group;
a1 to a3 may be each independently an integer of 1 to 5. When a1 is 2 or more, 2 or more $L_1$s may be identical to or different from each other, when a2 is 2 or more, 2 or more $L_2$s may be identical to or different from each other, and when a3 is 2 or more, 2 or more $L_3$s may be identical to or different from each other;
$R_1$ to $R_7$ and $R_{11}$ to $R_{14}$ may be each independently selected from a hydrogen, a deuterium, a fluoro group (-F), a chloro group (-Cl), a bromo group (-Br), an iodo group (-I), a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, and $-B(Q_6)(Q_7)$;
b1 to b4 may be each independently an integer of 1 to 3;
at least one of substituents of the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed

polycyclic group, the substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be selected from

a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, and $-B(Q_{16})(Q_{17})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, and $-B(Q_{26})(Q_{27})$; and

$-N(Q_{31})(Q_{32})$, $-Si(Q_{33})(Q_{34})(Q_{35})$, and $-B(Q_{36})(Q_{37})$,

wherein $Q_1$ to $Q_7$, $Q_{11}$ to $Q_{17}$, $Q_{21}$ to $Q_{27}$, and $Q_{31}$ to $Q_{37}$ may be each independently selected from a hydrogen, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

In another embodiment, $X_1$ in Formula 1A above may be $N-[(L_1)_{a1}-(R_1)_{b1}]$, S, O, or $Si(R_4)(R_5)$.

In another embodiment, $X_1$ in Formula 1A above may be S, O, or $Si(R_4)(R_5)$, but $X_1$ is not limited thereto.

In another embodiment, $X_1$ in Formula 1A above may be S or O, but $X_1$ is not limited thereto.

The ring $A_1$ in Formula 1 above is a ring that is fused with two neighboring 6-membered rings by sharing its carbon atom.

For example, $L_1$ to $L_3$ in Formula 1 may be each independently selected from

a single bond, a phenylene group, a naphthylene group, a fluorenylene group, a spiro-fluorenylene group, a phenanthrenylene group, an anthracenylene group, a triphenylenylene group, a pyrenylene group, a chrysenylene group, a pyridinylene group, a pyrimidinylene group, a quinolinylene group, an isoquinolinylene group, a triazinylene group, and a carbazolylene group; and

a phenylene group, a naphthylene group, a fluorenylene group, a spiro-fluorenylene group, a phenanthrenylene group, an anthracenylene group, a triphenylenylene group, a pyrenylene group, a chrysenylene group, a pyridinylene group, a pyrimidinylene group, a quinolinylene group, an isoquinolinylene group, a triazinylene group, and a carbazolylene group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, a quinazolinyl group, a carbazolyl group, and $-Si(Q_{33})(Q_{34})(Q_{35})$,

wherein $Q_{33}$ to $Q_{35}$ may be each independently selected from a hydrogen, a $C_1$-$C_{20}$ alkyl group, a $C_1$-$C_{20}$ alkoxy group,

a phenyl group, a naphthyl group, an anthracenyl group, a pyrenyl group, a phenanthrenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group.

For example, $L_1$ to $L_3$ in Formula 1 may be each independently selected from groups selected from Formulae 2-1 to 2-17 below:

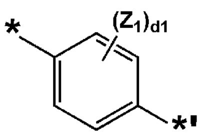

Formula 2-1

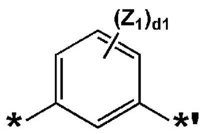

Formula 2-2

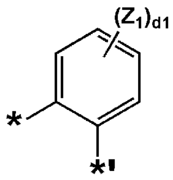

Formula 2-3

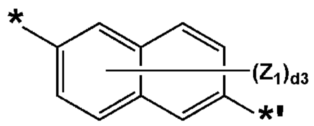

Formula 2-4

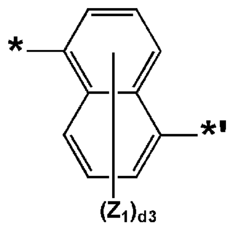

Formula 2-5

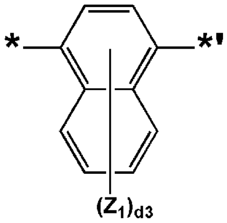

Formula 2-6

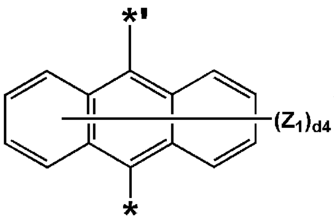

Formula 2-7

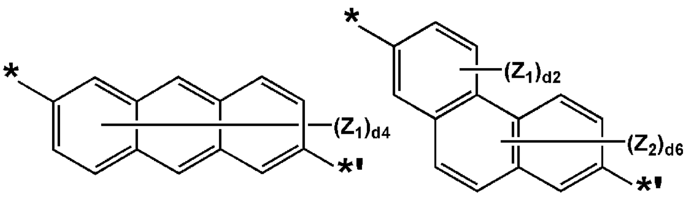

Formula 2-8

Formula 2-9

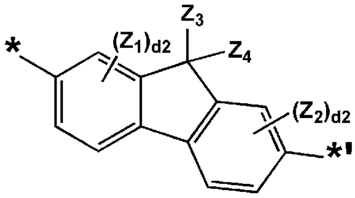

Formula 2-10

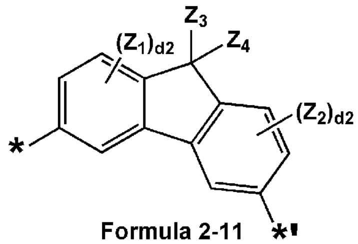

Formula 2-11

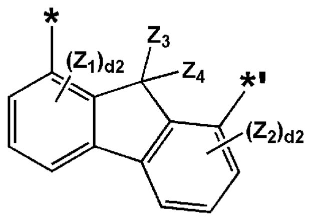

Formula 2-12

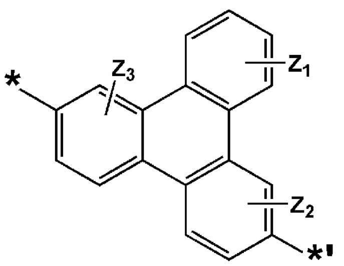

Formula 2-13

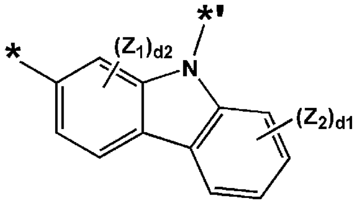

Formula 2-14

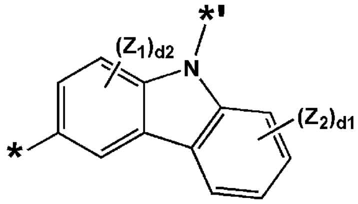

Formula 2-15

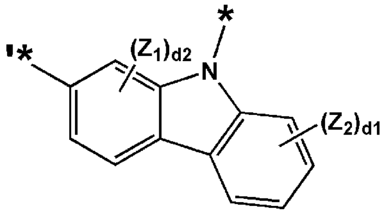

Formula 2-16

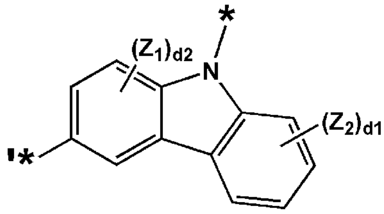

Formula 2-17

In Formulae 3-1 to 3-12, * and *' may each independently indicate a binding site to a neighboring atom.

In Formulae 2-1 to 2-17,

$Z_1$ to $Z_4$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a triphenylenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, a quinoxalinyl group, a biphenyl group, and -Si($Q_{33}$)($Q_{34}$)($Q_{35}$),

wherein $Q_{33}$ to $Q_{35}$ may be each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group;

d1 may be an integer of 1 to 4, d2 may be an integer of 1 to 3, d3 may be an integer of 1 to 6, d4 may be an integer of 1 to 8, d6 may be an integer of 1 to 5, and * and *' may each independently indicate a binding site to a neighboring atom.

For example, $L_1$ to $L_3$ in Formula 1 may be each independently a group represented by one of Formulae 3-1 to 3-12 below, but $L_1$ to $L_3$ are not limited thereto:

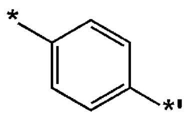
Formula 3-1

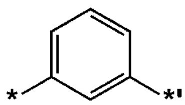
Formula 3-2

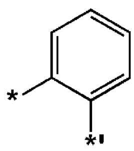
Formula 3-3

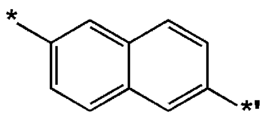
Formula 3-4

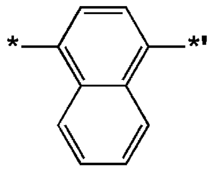
Formula 3-5

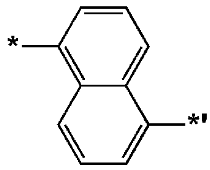
Formula 3-6

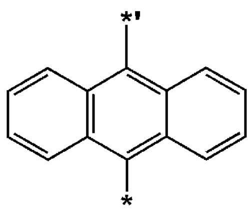
Formula 3-7

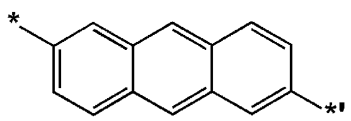
Formula 3-8

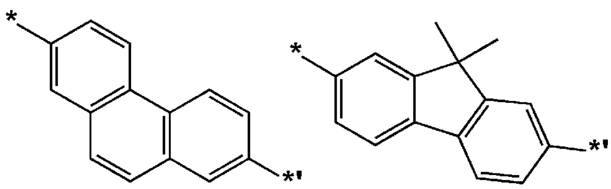
Formula 3-9

Formula 3-10

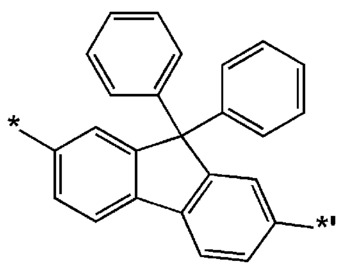
Formula 3-11

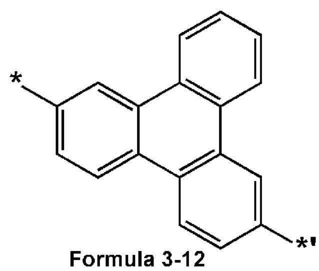
Formula 3-12

In Formula 1, a1 may indicate the number of $L_1$ and may be 1, 2, 3, 4, or 5, e.g., 1 or 2. In an embodiment, a1 in Formula 1 may be 1. When a1 is 2 or more, 2 or more $L_1$s may be identical to or different from each other. Descriptions of a2 and a3 may be understood by referring to the description provided in connection with a1 and the structure of Formula 1.

In an embodiment, a1, a2, and a3 may be each independently 1 or 2.

In Formula 1, i) at least one of $R_2$ and $R_3$ and ii) $R_1$ and $R_7$ may be each independently selected from

a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, -Si($Q_{33}$)($Q_{34}$)($Q_{35}$), a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, and a biphenyl group.

In another embodiment, $R_1$ to $R_7$ in Formula 1 may be each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

, a $C_1$-$C_{20}$ alkyl group and a $C_1$-$C_{20}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof,;

a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, a benzocarbazolyl group, and a dibenzocarbazolyl group;

a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group, an isoquinolinyl group, a quinoxalinyl group, a quinazolinyl

group, a carbazolyl group, a triazinyl group, a dibenzofuranyl group, a dibenzothiophenyl group, a benzocarbazolyl group, and a dibenzocarbazolyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, -Si($Q_{33}$)($Q_{34}$)($Q_{35}$), a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, a benzocarbazolyl group, and a dibenzocarbazolyl group; and

-Si($Q_3$)($Q_4$)($Q_5$) (but, $R_4$ and $R_5$ are not -Si($Q_3$)($Q_4$)($Q_5$)),

wherein $Q_3$ to $Q_5$ and $Q_{33}$ to $Q_{35}$ may be each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group, and

at least one of i) $R_2$ and $R_3$ and ii) $R_1$ and $R_7$ may be each independently selected from

a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, a benzocarbazolyl group, and a dibenzocarbazolyl group; and

a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, a benzocarbazolyl group, and a dibenzocarbazolyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, -Si($Q_{33}$)($Q_{34}$)($Q_{35}$), a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, a benzocarbazolyl group, and a dibenzocarbazolyl group.

In another embodiment, $R_1$ to $R_7$ in Formulae above may be each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

one of Formulae 4-1 to 4-31; and

-Si($Q_3$)($Q_4$)($Q_5$) (but, $R_4$ to $R_5$ are not -Si($Q_3$)($Q_4$)($Q_5$)),

wherein at least one of i) $R_2$ and $R_3$ and ii) $R_1$ and $R_7$ may be each independently a group represented by one of Formulae 4-1 to 4-31 below:

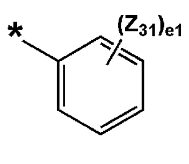
Formula 4-1

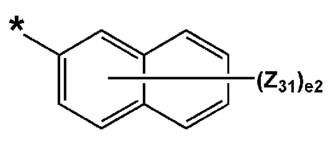
Formula 4-2

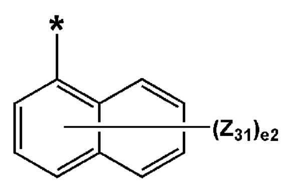
Formula 4-3

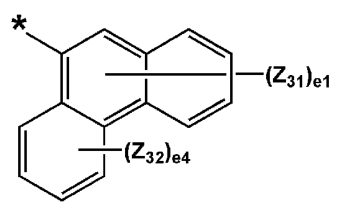
Formula 4-4

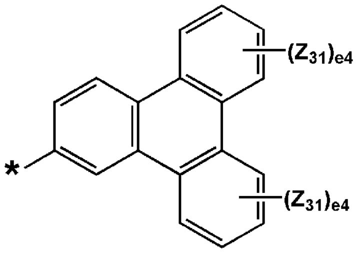
Formula 4-5

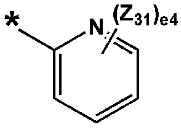
Formula 4-6

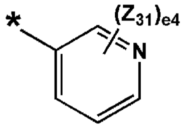
Formula 4-7

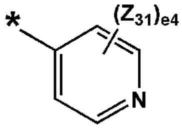
Formula 4-8

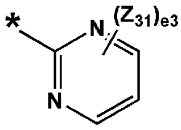
Formula 4-9

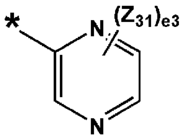
Formula 4-10

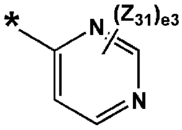
Formula 4-11

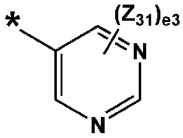
Formula 4-12

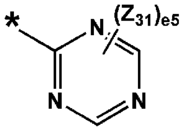
Formula 4-13

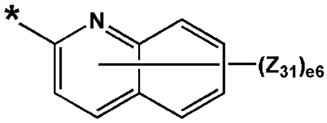
Formula 4-14

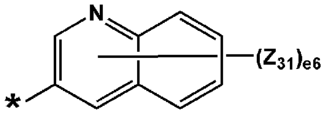
Formula 4-15

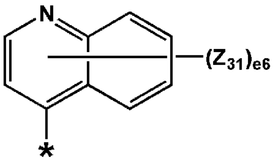
Formula 4-16

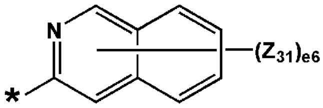
Formula 4-17

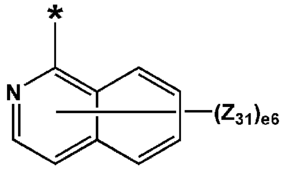
Formula 4-18

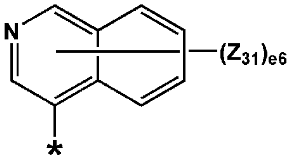
Formula 4-19

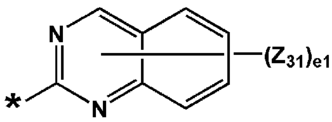
Formula 4-20

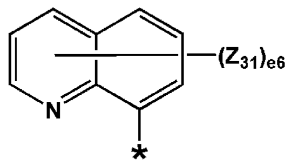
Formula 4-21

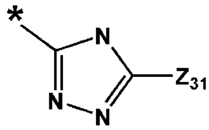
Formula 4-22

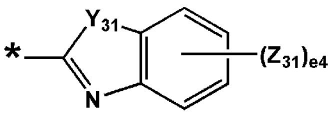
Formula 4-23

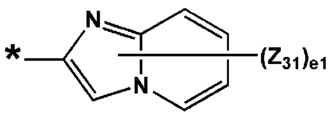
Formula 4-24

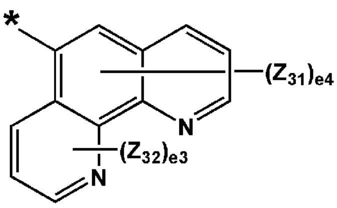
Formula 4-25

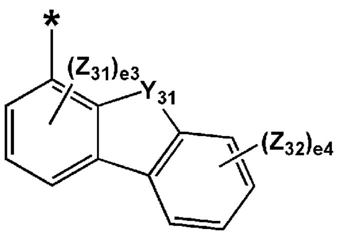
Formula 4-26

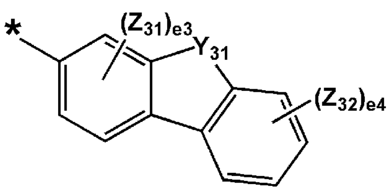
Formula 4-27

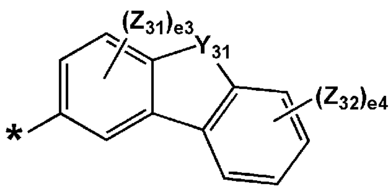
Formula 4-28

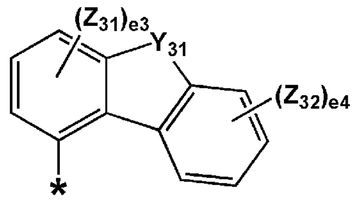

Formula 4-29

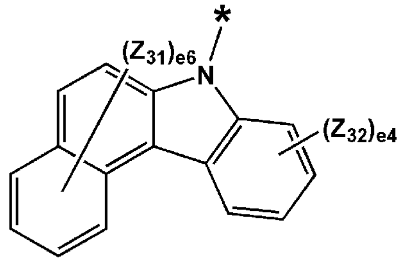

Formula 4-30

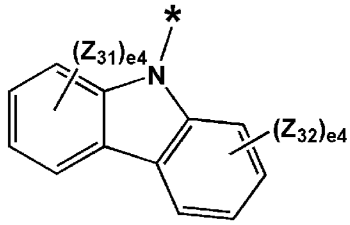

Formula 4-31

In Formulae 4-1 to 4-31,

$Y_{31}$ may be O, S, $C(Z_{33})(Z_{34})$, $N(Z_{35})$, or $Si(Z_{36})(Z_{37})$ (wherein $Y_{31}$ in Formula 4-23 is not NH);

$Z_{31}$ to $Z_{37}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, a quinoxalinyl group, a biphenyl group, and $-Si(Q_{33})(Q_{34})(Q_{35})$,

wherein $Q_3$ to $Q_5$ and $Q_{33}$ to $Q_{35}$ may be each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group;

e1 may be an integer of 1 to 5, e2 may be an integer of 1 to 7, e3 may be an integer of 1 to 3, e4 may be an integer of 1 to 4, e5 may be an integer of 1 or 2, e6 may be an integer of 1 to 6, and * indicates a binding site to a neighboring atom.

In another embodiment, $R_1$ and $R_7$ may be each independently selected from

a phenyl group, a naphthyl group, a phenalenyl group, a phenanthrenyl group, an anthracenyl group, a fluoranthenyl group, a triphenylenyl group, a pyrenyl group, a chrysenyl group, and a perylenyl group; and

a phenyl group, a naphthyl group, a phenalenyl group, a phenanthrenyl group, an anthracenyl group, a fluoranthenyl group, a triphenylenyl group, a pyrenyl group, a chrysenyl group, and a perylenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a phenalenyl group, a phenanthrenyl group, an anthracenyl group, a fluoranthenyl group, a triphenylenyl group, a pyrenyl group, a chrysenyl group, and a perylenyl group.

In another embodiment, at least one of $R_2$ and $R_3$ in Formula 1 may be selected from

a triphenylenyl group, a carbazolyl group, a dibenzofuranyl group, a dibenzothiophenyl group, and a benzocarbazolyl group; and

a triphenylenyl group, a carbazolyl group, a dibenzofuranyl group, a dibenzothiophenyl group, and a benzocarbazolyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, $-Si(Q_{33})(Q_{34})(Q_{35})$, a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, a benzocarbazolyl group, and a dibenzocarbazolyl group.

In another embodiment, at least one of $R_2$ and $R_3$ in Formula 1 may be selected from

a triphenylenyl group and a carbazolyl group; and

a triphenylenyl group and a carbazolyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, $-Si(Q_{33})(Q_{34})(Q_{35})$, a phenyl group, a naphthyl group, a phenalenyl group, a phenanthrenyl group, an anthracenyl group, a fluoranthenyl group, a triphenylenyl group, a pyrenyl group, a chrysenyl group, a perylenyl group, a pyridinyl group, a pyrazinyl group, a pyrimidinyl group, a pyridazinyl group, a quinolinyl group,

an isoquinolinyl group, a quinoxalinyl group, a quinazolinyl group, a carbazolyl group, a triazinyl group, a dibenzofuranyl group, a dibenzothiophenyl group, a benzocarbazolyl group, and a dibenzocarbazolyl group.

In Formula 1, $R_{11}$ to $R_{14}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_1$)($Q_2$), -Si($Q_3$)($Q_4$)($Q_5$), and -B($Q_6$)($Q_7$).

For example, $R_{11}$ to $R_{14}$ in Formula 1 may be each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

-Si($Q_3$)($Q_4$)($Q_5$),

wherein $Q_3$ to $Q_5$ may be each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group.

For example, $R_{11}$ to $R_{14}$ in Formula 1 may be each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

a phenyl group, a naphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a thiophenyl group, a furanyl group, a pyridinyl group, a pyrazinyl group, a pyrimidinyl group, a pyridazinyl group, a quinolinyl group, an isoquinolinyl group, a quinoxalinyl group, a quinazolinyl group, a benzofuranyl group, a benzothiophenyl group, an isobenzothiazolyl group, a triazinyl group, a dibenzofuranyl group, a dibenzothiophenyl group, a benzocarbazolyl group, and a dibenzocarbazolyl group; and

-Si($Q_3$)($Q_4$)($Q_5$),

wherein $Q_3$ to $Q_5$ may be each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group.

For example, $R_{11}$ to $R_{14}$ in Formula 1 may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group, but $R_{11}$ to $R_{14}$ are not limited thereto.

For example, all of $R_{11}$ to $R_{14}$ in Formula 1 may be a hydrogen.

In an embodiment, $R_1$ to $R_7$ may be each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

one of Formulae 5-1 to 5-85 below; and

-Si($Q_3$)($Q_4$)($Q_5$) (bur, $R_4$ and $R_5$ are not -Si($Q_3$)($Q_4$)($Q_5$));

at least one of i) $R_2$ and $R_3$ and ii) $R_1$ and $R_7$ may be each independently a group represented by one of Formulae 5-1 to 5-85 below; and

$R_{11}$ to $R_{14}$ may be each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

Formulae 5-1 to 5-4, 5-10 to 5-17, 5-26 to 5-31, 5-39, 5-40, 5-42, 5-44, 5-47, and 5-48; and

-Si($Q_3$)($Q_4$)($Q_5$),

wherein $Q_3$ to $Q_5$ may be each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group, but $Q_3$ to $Q_5$ are not limited thereto:

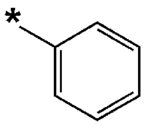
Formula 5-1

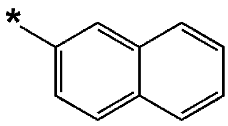
Formula 5-2

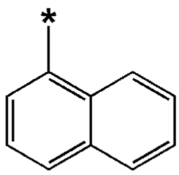
Formula 5-3

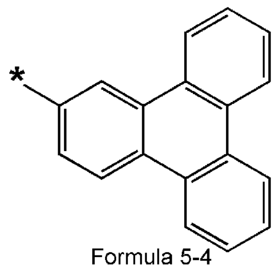
Formula 5-4

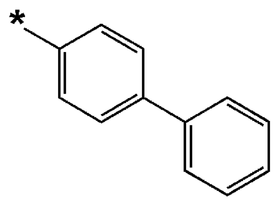
Formula 5-5

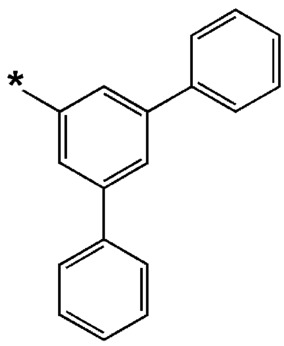
Formula 5-6

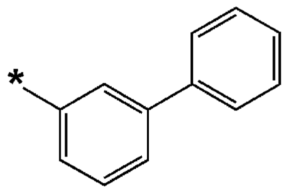
Formula 5-7

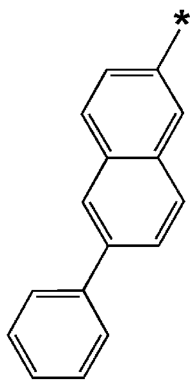
Formula 5-8

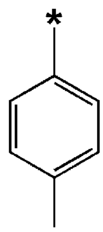
Formula 5-9

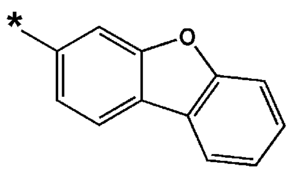
Formula 5-10

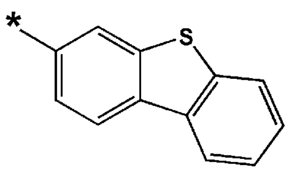
Formula 5-11

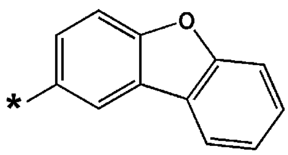
Formula 5-12

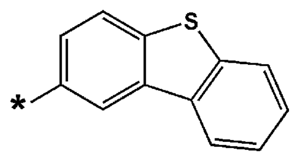
Formula 5-13

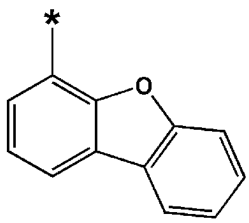
Formula 5-14

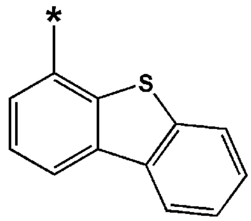
Formula 5-15

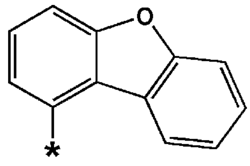
Formula 5-16

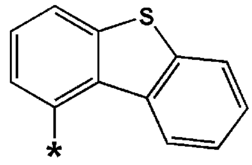
Formula 5-17

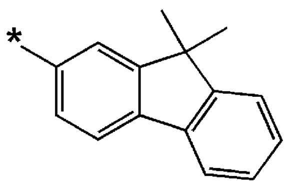
**Formula 5-18**

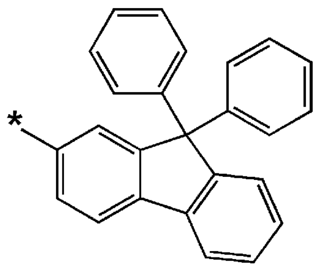
**Formula 5-19**

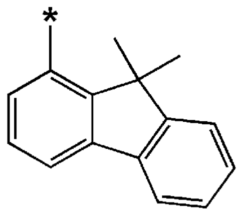
**Formula 5-20**

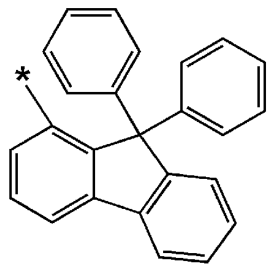
**Formula 5-21**

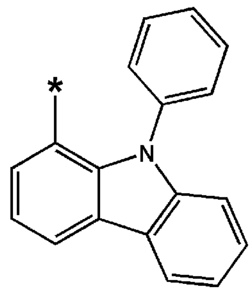
**Formula 5-22**

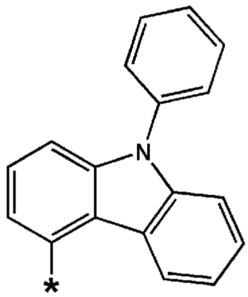
**Formula 5-23**

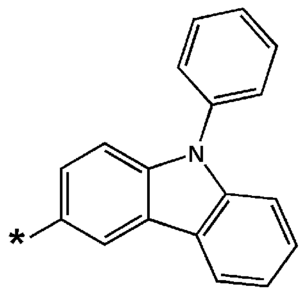
**Formula 5-24**

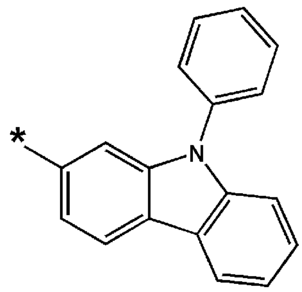
**Formula 5-25**

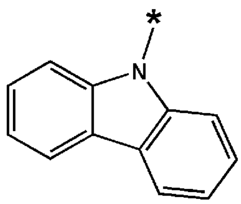
**Formula 5-26**

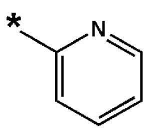
**Formula 5-27**

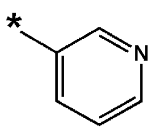
**Formula 5-28**

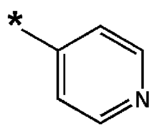
**Formula 5-29**

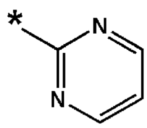
**Formula 5-30**

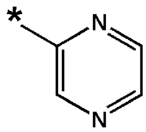
**Formula 5-31**

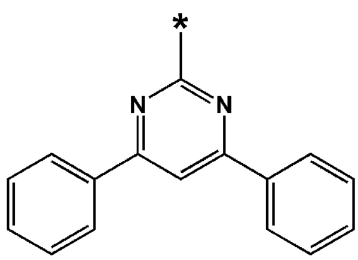
**Formula 5-32**

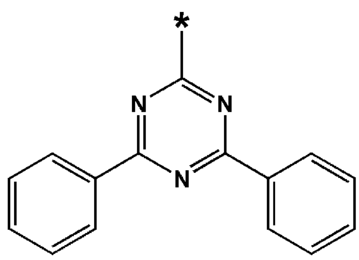
**Formula 5-33**

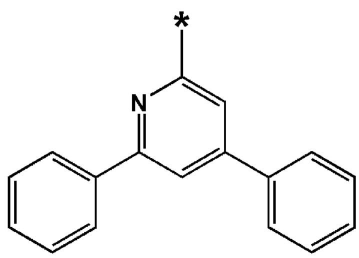
**Formula 5-34**

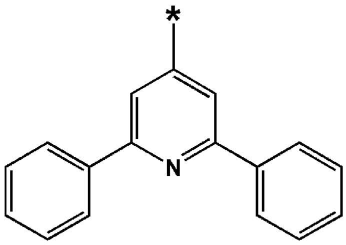

Formula 5-35

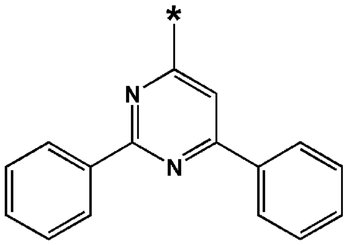

Formula 5-36

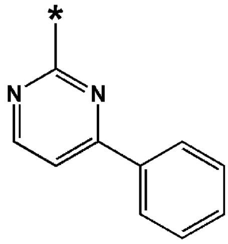

Formula 5-37

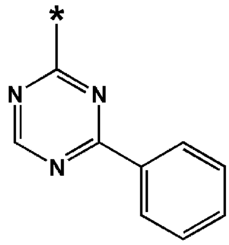

Formula 5-38

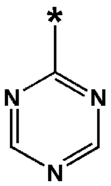

Formula 5-39

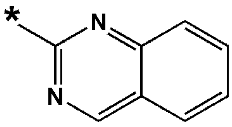

Formula 5-40

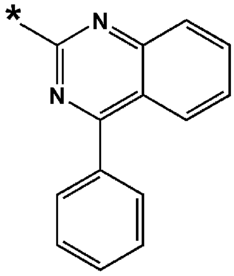

Formula 5-41

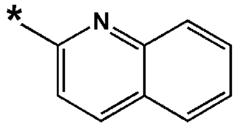

Formula 5-42

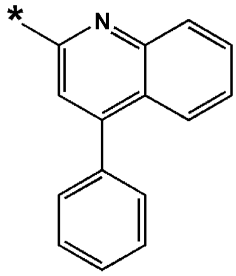

Formula 5-43

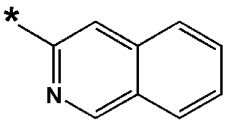

Formula 5-44

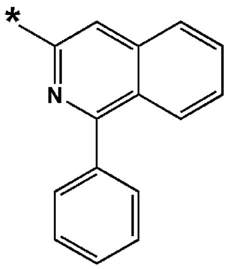

Formula 5-45

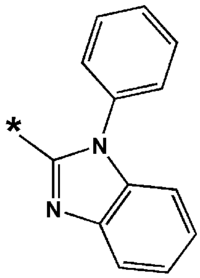

Formula 5-46

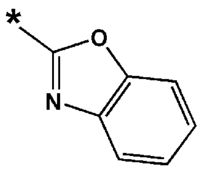

Formula 5-47

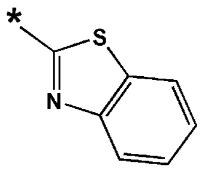

Formula 5-48

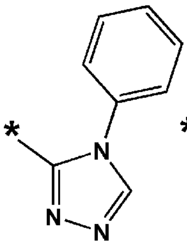

Formula 5-49

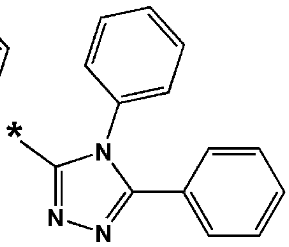

Formula 5-50

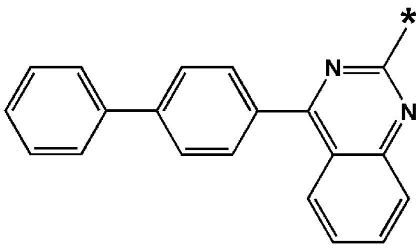

Formula 5-51

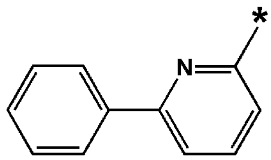

Formula 5-52

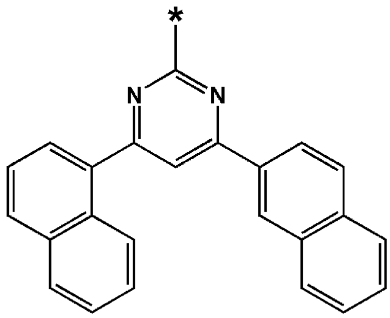

Formula 5-53

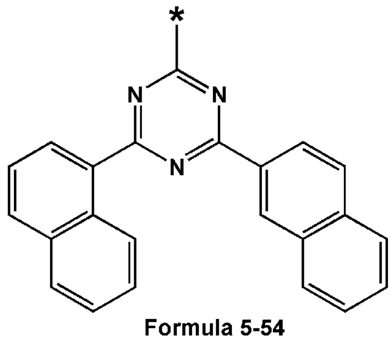

Formula 5-54

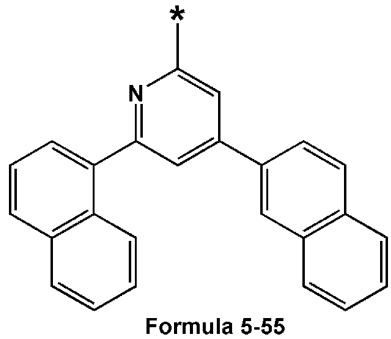

Formula 5-55

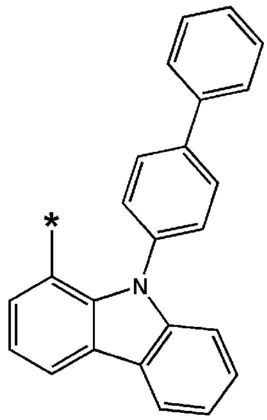

Formula 5-56

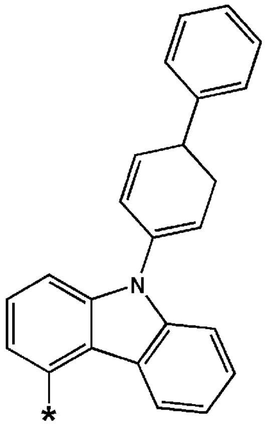

Formula 5-57

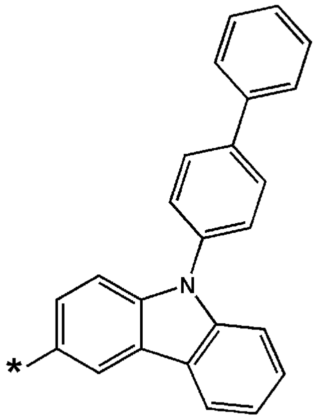

Formula 5-58

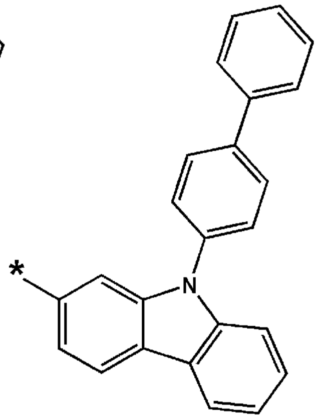

Formula 5-59

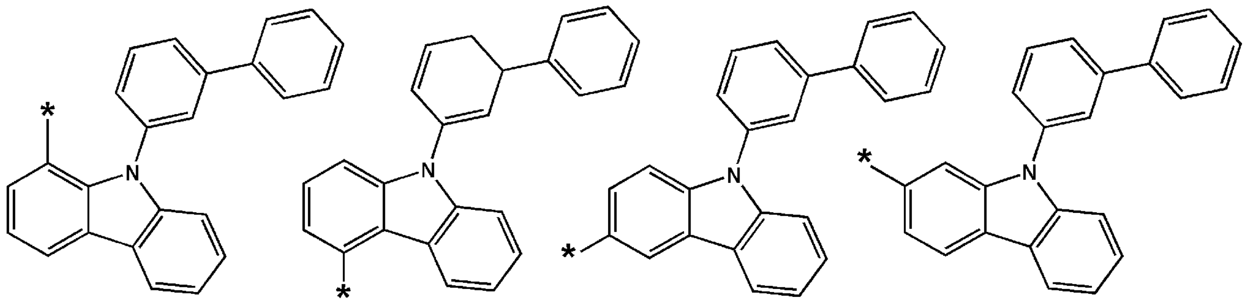

Formula 5-60

Formula 5-61

Formula 5-62

Formula 5-63

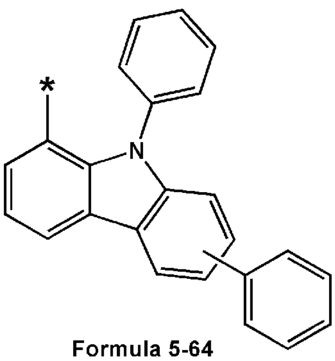

Formula 5-64

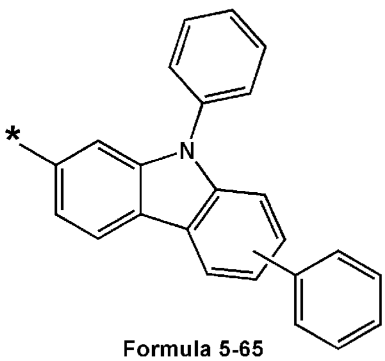

Formula 5-65

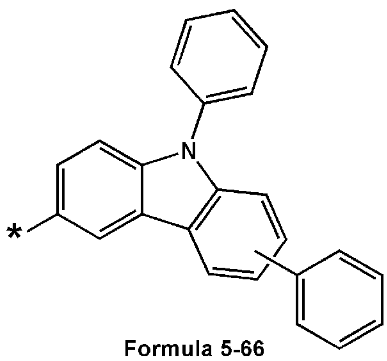

Formula 5-66

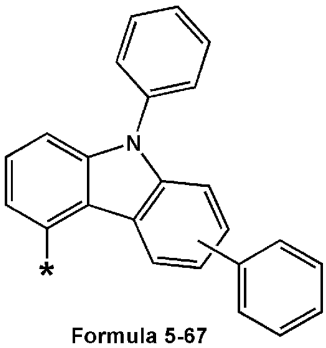
Formula 5-67

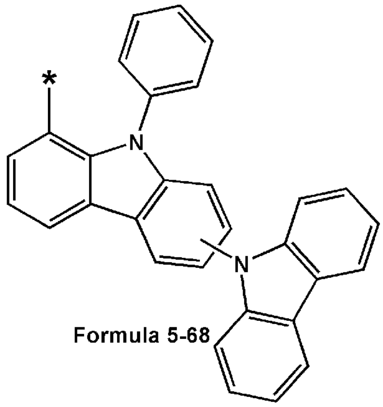
Formula 5-68

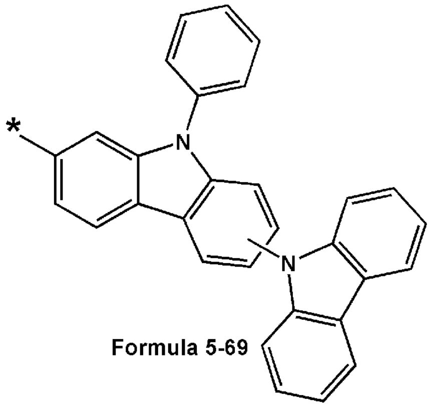
Formula 5-69

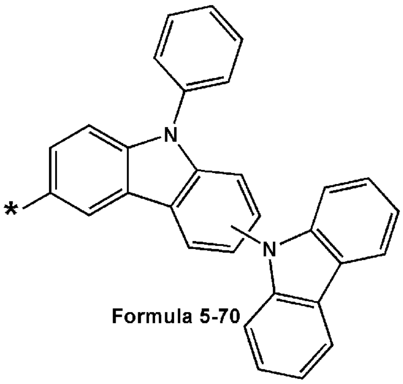
Formula 5-70

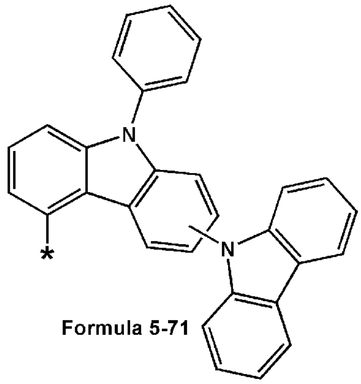
Formula 5-71

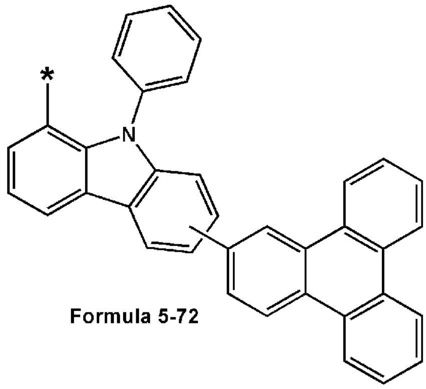
Formula 5-72

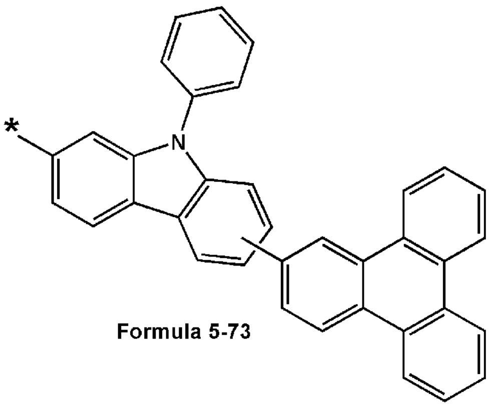
Formula 5-73

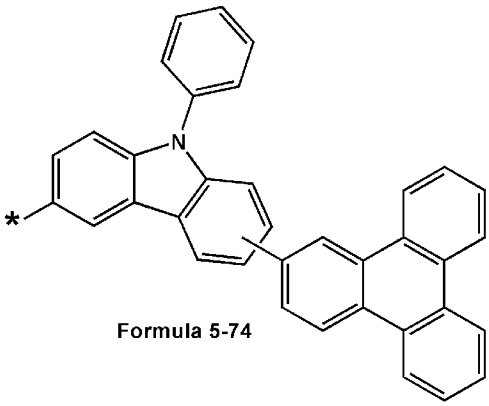
Formula 5-74

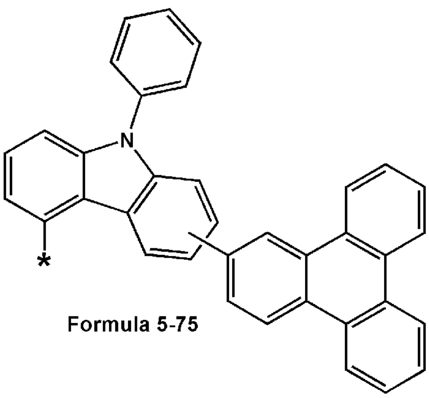
Formula 5-75

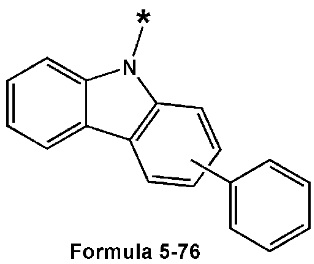
Formula 5-76

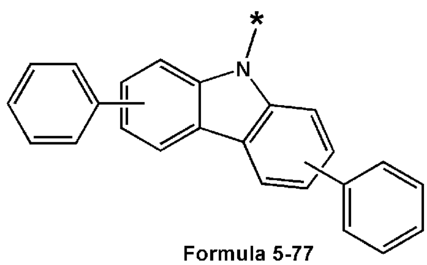
Formula 5-77

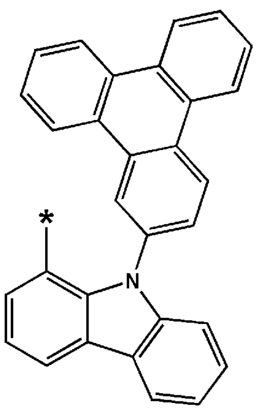

Formula 5-78

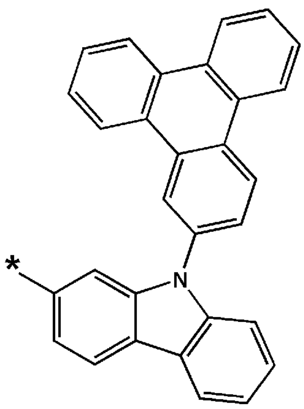

Formula 5-79

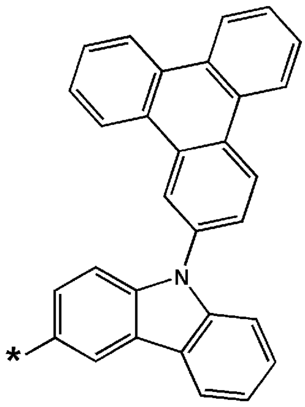

Formula 5-80

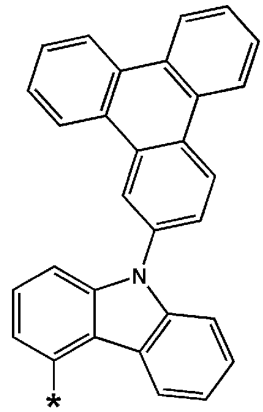

Formula 5-81

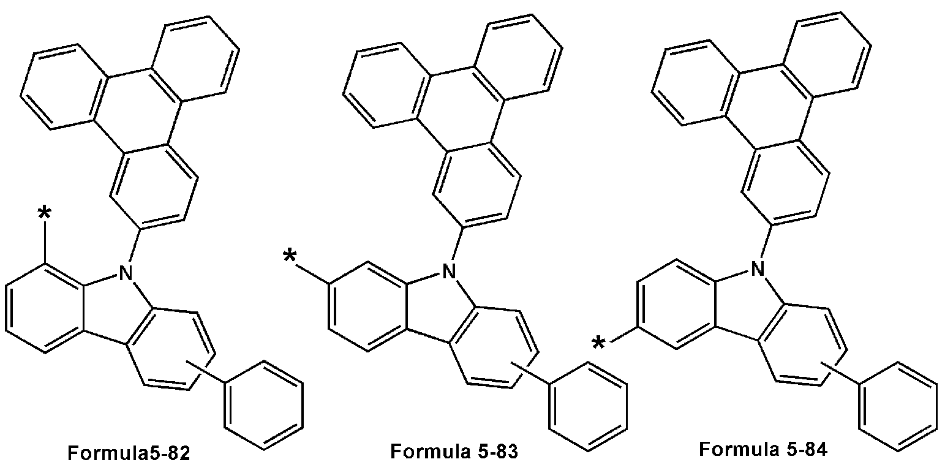

Formula5-82

Formula 5-83

Formula 5-84

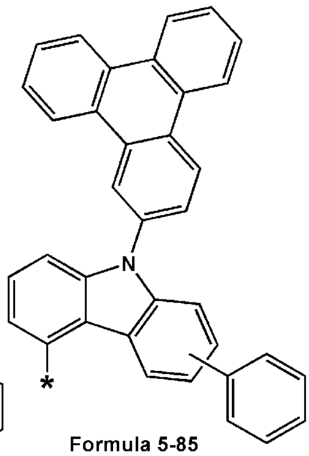

Formula 5-85

In Formulae 5-1 to 5-85, * may indicate a binding site to a neighboring atom.

For example, but not limited to, $L_2$ in Formula 1 may be represented by one of Formulae 2-2 and 2-14 to 2-16 above, a2 may be 1, $R_2$ may be selected from a hydrogen and groups represented by Formulae 4-1 to 4-5 and 4-31, b2 may be 1 or 2, $R_6$ may be a hydrogen, and $R_7$ may be selected from groups represented by Formulae 4-1 to 4-5.

In an embodiment, the electron-transporting host may include at least one of Compounds EH1-401 to EH1-415 and EH2-1 to EH2-30 below:

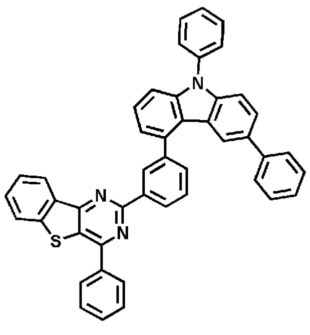

EH1-401

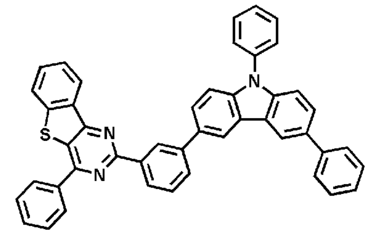

EH1-402

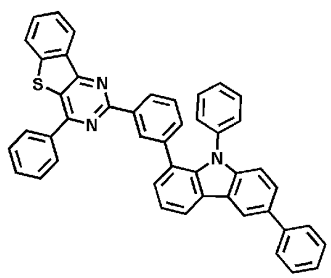

EH1-403

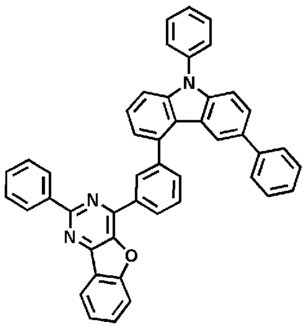

EH1-404

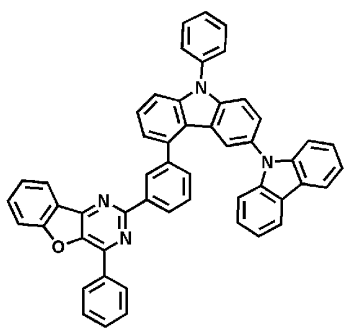

EH1-405

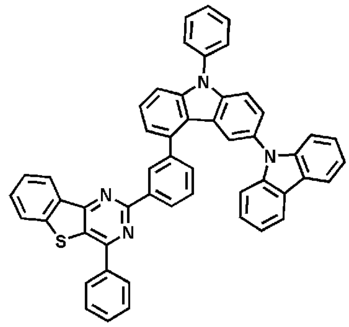

EH1-406

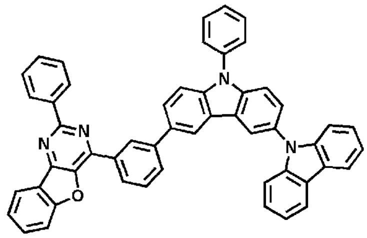

EH1-407

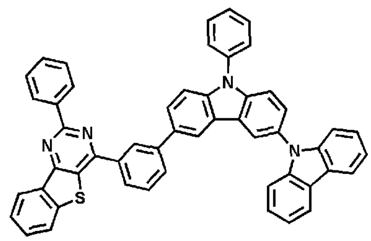

EH1-408

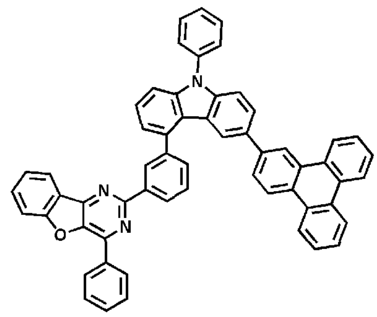

EH1-409

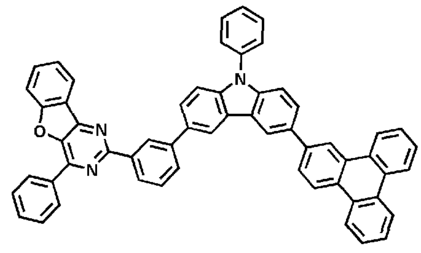

EH1-410

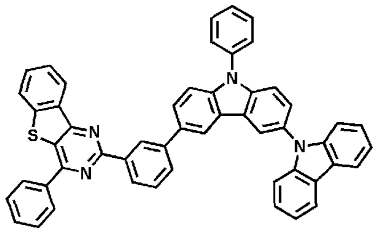

EH1-411

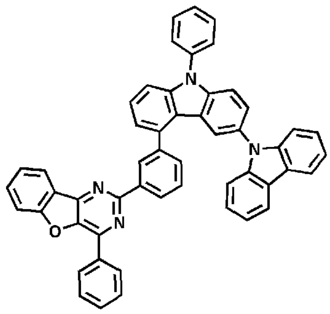

EH1-412

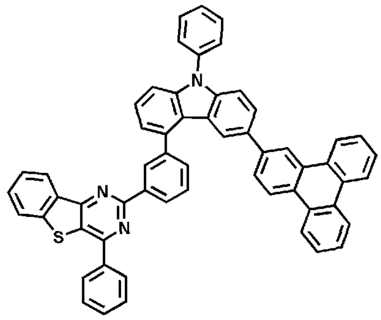

EH1-413

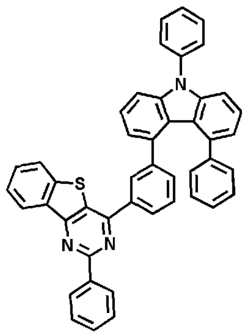

EH1-414

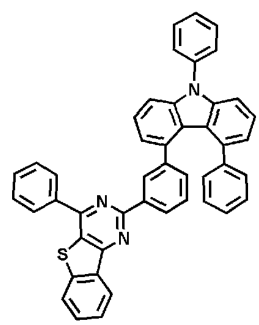

EH1-415

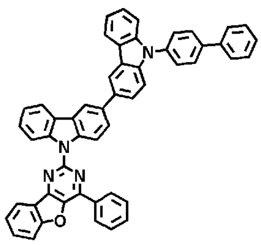

EH2-1

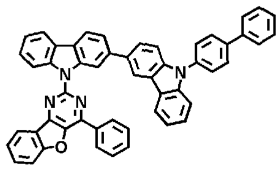

EH2-2

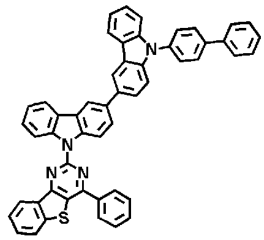

EH2-3

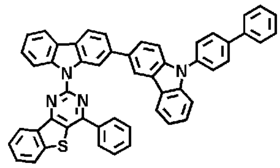

EH2-4

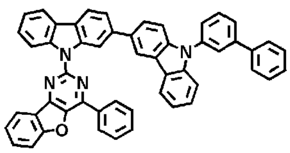

EH2-5

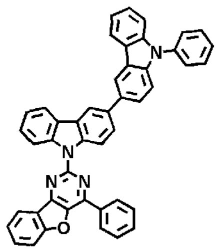

EH2-6

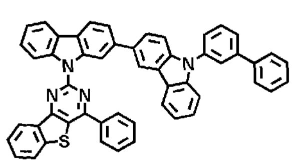

EH2-7

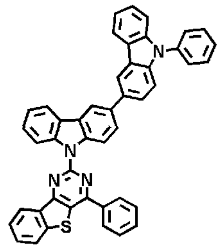

EH2-8

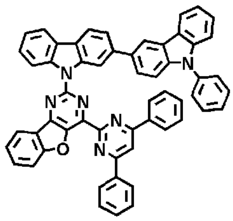

EH2-9

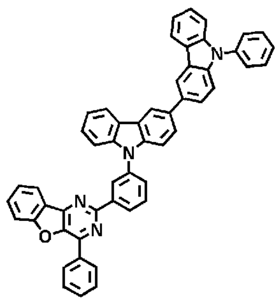

EH2-10

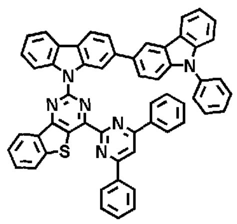

EH2-11

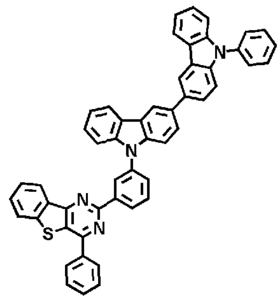

EH2-12

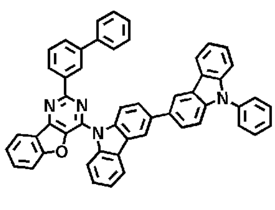

EH2-13

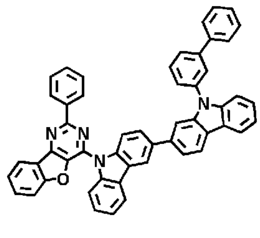

EH2-14

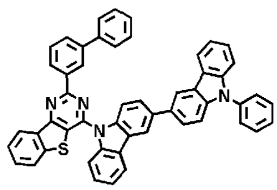

EH2-15

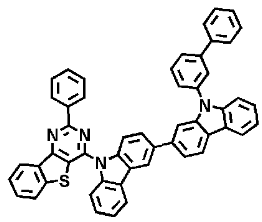

EH2-16

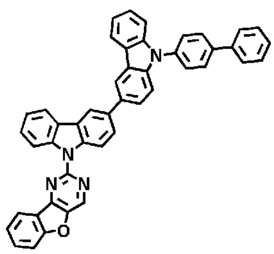

EH2-17

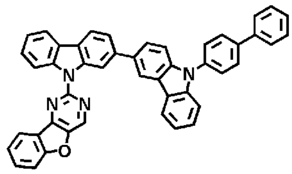

EH2-18

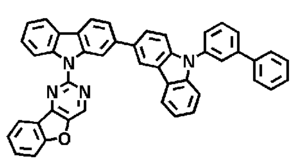

EH2-19

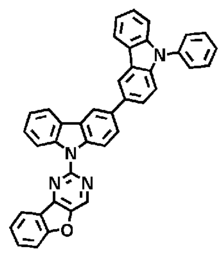

EH2-20

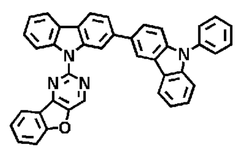

EH2-21

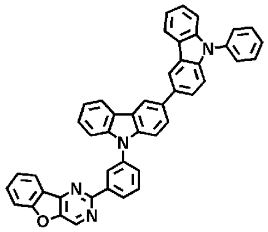

EH2-22

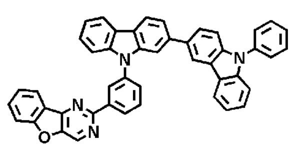

EH2-23

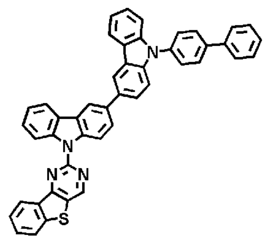

EH2-24

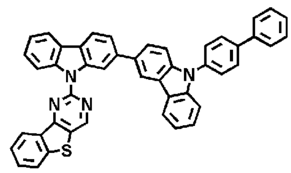

EH2-25

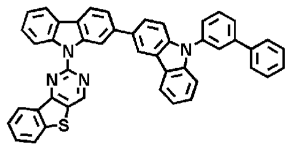

EH2-26

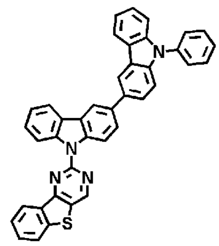

EH2-27

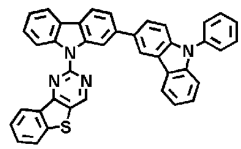

EH2-28

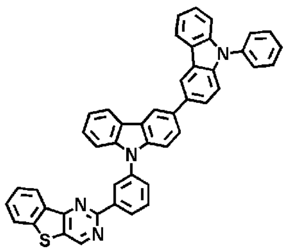

EH2-29

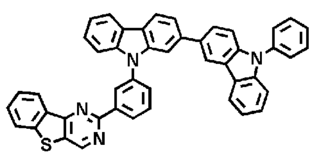

EH2-30

In another embodiment, the electron-transporting host included in the emission layer 15 of the organic light-emitting device 10 may include a compound represented by Formula 10 below:

<Formula 10>

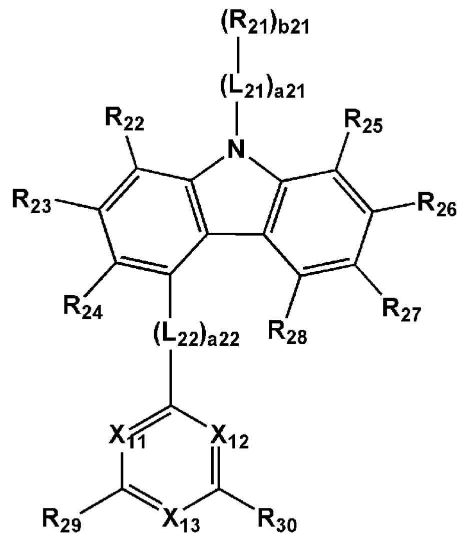

In Formula 10,

$L_{21}$ and $L_{22}$ may be each independently selected from a substituted or unsubstituted $C_3$-$C_{IO}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,

a21 and a22 may be each independently an integer of 0 to 3,

$X_{11}$ may be N or C($R_{51}$), $X_{12}$ may be N or C($R_{52}$), $X_{13}$ may be N or C($R_{53}$), and at least two of $X_{11}$ to $X_{13}$ may be N,

$R_{21}$ to $R_{30}$ and $R_{51}$ to $R_{53}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, and -Si($Q_{41}$)($Q_{42}$)($Q_{43}$),

b21 and b22 may be each independently an integer of 1 to 5,

at least one of $R_{25}$ to $R_{28}$ may be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group;

at least one of substituents of the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, the substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be selected from

a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{51}$)($Q_{52}$)($Q_{53}$), and -B($Q_{54}$)($Q_{55}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{61}$)($Q_{62}$)($Q_{63}$), and -B($Q_{64}$)($Q_{65}$); and

$-Si(Q_{71})(Q_{72})(Q_{73})$ and $-B(Q_{74})(Q_{75})$,
wherein $Q_{41}$ to $Q_{43}$, $Q_{51}$ to $Q_{55}$, $Q_{61}$ to $Q_{65}$, and $Q_{71}$ to $Q_{75}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group.

For example, $L_{21}$ and $L_{22}$ in Formula 10 may be each independently selected from
a phenylene group, a naphthylene group, a phenalenylene group, a phenanthrenylene group, a triphenylenylene group, an anthracenylene group, a pyrrolylene group, a pyridinylene group, a pyrazinylene group, a pyrimidinylene group, a pyridazinylene group, an isoindolylene group, an indolylene group, a furanylene group, a benzofuranylene group, a thiophenylene group, a benzothiophenylene group, and a triazinylene group;
a phenylene group, a naphthylene group, a phenalenylene group, a phenanthrenylene group, a triphenylenylene group, an anthracenylene group, a pyrrolylene group, a pyridinylene group, a pyrazinylene group, a pyrimidinylene group, a pyridazinylene group, an isoindolylene group, an indolylene group, a furanylene group, a benzofuranylene group, a thiophenylene group, a benzothiophenylene group, and a triazinylene group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a triphenylenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group; and
groups represented by Formulae 11-1 to 11-6 below:

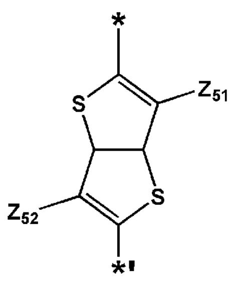
Formula 11-1

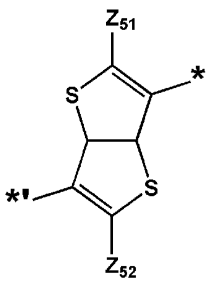
Formula 11-2

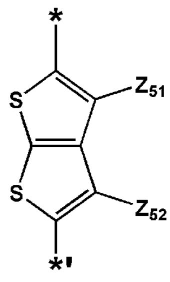
Formula 11-3

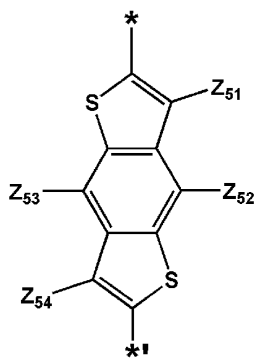
Formula 11-4

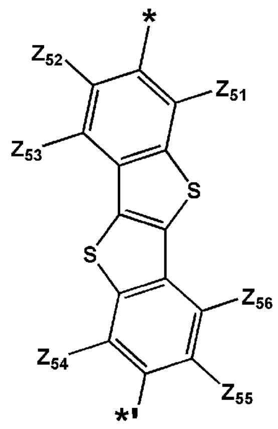
Formula 11-5

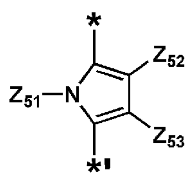
Formula 11-6

in Formulae 11-1 to 11-6,

$Z_{51}$ to $Z_{56}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a triphenylenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl

group, a quinolinyl group, an isoquinolinyl group, a phthalazinyl group, a quinoxalinyl group, a cinnolinyl group, and a quinazolinyl group, and

* and *' may indicate a binding site to a neighboring atom.

For example, $L_{21}$ and $L_{22}$ in Formula 10 may be each independently selected from groups represented by Formulae 12-1 to 12-15 below and Formulae 11-1 to 11-6 above, but $L_{21}$ and $L_{22}$ are not limited thereto:

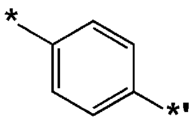
Formula 12-1

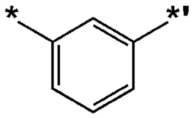
Formula 12-2

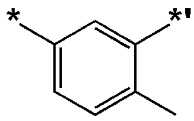
Formula 12-3

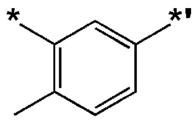
Formula 12-4

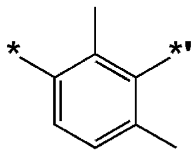
Formula 12-5

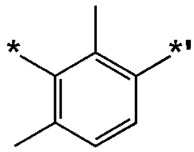
Formula 12-6

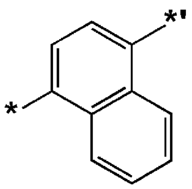
Formula 12-7

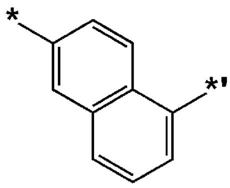
Formula 12-8

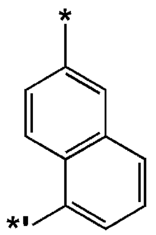
Formula 12-9

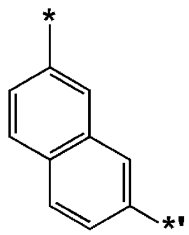
Formula 12-10

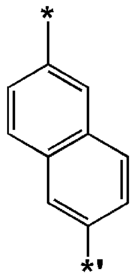
Formula 12-11

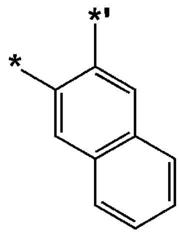
Formula 12-12

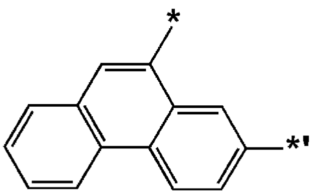
Formula 12-13

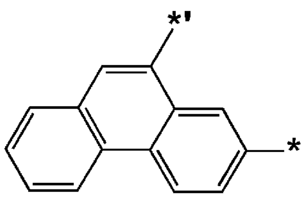
Formula 12-14

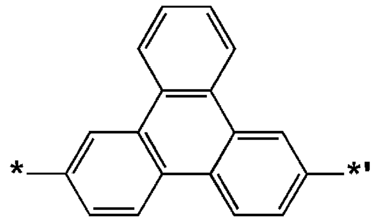
Formula 12-15

In Formulae 12-1 to 12-15, * and *' may each independently indicate a binding site to a neighboring atom.

In Formula 10, a21 may indicate the number of $L_{21}$ and may be an integer of 0 to 3. For example, a21 may be 0, 1, or 2. When a21 is 0, $-(L_{21})_{a21}-$ is a single bond. When a21 is 2 or more, 2 or more $L_{21}$s may be identical to or different from each other. A description a22 may be understood by referring to the description provided in connection with a1 and the structure of Formula 10.

In Formula 10, a21 and a22 may be each independently 0, 1, or 2, but a21 and a22 are not limited thereto.

In an embodiment, in Formula 10, $X_{11}$ to $X_{13}$ may be N; or $X_{11}$ and $X_{12}$ may be N and $X_{13}$ may be $C(R_{53})$, are not limited thereto.

In an embodiment, in Formula 10,

$R_{21}$ may be selected from groups represented by Formulae 15-1 to 15-40 and $-Si(Q_{41})(Q_{42})(Q_{43})$ (wherein $Q_{41}$ to $Q_{43}$ may be each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a triphenylenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group);

$R_{22}$ to $R_{24}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

$R_{25}$ to $R_{30}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group,

a $C_1$-$C_{20}$ alkoxy group, and groups represented by Formulae 15-1 to 15-40 below;
at least one of $R_{25}$ to $R_{28}$ may be each independently selected from groups represented by Formulae 15-1 to 15-40 below; and
at least one of $R_{29}$ and $R_{30}$ may be each independently selected from groups represented by Formulae 15-1 to 15-40 below:

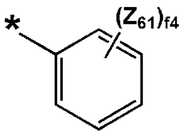
Formula 15-1

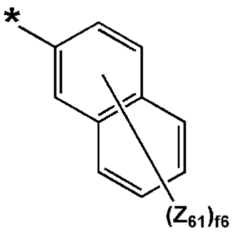
Formula 15-2

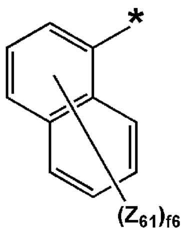
Formula 15-3

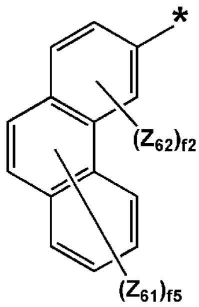
Formula 15-4

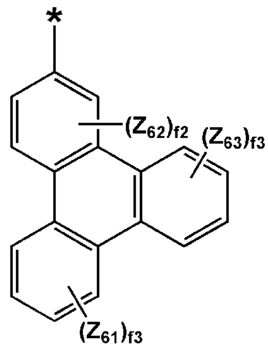
Formula 15-5

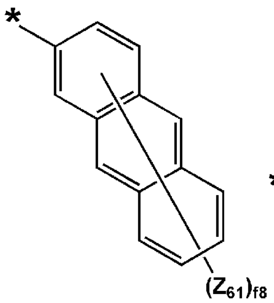
Formula 15-6

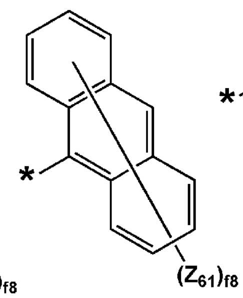
Formula 15-7

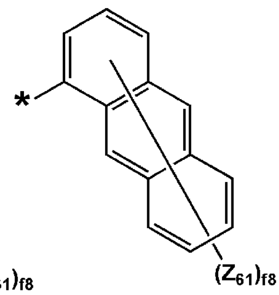
Formula 15-8

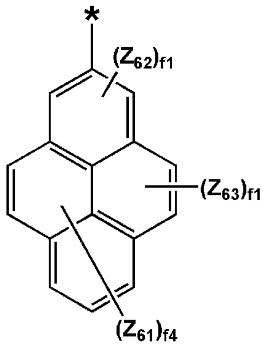
Formula 15-9

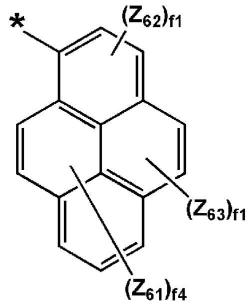
Formula 15-10

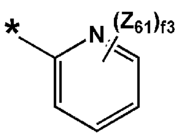
Formula 15-11

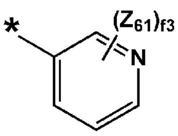
Formula 15-12

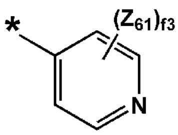
Formula 15-13

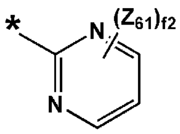
Formula 15-14

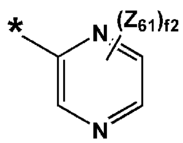
Formula 15-15

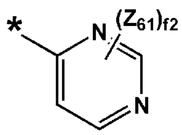
Formula 15-16

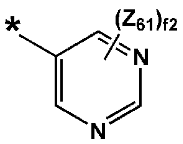
Formula 15-17

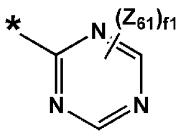
Formula 15-18

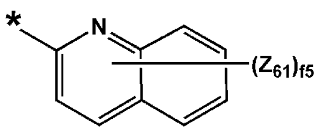
Formula 15-19

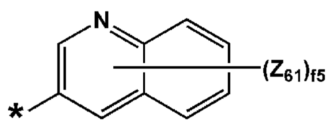
Formula 15-20

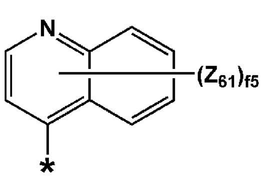
Formula 15-21

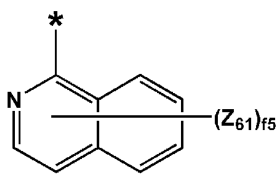
Formula 15-22

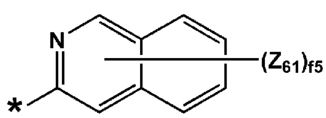
Formula 15-23

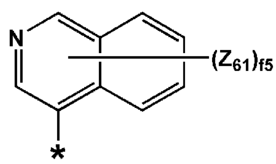
Formula 15-24

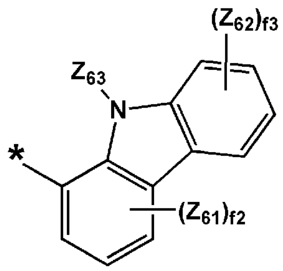

Formula 15-25

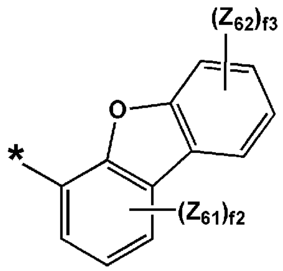

Formula 15-26

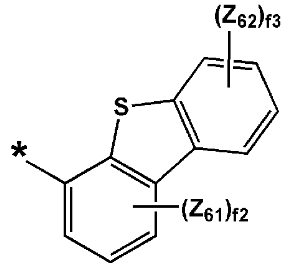

Formula 15-27

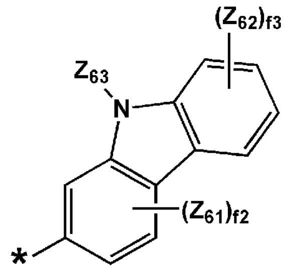

Formula 15-28

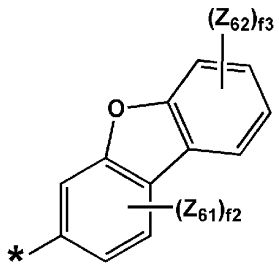

Formula 15-29

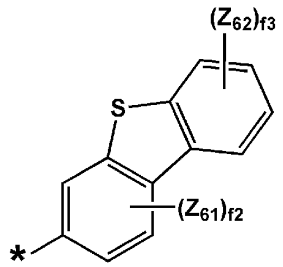

Formula 15-30

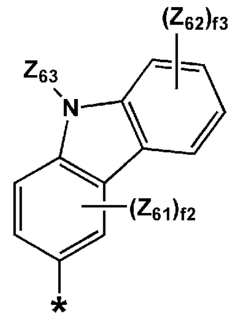

Formula 15-31

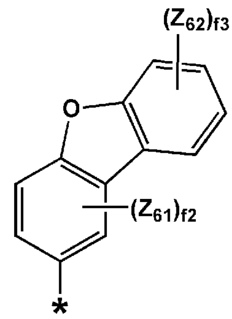

Formula 15-32

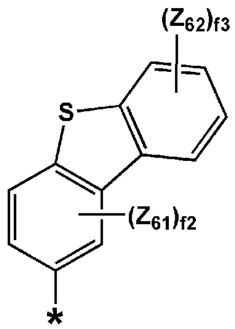

Formula 15-33

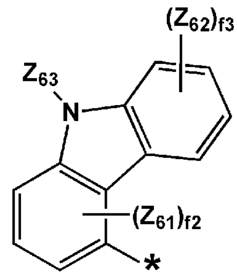

Formula 15-34

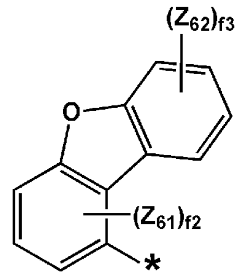

Formula 15-35

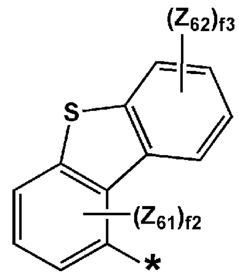

Formula15-36

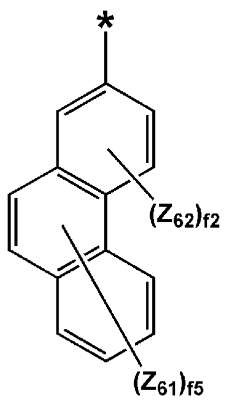

Formula 15-37

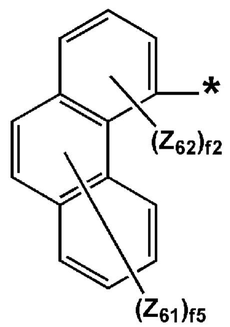

Formula 15-38

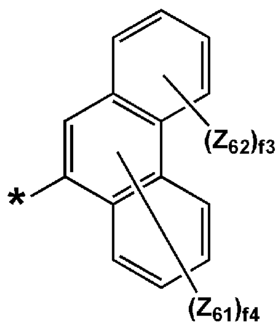

Formula 15-39

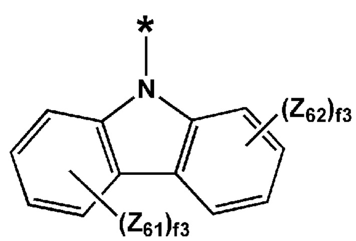

Formula 15-40

In Formulae 15-1 to 15-40,

$Z_{61}$ to $Z_{63}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group,

a $C_2$-$C_{20}$ alkenyl group, a $C_2$-$C_{20}$ alkynyl group, a $C_1$-$C_{20}$ alkoxy group, a phenyl group, a naphthyl group, an anthracenyl group, a pyrenyl group, a phenanthrenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group;

f1 may be 1 or 2, f2 may be an integer of 1 to 3, f3 may be an integer of 1 to 4, f4 may be an integer of 1 to 5, f5 may be an integer of 1 to 6, f6 may be an integer of 1 to 7, f7 may be an integer of 1 to 8, and f8 may be an integer of 1 to 9; and

* indicates a binding site to a neighboring atom.

In another embodiment, $R_{21}$ to $R_{28}$ in Formula 10 may be each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a triphenylenyl group, a pyrenyl group, a phenanthrenyl group, a phenylenyl group, a fluorenyl group, a carbazolyl group, a dibenzofuranyl group, and a dibenzothiophenyl group;

a phenyl group, a naphthyl group, an anthracenyl group, a triphenylenyl group, a pyrenyl group, a phenanthrenyl group, a phenylenyl group, a fluorenyl group, a carbazolyl group, a dibenzofuranyl group, and a dibenzothiophenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a phenylenyl group, a fluorenyl group, a carbazolyl group, a dibenzofuranyl group, and a dibenzothiophenyl group; and

-Si($Q_{41}$)($Q_{42}$)($Q_{43}$) (wherein $Q_{41}$ to $Q_{43}$ may be each independently a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a triphenylenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group); and

at leat one of $R_{25}$ to $R_{28}$ may be each independently selected from

a phenyl group, a naphthyl group, an anthracenyl group, a triphenylenyl group, a pyrenyl group, a phenanthrenyl group, a phenylenyl group, a fluorenyl group, a carbazolyl group, a dibenzofuranyl group, and a dibenzothiophenyl group; and

a phenyl group, a naphthyl group, an anthracenyl group, a triphenylenyl group, a pyrenyl group, a phenanthrenyl group, a phenylenyl group, a fluorenyl group, a carbazolyl group, a dibenzofuranyl group, and a dibenzothiophenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a phenylenyl group, a fluorenyl group, a carbazolyl group, a dibenzofuranyl group, and a dibenzothiophenyl group.

In another embodiment, the electron-transporting host included in the emission layer 15 may be represented by Formula 10 above, but in Formula 10,

$L_{21}$ and $L_{22}$ may be each independently selected from groups represented by Formulae 12-1 to 12-15 above,

a21 and a22 may be each independently 0 or 1,

$X_{11}$ to $X_{13}$ may be N,

$R_{22}$ to $R_{26}$ and $R_{28}$ may be a hydrogen,

$R_{27}$, $R_{29}$, and $R_{30}$ may be each independently a compound represented by Formulae 15-1 to 15-40 above.

In another embodiment, the electron-transporting host included in the emission layer 15 of the organic light-emitting device 10 may include at least one of Compounds EH3-1 to EH3-102 below, but the electron-transporting host is not limited thereto:

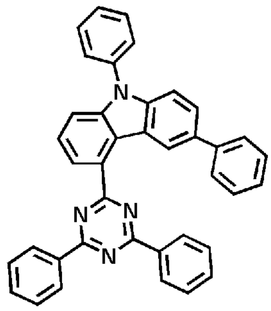

EH3-1

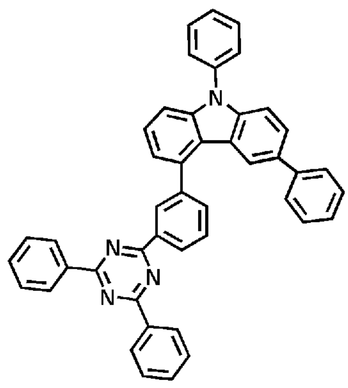

EH3-2

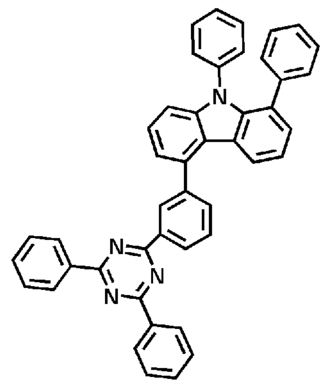

EH3-3

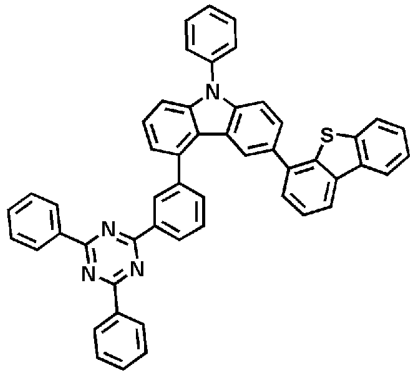

EH3-4

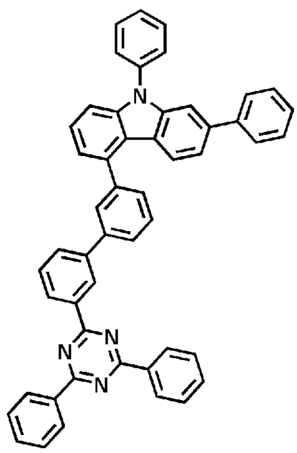

EH3-5

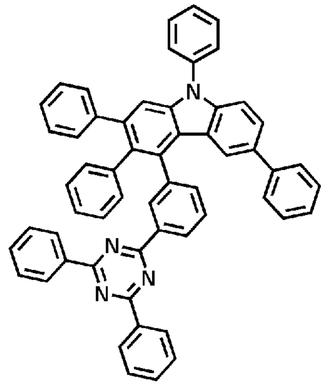

EH3-6

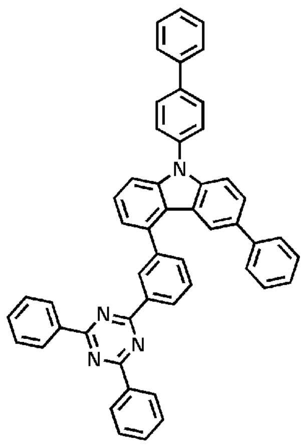

EH3-7

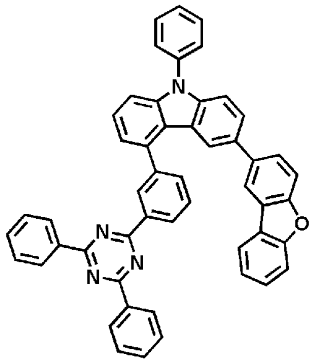

EH3-8

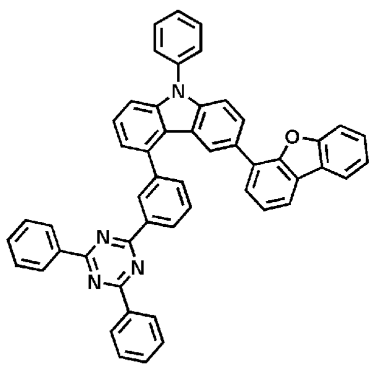

EH3-9

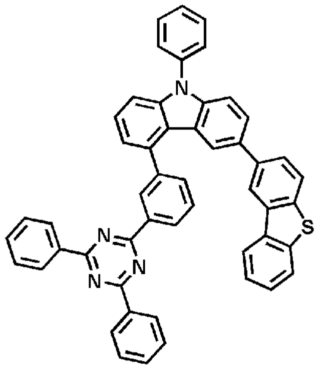

**EH3-10**

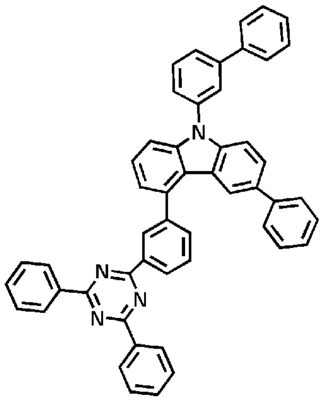

**EH3-11**

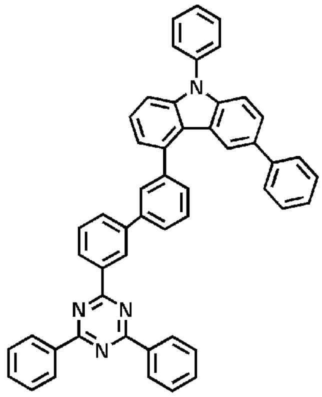

**EH3-12**

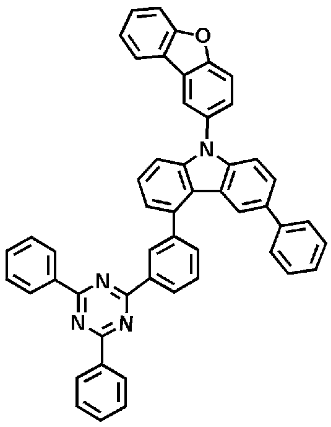

**EH3-13**

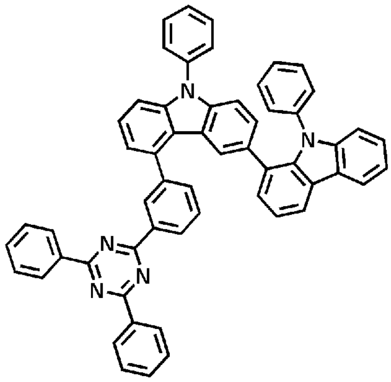

**EH3-14**

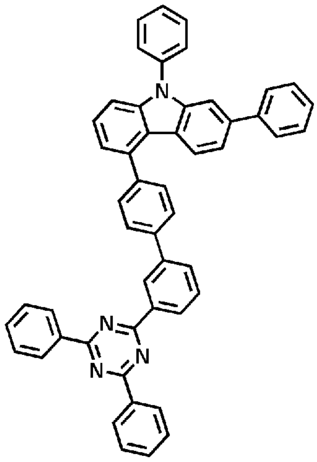

**EH3-15**

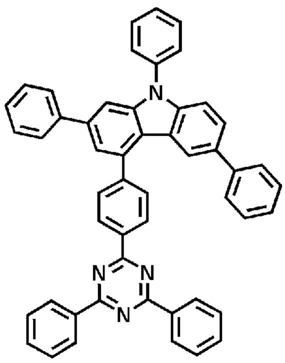

**EH3-16**

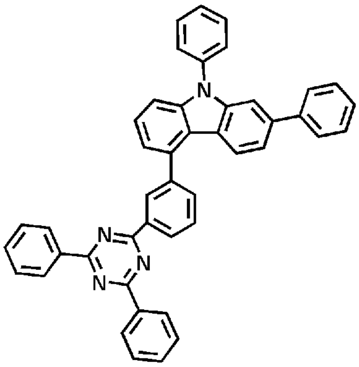

**EH3-17**

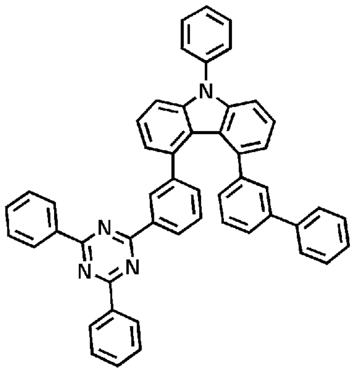

**EH3-18**

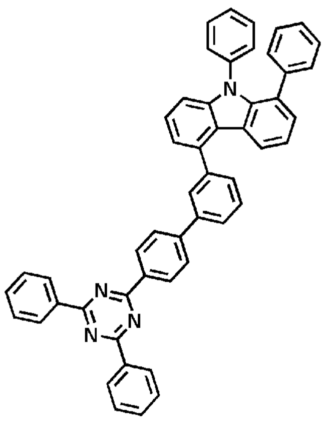

EH3-19

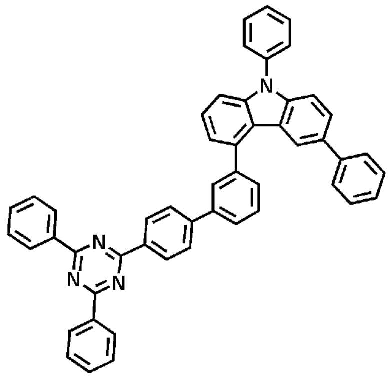

EH3-20

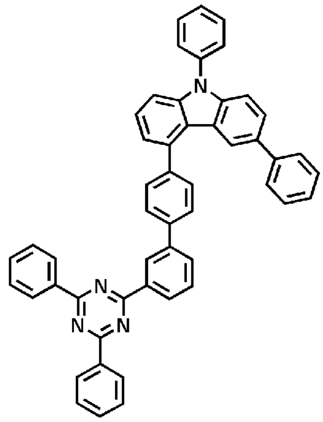

EH3-21

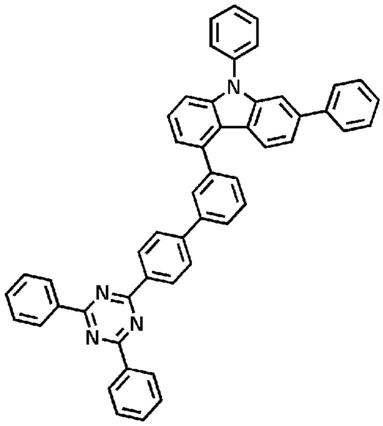

EH3-22

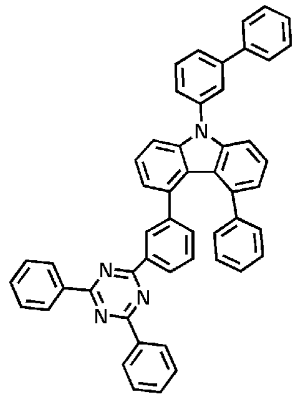

EH3-23

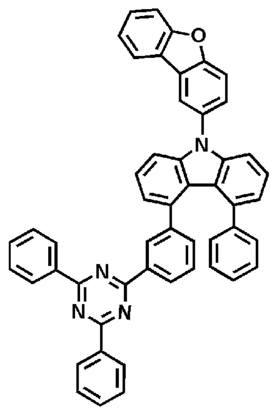

EH3-24

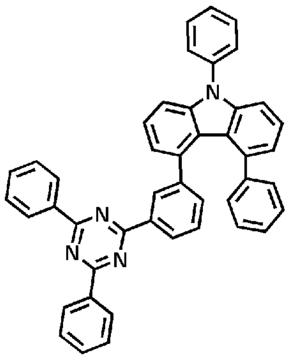

EH3-25

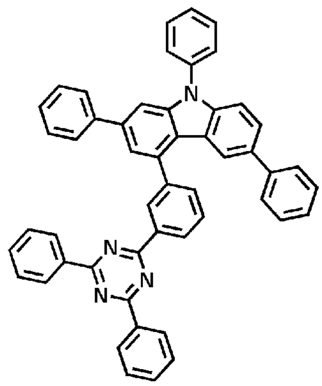

EH3-26

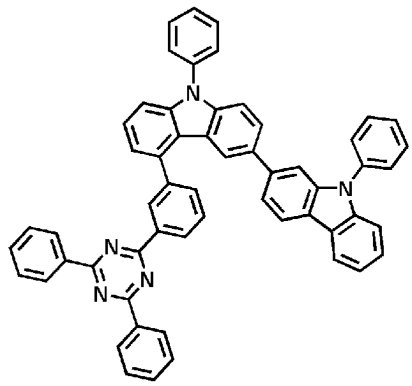

EH3-27

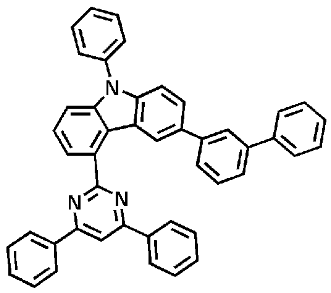

EH3-28

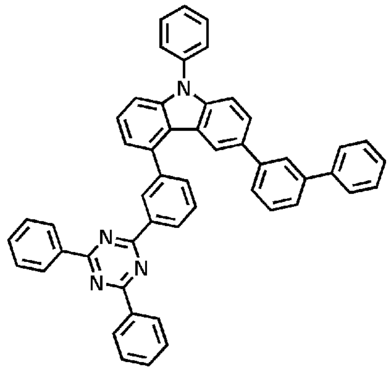

EH3-29

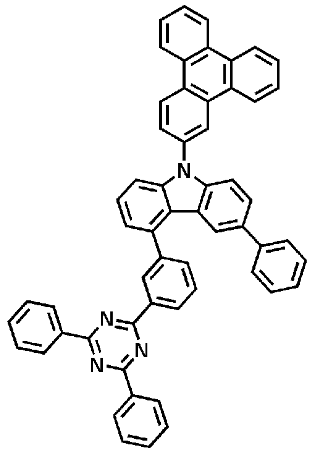

EH3-30

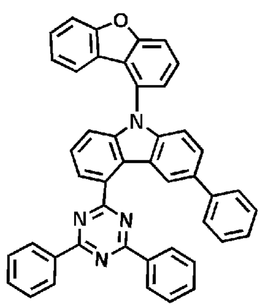

EH3-31

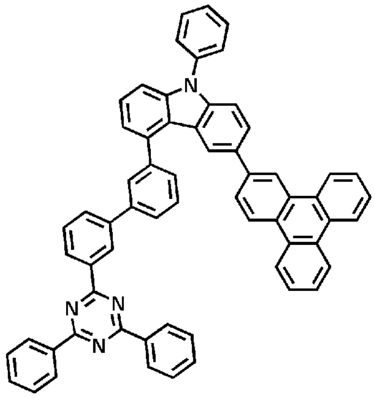

EH3-32

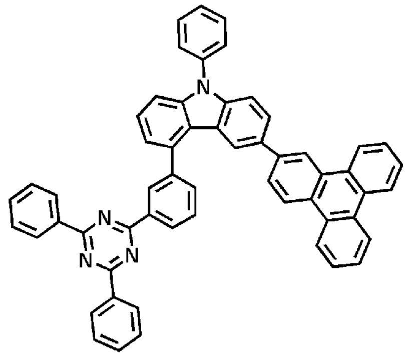

EH3-33

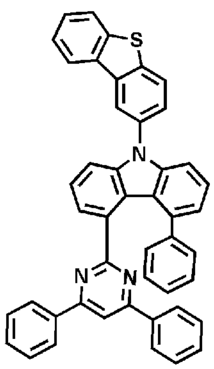

EH3-34

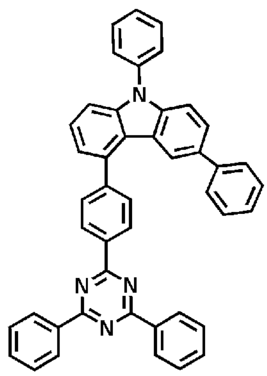

EH3-35

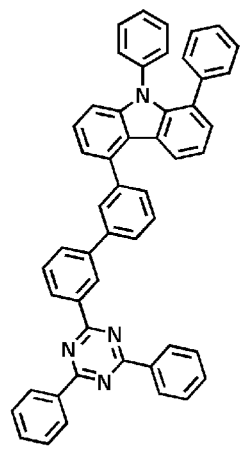

EH3-36

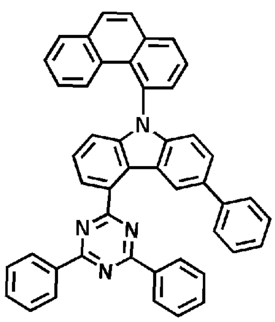

EH3-37

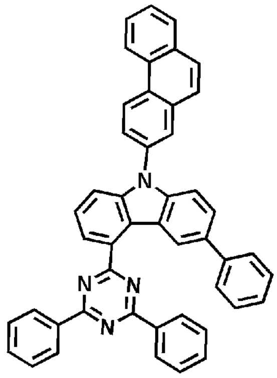

EH3-38

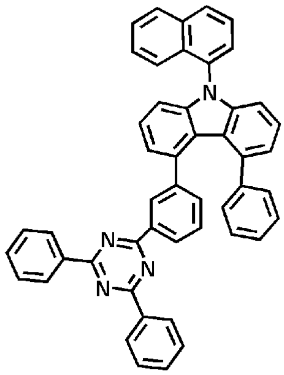

EH3-39

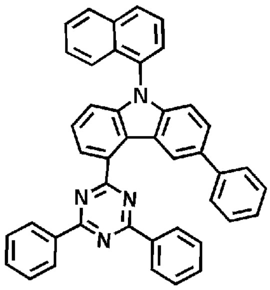

EH3-40

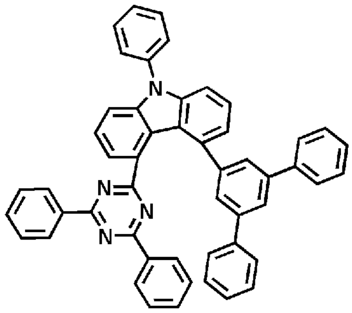

EH3-41

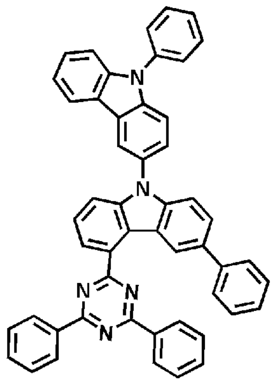

EH3-42

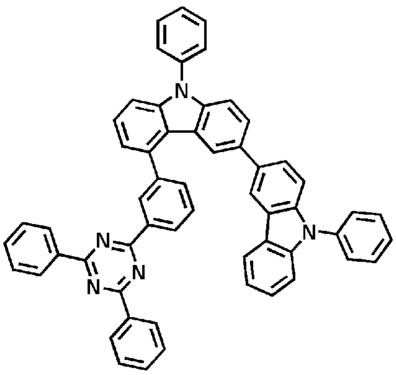

EH3-43

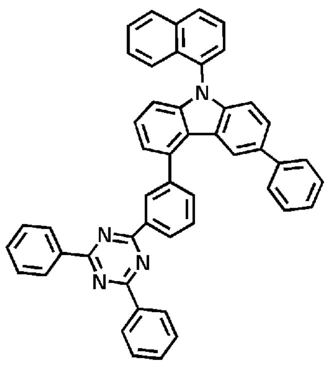

EH3-44

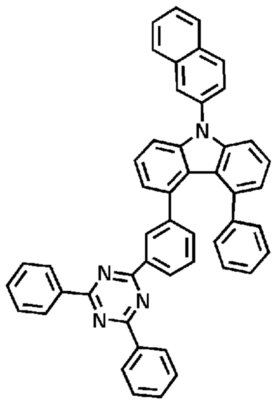

EH3-45

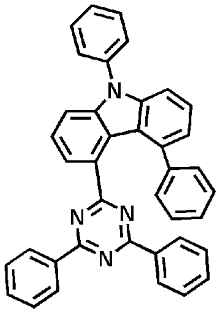

EH3-46

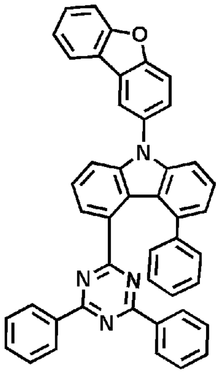

EH3-47

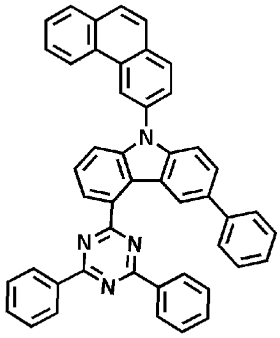

EH3-48

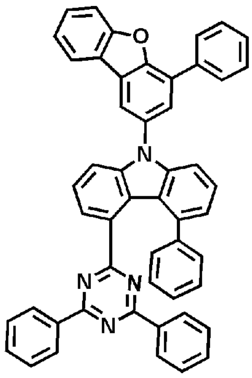

EH3-49

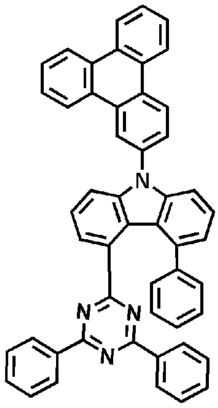

EH3-50

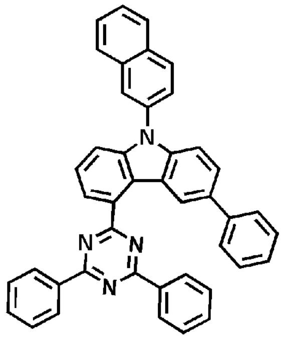

EH3-51

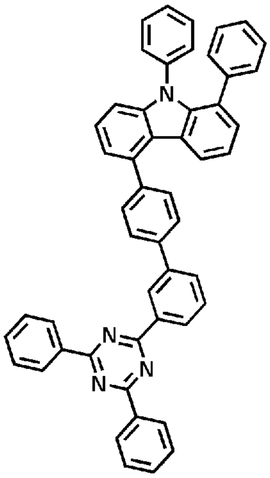

EH3-52

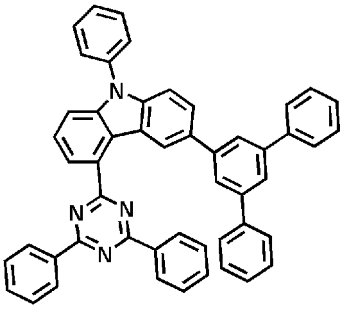

EH3-53

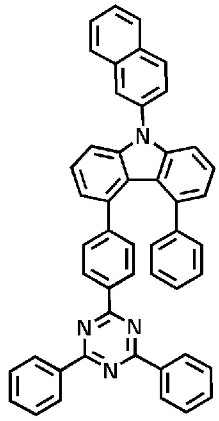

EH3-54

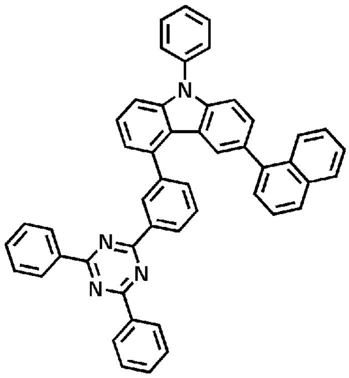

EH3-55

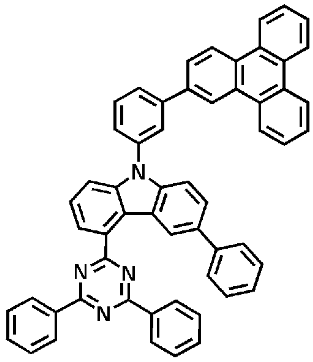

EH3-56

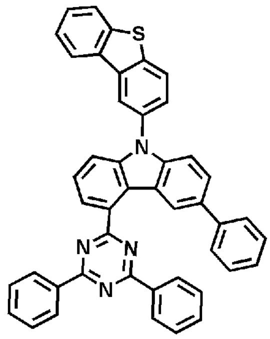

EH3-57

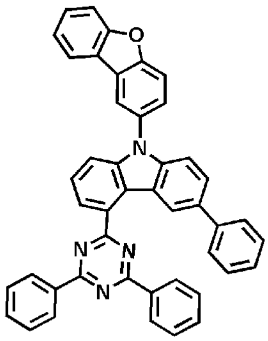

EH3-58

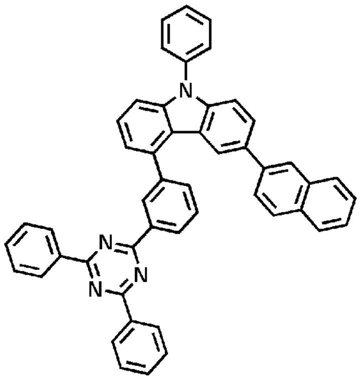

EH3-59

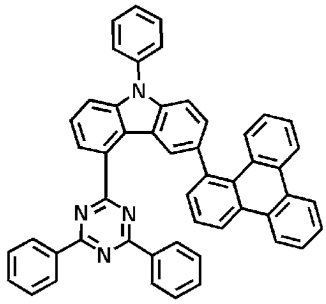

EH3-60

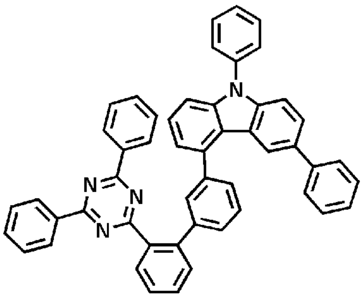

EH3-61

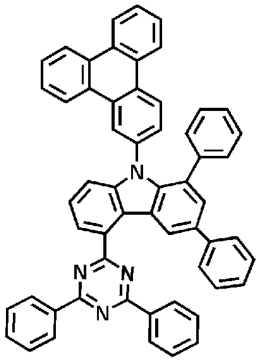

EH3-62

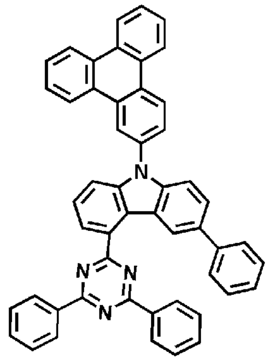

EH3-63

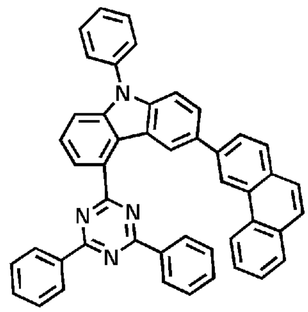

EH3-64

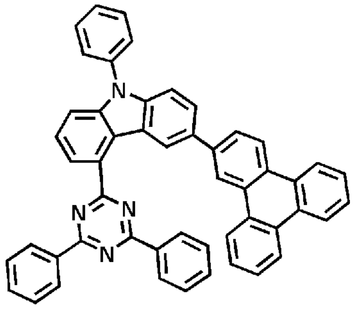

EH3-65

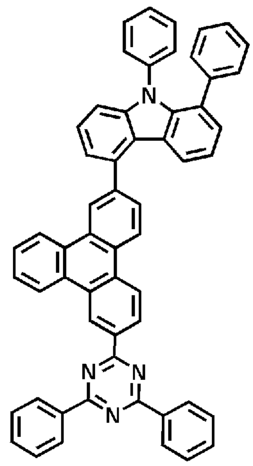

EH3-66

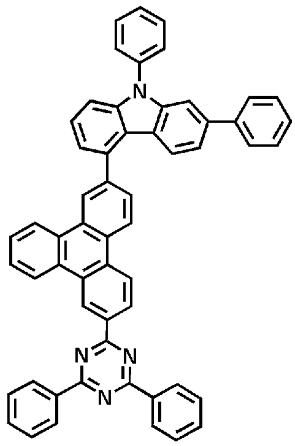

EH3-67

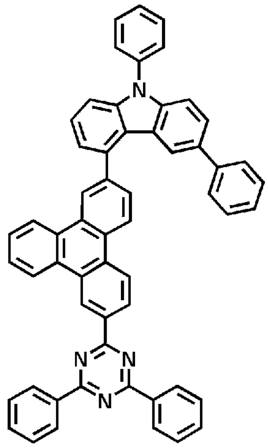

EH3-68

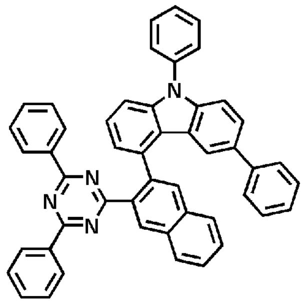

EH3-69

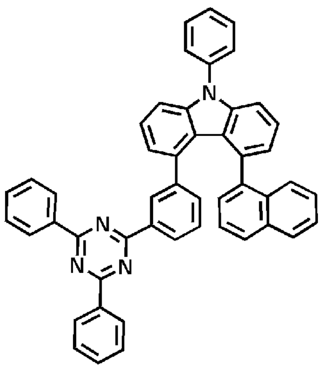

EH3-70

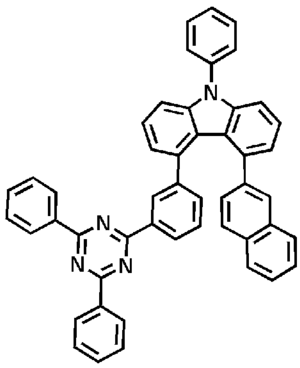

EH3-71

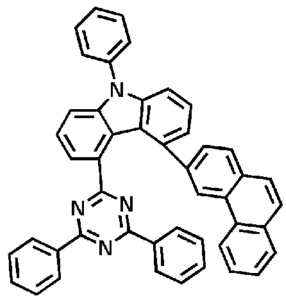

EH3-72

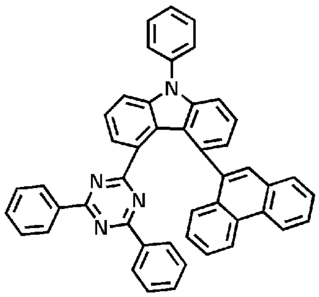

EH3-73

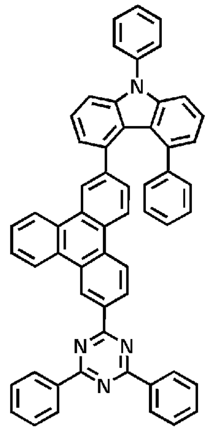

EH3-74

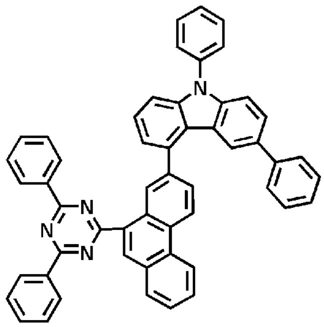

EH3-75

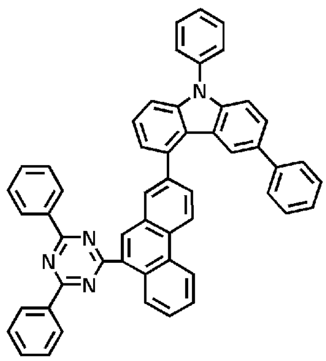

EH3-76

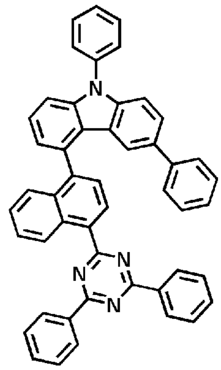

EH3-77

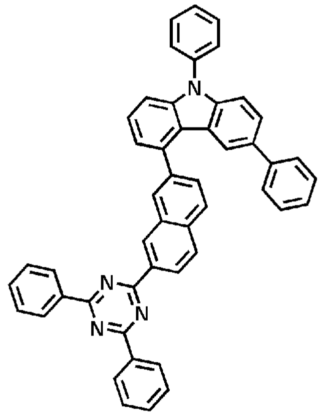

EH3-78

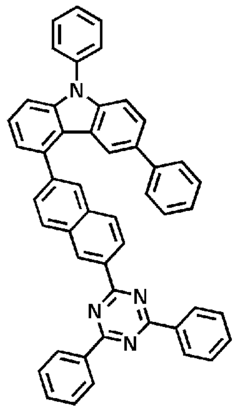

EH3-79

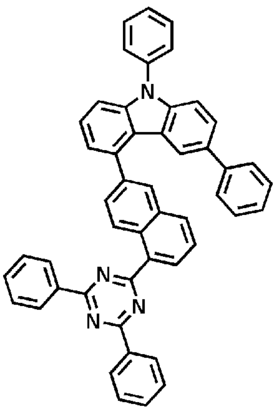

EH3-80

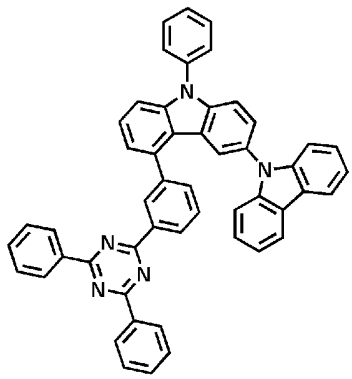

EH3-81

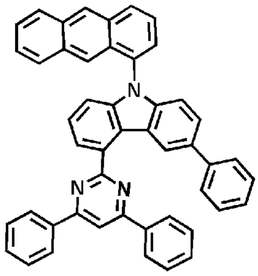

EH3-82

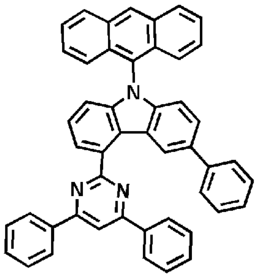

EH3-83

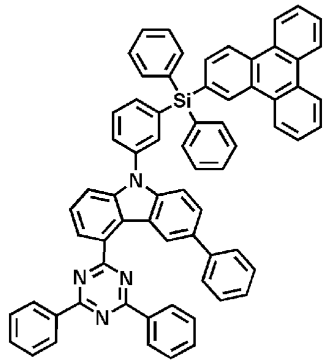

EH3-84

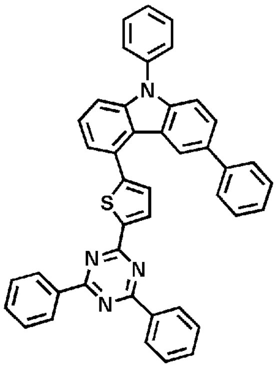

EH3-85

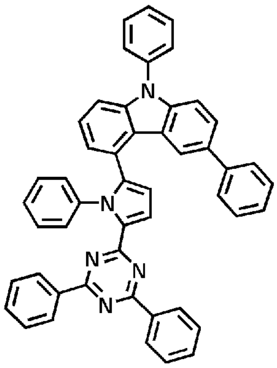

EH3-86

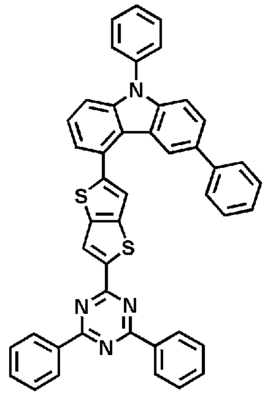

EH3-87

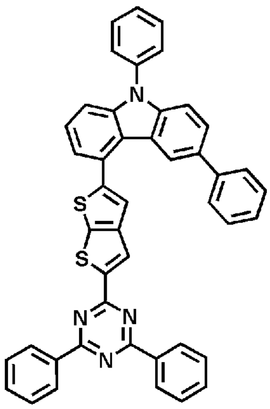

EH3-88

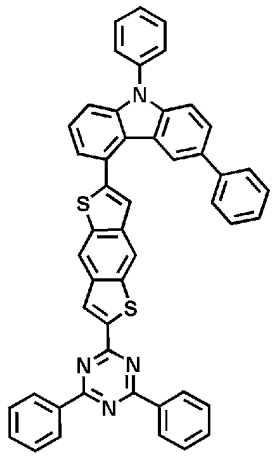

EH3-89

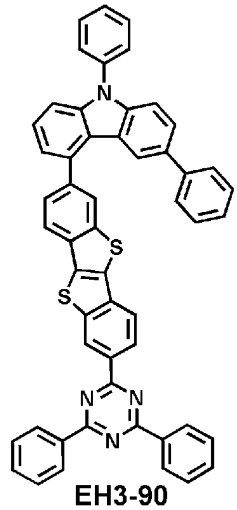

EH3-90

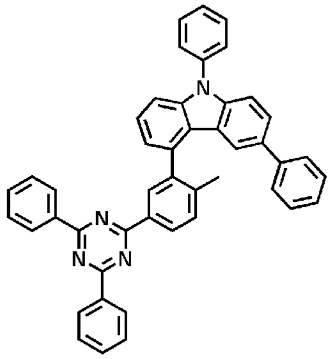

**EH3-91**

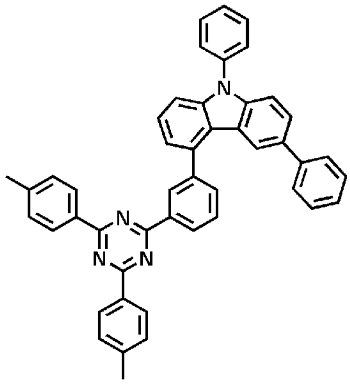

**EH3-92**

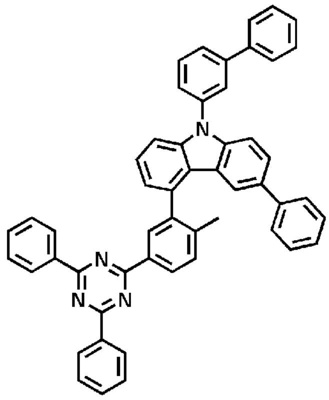

**EH3-93**

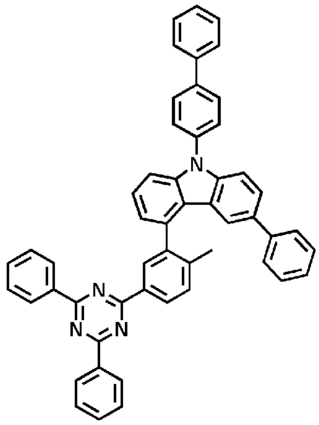

**EH3-94**

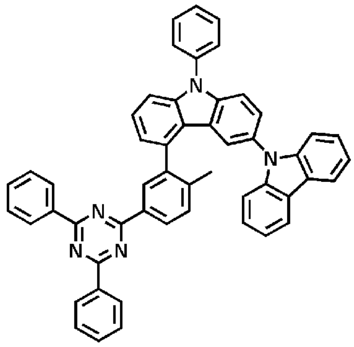

**EH3-95**

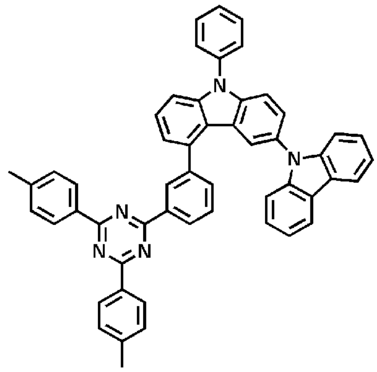

**EH3-96**

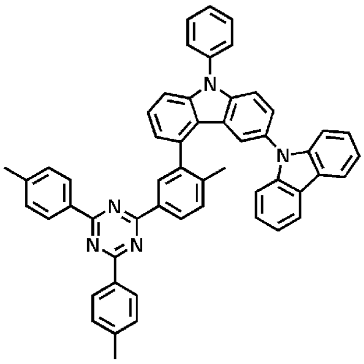

**EH3-97**

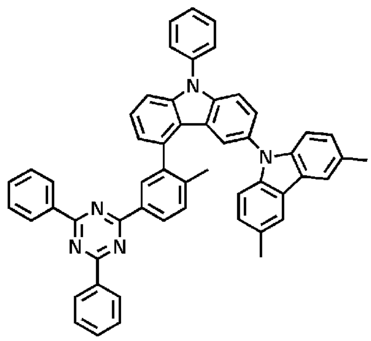

**EH3-98**

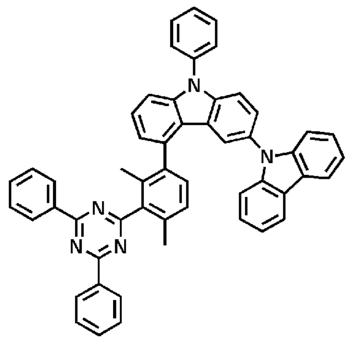

**EH3-99**

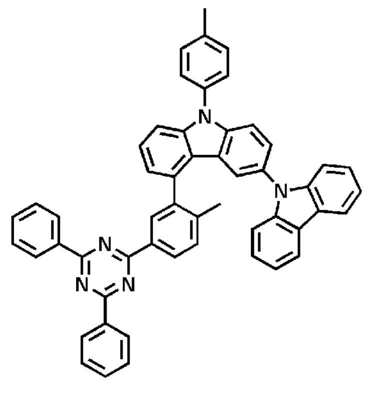

**EH3-100**

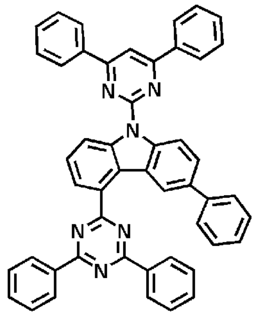

**EH3-101**

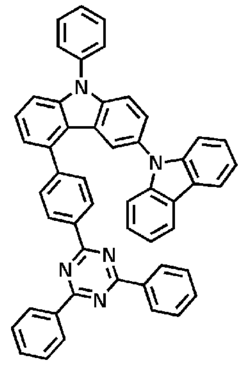

**EH3-102**

Meanwhile, the hole-transporting host included in the emission layer 15 of the organic light-emitting device 10 may include a compound represented by Formula 20 below:

<Formula 20>

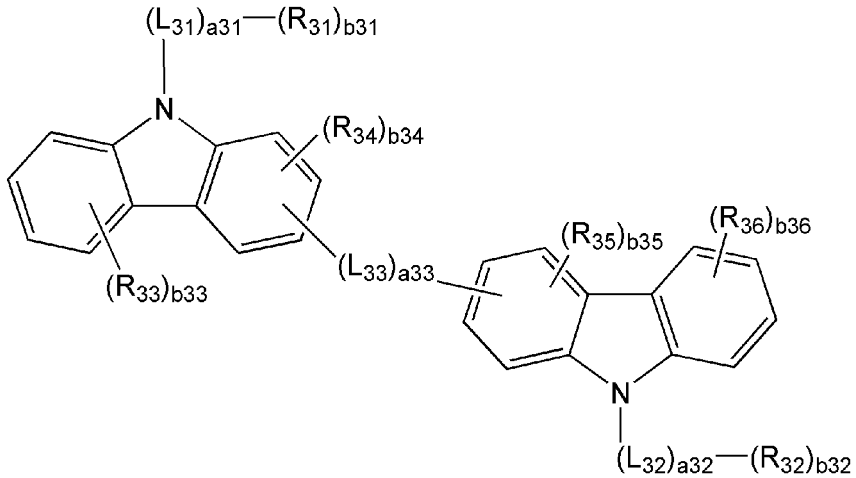

In Formula 20,
$L_{31}$ to $L_{33}$ may be each independently selected from a substituted or unsubstituted $C_3$-$C_{10}$ cycloalkylene group, a substituted or unsubstituted $C_3$-$C_{10}$ cycloalkenylene group, a substituted or unsubstituted $C_6$-$C_{60}$ arylene group, and a substituted or unsubstituted divalent non-aromatic condensed polycyclic group;
a31 to a33 may be each independently an integer of 0 to 5;
$R_{31}$ and $R_{32}$ may be each independently selected from a substituted or unsubstituted $C_3$-$C_{10}$ cycloalkyl group, a substituted or unsubstituted $C_3$-$C_{10}$ cycloalkenyl group, a substituted or unsubstituted $C_6$-$C_{60}$ aryl group, and a substituted or unsubstituted monovalent non-aromatic condensed polycyclic group;
$R_{33}$ to $R_{36}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_3$-$C_{10}$ cycloalkenyl group, a substituted or unsubstituted $C_6$-$C_{60}$ aryl group, and a substituted or unsubstituted monovalent non-aromatic condensed polycyclic group;
b31 to b36 may be each independently an integer of 1 to 3; and
at least one of substituents of the substituted $C_3$-$C_{10}$ cycloalkylene group, the substituted $C_3$-$C_{10}$ cycloalkenylene group, the substituted $C_6$-$C_{60}$ arylene group, the substituted divalent non-aromatic condensed polycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_3$-$C_{10}$ cycloalkenyl group, the substituted $C_6$-$C_{60}$

aryl group, and the substituted monovalent non-aromatic condensed polycyclic group may be selected from a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_6$-$C_{60}$ aryl group, and a monovalent non-aromatic condensed polycyclic group.

In Formula 20, $L_{31}$ to $L_{33}$ may be each independently selected from

a phenylene group, a naphthylene group, a fluorenylene group, a spiro-fluorenylene group, a phenalenylene group, a phenanthrenylene group, an anthracenylene group, a fluoranthrenylene group, a triphenylenylene group, a pyrenylene group, and a chrysenylene group; and

a phenylene group, a naphthylene group, a fluorenylene group, a spiro-fluorenylene group, a phenalenylene group, a phenanthrenylene group, an anthracenylene group, a fluoranthrenylene group, a triphenylenylene group, a pyrenylene group, and a chrysenylene group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a phenyl group substituted with a phenyl group (i.e., a biphenyl group), a naphthyl group, a fluorenyl group, a spiro-fluorenyl group, a phenalenyl group, a phenanthrenyl group, an anthracenyl group, a fluoranthrenyl group, a triphenylenyl group, a pyrenyl group, and a chrysenyl group;

a31 to a33 may be each independently 0, 1, or 2;

$R_{31}$ and $R_{32}$ may be each independently selected from

a phenyl group, a naphthyl group, a fluorenyl group, a spiro-fluorenyl group, a phenalenyl group, a phenanthrenyl group, an anthracenyl group, a fluoranthrenyl group, a triphenylenyl group, a pyrenyl group, and a chrysenyl group; and

a phenyl group, a naphthyl group, a fluorenyl group, a spiro-fluorenyl group, a phenalenyl group, a phenanthrenyl group, an anthracenyl group, a fluoranthrenyl group, a triphenylenyl group, a pyrenyl group, and a chrysenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group substituted with a phenyl group (i.e., a biphenyl group), a naphthyl group, a fluorenyl group, a spiro-fluorenyl group, a phenalenyl group, a phenanthrenyl group, an anthracenyl group, a fluoranthrenyl group, a triphenylenyl group, a pyrenyl group, and a chrysenyl group;

$R_{33}$ to $R_{36}$ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, and a naphthyl group; and

b31 to b36 may be each independently 1 or 2, but b31 to b36 are not limited thereto.

In another embodiment, in Formula 20,

$L_{31}$ and $L_{32}$ may be each independently selected from

a phenylene group and a naphthylene group; and

a phenylene group and a naphthylene group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a phenyl group substituted with a phenyl group (i.e., a biphenyl group), and a naphthyl group;

a31 and a32 may be each independently 0, 1, or 2, and a33 may be 0;

$R_{31}$ and $R_{32}$ may be each independently selected from

a phenyl group and a naphthyl group; and

a phenyl group and a naphthyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a phenyl group substituted with a phenyl group (i.e., a biphenyl group), and a naphthyl group;

$R_{33}$ to $R_{36}$ may be each independently a hydrogen; and

b31 to b36 may be each independently 1, but b31 to b36 are not limited thereto.

For example, the hole-transporting host included in the emission layer 15 of the organic light-emitting device 10 may include a compound represented by one of Formulae 20-1 to 20-7 below, but the hole-transporting host is not limited thereto:

<Formula 20-1>

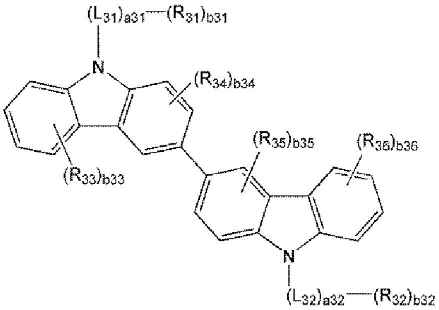

<Formula 20-2>

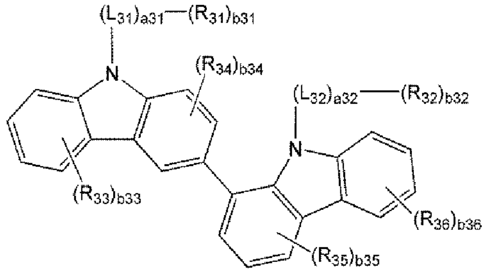

<Formula 20-3>

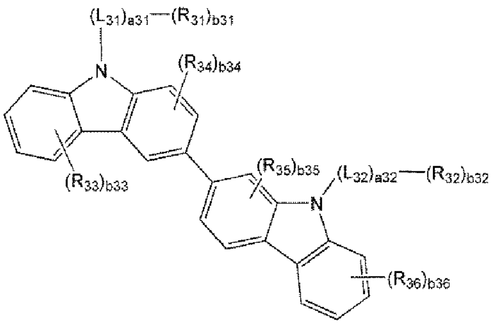

<Formula 20-4>

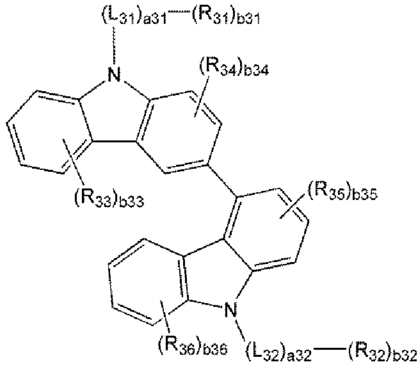

<Formula 20-5>

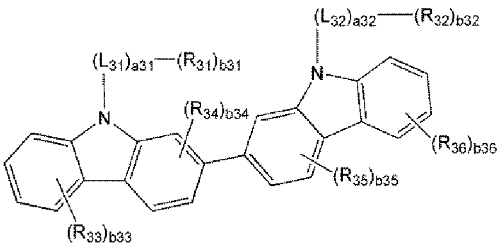

<Formula 20-6>

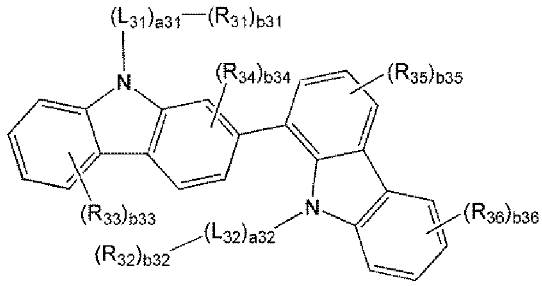

<Formula 20-7>

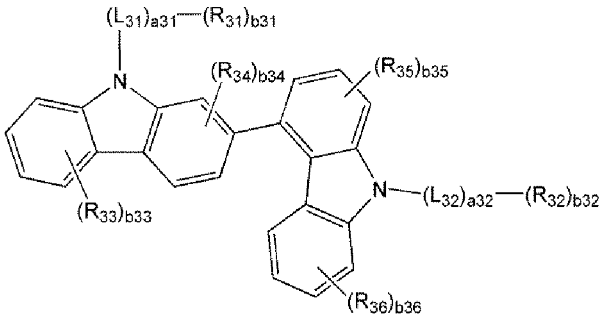

In Formulae 20-1 to 20-7, descriptions of $L_{31}$, $L_{32}$, a31, a32, $R_{31}$ to $R_{36}$, and b31 to b36 may be understood by

referring to the description provided in the present specification.

In an embodiment, the hole-transporting host included in the emission layer 15 of the organic light-emitting device may include at least one of Compounds HH1-2 to HH1-51 below, but the hole-transporting host is not limited thereto:

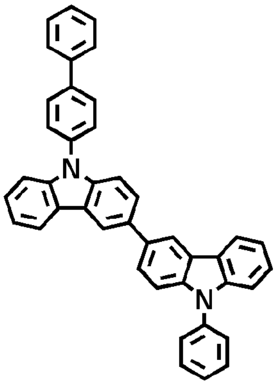

HH1-2

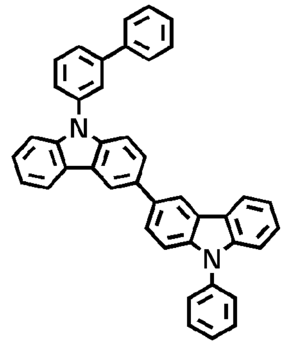

HH1-3

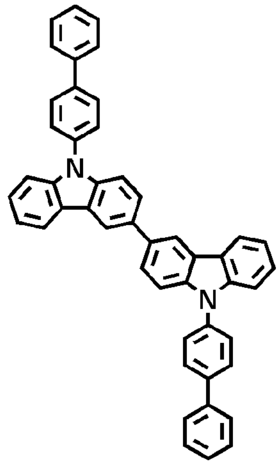

HH1-4

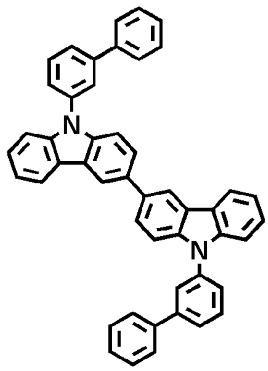

HH1-5

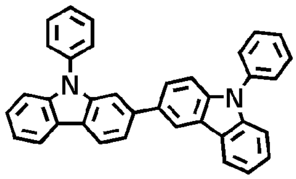

HH1-6

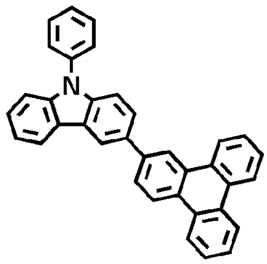

HH1-7

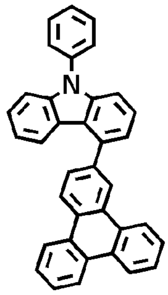

HH1-8

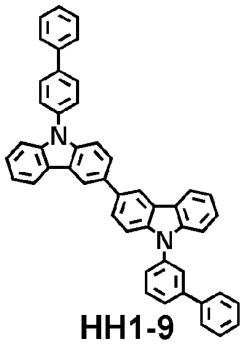

HH1-9

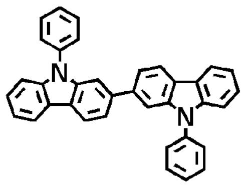

HH1-10

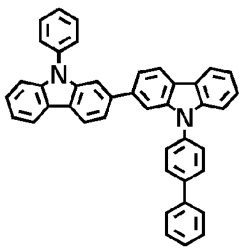

HH1-11

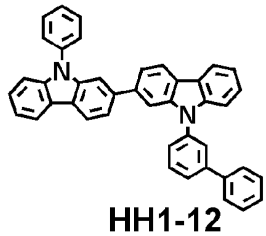

HH1-12

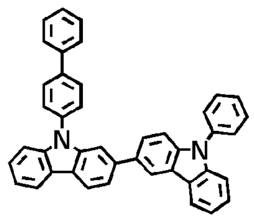
HH1-13

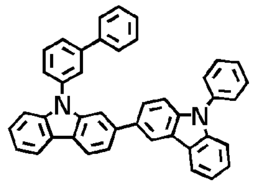
HH1-14

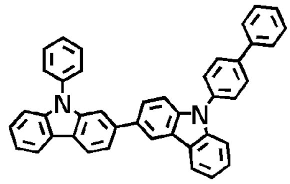
HH1-15

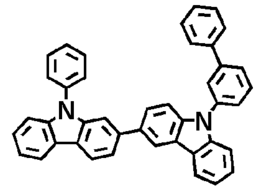
HH1-16

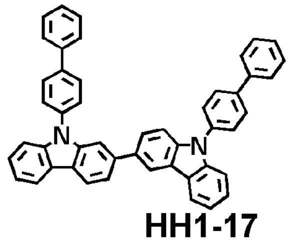
HH1-17

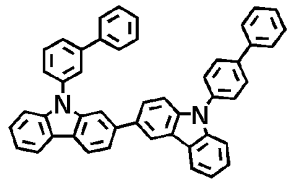
HH1-18

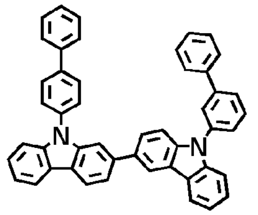
HH1-19

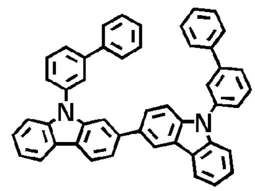
HH1-20

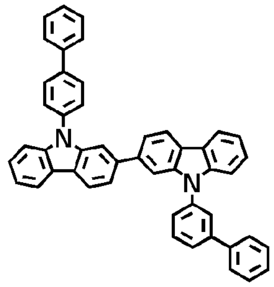
HH1-21

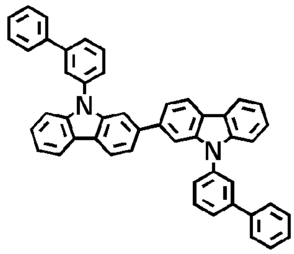
HH1-22

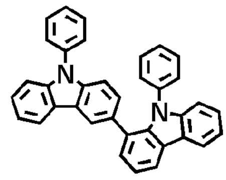
HH1-23

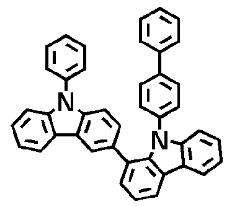
HH1-24

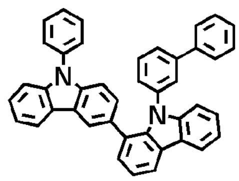
HH1-25

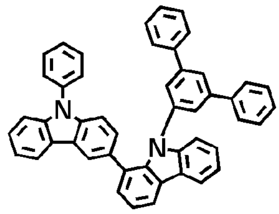
HH1-26

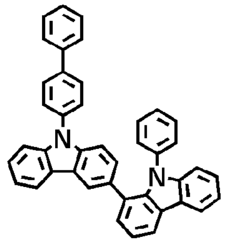
HH1-27

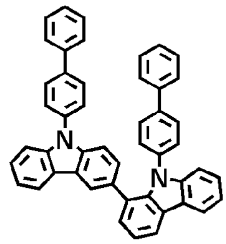
HH1-28

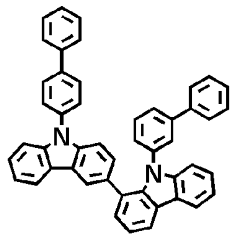
HH1-29

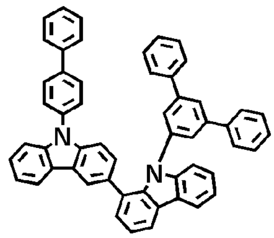
HH1-30

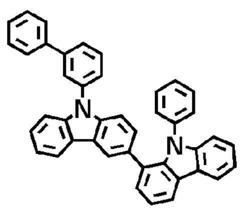
HH1-31

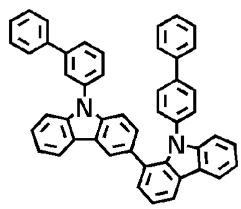
HH1-32

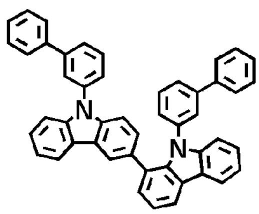

HH1-33

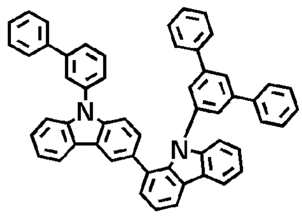

HH1-34

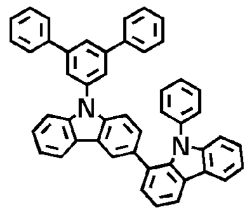

HH1-35

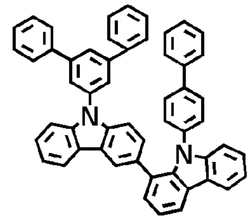

HH1-36

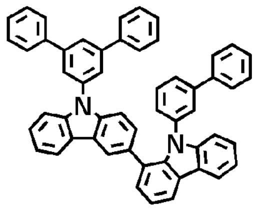

HH1-37

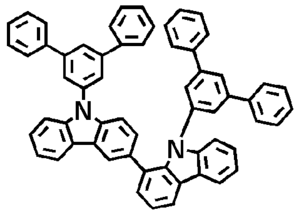

HH1-38

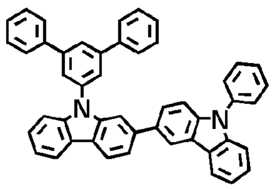

HH1-39

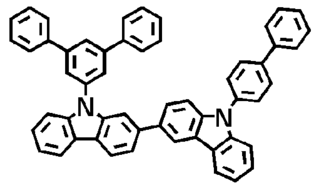

HH1-40

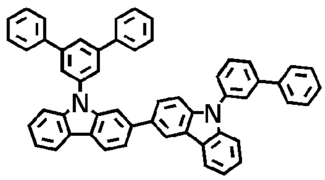

HH1-41

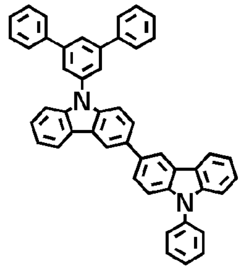

HH1-42

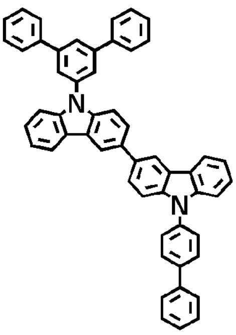

HH1-43

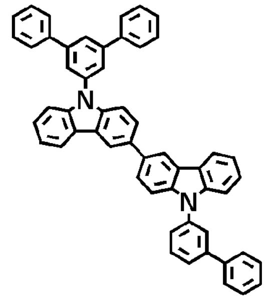

HH1-44

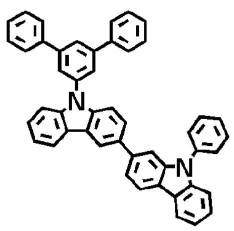

HH1-45

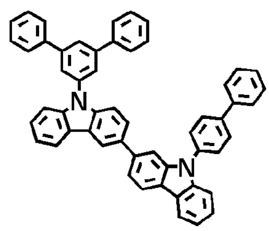

HH1-46

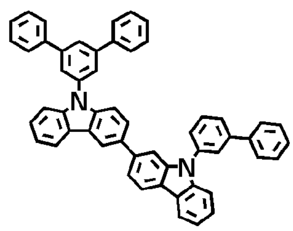

HH1-47

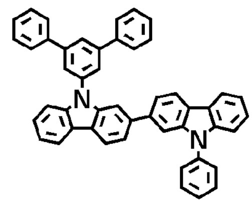

HH1-48

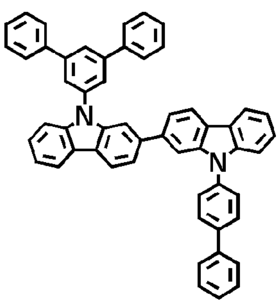

HH1-49

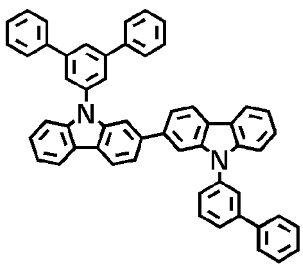

HH1-50

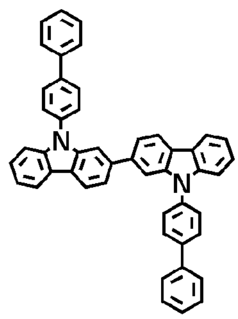

HH1-51

Here, the hole-transporting host may not include Compound HH-1-1 below:

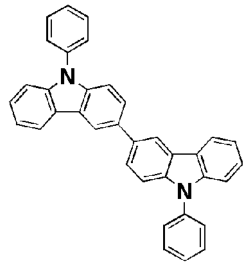

HH1-1

A weight ratio of the electron-transporting host to the hole-transporting host included in the emission layer 15 may be about 1:9 to about 9:1, e.g., about 3:7 to about 7:3. For example, but not limited to, a weight ratio of the electron-transporting host to the hole-transporting host included in the emission layer 15 may be about 4:6 to about 6:4. When the weight ratio of the electron-transporting host to the hole-transporting host is within these ranges, the formation of the exciplex made by the electron-transporting host and the hole-transporting host included in the emission layer 15 of the organic light-emitting device 10 may be effectively achieved.

In an embodiment, in the emission layer 15 of the organic light-emitting device 10,
the electron-transporting host is Compound EH1-401,
the hole-transporting host comprises a compound satisfying $-0.1 \leq$ Type (Compound EH1-401) $\leq 0.6$ (e.g., $0.1 \leq$ Type (Compound EH1-401) $\leq 0.3$),
wherein a volume ratio of the electron-transporting host to the hole-transporting host may be selected from a range of $-0.1 \leq$ Type (Compound EH1-401) $\leq 0.6$ (e.g., $0.1 \leq$ Type (Compound EH1-401) $\leq 0.3$), and

Type (Compound EH1-401) is defined by Equation 10 below:

<Equation 10>

$$\text{Type (Compound EH1-401)} = \log(J_{HOD}\,(\text{at } 11.5\text{ V}) / J_{EOD}\,(\text{at } 4\text{ V}))$$

In Equation 10,
$J_{HOD}$ (at 11.5 V) refers to a current density value (mA/cm$^2$) at a voltage of 11.5 V of a hole-only device having a structure of ITO (150 nm or 1,500 Å) / Compound HT3:TCNPQ (3 wt%) (10 nm or 100 Å) / Compound HT3 (100 nm or 1,000 Å) / host:Compound PD79 (10 wt%) (60 nm or 600 Å) / Compound ET1 (10 nm or 100 Å) / Al (10 nm or 100 Å) (wherein the host consists of Compound EH1-401 and the hole-transporting host), and
$J_{EOD}$ (at 4 V) refers to a current density value (mA/cm$^2$) at a voltage of 4 V of an electron-only device having a structure of ITO (150 nm or 1,500 Å) / Mg:Ag (10 wt%) (30 nm or 300 Å) / Liq (1 nm or 10 Å) / Compound ET16:Liq (50 wt%) (20 nm or 200 Å) / host:Compound PD79 (10 wt%) (60 nm or 600 Å) / Compound ET16:Liq (50 wt%) (20 nm or 200 Å) / Liq (1 nm or 10 Å) / Mg:Ag (10 wt%) (30 nm or 300 Å) (wherein the host consists of Compound EH1-401 and the hole-transporting host).

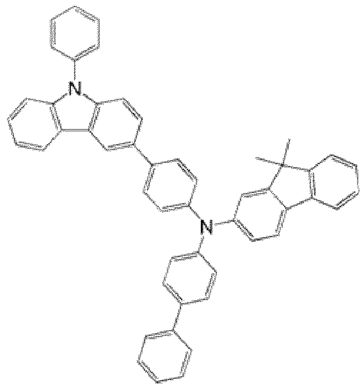

HT3

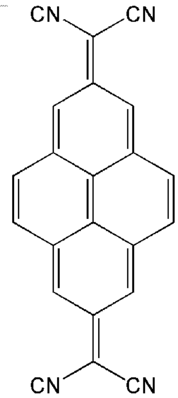

TCNPQ

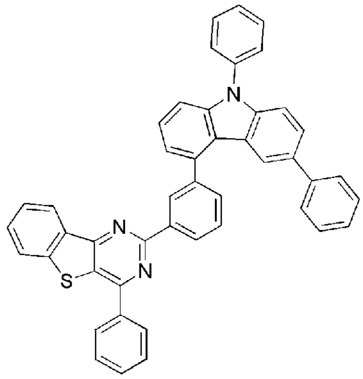

EH1-401

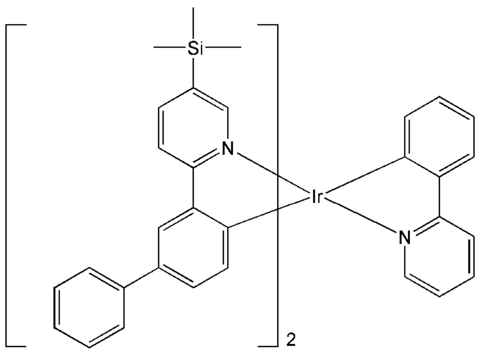

PD79

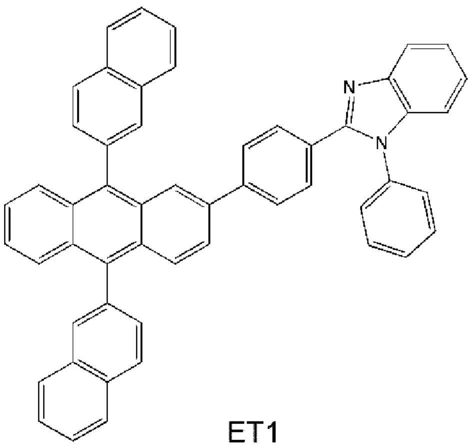

ET1

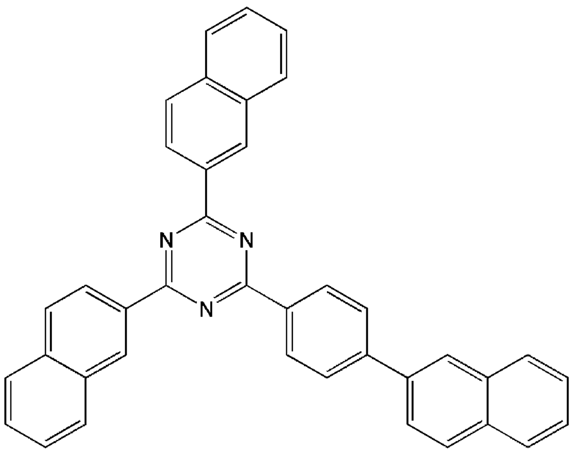

ET16

In another embodiment, in the emission layer 15 of the organic light-emitting device 10,
the electron-transporting host is Compound EH3-81,
the hole-transporting host comprises a compound satisfying $0.1 \leq$ Type (Compound EH3-81) $\leq 1.2$ (e.g., $0.23 \leq$ Type (Compound EH3-81) $\leq 1.15$),
wherein a volume ratio of the electron-transporting host to the hole-transporting host may be selected from a range of $0.1 \leq$ Type (Compound EH3-81) $\leq 1.2$ (e.g., $0.23 \leq$ Type (Compound EH3-81) $\leq 1.15$), and

Type (Compound EH3-81) is defined by Equation 11 below:

<Equation 11>

$$\text{Type (Compound EH3-81)} = \log(J_{HOD}\text{ (at 11.5 V)} / J_{EOD}\text{ (at 4 V)})$$

In Equation 11,
$J_{HOD}$(at 11.5V) refers to a current density value (mA/cm$^2$) at a voltage of 11.5 V of a hole-only device having a structure of ITO (150 nm or 1,500 Å) / Compound HT3:TCNPQ (3 wt%) (10 nm or 100 Å) / Compound HT3 (100 nm or 1,000 Å) / host:Compound PD79 (10 wt%) (60 nm or 600 Å) / Compound ET1 (10 nm or 100 Å) / Al (10 nm or 100 Å) (wherein the host consists of Compound EH3-81 and the hole-transporting host), and
$J_{EOD}$ (at 4 V) refers to a current density value (mA/cm$^2$) at a voltage of 4 V of an electron-only device having a structure of ITO (150 nm or 1,500 Å) / Mg:Ag (10 wt%) (30 nm or 300 Å) / Liq (1 nm or 10 Å) / Compound ET16:Liq (50 wt%) (20 nm or 200 Å) / host:Compound PD79 (10 wt%) (60 nm or 600 Å) / Compound ET16:Liq (50 wt%) (20 nm or 200 Å) / Liq (1 nm or 10 Å) / Mg:Ag (10 wt%) (30 nm or 300 Å) (wherein the host consists of Compound EH3-81 and the hole-transporting host).

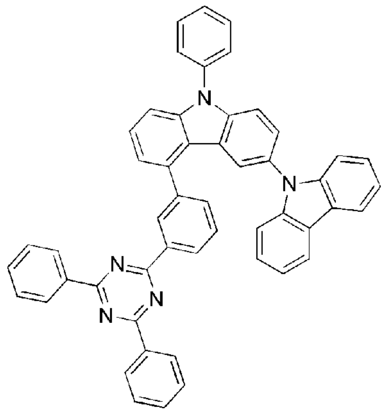

**EH3-81**

In the emission layer 15 of the organic light-emitting device 10, i) when the electron-transporting host is Compound EH1-401 and the hole-transporting host comprises a compound satisfying -0.1 ≤ Type (Compound EH1-401) ≤ 0.6, or ii) when the electron-transporting host is Compound EH3-81 and the hole-transporting host comprises a compound satisfying 0.1 ≤ Type (Compound EH3-81) ≤ 1.2, and in this regard, the electrons and the holes in the emission layer 15 may be balanced good enough to improve the efficiency of the organic light-emitting device 10.
The emission layer 15 may further include a dopant in addition to the electron-transporting host and the hole-transporting host described above. The dopant may be selected from materials known as a fluorescent dopant and a phosphorescent dopant in the art.
In an embodiment, the dopant may be a phosphorescent dopant.
The phosphorescent dopant may include an organometallic compound represented by Formula 81 below:

<Formula 81>

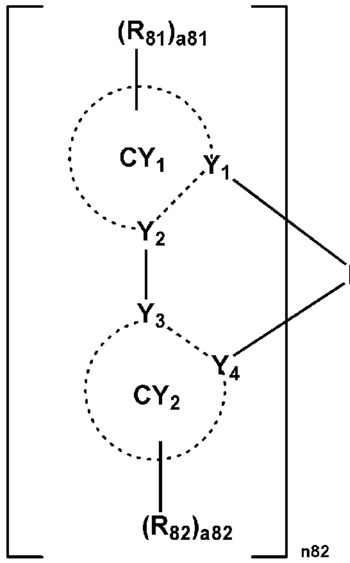

In Formula 81, M may be iridium (Ir), platinum (Pt), osmium (Os), titanium (Ti), zirconium (Zr), hafnium (Hf), europium (Eu), terbium (Tb) or thulium (Tm);
$Y_1$ to $Y_4$ may be each independently carbon (C) or nitrogen (N);

$Y_1$ 과 $Y_2$ may be linked with each other via a single bond or a double bond, and $Y_3$ and $Y_4$ may be linked with each other via a single bond or a double bond;
$CY_1$ and $CY_2$ may be each independently a benzene, a naphthalene, a fluorene, a spiro-fluorene, an indene, a pyrrole, a thiophene, a furan, an imidazole, a pyrazole, a thiazole, an isothiazole, an oxazole, an isoxazole, a pyridine, a pyrazine, a pyrimidine, a pyridazine, a quinoline, an isoquinoline, a benzoquinoline, a quinoxaline, a quinazoline, a carbazole, a benzoimidazole, a benzofuran, a benzothiophene, an isobenzothiophene, a benzoxazole, an isobenzoxazole, a triazole, a tetrazole, an oxadiazole, a triazine, a dibenzofuran,or a dibenzothiophene, wherein $CY_1$ and $CY_2$ may be optionally further linked with each other via a organic linking group;
$R_{81}$ and $R_{82}$ may be each independently a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, or $-B(Q_6)(Q_7)$;
a81 and a82 may be each independently an integer of 1 to 5;
n81 may be an inter of 0 to 4;
n82 may be 1, 2, or 3; and
$L_{81}$ may be selected from a monovalent organic ligand, a divalent organic ligand, and a trivalent organic ligand.

Descriptions of $R_{81}$ and $R_{82}$ may be understood by referring to the description provided in connection with $R_1$.

For example, the phosphorescent dopant may include at least one of Compounds PD1 to PD79 below, but the phosphorescent dopant is not limited thereto (wherein Compound PD1 is $Ir(ppy)_3$):

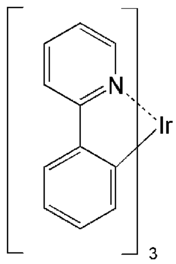

PD1

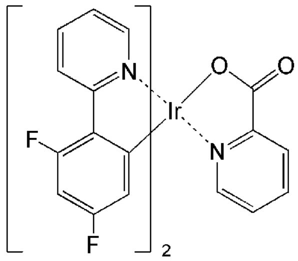

PD2

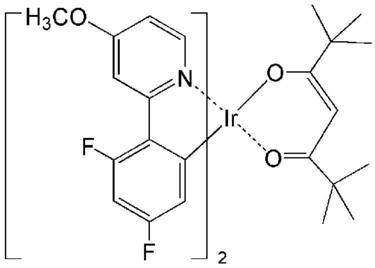

PD3

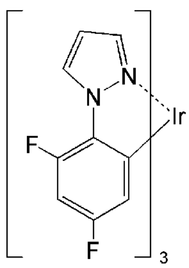

PD4

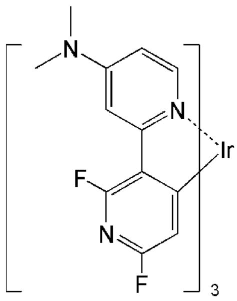

PD5

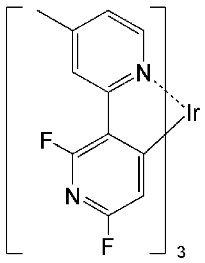

PD6

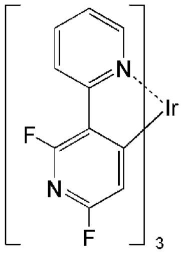

PD7

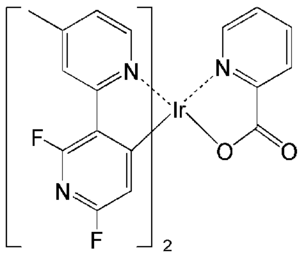

PD8

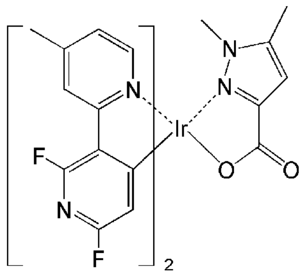

PD9

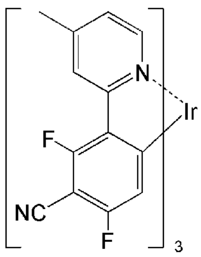

PD10

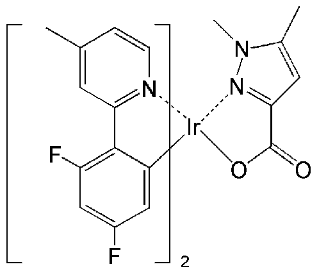

PD11

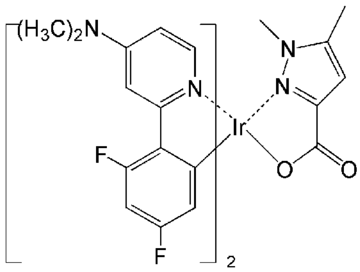

PD12

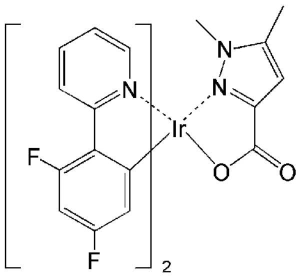

PD13

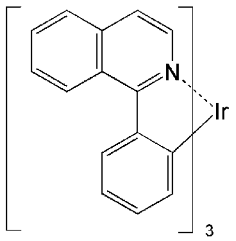

PD14

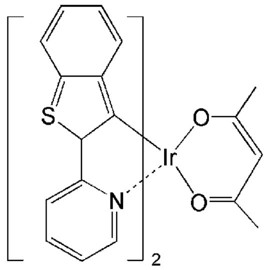

PD15

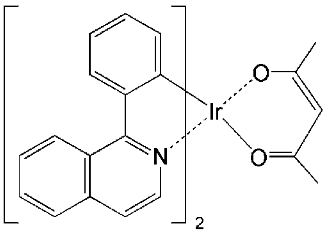

PD16

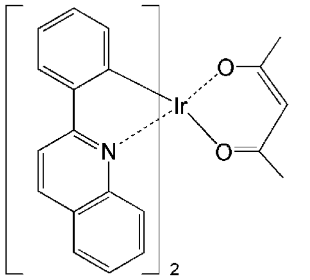

PD17

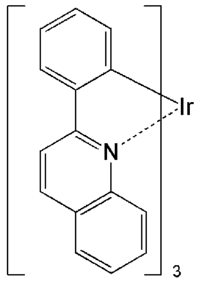

PD18

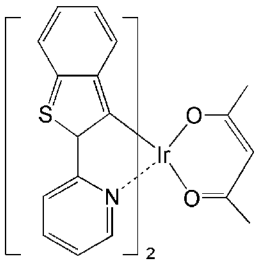

PD19

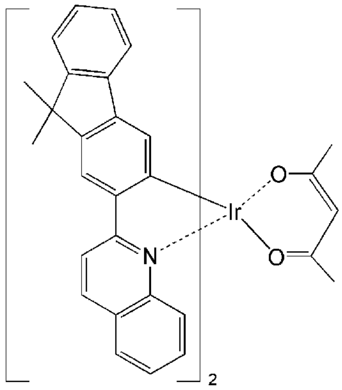

PD20

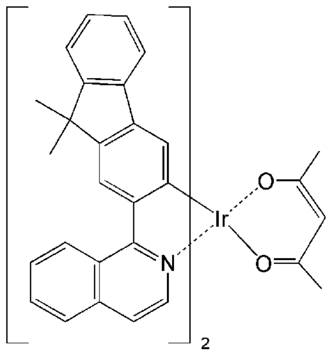

PD21

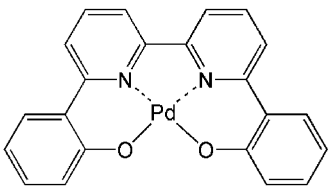

PD22

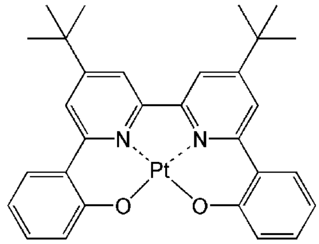

PD23

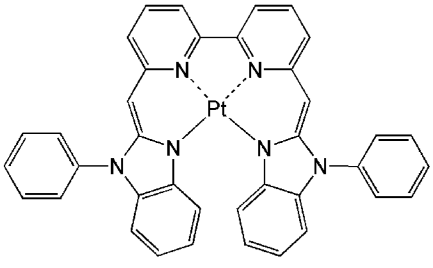

PD24

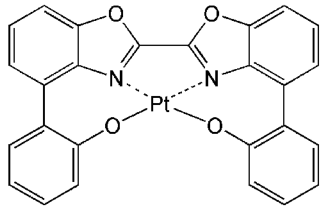

PD25

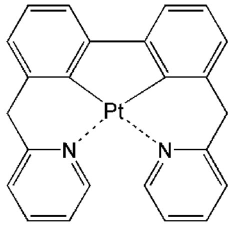

PD26

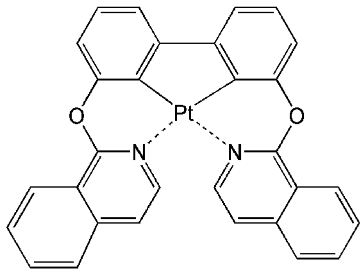

PD27

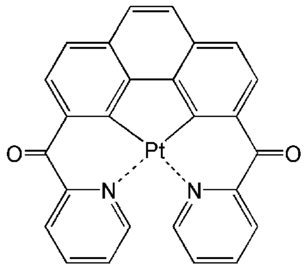

PD28

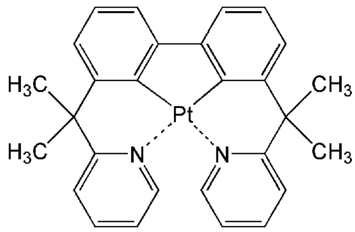

PD29

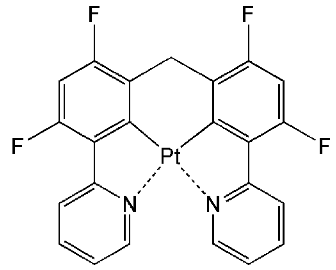

PD30

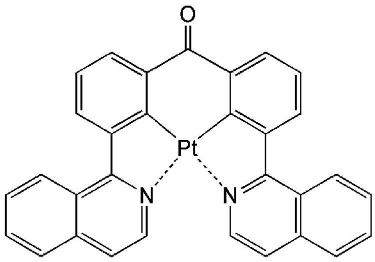

PD31

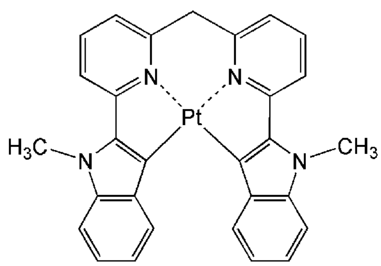

PD32

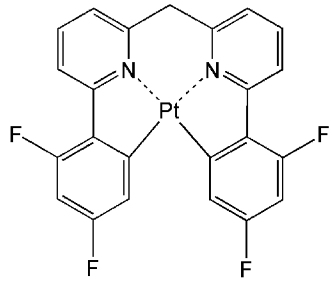

PD33

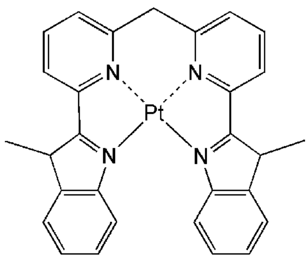

PD34

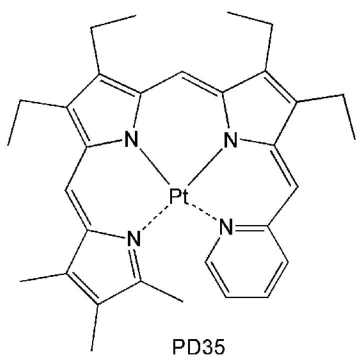

PD35

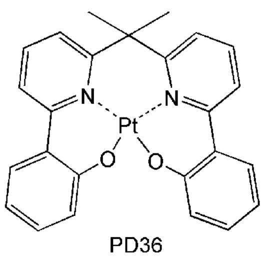

PD36

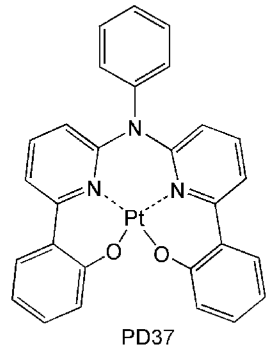

PD37

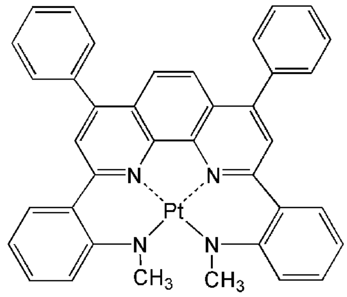

PD38

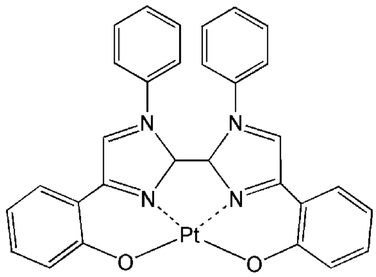

PD39

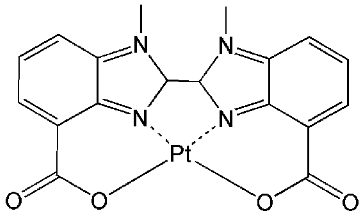

PD40

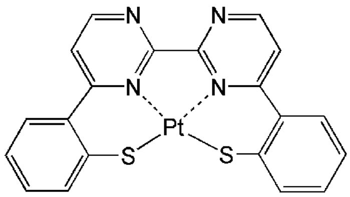

PD41

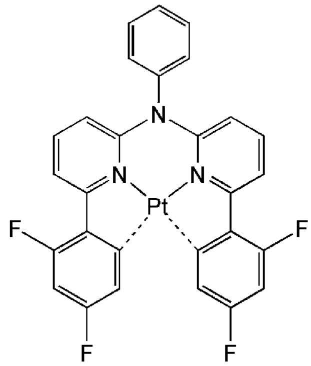

PD42

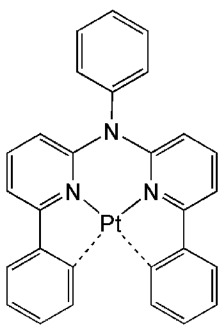

PD43

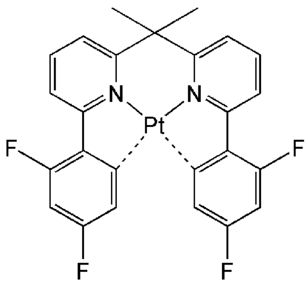

PD44

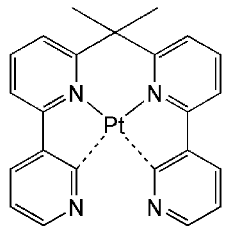

PD45

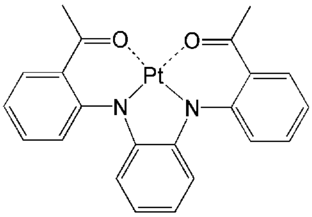

PD46

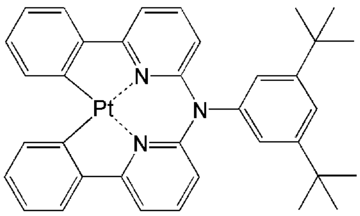

PD47

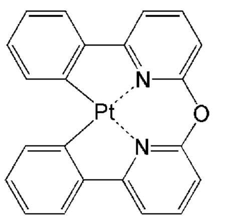

PD48

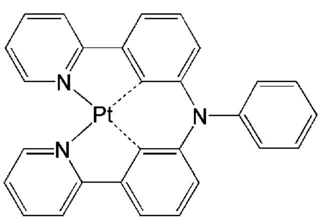

PD49

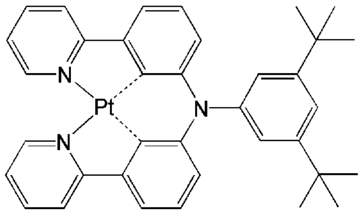

PD50

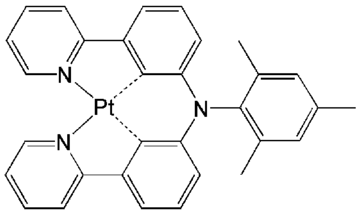

PD51

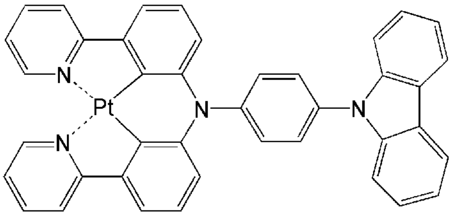

PD52

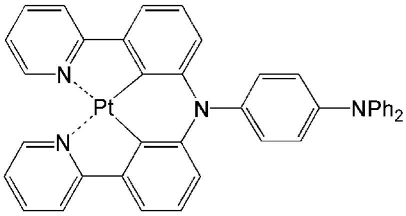

PD53

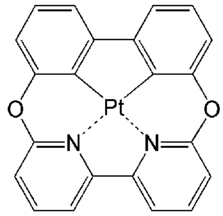

PD54

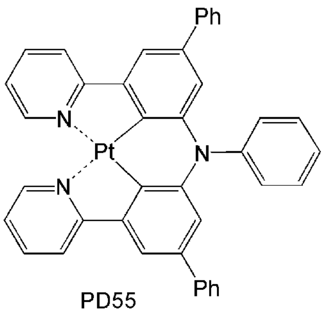

PD55

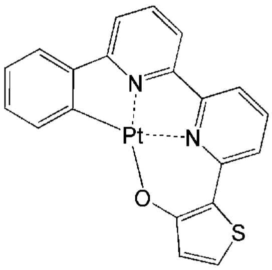

PD56

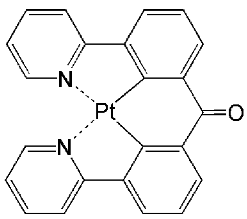

PD57

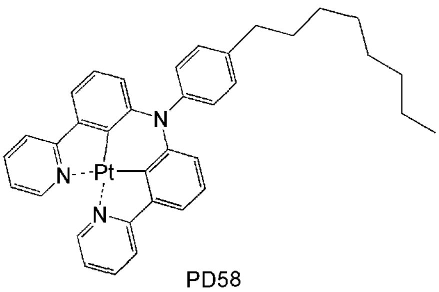

PD58

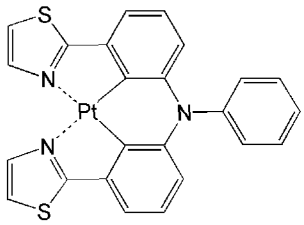

PD59

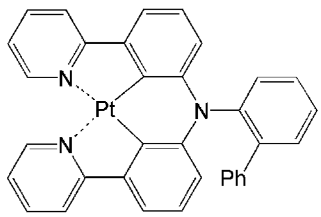

PD60

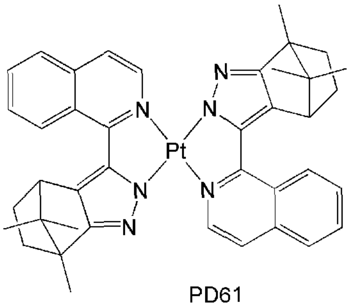

PD61

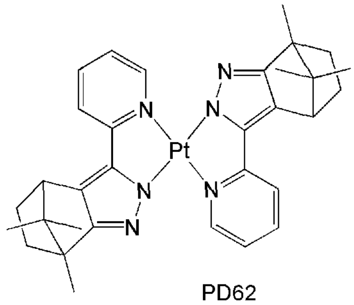

PD62

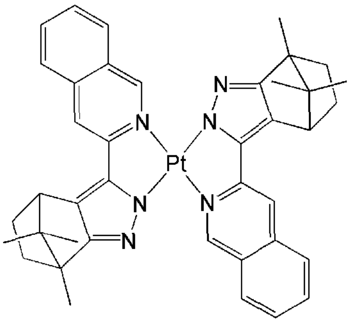

PD63

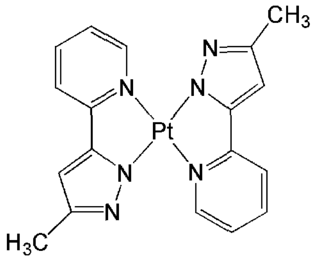
PD64

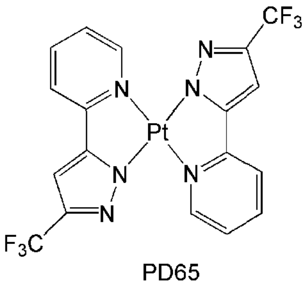
PD65

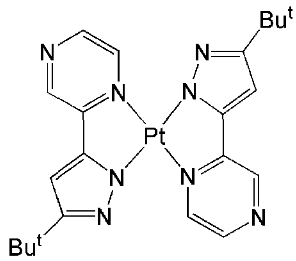
PD66

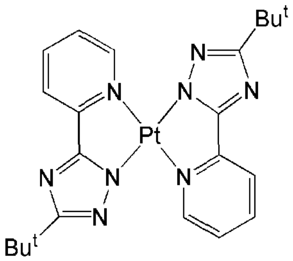
PD67

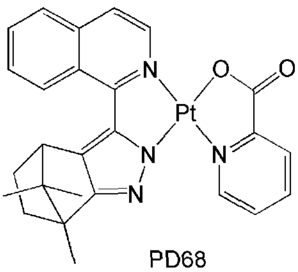
PD68

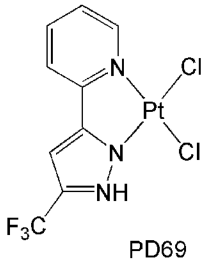
PD69

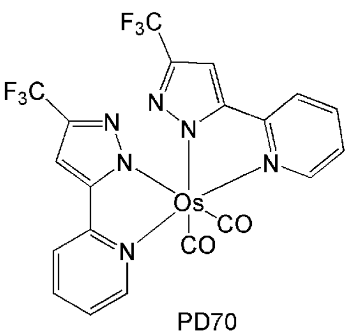
PD70

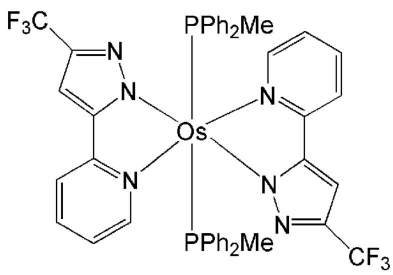
PD71

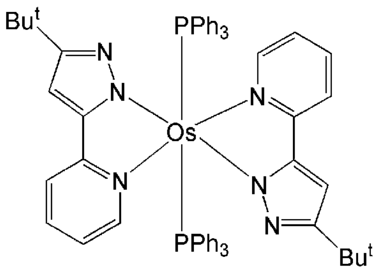
PD72

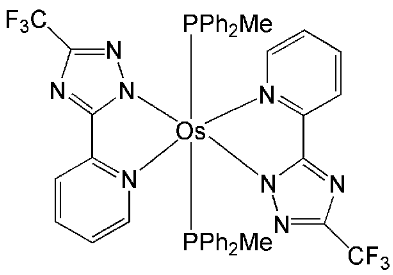
PD73

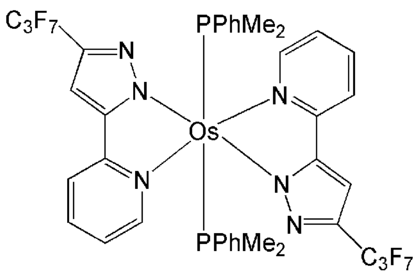
PD74

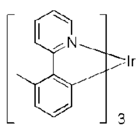
PD75

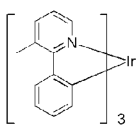
PD76

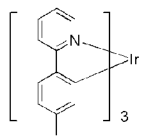
PD77

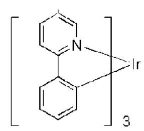
PD78

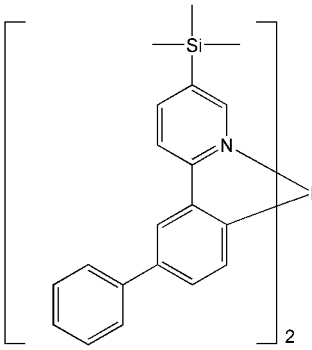

PD79

Alternatively, the phosphorescent dopant may include PtOEP below:

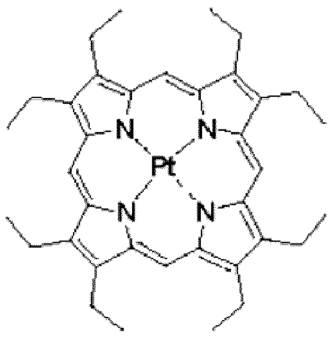

**PtOEP**

An amount of the dopant included in the emission layer 15 may be, but not limited to, about 0.01 to about 15 parts by weight, based on 100 parts by weight of the host (e.g., the electron-transporting host and the hole-transporting host).

A thickness of the emission layer 15 may be about 10 nm (100 Å) to about 100 nm (1,000 Å), e.g., 20 nm (200 Å) to about 60 nm (600 Å). When the thickness of the emission layer 15 is within these ranges, excellent emission characteristics may be obtained without a substantial increase in driving voltage.

The host transport region 13 of the organic light-emitting device 10 may further include at least one of a hole injection layer, an electron blocking layer, and a buffer layer, in addition to the hole transport layer.

For example, the hole transport region 13 may include a hole transport layer only, or may have a structure of hole injection layer/hole transport layer or a structure of hole injection layer/hole transport layer/electron blocking layer, each of which layers are sequentially stacked in the stated order from the first electrode 11.

When the hole transport region 13 includes the hole injection layer, the hole injection layer may be formed on the first electrode 11 by using various methods, such as vacuum deposition, spin coating, casting, or Langmuir-Blodgett (LB) deposition.

When the hole injection layer is formed by vacuum deposition, deposition conditions may vary according to a compound used to form the hole injection layer and the structure and thermal characteristics of the hole injection layer, and for example, the deposition conditions include a deposition temperature in a range of about 100°C to about 500°C, a vacuum pressure in a range of about $10^{-8}$ torr to about $10^{-3}$ torr, and a deposition rate in a range of about 0.001 nm/sec (0.01 Å/sec) to about 10 nm/sec (100 Å/sec), but the conditions are not limited thereto.

When the hole injection layer is formed by spin coating, spin coating conditions may vary according to a compound used to form the hole injection layer and the structure and thermal characteristics of the hole injection layer, and for example, the spin conditions include a coating speed in a range of about 2,000 rpm to about 5,000 rpm, and a temperature at which a heat treatment is performed to remove a solvent after coating may be in a range of about 80°C to about 200°C, but the conditions are not limited thereto.

Conditions for forming the hole transport layer and the electron blocking layer may be understood by referring to the conditions for forming the hole injection layer.

The hole transport region 13 may include, e.g., at least one of m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid:polyaniline/dodecylbenzene sulfonic acid (Pani/DBSA), poly(3,4-ethylene dioxythiophene)/poly(4-styrene sulfonate (PEDOT/PSS), polyaniline/camphor sulfonic acid:polyaniline (Pani/CSA), polyaniline/poly(4-styrene sulfonate) (PANI/PSS), and compounds represented by Formulae 201 and 202 below:

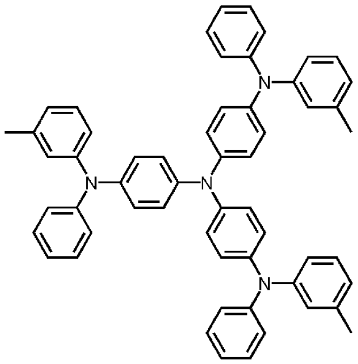

m-MTDATA

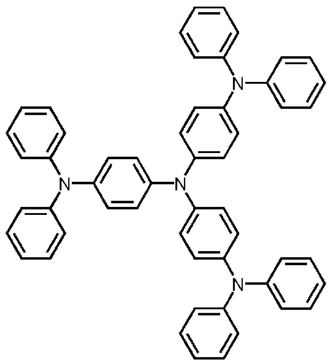

TDATA

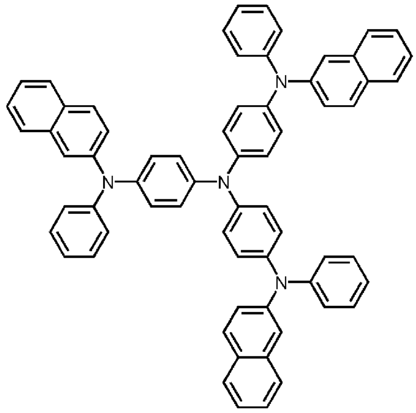

2-TNATA

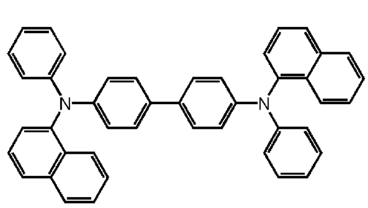

NPB

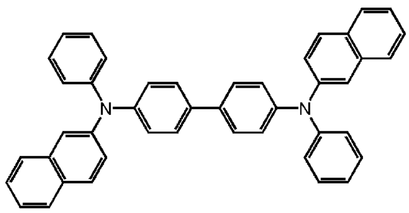

β-NPB

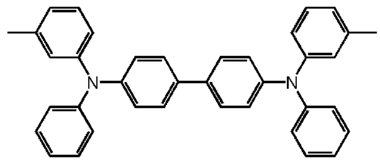

TPD

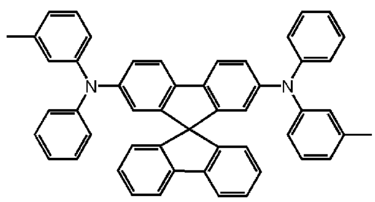

Spiro-TPD

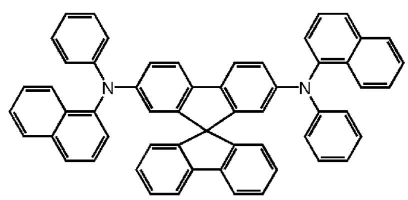

Spiro-NPB

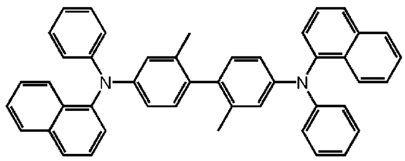

methylated NPB

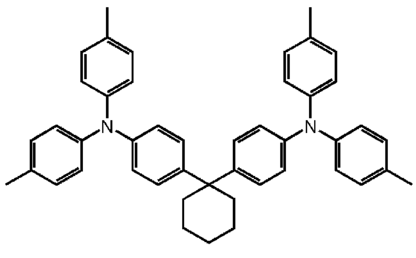

TAPC

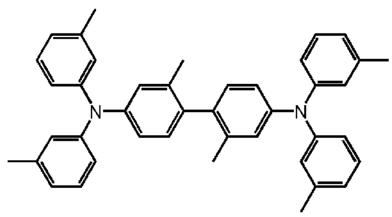

HMTPD

<Formula 201>

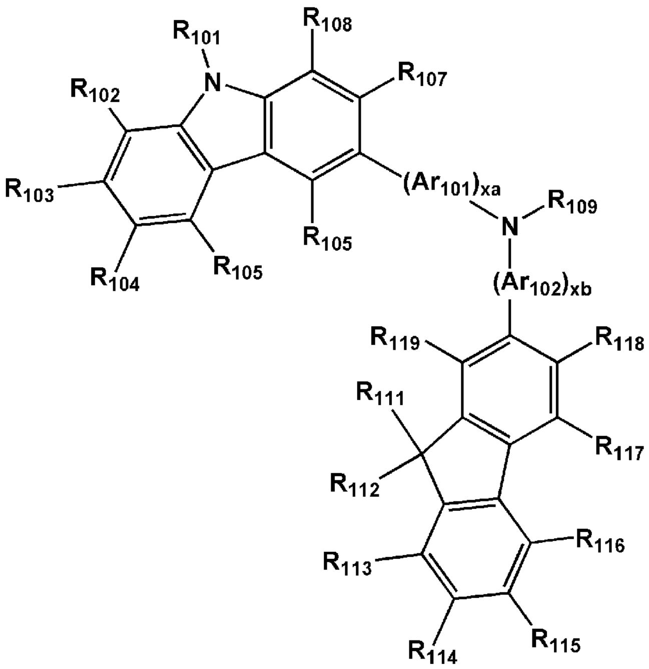

<Formula 202>

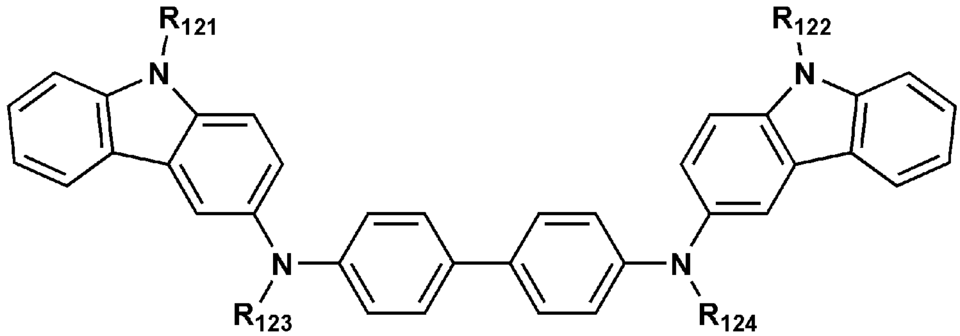

In Formula 201, $Ar_{101}$ and $Ar_{102}$ may be each independently selected from

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

In Formula 201, xa and xb may be each independently an integer of 0 to 5, or may be 0, 1, or 2. For example, xa may be 1 and xb may be 0, but xa and xb are not limited thereto.

In Formulae 201 and 202, $R_{101}$ to $R_{108}$, $R_{111}$ to $R_{119}$, and $R_{121}$ to $R_{124}$ may be each independently selected from, but not limited to,

a hydrogen, a deuterium, -F, -Cl, -Br, -I, a hydroxyl group, a cyano group, a nitro group, an amino group, an amidino

group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, a pentyl group, or a hexyl group), and a $C_1$-$C_{10}$ alkoxy group (e.g., a methoxy group, an ethoxy group, a propoxy group, a butoxy group, or a pentoxy group);
a $C_1$-$C_{10}$ alkyl group and a $C_1$-$C_{10}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group.

In Formula 201, $R_{109}$ may be selected from
a phenyl group, a naphthyl group, an anthracenyl group, and a pyridinyl group; and
a phenyl group, a naphthyl group, an anthracenyl group, and a pyridinyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

In an embodiment, the compound represented by Formula 201 may be represented by Formula 201A below, but the compound is not limited thereto:

<Formula 201A>

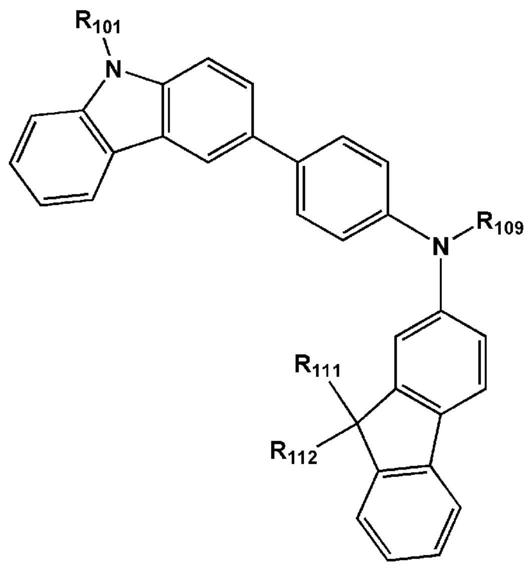

In Formula 201A, descriptions of $R_{101}$, $R_{111}$, $R_{112}$, and $R_{109}$ may be understood by referring to the description provided herein.

For example, the compound represented by Formula 201 and the compound represented by Formula 202 may include Compounds HT1 to HT20 below, but the compounds are not limited thereto:

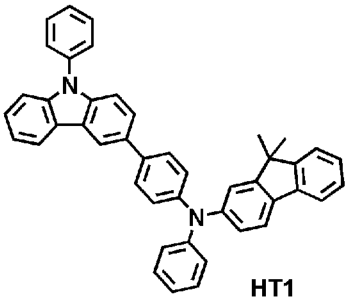
HT1

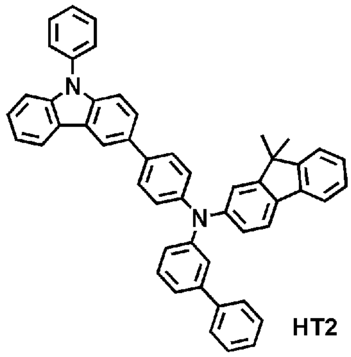
HT2

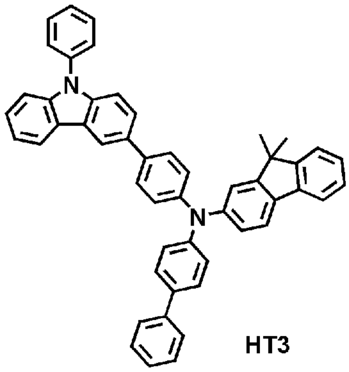
HT3

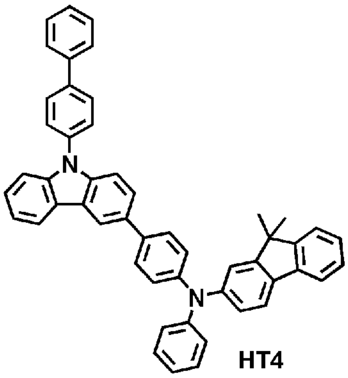
HT4

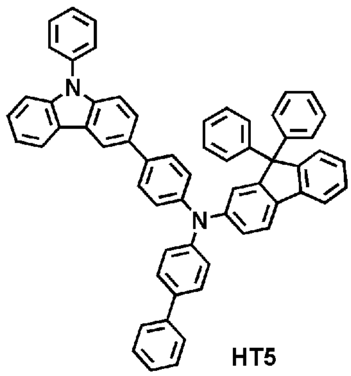
HT5

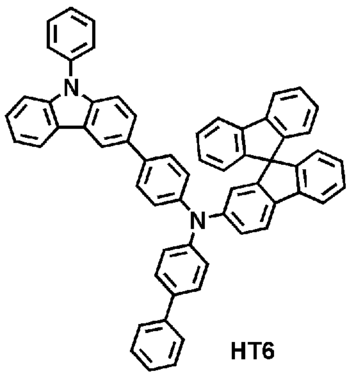
HT6

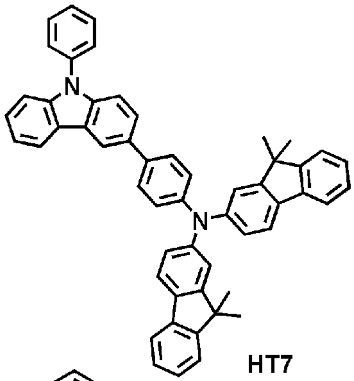
HT7

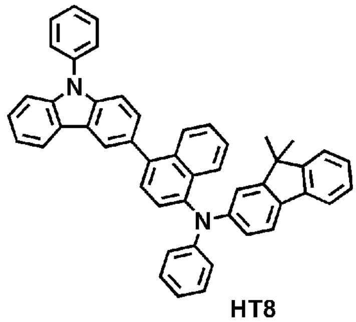
HT8

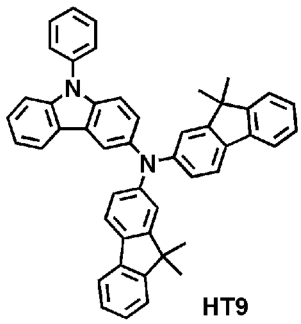
HT9

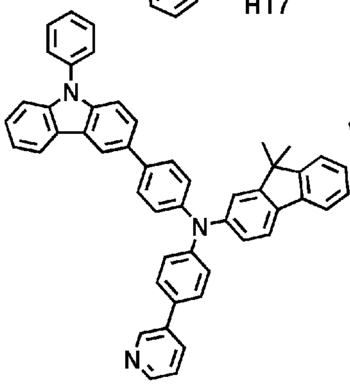
HT10

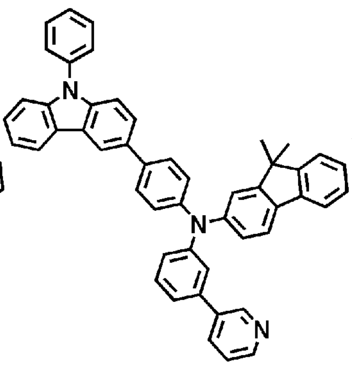
HT11

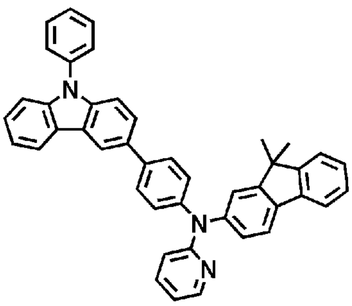
HT12

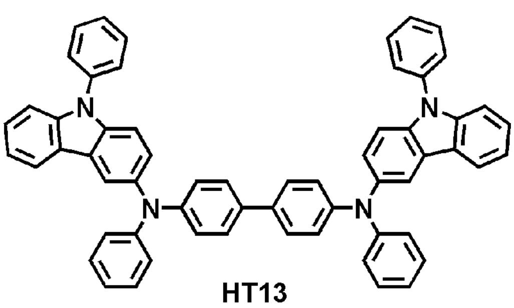

HT13

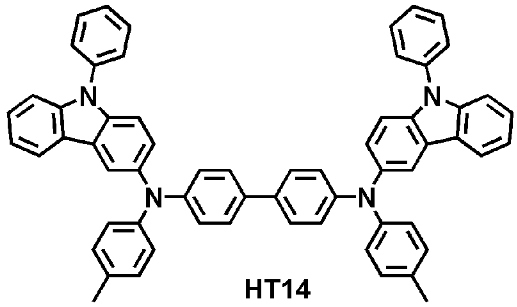

HT14

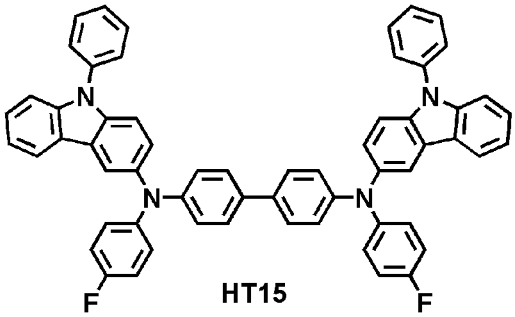

HT15

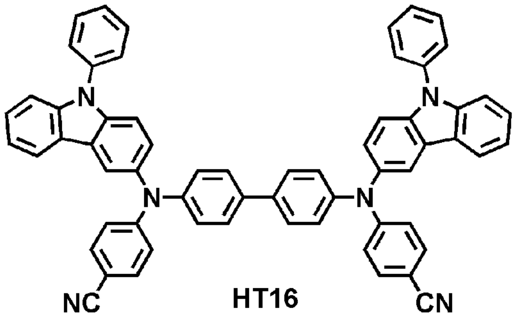

HT16

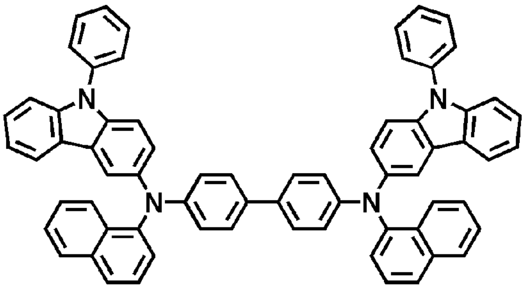

HT17

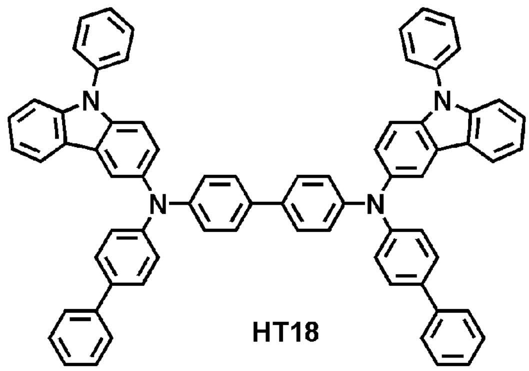

HT18

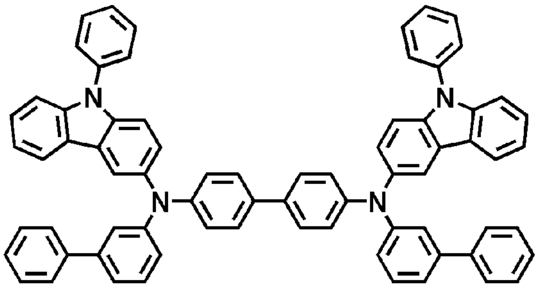

HT19

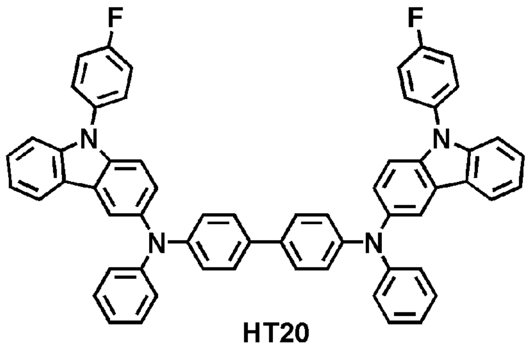

HT20

A thickness of the hole transport region 13 may be in a range of about 10 nm (100 Å ) to about 1,000 nm (10,000 Å), e.g., about 10 nm (100 Å) to about 100 nm (1,000 Å). When the hole transport region 13 includes both an hole injection layer and an hole transport layer, a thickness of the hole injection layer may be in a range of about 10 nm (100 Å) to about 1,000 nm (10,000 Å), e.g., about 10 nm (100 Å) to about 100 nm (1,000 Å), and a thickness of the hole transport layer may be in a range of about 5 nm (50 Å) to about 200 nm (2,000 Å), e.g., about 10 nm (100 Å) to about 150 nm (1,500 Å). When the thicknesses of the hole transport region 13, the hole injection layer, and the hole transport layer are within these ranges, satisfactory hole transporting characteristics may be obtained without a substantial increase in driving voltage.

The hole transport material included in the hole transport layer of the hole transport region 13 may include a

compound represented by Formula 201 above.

In an embodiment, the hole transport material included in the hole transport layer of the hole transport region 13 may include a compound represented by Formula 201A above.

In another embodiment, the hole transport material included in the hole transport layer of the hole transport region 13 may include at least one of Compounds HT1 to HT12 above, but the hole transport material is not limited thereto.

In addition to the materials described above, the hole transport region 13 may further include a charge-generation material for the improvement of conductive characteristics. The charge-generation material may be homogeneously or non-homogeneously dispersed in the hole transport region 13.

The charge-generation material may be, e.g., a p-dopant. The p-dopant may be, but not limited to, one of a quinone derivative, a metal oxide, and a cyano group-containing compound. Non-limiting examples of the p-dopant are, but not limited to, a quinone derivative such as tetracyanoquinonedimethane (TCNQ) and 2,3,5,6-tetrafluoro-tetracyano-1,4-benzoquinonedimethane (F4-TCNQ); a metal oxide such as a tungsten oxide or a molybdenum oxide; and Compound HT-D1 below.

<Compound HT-D1>

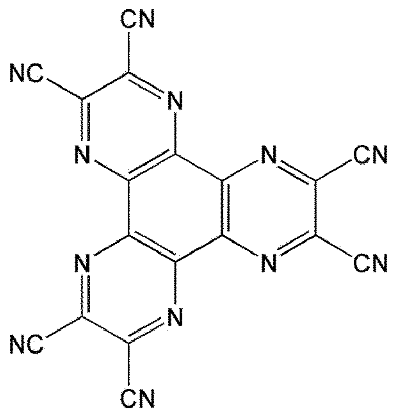

<F4-TCNQ>

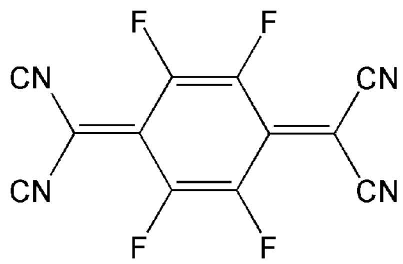

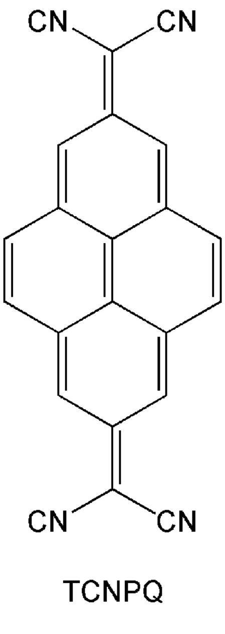

TCNPQ

The hole transport region 13 may further include a buffer layer.

The buffer layer may compensate for an optical resonance distance according to a wavelength of light emitted from the emission layer 15, and thus, a light-emission efficiency of a formed organic light-emitting device may be improved.

The electron transport region 17 may further include at least one of a hole blocking layer and an electron injection layer, in addition to the electron transport layer.

For example, electron transport region may have a structure of hole blocking layer/electron transport layer/electron injection layer or a structure of electron transport layer/electron injection layer, but the structure is not limited thereto. The electron transport layer may have a single-layer structure or a multi-layer structure including at least two different materials.

Conditions for forming the hole blocking layer, the electron transport layer, and the electron injection layer included in the electron transport region may be understood by referring to the conditions for forming the hole injection layer.

When the electron transport region includes the hole blocking layer, the hole blocking layer may include, e.g., at least one of BCP, Bphen, and BAlq below, but the material is not limited thereto.

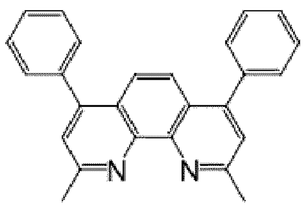

**BCP**

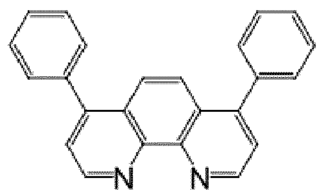

**Bphen**

A thickness of the hole blocking layer may be in a range of about 2 nm (20 Å) to about 100 nm (1,000 Å), e.g., about 3 nm (30 Å) to about 30 nm (300 Å). When the thickness of the hole blocking layer is within these ranges, excellent hole blocking characteristics may be obtained without substantial increase in driving voltage.

The electron transport material included in the electron transport layer may include a compound represented by Formulae 40 or 41 below:

<Formula 40>

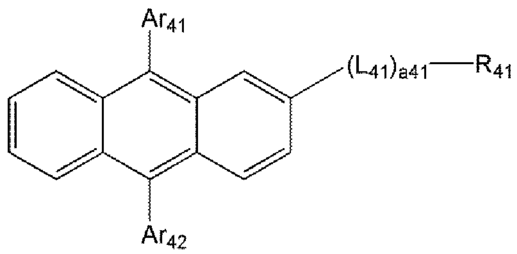

<Formula 41>

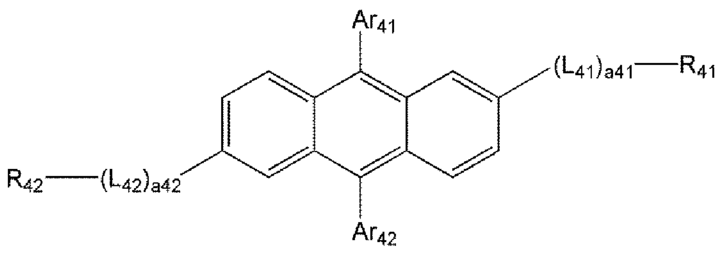

In Formulae 40 and 41,

$L_{41}$ and $L_{42}$ may be each independently selected from

a $C_6$-$C_{60}$ arylene group, a $C_1$-$C_{60}$ heteroarylene group, a divalent non-aromatic condensed polycyclic group, and a divalent non-aromatic condensed heteropolycyclic group; and

a $C_6$-$C_{60}$ arylene group, a $C_1$-$C_{60}$ heteroarylene group, a divalent non-aromatic condensed polycyclic group, and a divalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group;

a41 and a42 may be each independently an integer of 0 to 5;

$Ar_{41}$ and $Ar_{42}$ may be each independently selected from
a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group; and
$R_{41}$ and $R_{42}$ may be each independently selected from
a benzoimidazolyl group, a benzoxazolyl group, a benzothiazolyl group, a benzopyrimidinyl group, an imidazopyridinyl group, a quinolinyl group, an isoquinolinyl group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group; and
a benzoimidazolyl group, a benzoxazolyl group, a benzothiazolyl group, a benzopyrimidinyl group, an imidazopyridinyl group, a quinolinyl group, an isoquinolinyl group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a benzoimidazolyl group, a benzoxazolyl group, a benzothiazolyl group, a benzopyrimidinyl group, an imidazopyridinyl group, a quinolinyl group, an isoquinolinyl group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group.

Descriptions of $L_{41}$ and $L_{42}$ may be understood by referring to the description provided in connection with $L_2$.

Alternatively, the electron transport material included in the electron transport layer may include a compound represented by Formula 42 below:

<Formula 42>

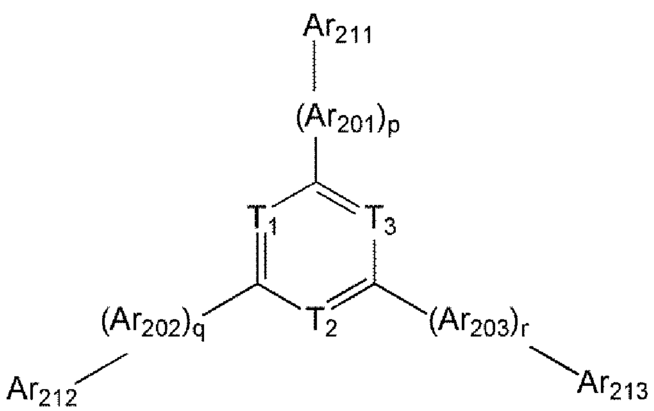

In Formula 42,
$T_1$ may be N or $C(R_{201})$, $T_2$ may be N or $C(R_{202})$, and $T_3$ may be N or $C(R_{203})$, wherein at least one of $T_1$ to $T_3$ may be N,
$R_{201}$ to $R_{203}$ may be each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl

group, a chrysenyl group, a phenanthrenyl group, a pyridinyl group, a pyrimidinyl group, and a triazinyl group,

$Ar_{201}$ to $Ar_{203}$ may be each independently selected from

a $C_6$-$C_{60}$ arylene group, a $C_1$-$C_{60}$ heteroarylene group, a divalent non-aromatic condensed polycyclic group, and a divalent non-aromatic condensed heteropolycyclic group; and

a $C_6$-$C_{60}$ arylene group, a $C_1$-$C_{60}$ heteroarylene group, a divalent non-aromatic condensed polycyclic group, and a divalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group,

p, q, and r may be each independently 0, 1, or 2; and

$Ar_{211}$ and $Ar_{213}$ may be each independently selected from

a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and

a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group.

In an embodiment, at least two of $T_1$ to $T_3$ in Formula 42 may be N.

In another embodiment, all of $T_1$ to $T_3$ in Formula 42 may be N.

In Formula 42, $Ar_{201}$ to $Ar_{203}$ may be each independently selected from

a phenylene group, a naphthylene group, an anthrylene group, a pyrenylene group, a fluorenylene group, a triphenylenyl group, a pyridinylene group, and a pyrimidinylene group; and

a phenylene group, a naphthylene group, an anthrylene group, a pyrenylene group, a fluorenylene group, a triphenylenyl group, a pyridinylene group, and a pyrimidinylene group, each substituted with at least one of a phenyl group, a naphthyl group, an anthryl group, a pyrenyl group, a fluorenyl group, a triphenylenyl group, a pyridinyl group, and a pyrimidinyl group.

In Formula 42, p, q, and r may be each independently 0, 1, or 2. For example, in Formula 42, p, q, and r may be each independently 0 or 1, but p, q, and 4 are not limited thereto.

In Formula 42, $Ar_{211}$ to $Ar_{213}$ may be each independently selected from

a phenyl group, a naphthyl group, a pyrenyl group, a chrysenyl group, a fluorenyl group, a phenanthrenyl group, a benzoimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group; and

a phenyl group, a naphthyl group, a pyrenyl group, a chrysenyl group, a fluorenyl group, a phenanthrenyl group, a benzoimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group.

In an embodiment, at least one of $Ar_{211}$ to $Ar_{213}$ in Formula 42 may be each independently selected from

a benzoimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group; and

a benzoimidazolyl group, a benzoxazolyl group, a benzothiazolyl group, a benzopyrimidinyl group, an imidazopyrimidinyl group, a quinolinyl group, an isoquinolinyl group, a quinazolinyl group, a pyridinyl group, a pyrimidinyl group, a pyrazinyl group, and a triazinyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group, but $Ar_{211}$ to $Ar_{213}$ are not limited thereto.

In another embodiment, at least one of $Ar_{211}$ to $Ar_{213}$ in Formula 20A may be a substituted or unsubstituted phenanthrenyl group.

For example, the electron transport layer included in the electron transport region 17 may include, but not

limited, at least one of Compounds ET1 to ET16 below:

<Compound ET1>

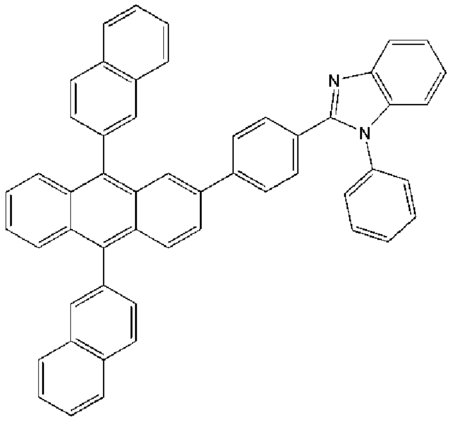

<Compound ET2>

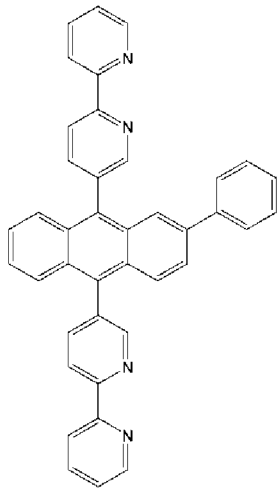

<Compound ET3>

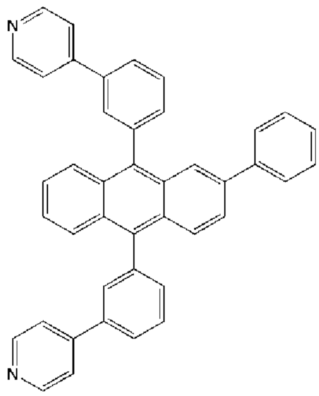

<Compound ET4>

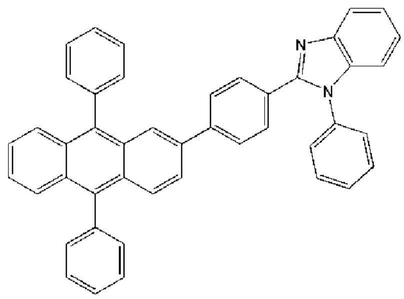

<Compound ET5>

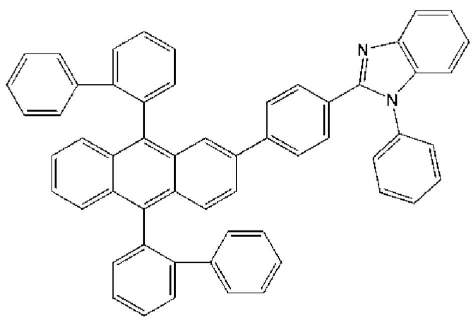

<Compound ET6>

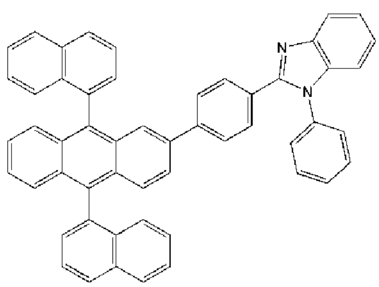

<Compound ET7>

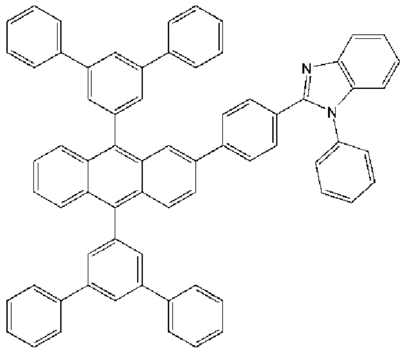

<Compound ET8>

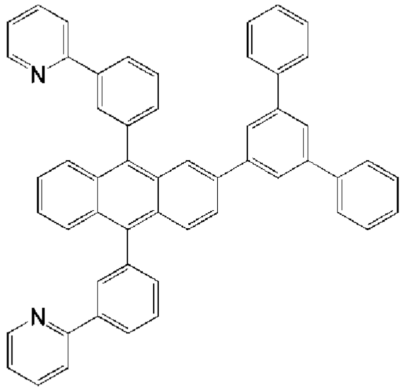

<Compound ET8>

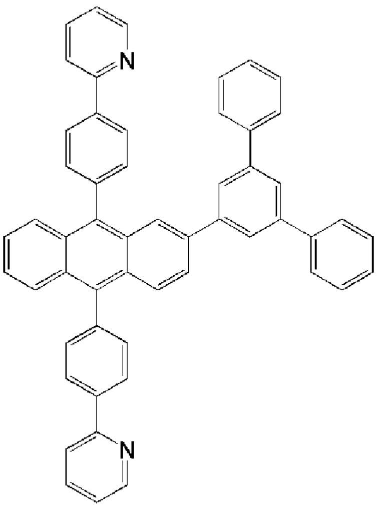

<Compound ET10>

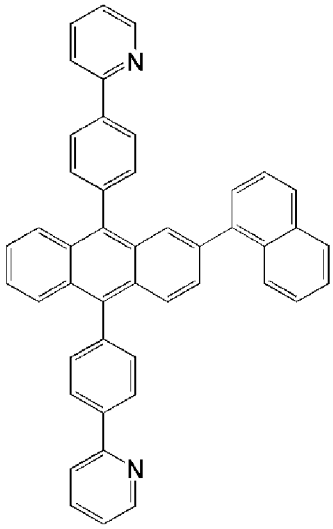

<Compound ET11>

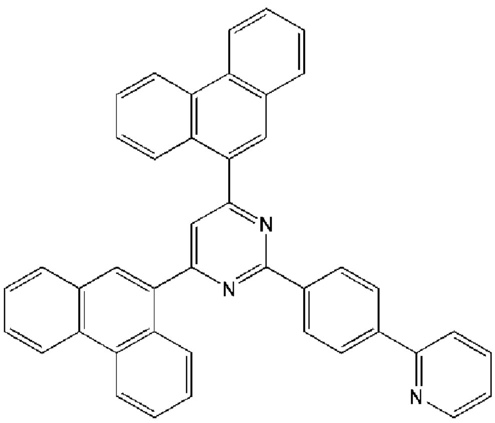

<Compound ET12>

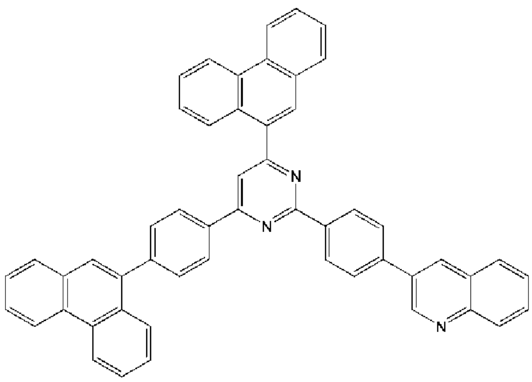

<Compound ET13>

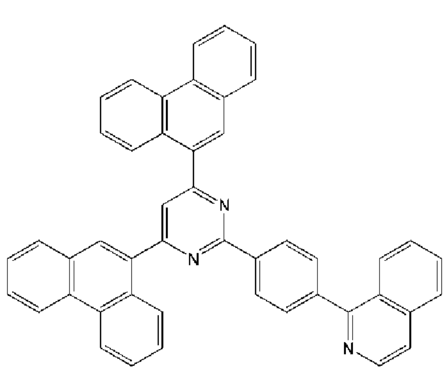

<Compound ET14>

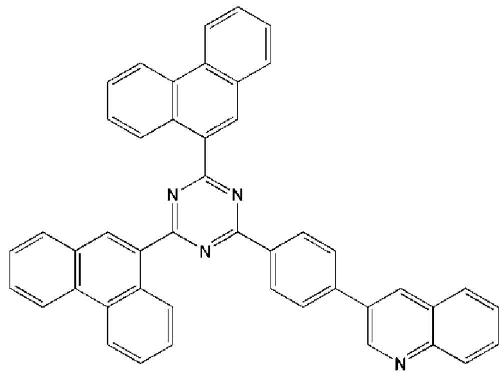

<Compound ET15>

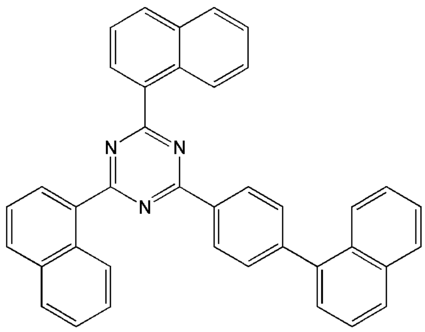

<Compound ET16>

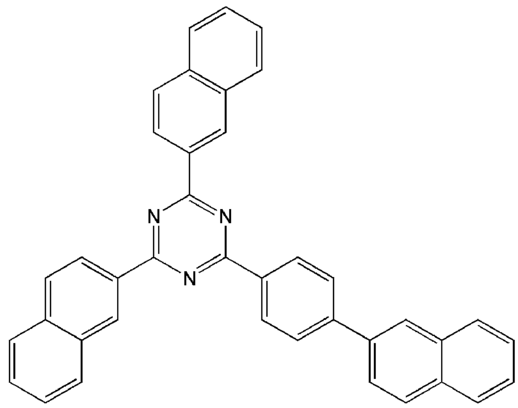

A thickness of the electron transport layer may be about 10 nm (100 Å) to about 100 nm (1,000 Å), e.g., about 15 nm (150 Å) to about 50 nm (500 Å). When the thickness of the electron transport layer is within these ranges, satisfactory electron transporting characteristics may be obtained without a substantial increase in driving voltage.

In addition to the materials described above, the electron transport layer may further include a metal-containing material.

The metal-containing material may include a Li complex. The Li complex may include, e.g., Compound ET-D1 (e.g., lithium quinolate (LiQ)) or Compound ET-D2 below.

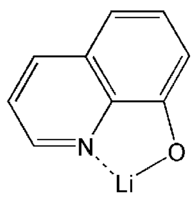

ET-D1

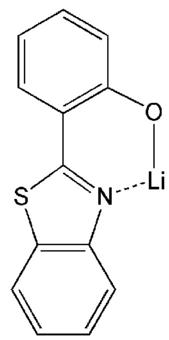

ET-D2

In addition, the electron transport region 17 may include an electron injection layer that facilitates electron injection from the second electrode 19.

The electron injection layer may include at least one selected from LiF, NaCl, CsF, $Li_2O$, and BaO.

A thickness of the electron injection layer may be about 0.1 nm (1 Å) to about 10 nm (100 Å), e.g., about 0.3 nm (3 Å) to about 9 nm (90 Å). When the thickness of the electron injection layer is within these ranges, satisfactory electron injecting characteristics may be obtained without a substantial increase in driving voltage.

The second electrode 19 may be disposed on top of the organic layer 15. The second electrode 19 may be a cathode. A material for forming the second electrode 19 may be a material having a low work function, such as a metal, an alloy, an electrically conductive compound, or a mixture thereof. Detailed examples of the material for forming the second electrode 190 may include lithium (Li), magnesium (Mg), aluminium (Al), aluminium-lithium (Al-Li), calcium (Ca), magnesium-indium (Mg-In), and magnesium-silver (Mg-Ag). Alternatively, to fabricate a top emission type light-emitting device, the material for forming the second electrode 10 may be ITO or IZO to form a transmissive second electrode 19.

Hereinafter, the organic light-emitting device 10 has been described with reference to FIG. 1, but is not limited thereto.

A $C_1$-$C_{60}$ alkyl group used herein refers to a linear or branched aliphatic hydrocarbon monovalent group having 1 to 60 carbon atoms, and detailed examples thereof are a methyl group, an ethyl group, a propyl group, an isobutyl group, a sec-butyl group, a ter-butyl group, a pentyl group, an iso-amyl group, and a hexyl group. A $C_1$-$C_{60}$ alkylene group used herein refers to a divalent group having the same structure as the $C_1$-$C_{60}$ alkyl group.

A $C_1$-$C_{60}$ alkoxy group used herein refers to a monovalent group represented by $-OA_{101}$ (wherein $A_{101}$ is the $C_1$-$C_{60}$ alkyl group), and detailed examples thereof are a methoxy group, an ethoxy group, and an isopropyloxy group.

A $C_2$-$C_{60}$ alkenyl group used herein refers to a hydrocarbon group having at least one carbon double bond in the middle or terminal of the $C_2$-$C_{60}$ alkyl group, and detailed examples thereof are an ethenyl group, a prophenyl group, and a butenyl group. A $C_2$-$C_{60}$ alkenylene group used herein refers to a divalent group having the same structure as the $C_2$-$C_{60}$ alkenyl group.

A $C_2$-$C_{60}$ alkynyl group used herein refers to a hydrocarbon group having at least one carbon triple bond in the middle or terminal of the $C_2$-$C_{60}$ alkyl group, and detailed examples thereof are an ethynyl group and a propynyl group. A $C_2$-$C_{60}$ alkynylene group used herein refers to a divalent group having the same structure as the $C_2$-$C_{60}$ alkynyl group.

A $C_3$-$C_{10}$ cycloalkyl group used herein refers a monovalent hydrocarbon monocyclic group having 3 to 10 carbon atoms, and detailed examples thereof are a cyclopropyl group, a cyclobutyl group, a cyclopentyl group, a cyclohexyl group, and a cycloheptyl group. A $C_3$-$C_{10}$ cycloalkylene group used herein refers to a divalent group having the same structure as the $C_3$-$C_{10}$ cycloalkyl group.

A $C_1$-$C_{10}$ heterocycloalkyl group used herein refers a monovalent monocyclic group having at least one heteroatom selected from N, O, P, and S as a ring-forming atom and 1 to 10 carbon atoms, and detailed examples thereof are a tetrahydrofuranyl group and a tetrahydrothiophenyl group. A $C_1$-$C_{10}$ heterocycloalkylene group used herein refers to a divalent group having the same structure as the $C_1$-$C_{10}$ heterocycloalkyl group.

A $C_3$-$C_{10}$ cycloalkenyl group used herein refers to a monovalent monocyclic group that has 3 to 10 carbon atoms and at least one double bond in the ring thereof and does not have aromacity, and detailed examples thereof are a cyclopentenyl group, a cyclohexenyl group, and a cycloheptenyl group. A $C_3$-$C_{10}$ cycloalkenylene group used herein refers to a divalent group having the same structure as the $C_3$-$C_{10}$ cycloalkenyl group.

A $C_1$-$C_{10}$ heterocycloalkenyl group used herein refers to a monovalent monocyclic group that has at least one heteroatom selected from N, O, P, and S as a ring-forming atom, 1 to 10 carbon atoms, and at least one double bond in its ring. Detailed examples of the $C_1$-$C_{10}$ heterocycloalkenyl group are a 2,3-hydrofuranyl group and a 2,3-hydrothiophenyl group. A $C_1$-$C_{10}$ heterocycloalkenylene group used herein refers to a divalent group having the same structure as the $C_1$-$C_{10}$ heterocycloalkenyl group.

A $C_6$-$C_{60}$ aryl group used herein refers to a monovalent group having a carbocyclic aromatic system having 6 to 60 carbon atoms, and a $C_6$-$C_{60}$ arylene group used herein refers to a divalent group having a carbocyclic aromatic system having 6 to 60 carbon atoms. Detailed examples of the $C_6$-$C_{60}$ aryl group are a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

A $C_1$-$C_{60}$ heteroaryl group used herein refers to a monovalent group having a carbocyclic aromatic system that has at least one heteroatom selected from N, O, P, and S as a ring-forming atom, and 1 to 60 carbon atoms. A $C_1$-$C_{60}$ heteroarylene group used herein refers to a divalent group having a carbocyclic aromatic system that has at least one heteroatom selected from N, O, P, and S as a ring-forming atom, and 1 to 60 carbon atoms. Detailed examples of the $C_1$-$C_{60}$ heteroaryl group are a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

A $C_6$-$C_{60}$ aryloxy group used herein indicates $-OA_{102}$ (wherein $A_{102}$ is the $C_6$-$C_{60}$ aryl group), and a $C_6$-$C_{60}$ arylthio group used herein indicates $-SA_{103}$ (wherein $A_{103}$ is the $C_6$-$C_{60}$ aryl group).

A monovalent non-aromatic condensed polycyclic group (e.g., a group having 8 to 60 carbon atoms) used herein refers to a monovalent group that has two or more rings condensed to each other, has carbon atoms only as a ring-forming atom, and has non-aromacity in the entire molecular structure. A detailed example of the monovalent non-aromatic condensed polycyclic group is a fluorenyl group. A divalent non-aromatic condensed polycyclic group used herein refers to a divalent group having the same structure as the monovalent non-aromatic condensed polycyclic group.

A monovalent non-aromatic condensed heteropolycyclic group (e.g., a group having 1 to 60 carbon atoms) used herein refers to a monovalent group that has two or more rings condensed to each other, has heteroatoms as a ring-forming atom selected from N, O, P, and S, in addition to C, and has non-aromacity in the entire molecular structure. A detailed example of the monovalent non-aromatic condensed heteropolycyclic group is a carbazolyl group. A divalent non-aromatic condensed heteropolycyclic group used herein refers to a divalent group having the same structure as the monovalent non-aromatic condensed heteropolycyclic group.

At least one of substituents of the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, the substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be selected from

a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, and $-B(Q_{16})(Q_{17})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, and $-B(Q_{26})(Q_{27})$; and

$-N(Q_{31})(Q_{32})$, $-Si(Q_{33})(Q_{34})(Q_{35})$, and $-B(Q_{36})(Q_{37})$,

wherein $Q_1$ to $Q_7$, $Q_{11}$ to $Q_{17}$, $Q_{21}$ to $Q_{27}$, and $Q_{31}$ to $Q_{37}$ may be each independently selected from a hydrogen, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that a molar equivalent of A was identical to a molar equivalent of B.

**[Example]**

**Synthesis Example 1: Synthesis of Compound EH1-401**

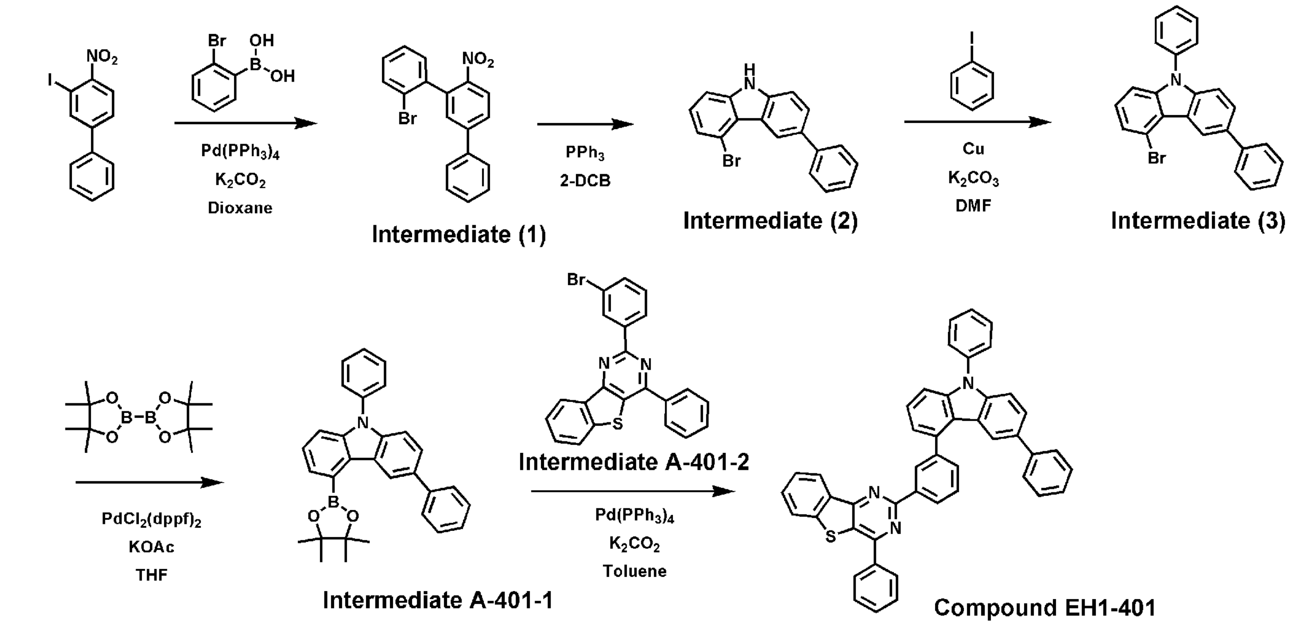


Synthesis of Intermediate (1)

20.1 g (61.8 mmol) of 3-iodo-4-nitro-1,1'-biphenyl, 18.6 g (92.7 mmol) of (2-bromophenyl)boronic acid, 2.4 g (9.2 mmol) of triphenylphosphine, 0.7 g (3.1 mmol) of Tetrakis(triphenylphosphine)palladium(0) ($Pd(PPh_3)_4$), and 17.1 g (123.7 mmol) of potassium carbonate ($K_2CO_3$) were added to a two-necked flask, and then, 800 ml of toluene and 80 ml of $H_2O$ were added thereto. The mixture was refluxed under argon atmosphere. Afterwards, the reaction solution was cooled to room temperature (about 25°C), and then, an organic layer was extracted therefrom by using ethyl acetate (EA). The organic layer was dried by using magnesium sulfate ($MgSO_4$) to remove moisture therefrom, and then, was concentrated and subjected to a column chromatography (hexane/EA = 10/1) to obtain 47 g (yield = 75 %) of Intermediate (1).
$^1$H NMR ($CDCl_3$, 300MHz) : 8.22 (d, 1 H), 7.78 (dd, 1 H), 7.70~7.64 (m, 3H), 7.56 (d, 1 H), 7.52~7.39 (m, 4H), 7.33~7.26 (m, 2H).

Synthesis of Intermediate (2)

25.8 g (72.9 mmol) of Intermediate (1) and 57.4 g (218.8 mmol) of $PPh_3$ were added to a flask, and then, 80 ml of 1,2-dichlorobenzene (DCB) was added thereto. The mixture was stirred for 12 hours at a temperature of 150°C under argon atmosphere. DCB was removed therefrom by distillation, and then, was cooled to room temperature and dissolved in a small amount of toluene. The reaction solution was refined by performing a column chromatography (hexane) to obtain 15 g (yield = 64 %) of Intermediate (2).
$^1$H NMR ($CDCl_3$, 300MHz): 8.99 (s, 1 H), 8.20 (b, 1 H), 7.75~7.72 (m, 3H), 7.51~7.46 (m, 3H), 7.43~7.27 (m, 4H).

Synthesis of Intermediate (3)

32.0 g (99.3 mmol) of Intermediate (2), 0.63 g (9.9 mmole) of Cu, and 27.1 g (198.6 mmol) of $K_2CO_3$ were added to a two-necked flask, and then, 320 ml of dimethylformamide (DMF) was added thereto. Under argon atmosphere, 22.5 ml (198.6 mmol) of iodobenzene was added to the mixture. Afterwards, the mixture was refluxed for 12 hours, and then, cooled to room temperature. An organic layer was extracted therefrom by using EA and dried by using $MgSO_4$ to remove moisture therefrom. The remaining product was concentrated and subjected to a column chromatography (hexane) to obtain 25 g (yield = 64%) of Intermediate (3) in a white solid. Intermediate (3) was identified by performing 1 H-NMR and liquid chromatography-mass spectrometry (LC/MS).
1H NMR (CDCl3, 300MHz) : 9.07 (d, 1H), 7.75~7.71 (m, 3H), 7.69~7.61 (m, 2H), 7.55~7.40 (m, 7H), 7.37~7.31 (m, 2H), 7.26~7.22 (dd, 1 H)
LC/MS, calculated : $C_{24}H_{16}BrN$ = 398.29, found: m/z = 398.1 (M+, 100 %)

Synthesis of Intermediate A-401-1

33 g (83 mmol) of Intermediate (3), 25 g (100 mmol) of 4,4,4',4',5,5,5',5'-octamethyl-2,2'-bi(1,3,2-dioxaborolane), 21 g (210 mmol) of potassium acetate (KOAc), and 3.4 g (4.2 mmol) of 1,1'-bis(diphenylphosphino)ferrocene-palladium(II)dichloride ($PdCl_2(dppf)_2$) were added to a two-necked flask, and then, 200 mL of THF was added thereto. Afterwards, the mixture was stirred for 24 hours at a temperature of 70°C. After the completion of the reaction, an organic layer was extracted from the reaction solution by using water and EA, and then, dried by using $MgSO_4$ to remove moisture therefrom. The reaction solution was refined by performing a column chromatograph (methylene chloride/n-hexane=3/2, silica gel) to obtain 26 g (yield= 60 %) of Intermediate A-401-1 in a white solid.
$^1H$ NMR ($CDCl_3$, 300MHz) : 9.52 (s, 1 H), 7.79~7.32 (m, 15H), 1.50 (s, 12H).

Synthesis of Compound EH1-401

16.0 g (36 mmol) of Intermediate A-401-1, 15.0 g (36 mmol) of Intermediate A-401-2, 12 g (89.8 mmol) of $K_2CO_3$, and 2.1 g (1.8 mmol) of $Pd(PPh_3)_4$ were added to 50 mL of toluene and 20 ml of $H_2O$, and then, the mixture was stirred for 24 hours at a temperature of 120°C. After the completion of the reaction, water was added to the reaction solution, and the reaction solution was stirred and filtered. The dark gray solid product obtained therefrom was then dissolved in hot toluene, and filtered. The toluene solution obtained therefrom was mixed with methanol to allow precipitation. After filteration, the solid product obtained therefrom was refined to 1-chlorobenzene by recrystallization, so as to obtain 14.0 g (yield= 60 %) of Compound EH1-401 in yellow crystals. The structure of Compound EH1-401 obtained therefrom was identified by performing LC/MS.
LC/MS, calculated : $C_{46}H_{29}N_3S$ = 655.21 found: m/z = 655.20 (M+, 100 %)

**Synthesis Example 2: Synthesis of Compound EH1-402**

Compound EH1-402 was synthesized in the same manner as in Synthesis of Intermediate (1) of Synthesis Example 1, except that (3-bromophenyl)boronic acid was used instead of (2-bromophenyl)boronic acid.

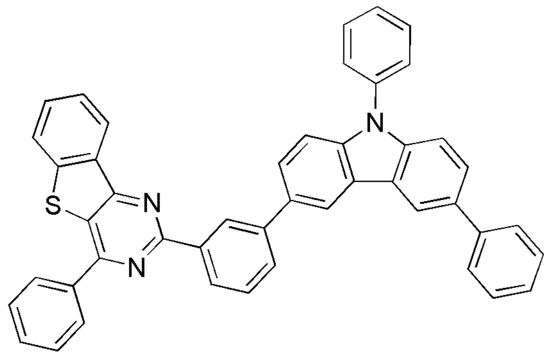

**EH1-402**

**Synthesis Example 3: Synthesis of Compound EH3-2**

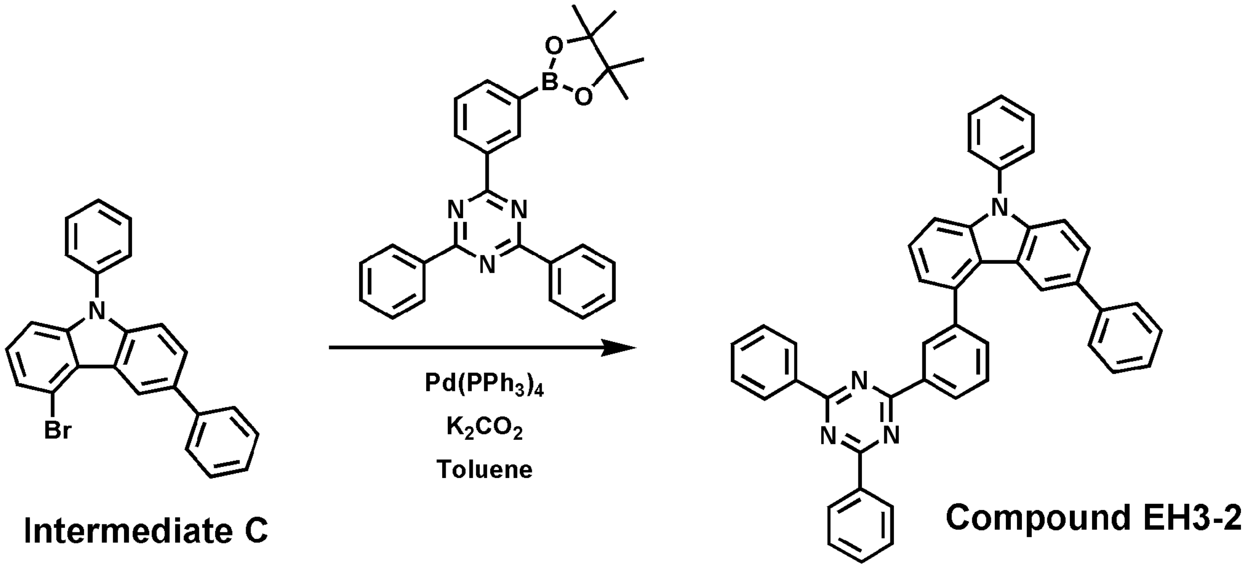


Intermediate C

Compound EH3-2

17.5 g (42 mmol) of Intermediate C, 20.0 g (46 mmol) of 2,4-diphenyl-6-(2-(4,4,5,5-tetramethyl-1,3,2-dioxaborolan-2-yl)phenyl)-1,3,5-triazine, 14 g (104 mmol) of $K_2CO_3$, and 2.4 g (2.1 mmol) of $Pd(PPh_3)_4$ were added to 80 mL of toluene, and then, the mixture was stirred for 48 hours at a temperature of 120°C. After the completion of the reaction, water was added to the reaction solution, and the reaction solution was stirred and filtered. The dark gray solid product obtained therefrom was then dissolved in hot toluene, and filtered. The toluene solution obtained therefrom was mixed with methanol to allow precipitation. After filteration, the solid product obtained therefrom was refined to 1-chlorobenzene by recrystallization, so as to obtain 18.0 g (yield= 70 %) of Compound EH3-2 in white powders. Compound EH3-2 obtained therefrom was identified by performing 1 H-NMR and LC/MS.

$^1$H NMR ($CDCl_3$, 300MHz) : 9.17 (s, 1 H), 8.92 (d, 1 H), 8.77 (dd, 4H), 7.95~7.68 (m, 7H), 7.66~7.40 (m, 14H), 7.27~7.19 (m, 3H).

LC/MS, calculated : $C_{45}H_{30}N_4$ = 626.75, found: m/z = 626.2 (M+, 100 %)

**Synthesis Example 4: Synthesis of Compound EH3-81**

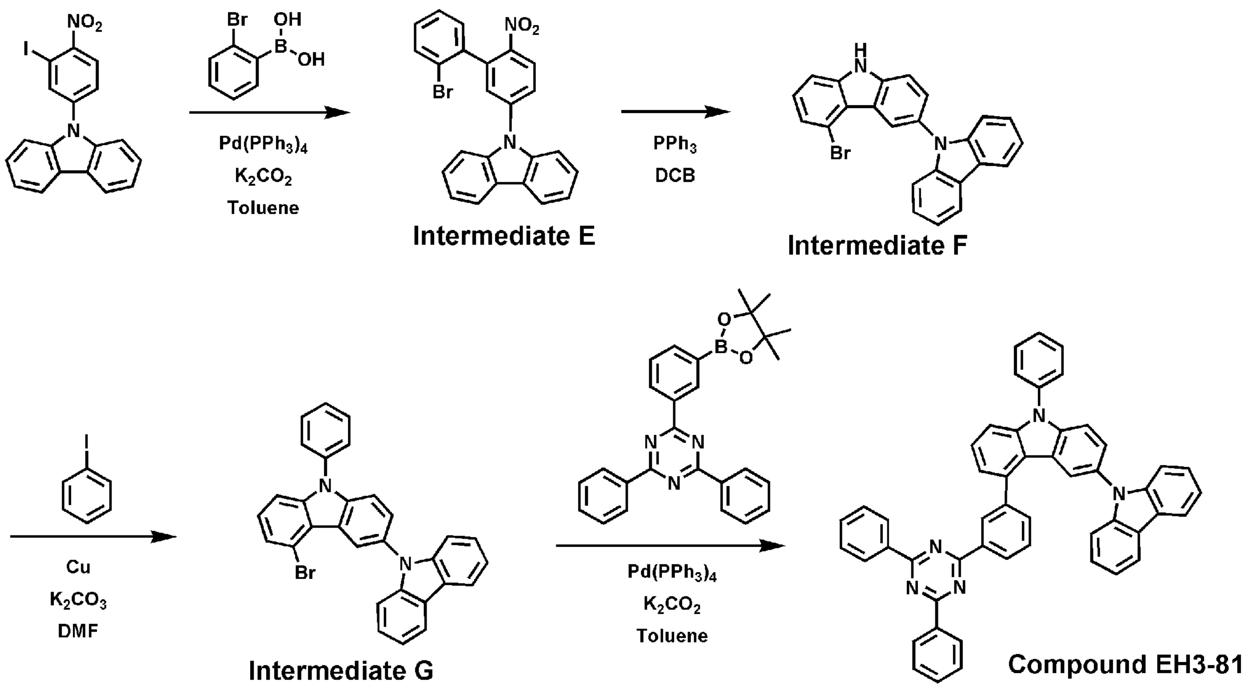


Intermediate E

Intermediate F

Intermediate G

Compound EH3-81

Synthesis of Intermediate E

Intermediate E (in a white solid, yield = 60%) was synthesized in the same manner as in Synthesis of Intermediate (1) of Synthesis Example 1, except that 9-(3-iodo-4-nitrophenyl)-9H-carbazole was used instead of 3-iodo-4-nitro-1,1'-biphenyl. Intermediate E synthesized therefrom was identified by performing LC/MS.
LC/MS, calculated : $C_{24}H_{15}N_2O_2$ = 443.29, found: m/z = 442.0 (M+, 100 %)

Synthesis of Intermediate F

Intermediate F (in a white solid, yield = 55 %) was synthesized in the same manner as in Synthesis of Intermediate (2) of Synthesis Example 1, except that Intermediate E was used instead of Intermediate (1). Intermediate F synthesized therefrom was identified by performing LC/MS.
LC/MS, calculated : $C_{24}H_{15}BrN_2$ = 411.29, found: m/z = 410.0 (M+, 100 %)

Synthesis of Intermediate G

Intermediate G (in a white solid, yield = 62 %) was synthesized in the same manner as in Synthesis of Intermediate (3) of Synthesis Example 1, except that Intermediate F was used instead of Intermediate (2). Intermediate G synthesized therefrom was identified by performing LC/MS.
LC/MS, calculated : $C_{30}H_{19}BrN_2$ = 487.39 found: m/z = 486.0 (M+, 100 %)

Synthesis of Compound EH3-81

Compound EH3-81 (in a white solid, yield = 68 %) was synthesized in the same manner as in Synthesis of Compound EH3-2 of Synthesis Example 3, except that Intermediate G was used instead of Intermediate C, and then, the solid product obtained therefrom was refined to N-methyl-2-pyrrolidone (NMP). Compound EH3-81 obtained therefrom was identified by performing LC/MS.
LC/MS, calculated : $C_{51}H_{33}N_5$ = 715.84, found: m/z = 715.2 (M+, 100 %)

**Synthesis Example 5: Synthesis of Compound EH3-91**

Compound EH3-9 was synthesized in the same manner as in Synthesis Example 3, except that 2,4-diphenyl-6-(2-(4,4,5,5-tetramethyl-1,3,2-dioxaborolan-2-yl)-3-methyl-phenyl)-1,3,5-triazi ne was used instead of 12,4-diphenyl-6-(2-(4,4,5,5-tetramethyl-1,3,2-dioxaborolan-2-yl)phenyl)-1,3,5-triazine.

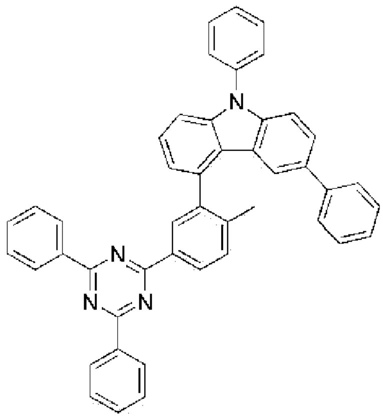

**EH3-91**

**Synthesis Example 6: Synthesis of Compound HH1-1**

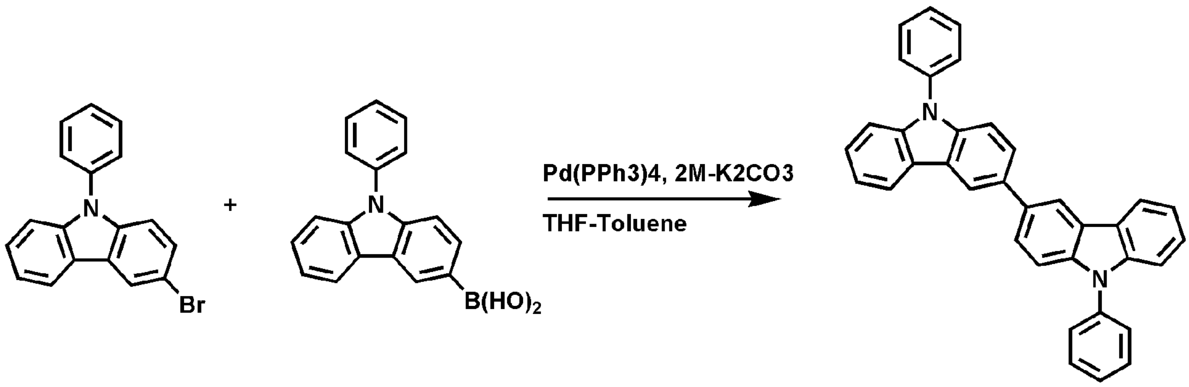


Compound HH1-1

In a 500 mL, round-bottom flask equipped with a stirring device, 16.62 g (51.59 mmol) of 3-bromo-N-phenylcarbazole, 17.77 g (61.91 mmol) of N-phenylcarbazole-3-ylboronic acid, 200 mL of tetrahydrofuran:toluene (1:1), and 100 mL of 2M-potassium carbonate solution were mixed under nitrogen atmosphere, and then, 2.98 g (2.58 mmol) of tetrakis triphenylphosphine palladium(0) was added thereto. The mixture was heated under reflux for 12 hours under the nitrogen stream. After the completion of the reaction, the reaction solution was added to methanol and solid products were filtered therefrom. The resulting solid products obtained therefrom were sufficiently washed with water and methanol, dried, and dissolved by heating in 1 L of chlorobenzene. The resulting solution was subjected to silica gel to perform filteration. After the solvent was completely removed therefrom, the remaining product was dissolved by heating in 500 mL of toluene, and then, was refined by recrystallization, so as to obtain 16.05 g (yield = 64%) of Compound HH1-1. calculated. $C_{36}H_{24}N_2$: C, 89.23; H, 4.99; N, 5.78; found: C, 89.45; H, 4.89; N, 5.65

**Synthesis Example 7: Synthesis of Compound HH1-2**

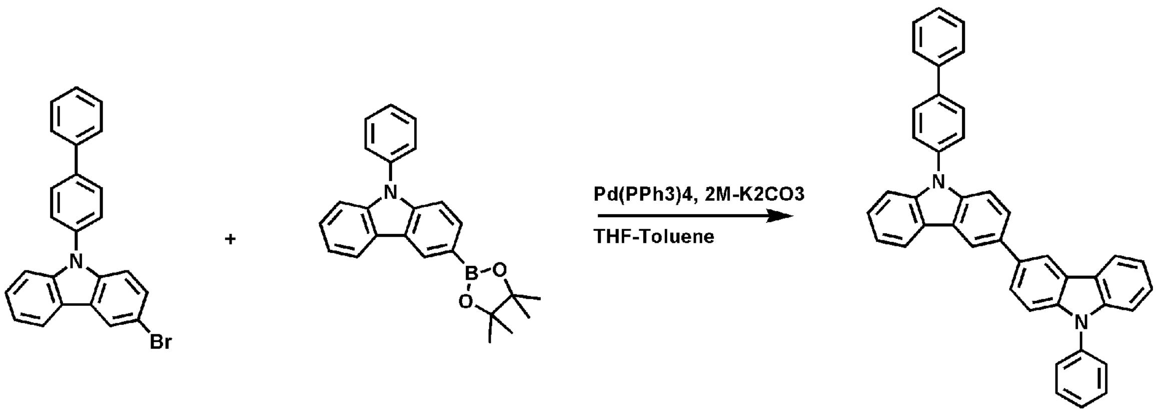


Compound HH1-2

In a 500 mL, round-bottom flask equipped with a stirring device, 20.00 g (50.21 mmol) of 3-bromo-N-biphenylcarbazole, 18.54 g (50.21 mmol) of N-phenylcarbazole-3-boronic ester, 175 mL of tetrahydrofuran:toluene (1:1), and 75 mL of 2M-potassium carbonate solution were mixed under nitrogen atmosphere, and then, 2.90 g (2.51 mmol) of tetrakistri phenylphosphine palladium(0) was added thereto. The mixture was heated under reflux for 12 hours under the nitrogen stream. After the completion of the reaction, the reaction solution was added to methanol and solid products were filtered therefrom. The resulting solid products obtained therefrom were sufficiently washed with water and methanol, dried, and dissolved by heating in 700 mL of chlorobenzene. The resulting solution was subjected to silica gel to perform filteration. After the solvent was completely removed therefrom, the remaining product was dissolved by heating in 400 mL of chlorobenzene, and then, was refined by recrystallization, so as to obtain 9.15 g (yield = 68%) of Compound HH1-2 1. calcd. $C_{42}H_{28}N_2$: C, 89.97; H, 5.03; N, 5.00; found: C, 89.53; H, 4.92; N, 4.89

**Synthesis Example 8: Synthesis of Compound HH1-3**

Compound HH1-3 was synthesized in the same manner as in Synthesis Example 7, except that 3-bromo-N-metabiphenylcarbazole was used instead of 3-bromo-N-biphenylcarbazole.

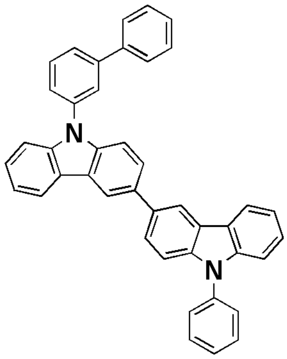

HH1-3

**Synthesis Example 9: Synthesis of Compound HH1-7**

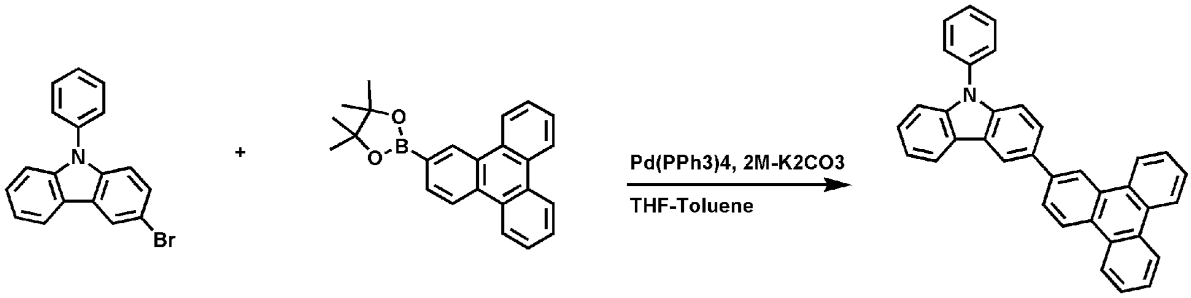


Compound HH1-7

In a 500 mL, round-bottom flask equipped with a stirring device, 10.00 g (31.04 mmol) of 3-bromo-N-phenylcarbazole, 10.99 g (31.04 mmol) of 2-triphenylene boronic ester, 150 mL of tetrahydrofuran:toluene (1:1), and 75 mL of 2M-potassium carbonate solution were mixed under nitrogen atmosphere, and then, 1.79 g (1.55mmol) of tetrakistri phenylphosphine palladium(0) was added thereto. The mixture was heated under reflux for 12 hours under the nitrogen stream. After the completion of the reaction, the reaction solution was added to methanol and solid products were filtered therefrom. The resulting solid products obtained therefrom were sufficiently washed with water and methanol, dried, and dissolved by heating in 400 mL of chlorobenzene. The resulting solution was subjected to silica gel to perform filteration. After the solvent was completely removed therefrom, the remaining product was dissolved by heating in 300 mL of toluene, and then, was refined by recrystallization, so as to obtain 8.74 g (yield = 60%) of Compound HH1-7.
calculated: $C_{36}H_{23}N$: C, 92.08; H, 4.94; N, 2.98; found: C, 92.43; H, 4.63; N, 2.84

**Evaluation Example 1 : Evaluation of photoluminescence (PL) spectrum**

A quartz substrate, which was washed with chloroform and pure water, was prepared, and then, each of predetermined compounds shown in Table 1 below was formed thereon by vacuum deposition at a vacuum pressure of $10^{-7}$ torr. Accordingly, Films B, D, F, BD, and BF were formed, each of which films had a thickness of 40 nm (400 Å).

[Table 1]

| Film No. | Compound in a film |
|---|---|
| Film B | Compound HH1-2 |

(continued)

| Film No. | Compound in a film |
|---|---|
| Film D | Compound EH1-401 |
| Film F | Compound EH3-81 |
| Film BD | Compound EH1-401 : Compound HH1-2 (at a molar ratio of 7:3) |
| Film BF | Compound EH3-81 : Compound HH1-2 (at a molar ratio of 5:5) |

Next, an ISC PC1 spectrofluorometer equipped with an xenon lamp was used to evaluate photoluminecscence (PL) spectrum of each of Films B, D, F, BD, and BF above. The results are shown in FIGS. 2A and 2B.

In FIG. 2A, it was confirmed that the PL spectrum of Film BD was shifted in the long wavelength direction as compared with the PL spectra of Films B and D. In FIG. 2B, it was confirmed that the PL spectrum of Film BF was shifted in the long wavelength direction as compared with the PL spectra of Films B and F. That is, it was confirmed that any combination of the compounds used to form Films BD and BF was capable of forming an exciplex.

**<u>Example : Manufacture of organic light-emitting device (OLED)</u>**

A glass substrate on which an ITO electrode was formed as an anode was cut into a size of 50 mm x 50 mm x 0.5 mm, sonicated by using acetone isopropyl alcohol and pure water each for 15 minutes, and cleaned by the exposure to UV ozone for 30 minutes.

Compound HT3 and TCNPQ (a concentration of TCNPQ was 3 wt%) were co-deposited on the anode to form a hole injection layer having a thickness of 10 nm (100 Å). Compound HT3 was deposited on the hole injection layer to form a hole transport layer having a thickness of 170 nm (1,700 Å).

An electron-transporting host, a hole-transporting host, and Compound PD79 (having a concentration of 10 wt% based on 100 wt% of an emission layer) were co-deposited on the hole transport layer to form an emission layer having a thickness of 40 nm (400 Å).

Compound ET16 and LiQ were co-deposited on the emission layer at a weight ratio of 5:5 to form an electron transport layer having a thickness of 36 nm (360 Å). Then, LiQ was deposited on the electron transport layer to form an electron injection layer having a thickness of 0.5 nm (5 Å). A MgAg electrode (in which an amount of Ag was 10 wt%) was deposited on the electron injection layer to a thickness of 12 nm (120 Å). Compound HT13, above, was deposited on the MgAg electrode to form a capping layer having a thickness of 60 nm (600 Å), thereby completing the manufacture of an organic light-emitting device (OLED). The electron-transporting host, the hole-transporting host, and the volume ratio of the electron-transporting host to the hole-transporting host used in the manufacture of each of OLEDs 1 to 7 and A to C are as shown in Tables 2 and 3 below. In Tables 2 and 3, values of Euqations 1 to 7 were evaluated based on each of the HOMO, LUMO and S1 energy levels evaluated by using a density functional theory ("DFT") method of Gaussian program (structurally optimized at a level of B3LYP, 6-31G(d,p)).

[Table 2]

| OLED No. | Electron-transporting host | Holetransporting host | Volume ratio[1] | LUMO (eV) Of electron-transporting host (absolute value) | LUMO (eV) Of hole-transpo ting host (absolute value) | Value of Equation 1 | Value of Equation 6 | Value of Equation 7 | Value of Equation 2 |
|---|---|---|---|---|---|---|---|---|---|
| 1 | Compound EH1-401 | Compound HH1-2 | 5:5 | 1.786 | 0.989 | 0.797 | 0.20 | 0.00 | 0.07 |
| 2 | Compound EH1-401 | Compound HH1-2 | 6:4 | 1.786 | 0.989 | 0.797 | 0.20 | 0.00 | 0.07 |
| 3 | Compound EH1-402 | Compound HH1-2 | 6:4 | 1.775 | 0.989 | 0.786 | 0.20 | 0.00 | 0.08 |
| 4 | Compound EH3-2 | Compound HH1-2 | 4:6 | 1.800 | 0.989 | 0.811 | 0.21 | 0.00 | 0.06 |
| 5 | Compound EH3-2 | Compound HH1-3 | 4:6 | 1.800 | 0.964 | 0.836 | 0.21 | 0.01 | 0.14 |
| 6 | Compound EH3-81 | Compound HH1-2 | 4:6 | 1.809 | 0.989 | 0.820 | 0.20 | 0.00 | 0.06 |
| 7 | Compound EH3-81 | Compound HH1-2 | 5:5 | 1.809 | 0.989 | 0.820 | 0.20 | 0.00 | 0.06 |
| A | Compound A | Compound HH1-1 | 5:5 | 1.816 | 0.690 | 1.126 | 0.05 | 0.06 | 0.27 |
| B | Compound B | Compound HH1-2 | 4:6 | 1.730 | 0.989 | 0.741 | n/a | n/a | n/a |
| C | TATC | B3PYMPM | 5:5 | 2.151 | 0.985 | 1.116 | 0.22 | 0.00 | 0.20 |

1: A volume ratio of the electron-transporting host: the hole-transporting host.

<Equation 1> $0.75eV \leq |LUMO_{H(ET)} - LUMO_{H(HT)}| \leq 0.90eV$

<Equation 6> $\min\{E(S_{1,H(HT)}), E(S_{1,H(ET)})\}-E(S_{1,EX}) > 0.15eV$

<Equation 7> $E(S_{1,EX}) - E(T_{1,EX}) < 0.15eV$

<Equation 2> $|E(S_{1, H(ET)}) - E(S_{1, H(HT)})| < 0.15eV$

[Table 3]

| OLED No. | Electron-transporting host | Hole-transporting host | Volume ratio[2] | Value of Equation 3 | Value of Equation 4 | Value of Equation 5 |
|---|---|---|---|---|---|---|
| 1 | Compound EH1-401 | Compound HH1-2 | 5:5 | 0.285 | 0.170 | 0.136 |
| 2 | Compound EH1-401 | Compound HH1-2 | 6:4 | 0.285 | 0.170 | 0.136 |
| 3 | Compound EH1-402 | Compound HH1-2 | 6:4 | 0.285 | 0.194 | 0.125 |
| 4 | Compound EH3-2 | Compound HH1-2 | 4:6 | 0.285 | 0.250 | 0.150 |
| 5 | Compound EH3-2 | Compound HH1-3 | 4:6 | 0.282 | 0.253 | 0.150 |
| 6 | Compound EH3-81 | Compound HH1-2 | 4:6 | 0.285 | 0.177 | 0.159 |
| 7 | Compound EH3-81 | Compound HH1-2 | 5:5 | 0.285 | 0.177 | 0.159 |

2: A volume ratio of the electron-transporting host: the hole-transporting host.

<Equation 3> $|HOMO_{H(HT)} - HOMO_{HTL}| < 0.3eV$

<Equation 4> $0.15eV \leq |HOMO_{H(HT)} - HOMO_{H(ET)}| \leq 2.0eV$

<Equation 5> $|LUMO_{H(ET)} - LUMO_{ETL}| < 0.2eV$

<Compound A>

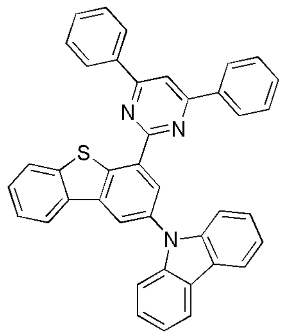

<Compound B>

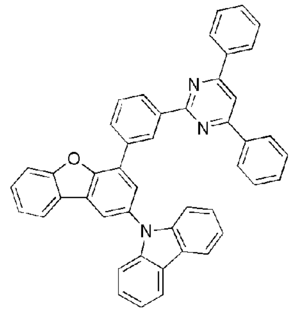

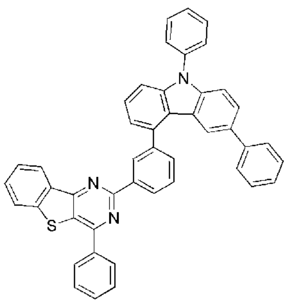

EH1-401

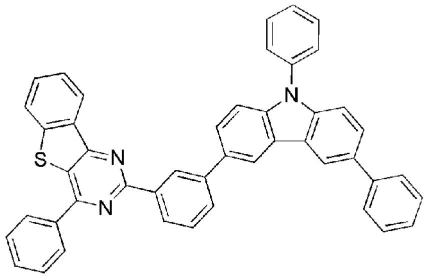

EH1-402

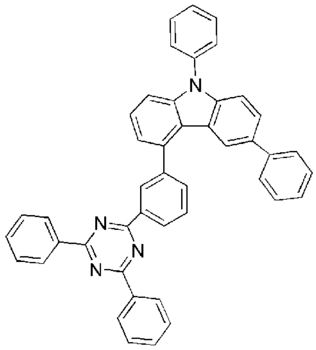

EH3-2

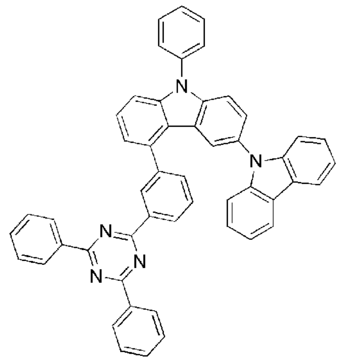

EH3-81

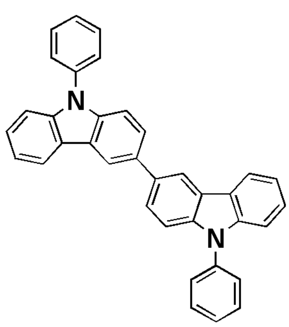

HH1-1

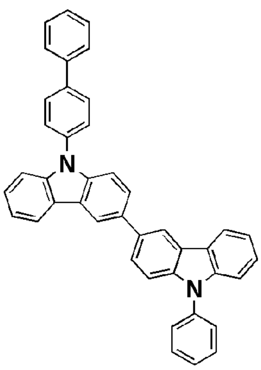

HH1-2

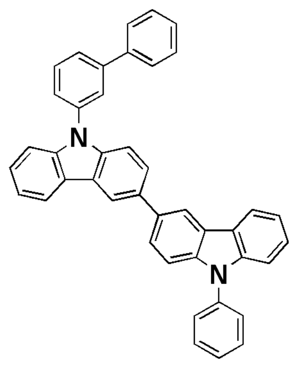

HH1-3

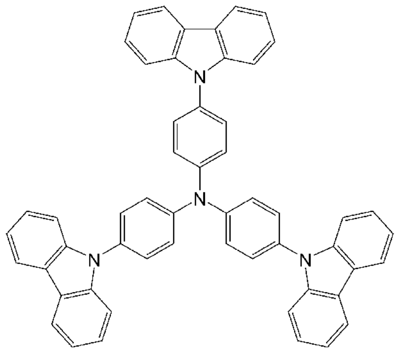

TCTA

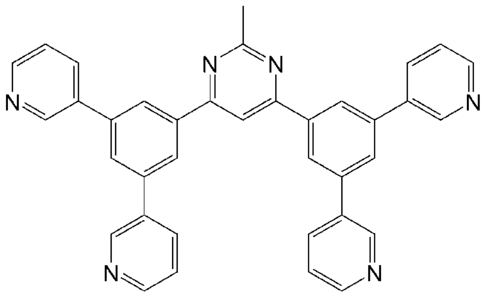

B3PYMPM

**Evaluation Example 2**

The OLEDs 1 to 7 and A to C were evaluated in terms of lifespan ($T_{95}$) characteristics, and the OLEDs 1, 2, 6, and 7 were evaluated by using a current-voltage meter (Keithley 2400) and a brightness photometer (Minolta Cs-1000A) in terms of driving voltage, brightness, power efficiency, color purity, roll off ratios, and life span ($T_{95}$) characteristics. The results are shown in Tables 4 and 5 below. Referring to the tables, $T_{95}$ (at 9,000 nit) refers to lifespan data in view of times taken to reach 95% of brightness if the initial brightness was considered as 100%. The roll off ratios was calculated according to <Equation 20> below:

<Equation 20>

Roll off = {1- (efficiency (at 9,000 nit) / maximum efficiency in light emissioni)} X 100%

[Table 4]

| OLED No. | Electron-transporting host | Hole-transporting host | Volume ratio | Lifespan ($T_{95}$) (hr) |
|---|---|---|---|---|
| 1 | Compound EH1-401 | Compound HH1-2 | 5:5 | 531 |
| 2 | Compound EH1-401 | Compound HH1-2 | 6:4 | 473 |
| 3 | Compound EH1-402 | Compound HH1-2 | 6:4 | 800 |
| 4 | Compound EH3-2 | Compound HH1-2 | 4:6 | 750 |
| 5 | Compound EH3-2 | Compound HH1-3 | 4:6 | 655 |
| 6 | Compound EH3-81 | Compound HH1-2 | 4:6 | 453 |
| 7 | Compound EH3-81 | Compound HH1-2 | 5:5 | 440 |
| A | Compound A | Compound HH1-1 | 5:5 | 200 |
| B | Compound B | Compound HH1-2 | 4:6 | 70 |
| C | TATC | B3PYMPM | 5:5 | 50 |

[Table 5]

| OLED No. | Electron-transporting host | Hole-transporting host | Volume ratio | Driving voltage (V) | Brightness (cd/A) | Current efficiency (lm/W) | CIE_x | CIE_y | Roll off ratio (%) | Lifespan ($L_{95}$) (hr) |
|---|---|---|---|---|---|---|---|---|---|---|
| 1 | Compound EH1-40 1 | Compound HH1-2 | 5:5 | 4.8 | 88.7 | 57.9 | 0.279 | 0.687 | 14 | 531 |
| 2 | Compound EH1-40 1 | Compound HH1-2 | 6:4 | 4.7 | 86.6 | 57.6 | 0.259 | 0.699 | 17 | 473 |
| 6 | Compound EH3-81 | Compound HH1-2 | 4:6 | 4.7 | 88.2 | 59.3 | 0.239 | 0.712 | 13 | 453 |
| 7 | Compound EH3-81 | Compound HH1-2 | 5:5 | 4.6 | 93.1 | 64.1 | 0.232 | 0.717 | 14 | 440 |

Referring to Tables 4 and 5, it was confirmed that the OLEDs 1 to 7 satisfying both <Equation 1> and <Equation 2> provided in the present inventive concept had excellent lifespan as compared with the OLEDs A to C not satisfying at least one of <Equation 1 > and <Equation 2> provided in the present inventive concept.

## Evaluation Example 5

Hole-only devices (HODs) 11 to 18 having a structure of ITO (150 nm or 1,500 Å) / Compound HT3:TCNPQ (in a concentration of 3 wt%) (10 nm or 100 Å) / Compound HT3 (100 nm or 1,000 Å) host:Compound PD79 (10 wt%) (60 nm or 600 Å) / Compound ET1 (10 nm or 100 Å) / Al (10 nm or 100 Å), electron-only devices (EODs) 11 to 18 having a structure of ITO (150 nm or 1,500 Å) / Mg:Ag (10 wt%) (30 nm or 300 Å) / Liq (1 nm or 10 Å) / Compound ET16:Liq (50 wt%) (20 nm or 200 Å) / host:Compound PD79 (10 wt%) (60 nm or 600 Å) / Compound ET16:Liq (50 wt%) (20 nm or 200 Å) / Liq (1 nm or 10 Å) / Mg:Ag (10 wt%) (30 nm or 300 Å), and OLEDs 11 to 18 (wherein OLEDs 14 and 15 were the same as the OLEDs 1 and 2, respectively) having a structure of ITO (150 nm or 1,500 Å ) / Compound HT3:TCNPQ (3 wt%) (10 nm or 100 Å) / Compound HT3 (170 nm or 1,700 Å) host:Compound PD79 (10 wt%) (40 nm or 400 Å) / Compound ET16:Liq (50 wt%) (36 nm or 360 Å) / Liq (0.5 nm or 5 Å) / Mg:Ag (10 wt%) (12 nm or 120 Å) / HT13 (60 nm or 600 Å) were each manufactured by referring to Examples described above. The host compositions of the HODs 11 to 18, the EODs 11 to 18, and the OLEDs 11 to 18 were shown in Table 6 below.

Next, $J_{HOD}$s referring to current density values (mA/cm$^2$) of the HODs 11 to 18 at a voltage of 11.5 V and $J_{EOD}$s referring to current density values (mA/cm$^2$) of the EODs 11 to 18 at a voltage of 4 V were each evaluated by using a current-voltage meter (Keithley 2400), and then, calculated by log($J_{HOD}$ (at 11.5 V) / $J_{EOD}$ (at 4 V)). The results are shown in Table 6 below. In addition, the lifespan ($L_{95}$) characteristics of the OLEDs 11 to 18 was evaluated and shown in Table 6 below.

[Table 6]

| HOD, EOD, and OLED No. | Electron-transporting host | Hole-transporting host | Volume ratio of electron-transporting host to hole-transporting host | $J_{HOD}$ (at 11.5 V) ($mA/cm^2$) | $J_{EOD}$ (at 4 V) $mA/cm^2$) | log($J_{HOD}$ (at 11.5 V) / $J_{EOD}$ (at 4 V)) (i.e., Type(Compound EH1-401) | Lifespan ($T_{95}$) (hr) |
|---|---|---|---|---|---|---|---|
| 11 | Compound EH1-401 | Compound HH1-2 | 2:8 | 60 | 1 | 1.78 | 92 |
| 12 | Compound EH1-401 | Compound HH1-2 | 3:7 | 46.6 | 2.42 | 1.28 | 291 |
| 13 | Compound EH1-401 | Compound HH1-2 | 4:6 | 38 | 10 | 0.58 | 437 |
| 14 | Compound EH1-401 | Compound HH1-2 | 5:5 | 32.6 | 19 | 0.23 | 531 |
| 15 | Compound EH1-401 | Compound HH1-2 | 6:4 | 25 | 31 | -0.09 | 473 |
| 16 | Compound EH1-401 | Compound HH1-2 | 7:3 | 18.7 | 47.1 | -0.4 | 353 |
| 17 | Compound EH1-401 | Compound HH1-2 | 8:2 | 10 | 60 | -0.78 | 273 |
| 18 | Compound EH1-401 | Compound HH1-2 | 10:0 | 2.43 | 79.5 | -1.51 | 90 |

Referring to Table 6, it was confirmed that the OLEDs 13 to 15 including Type(Compound EH1-401) in a range of -0.09 to 0.58 had excellent lifespan characteristics.

**Evaluation Example 6**

Hole-only devices (HODs) 21 to 28 having a structure of ITO (150 nm or 1,500 Å) / Compound HT3:TCNPQ (in a concentration of 3 wt%) (10 nm or 100 Å) / Compound HT3 (100 nm or 1,000 Å) host:Compound PD79 (in a concentration of 10 wt%) (60 nm or 600 Å) / Compound ET1 (10 nm or 100 Å) / Al (10 nm or 100 Å), electron-only devices (EODs) 21 to 28 having a structure of ITO (150 nm or 1,500 Å) / Mg:Ag (10 wt%) (30 nm or 300 Å) / Liq (1 nm or 10 Å) / Compound ET16:Liq (50 wt%) (20 nm or 200 Å) / host:Compound PD79 (10 wt%) (60 nm or 600 Å) / Compound ET16:Liq (50 wt%) (20 nm or 200Å) / Liq (1 nm or 10 Å) / Mg:Ag (10 wt%) (30 nm or 300 Å), and OLEDs 21 to 28 (wherein OLEDs 23 and 24 were the same as the OLEDs 6 and 7) having a structure of ITO (150 nm or 1,500 Å) / Compound HT3:TCNPQ(3 wt%) (10 nm or 100 Å) / Compound HT3 (170 nm or 1,700 Å) host:Compound PD79(10 wt%) (40 nm or 400 Å) / Compound ET16:Liq (50 wt%) (36 nm or 360 Å) / Liq (0.5 nm or 5 Å) / Mg:Ag (10 wt%) (12 nm or 120 Å) / HT13 (60 nm or 600 Å) were each manufactured by referring to Examples described above. The host compositions of the HODs 21 to 28, the EODs 21 to 28, and the OLEDs 21 to 28 were shown in Table 7 below.

Next, $J_{HOD}$s referring to current density values (mA/cm$^2$) of the HODs 21 to 28 at a voltage of 11.5 V and $J_{EOD}$s referring to current density values (mA/cm$^2$) of the EODs 21 to 28 at a voltage of 4 V were each evaluated by using a current-voltage meter (Keithley 2400), and then, calculated by log($J_{HOD}$ (at 11.5 V) / $J_{EOD}$ (at 4 V)). The results are shown in Table 7 below. In addition, the lifespan ($L_{95}$) characteristics of the OLEDs 21 to 28 was evaluated and shown in Table 7 below.

[Table 7]

| HOD, EOD, and OLED No. | Electron-transporting host | Hole-transporting host | Volume ratio of electron-transporting host to hole-transporting host | $J_{HOD}$ (at 11.5 V) (mA/cm$^2$) | $J_{EOD}$ (at 4 V) mA/cm$^2$) | log($J_{HOD}$ (at 11.5 V)/ $J_{EOD}$ (at 4 V)) (i.e., Type(Compound EH1-401) | Lifespan ($T_{95}$) (hr) |
|---|---|---|---|---|---|---|---|
| 21 | Compound EH3-81 | Compound HH1-2 | 2:8 | 90 | 0.2 | 2.65 | 80 |
| 22 | Compound EH3-81 | Compound HH1-2 | 3:7 | 50 | 0.8 | 1.80 | 281 |
| 23 | Compound EH3-81 | Compound HH1-2 | 4:6 | 28 | 2 | 1.15 | 453 |
| 24 | Compound EH3-81 | Compound HH1-2 | 5:5 | 12 | 7 | 0.23 | 440 |
| 25 | Compound EH3-81 | Compound HH1-2 | 6:4 | 5 | 20 | -0.60 | 284 |
| 26 | Compound EH3-81 | Compound HH1-2 | 7:3 | 2 | 39 | -1.30 | 145 |
| 27 | Compound EH3-81 | Compound HH1-2 | 8:2 | 1 | 61 | -1.79 | 80 |
| 28 | Compound EH3-81 | Compound HH1-2 | 10:0 | 0.5 | 90 | -2.26 | 41 |

Referring to Table 7, it was confirmed that OLEDs 23 and 24 including Type (Compound EH3-81) in a range of 0.23 to 1.15 had excellent lifespan characteristics.

As described above, according to the one or more of the above exemplary embodiments, an organic light-emitting device is characterized by low driving voltage, high efficiency, high brightness, and long lifespan.

It should be understood that the exemplary embodiments described therein should be considered in a descriptive sense only and not for purposes of limitation. Descriptions of features or aspects within each exemplary embodiment should typically be considered as available for other similar features or aspects in other exemplary embodiments.

While one or more exemplary embodiments have been described with reference to the figures, it will be understood by those of ordinary skill in the art that various changes in form and details may be made therein without departing from the scope as defined by the following claims.

**Claims**

1. An organic light-emitting device (OLED), comprising
a first electrode;
a second electrode;
an emission layer disposed between the first electrode and the second electrode; a hole transport region disposed between the first electrode and the emission layer and comprising a hole transport layer; and
an electron transport region disposed between the emission layer and the second electrode and comprising an electron transport layer,
wherein the emission layer comprises an electron-transporting host and a hole-transporting host,
the hole transport layer comprises a hole transport material,
the electron transport layer comprises an electron transport material, and
the OLED satisfies Equations 1 and 2 below:

<Equation 1>

$$0.75eV \leq | LUMO_{H(ET)} - LUMO_{H(HT)} | \leq 0.90eV$$

<Equation 2>

$$| E(S_{1,\ H(ET)}) - E(S_{1,\ H(HT)}) | < 0.15eV$$

wherein in Equations 1 and 2,

$LUMO_{H(ET)}$ refers to a lowest unoccupied molecular orbital (LUMO) energy level of the electron-transporting host,
$LUMO_{H(HT)}$ refers to an LUMO energy level of the hole-transporting host,
$E(S_{1,\ H(ET)})$ refers to a singlet energy level of the electron-transporting host, and
$E(S_{1,\ H(HT)})$ refers to a singlet energy level of the hole-transporting host.

2. The OLED of claim 1, wherein the OLED satisfies Equations 3 and 4 below:

<Equation 3>

$$| HOMO_{H(HT)} - HOMO_{HTL} | < 0.3eV$$

<Equation 4>

$$0.15eV \leq | HOMO_{H(HT)} - HOMO_{H(ET)} | \leq 2.0eV$$

wherein in Equations 3 and 4,

$HOMO_{H(HT)}$ refers to a highest occupied molecular orbital of the hole-transporting host,

$HOMO_{HTL}$ refers to an HOMO energy level of the hole transport material, and $HOMO_{H(ET)}$ refers to an HOMO energy level of the electron-transporting host; and/or wherein the OLED satisfies Equation 5 below:

<Equation 5>

$$|LUMO_{H(ET)} - LUMO_{ETL}| < 0.2eV$$

wherein in Equation 5, $LUMO_{ETL}$ refers to an LUMO energy level of the electron transport material.

**3.** The OLED of claim 1 or 2, wherein the OLED satisfies Equations 6 and 7 below:

<Equation 6>

$$\min\{E(S_{1,H(HT)}), E(S_{1,H(ET)})\}-E(S_{1,EX}) > 0.15eV$$

<Equation 7>

$$E(S_{1,EX}) - E(T_{1,EX}) < 0.15eV$$

wherein in Equations 6 and 7,

$E(S_{1,H(HT)})$ refers to a singlet energy level of the hole-transporting host,
$E(S_{1,H(ET)})$ refers to a singlet energy level of the electron-transporting host,
$\min\{E(S_{1,H(HT)}), E(S_{1,H(ET)})\}$ refers to the smallest value of $E(S_{1,H(HT)})$ and $E(S_{1,H(ET)})$,
$E(S_{1,EX})$ refers to a singlet energy level of an exciplex formed by the hole-transporting host and the electron-transporting host, and
$E(T_{1,EX})$ refers to a triplet energy level of the exciplex formed by the electron-transporting host and the hole-transporting host.

**4.** The OLED of any of claims 1-3, wherein the electron-transporting host comprises a compound represented by Formula 1 below:

<Formula 1>

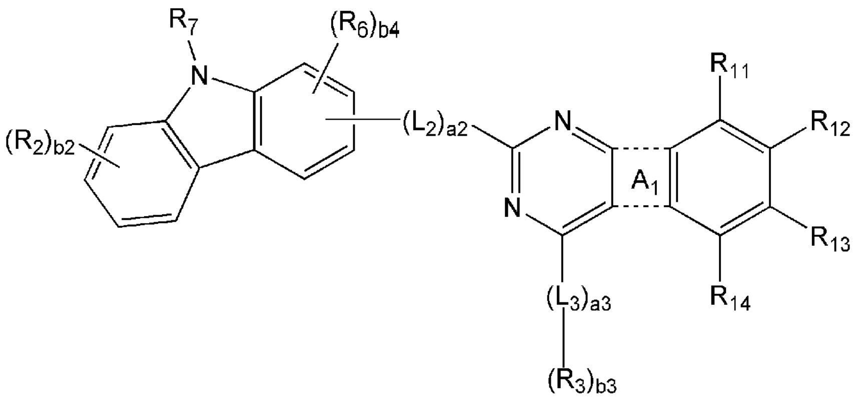

<Formula 1A>

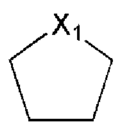

wherein a ring $A_1$ in Formula 1 is represented by Formula 1A above;

$X_1$ in Formula 1A is N-[$(L_1)_{a1}$-$(R_1)_{b1}$], S, O, S(=O), $S(=O)_2$, C(=O), $Si(R_4)(R_5)$, $P(R_4)$, $P(=O)(R_4)$, or $C=N(R_4)$;
$L_1$ to $L_3$ in Formula 1 are each independently selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group;
a1 to a3 in Formula 1 are each independently an integer of 1 to 5, when a1 is 2 or more, 2 or more $L_1$s are identical to or different from each other, when a2 is 2 or more, 2 or more $L_2$s are identical to or different from each other, and when a3 is 2 or more, 2 or more $L_3$s are identical to or different from each other;
$R_1$ to $R_7$ and $R_{11}$ to $R_{14}$ in Formula 1 are each independently selected from a hydrogen, a deuterium, a fluoro group (-F), a chloro group (-Cl), a bromo group (-Br), an iodo group (-I), a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, and $-B(Q_6)(Q_7)$;
b1 to b4 in Formula 1 are each independently an integer of 1 to 3; and
at least one of substituents of the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, the substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group are selected from
a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, and $-B(Q_{16})(Q_{17})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$

cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, and $-B(Q_{26})(Q_{27})$; and

$-N(Q_{31})(Q_{32})$, $-Si(Q_{33})(Q_{34})(Q_{35})$, and $-B(Q_{36})(Q_{37})$,

wherein $Q_1$ to $Q_7$, $Q_{11}$ to $Q_{17}$, $Q_{21}$ to $Q_{27}$, and $Q_{31}$ to $Q_{37}$ are each independently selected from a hydrogen, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

5. The OLED of claim 4, wherein $L_1$ to $L_3$ in Formula 1 are each independently a condensed cyclic compound selected from groups represented by Formulae 2-1 to 2-17 below:

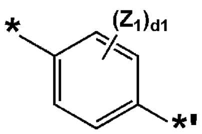
Formula 2-1

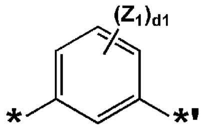
Formula 2-2

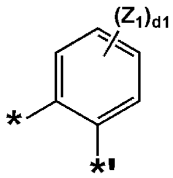
Formula 2-3

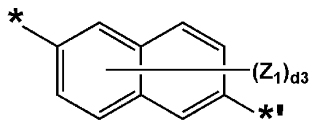
Formula 2-4

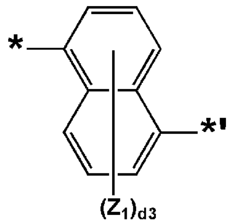
Formula 2-5

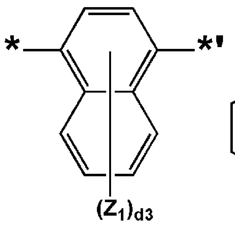
Formula 2-6

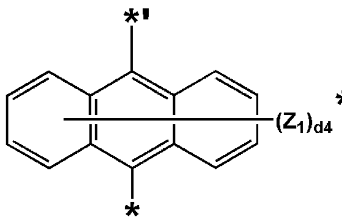
Formula 2-7

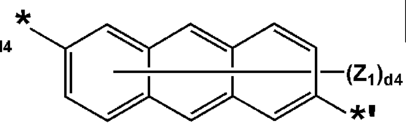
Formula 2-8

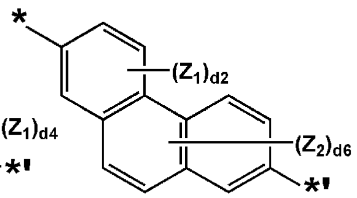
Formula 2-9

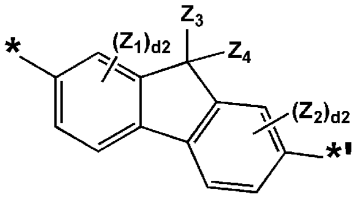
Formula 2-10

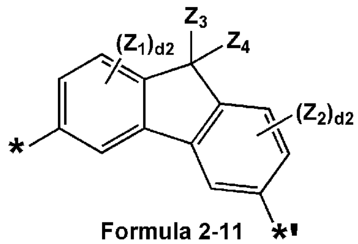
Formula 2-11

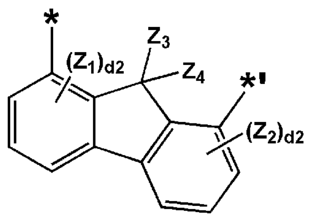
Formula 2-12

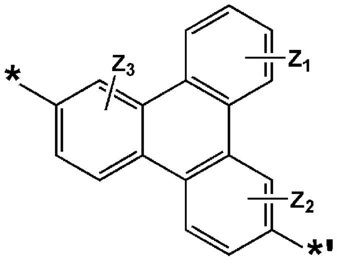
Formula 2-13

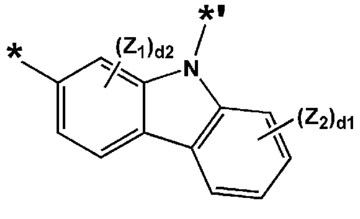
Formula 2-14

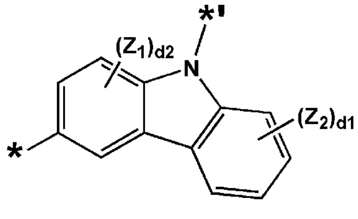
Formula 2-15

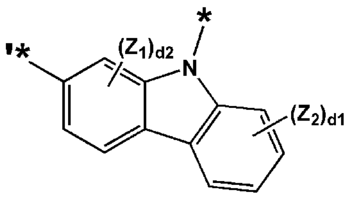

Formula 2-16

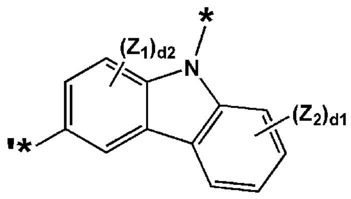

Formula 2-17

wherein in Formulae 2-1 to 2-17,

$Z_1$ to $Z_4$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a triphenylenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, a quinoxalinyl group, a biphenyl group, and -Si($Q_{33}$)($Q_{34}$)($Q_{35}$), wherein $Q_{33}$ to $Q_{35}$ are each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group; and

d1 is an integer of 1 to 4, d2 is an integer of 1 to 3, d3 is an integer of 1 to 6, d4 is an integer of 1 to 8, and d6 is an integer of 1 to 5, and * and *' each indicate a binding site to a neighboring atom.

**6.** The OLED of claim 4, wherein i) at least one of $R_2$ and $R_3$ and ii) $R_1$ and $R_7$ are each independently selected from:

a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl

group, and an imidazopyrimidinyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, -Si($Q_{33}$)($Q_{34}$)($Q_{35}$), a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, and a biphenyl group.

**7.** The OLED of claim 4, wherein $R_1$ to $R_7$ are each independently selected from:

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
one of groups represented by Formulae 4-1 to 4-31 below; and
-Si($Q_3$)($Q_4$)($Q_5$), (but $R_4$ to $R_5$ are not -Si($Q_3$)($Q_4$)($Q_5$)), and
wherein i) at least one of $R_2$ and $R_3$ and ii) $R_1$ and $R_7$ are each independently represented by one of Formulae 4-1 to 4-31 below:

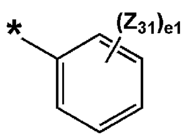
Formula 4-1

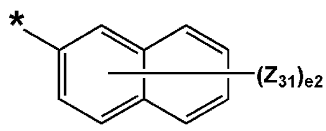
Formula 4-2

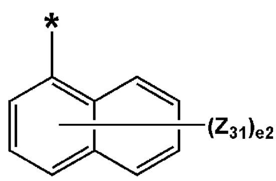
Formula 4-3

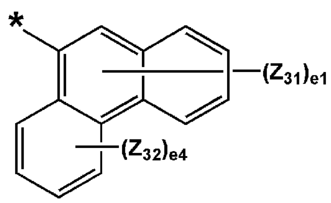
Formula 4-4

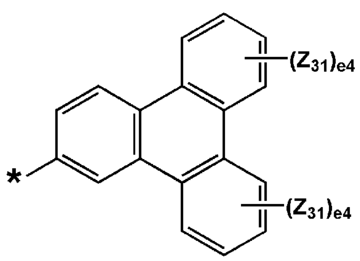
Formula 4-5

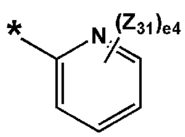
Formula 4-6

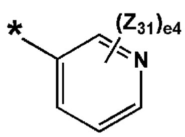
Formula 4-7

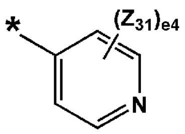
Formula 4-8

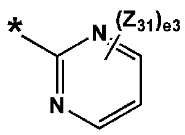
Formula 4-9

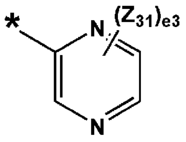
Formula 4-10

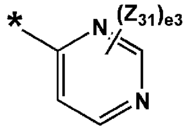
Formula 4-11

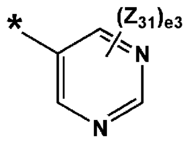
Formula 4-12

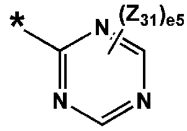
Formula 4-13

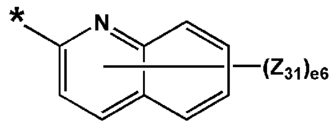
Formula 4-14

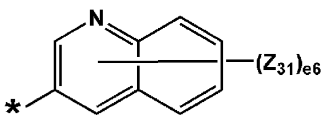
Formula 4-15

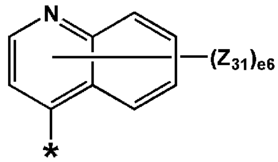
Formula 4-16

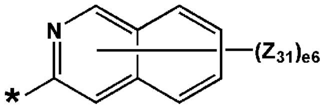
Formula 4-17

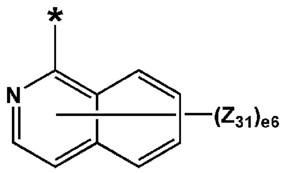
Formula 4-18

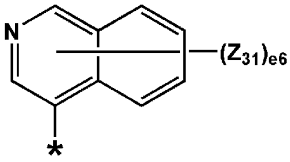
Formula 4-19

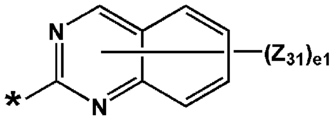
Formula 4-20

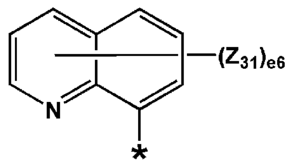
Formula 4-21

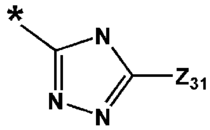
Formula 4-22

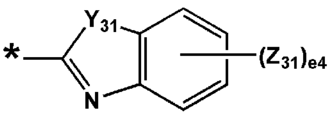
Formula 4-23

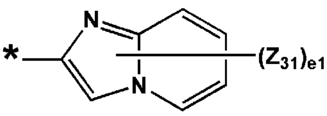
Formula 4-24

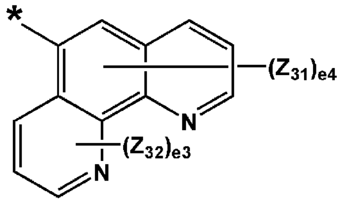
Formula 4-25

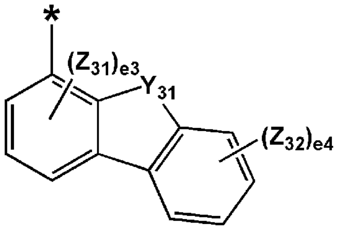
Formula 4-26

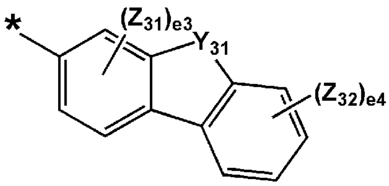
Formula 4-27

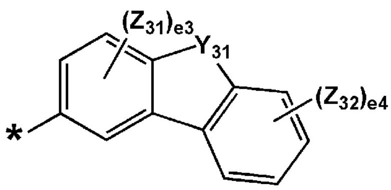
Formula 4-28

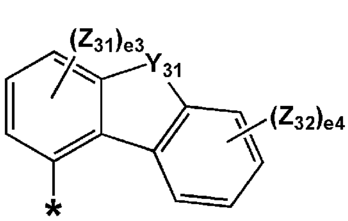
Formula 4-29

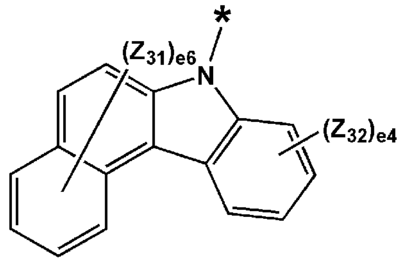
Formula 4-30

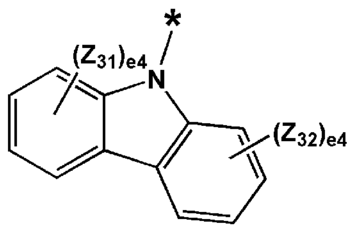
Formula 4-31

wherein in Formulae 4-1 to 4-31,
$Y_{31}$ is O, S, $C(Z_{33})(Z_{34})$, $N(Z_{35})$, or $Si(Z_{36})(Z_{37})$ (provided that, $Y_{31}$ in Formula 4-23 is not NH);
$Z_{31}$ to $Z_{37}$ are each independently selected from a hydrogen, a deuterium, -F, -Cl, -Br, -I, a hydroxyl group, a

cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, a quinoxalinyl group, a biphenyl group, and -Si($Q_{33}$)($Q_{34}$)($Q_{35}$), wherein $Q_3$ to $Q_5$ and $Q_{33}$ to $Q_{35}$ are each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a fluorenyl group, a chrysenyl group, a carbazolyl group, a benzocarbazolyl group, a dibenzocarbazolyl group, a dibenzofuranyl group, a dibenzothiophenyl group, a pyridinyl group, a pyrimidinyl group, a triazinyl group, a quinolinyl group, an isoquinolinyl group, a quinazolinyl group, and a quinoxalinyl group; and

e1 is an integer of 1 to 5 e2 is an integer of 1 to 7, e3 is an integer of 1 to 3, e4 is an integer of 1 to 4, e5 is an integer of 1 or 2, and e6 is an integer of 1 to 6, and * is a binding site to a neighboring atom.

**8.** The OLED of any of claims 1-7, wherein the electron-transporting host comprises at least one of Compounds EH1-401 to EH1-415and EH2-1 to EH2-30 below:

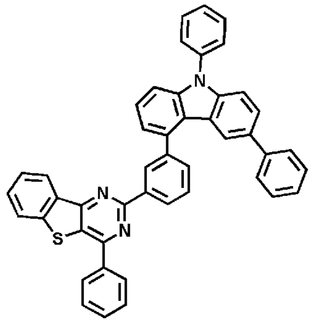

**EH1-401**

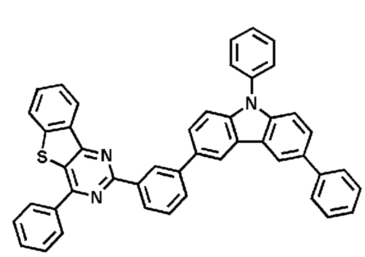

**EH1-402**

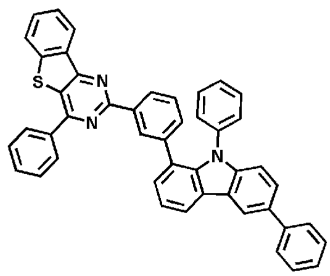

**EH1-403**

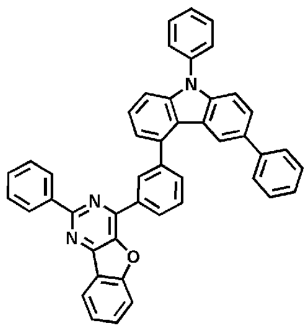

**EH1-404**

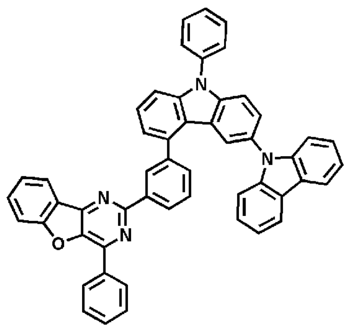

**EH1-405**

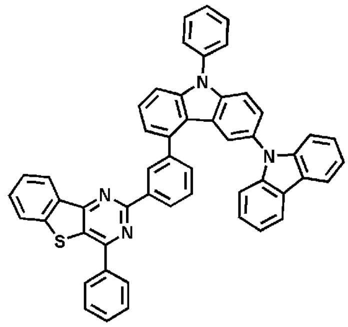

**EH1-406**

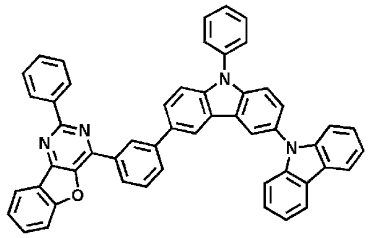

**EH1-407**

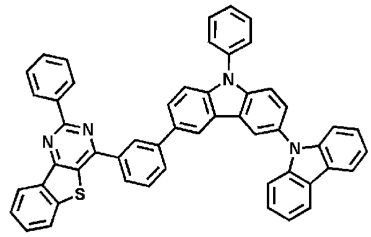

**EH1-408**

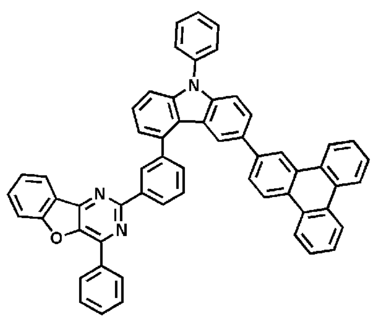

**EH1-409**

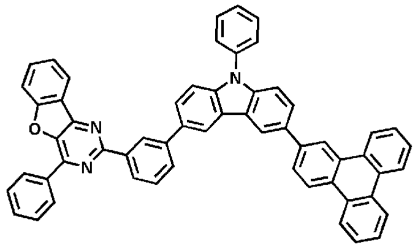

**EH1-410**

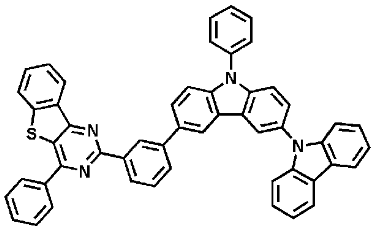

**EH1-411**

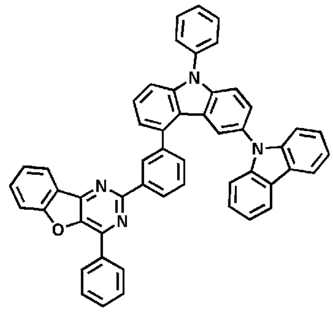

**EH1-412**

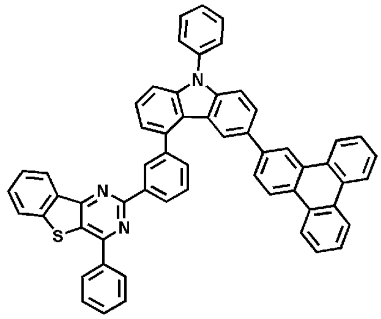

**EH1-413**

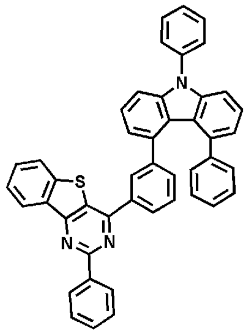

**EH1-414**

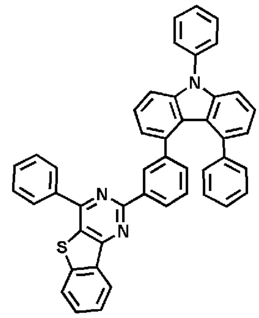

**EH1-415**

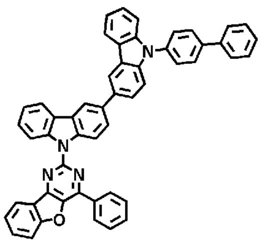

**EH2-1**

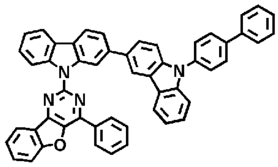

**EH2-2**

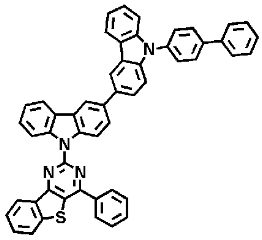

**EH2-3**

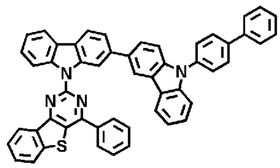

**EH2-4**

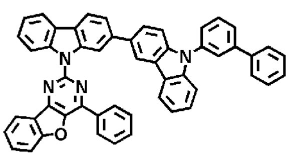

**EH2-5**

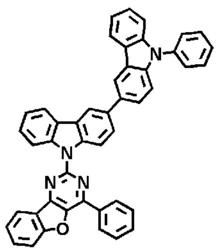

**EH2-6**

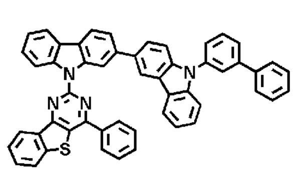

**EH2-7**

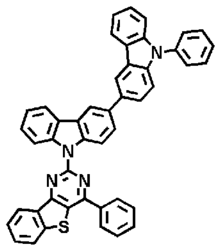

**EH2-8**

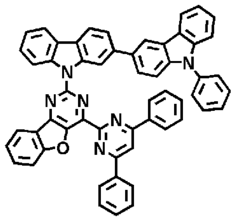

EH2-9

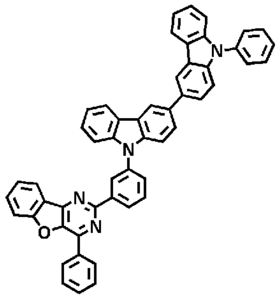

EH2-10

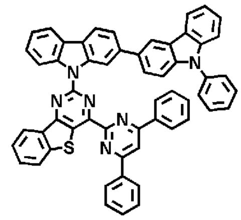

EH2-11

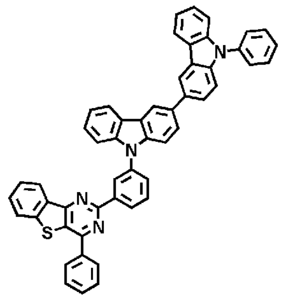

EH2-12

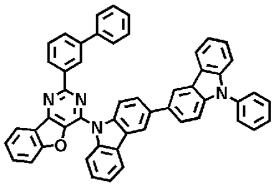

EH2-13

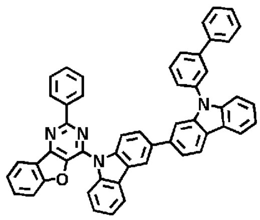

EH2-14

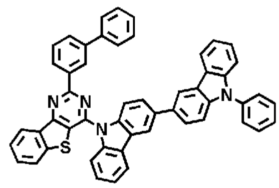

EH2-15

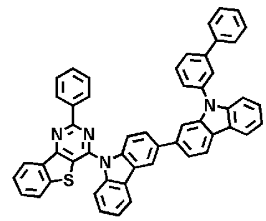

EH2-16

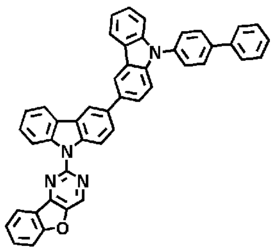

EH2-17

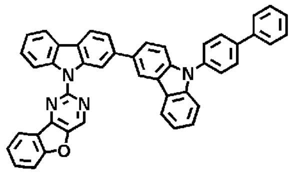

EH2-18

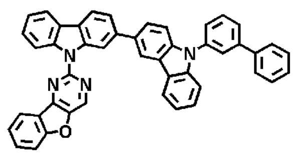

EH2-19

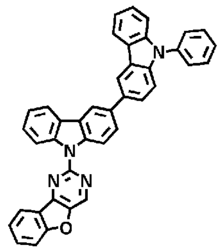

EH2-20

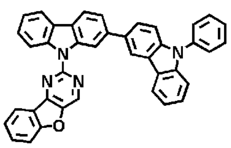

EH2-21

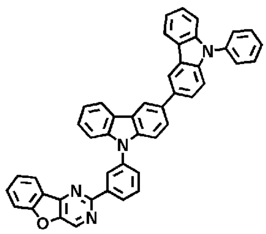

EH2-22

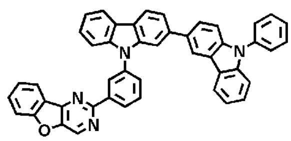

EH2-23

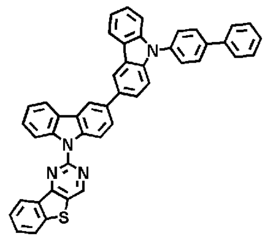

EH2-24

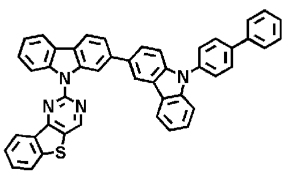

EH2-25

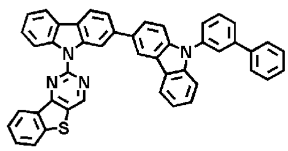

EH2-26

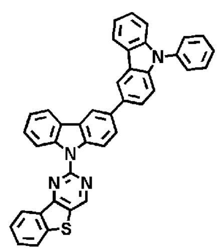

EH2-27

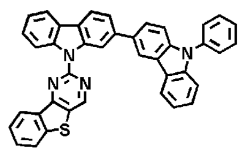

EH2-28

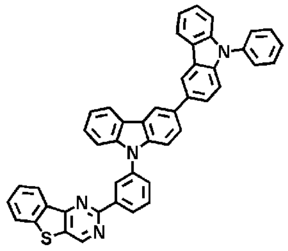

EH2-29

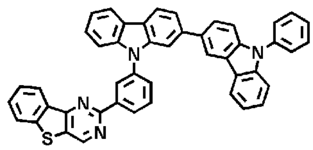

EH2-30

**9.** The OLED of any of claims 1-7, wherein the electron-transporting host comprises a compound represented by Formula 10 below:

<Formula 10>

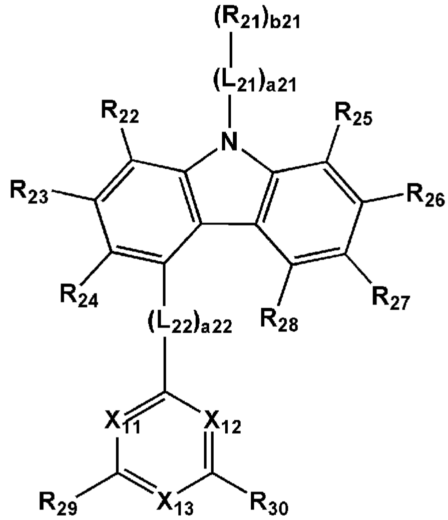

wherein in Formula 10,

$L_{21}$ and $L_{22}$ are each independently selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group;

a21 and a22 are each independently an integer of 0 to 3;

$X_{11}$ is N or C($R_{51}$), $X_{12}$ is N or C($R_{52}$), $X_{13}$ is N or C($R_{53}$), and at least two of $X_{11}$ to $X_{13}$ are N,

$R_{21}$ to $R_{30}$ and $R_{51}$ to $R_{53}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, and -Si($Q_{41}$)($Q_{42}$)($Q_{43}$);

b21 and b22 are each independently an integer of 1 to 5;

at least one of $R_{25}$ to $R_{28}$ is selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a

substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group; and

at least one of substituents of the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, the substituted divalent non-aromatic condensed heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is selected from:

a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and $C_1$-$C_{60}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{51}$)($Q_{52}$)($Q_{53}$), and -B($Q_{54}$)($Q_{55}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{61}$)($Q_{62}$)($Q_{63}$), and -B($Q_{64}$)($Q_{65}$); and

-Si($Q_{71}$)($Q_{72}$)($Q_{73}$), and -B($Q_{74}$)($Q_{75}$),

wherein $Q_{41}$ to $Q_{43}$, $Q_{51}$ to $Q_{55}$, $Q_{61}$ to $Q_{65}$, and $Q_{71}$ to $Q_{75}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, preferably wherein:

$L_{21}$ and $L_{22}$ in Formula 10 are each independently selected from:

a phenylene group, a naphthylene group, a phenalenylene group, a phenanthrenylene group, a triphenylenylene group, an anthracenylene group, a pyrrolylene group, a pyridinylene group, a pyrazinylene group, a pyrimidinylene group, a pyridazinylene group, an isoindolylene group, an indolylene group, a furanylene group, a benzofuranylene group, a thiophenylene group, a benzothiophenylene group, and

a triazinylene group;

a phenylene group, a naphthylene group, a phenalenylene group, a phenanthrenylene group, a triphenylenylene group, an anthracenylene group, a pyrrolylene group, a pyridinylene group, a pyrazinylene group, a pyrimidinylene group, a pyridazinylene group, an isoindolylene group, an indolylene group, a furanylene group, a benzofuranylene group, a thiophenylene group, a benzothiophenylene group, and a triazinylene group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a triphenylenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group; and

groups represented by Formulae 11-1 to 11-6 below:

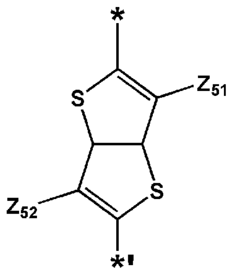
Formula 11-1

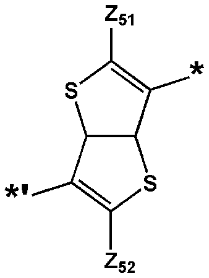
Formula 11-2

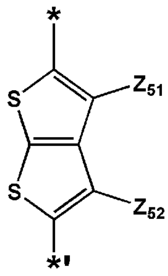
Formula 11-3

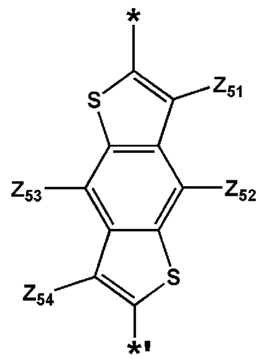
Formula 11-4

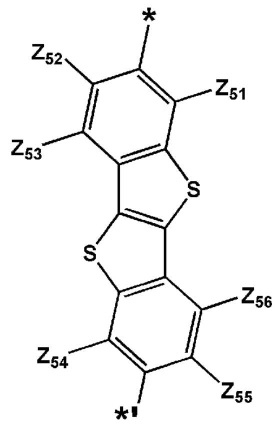
Formula 11-5

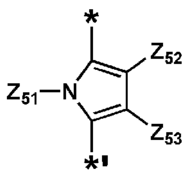
Formula 11-6

wherein in Formulae 11-1 to 11-6,

$Z_{51}$ to $Z_{56}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyrenyl group, a phenanthrenyl group, a triphenylenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group, and

* indicates a binding site to a neighboring atom; and/or

$R_{21}$ is selected from groups represented by Formulae 15-1 to 15-40 and -Si($Q_{41}$)($Q_{42}$)($Q_{43}$) (wherein $Q_{41}$ to $Q_{43}$ are each independently selected from a hydrogen, a $C_1$-$C_{20}$ alkyl group, a $C_1$-$C_{20}$ alkoxy group, a phenyl group, a naphthyl group, an anthracenyl group, a pyrenyl group, a phenanthrenyl group, a triphenylenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group);

$R_{22}$ to $R_{24}$ are each independently selected from a hydrogen, a deuterium, -F, -Cl, -Br, -I, a hydroxyl

group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;

$R_{25}$ to $R_{30}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, and groups represented by Formulae 15-1 to 15-40 below;

at least one of $R_{25}$ to $R_{28}$ is selected from groups represented by Formulae 15-1 to 15-40 below; and at least one of $R_{29}$ and $R_{30}$ is selected from groups represented by Formulae 15-1 to 15-40 below:

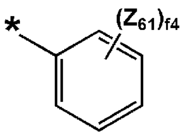
Formula 15-1

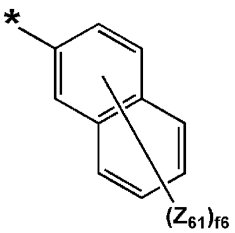
Formula 15-2

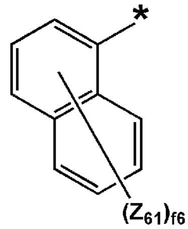
Formula 15-3

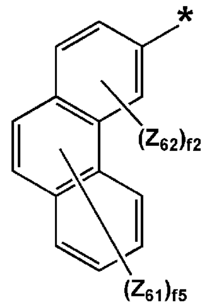
Formula 15-4

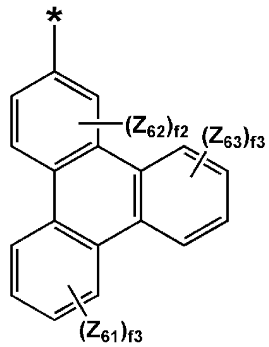
Formula 15-5

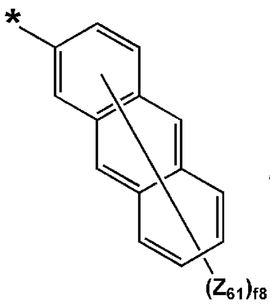
Formula 15-6

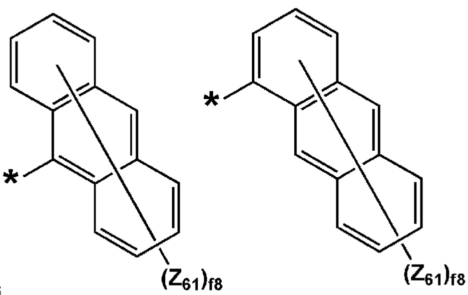
Formula 15-7

Formula 15-8

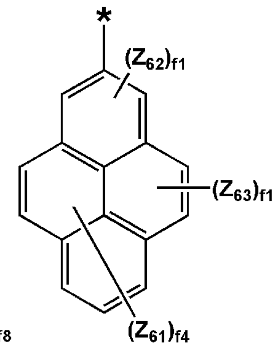
Formula 15-9

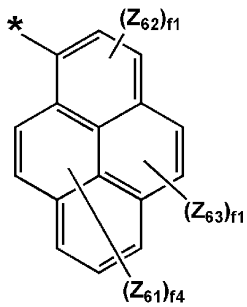
Formula 15-10

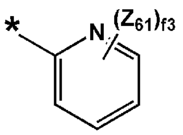
Formula 15-11

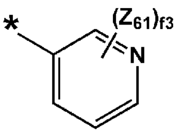
Formula 15-12

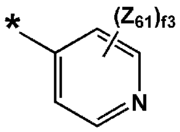
Formula 15-13

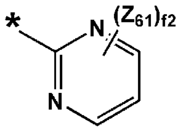
Formula 15-14

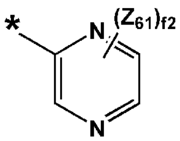
Formula 15-15

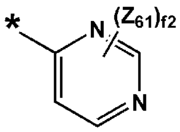
Formula 15-16

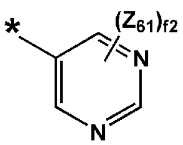
Formula 15-17

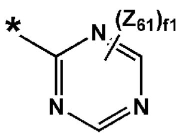
Formula 15-18

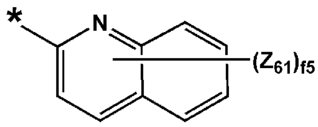
Formula 15-19

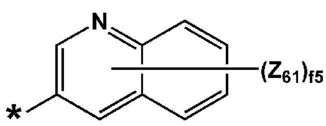
Formula 15-20

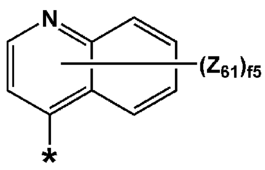

Formula 15-21

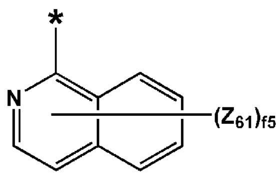

Formula 15-22

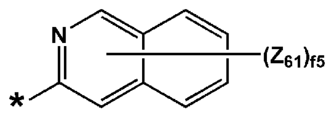

Formula 15-23

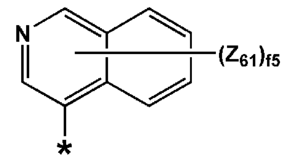

Formula 15-24

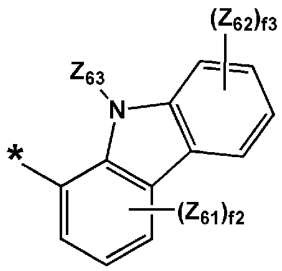

Formula 15-25

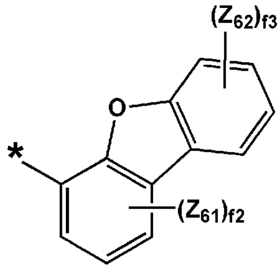

Formula 15-26

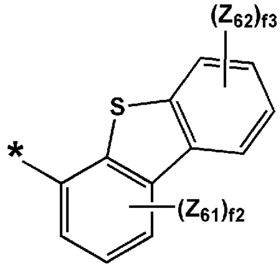

Formula 15-27

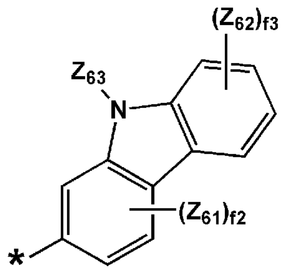

Formula 15-28

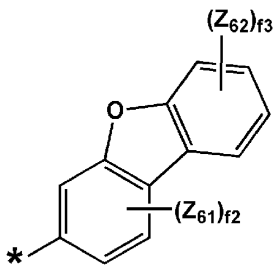

Formula 15-29

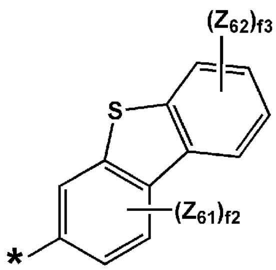

Formula 15-30

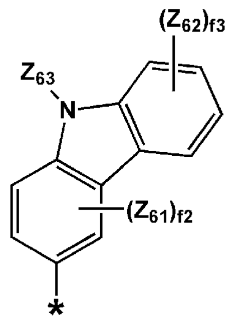

Formula 15-31

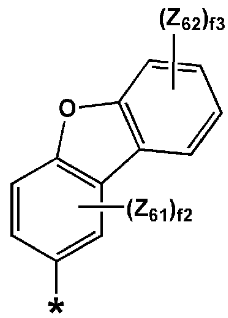

Formula 15-32

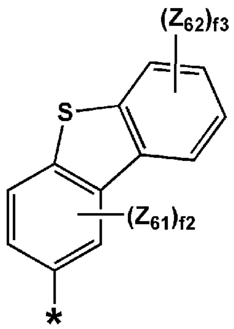

Formula 15-33

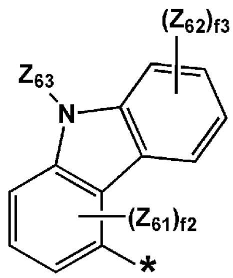

Formula 15-34

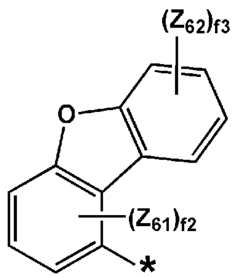

Formula 15-35

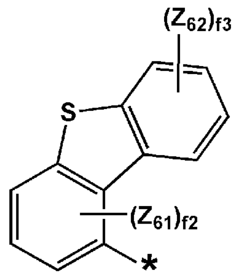

Formula15-36

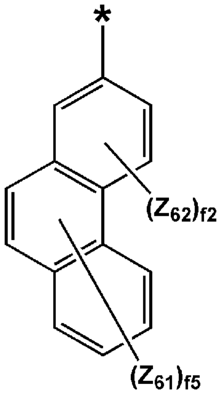
Formula 15-37

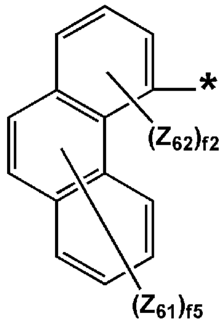
Formula 15-38

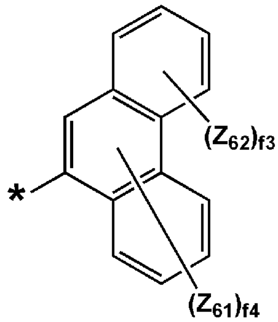
Formula 15-39

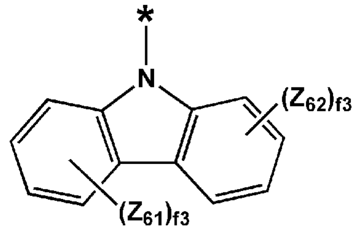
Formula 15-40

wherein in Formulae 15-1 to 15-40,

$Z_{61}$ to $Z_{63}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_2$-$C_{20}$ alkynyl group, a $C_1$-$C_{20}$ alkoxy group, a phenyl group, a naphthyl group, an anthracenyl group, a pyrenyl group, a phenanthrenyl group, a fluorenyl group, a carbazolyl group, a benzocarbazolyl group, a dibenzocarbazolyl group, a pyridinyl group, a pyrimidinyl group, a pyrazinyl group, a pyridazinyl group, a triazinyl group, a quinolinyl group, an isoquinolinyl group, a phthalazinyl group, a quinoxalinyl group, a cinnolinyl group, and a quinazolinyl group;

f1 is 1 or 2, f2 is an integer of 1 to 3, f3 is an integer of 1 to 4, f4 is an integer of 1 to 5, f5 is an integer of 1 to 6, f6 is an integer of 1 to 7, f7 is an integer of 1 to 8, and f8 is an integer of 1 to 9; and

* indicates a binding site to a neighboring atom.

**10.** The OLED of claim 9, wherein $L_{21}$ and $L_{22}$ are each independently selected from groups represented by Formulae 12-1 to 12-15 below;

$X_{11}$ to $X_{13}$ are N;

a21 and a22 are each independently 0 or 1;

$R_{22}$ to $R_{26}$ and $R_{28}$ are a hydrogen;

$R_{27}$, $R_{29}$, and $R_{30}$ are each independently selected from groups represented by Formulae 15-1 to 15-40 above:

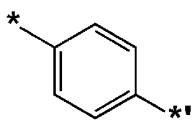
Formula 12-1

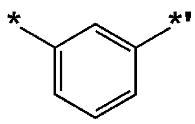
Formula 12-2

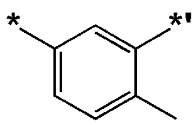
Formula 12-3

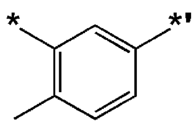
Formula 12-4

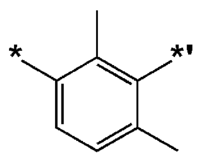
Formula 12-5

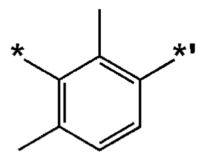
Formula 12-6

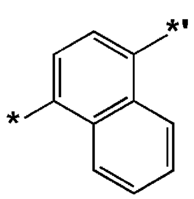
Formula 12-7

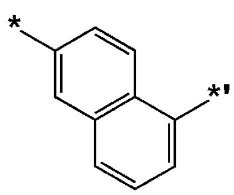
Formula 12-8

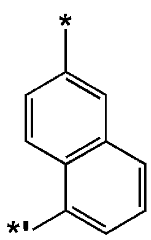
Formula 12-9

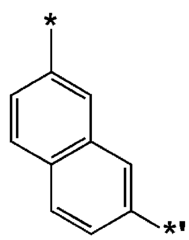
Formula 12-10

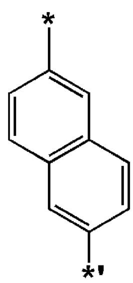
Formula 12-11

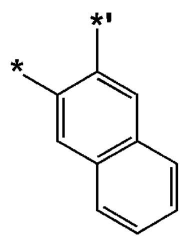
Formula 12-12

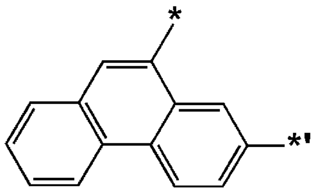

Formula 12-13

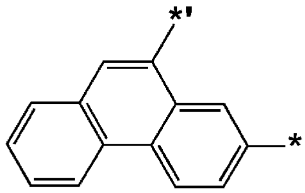

Formula 12-14

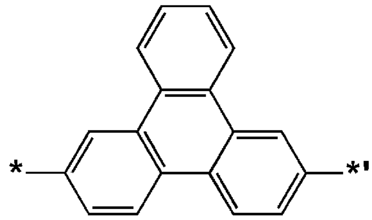

Formula 12-15

wherein in Formulae 12-1 to 12-15, * and *' are each independently indicate a binding site to a neighboring atom.

**11.** The OLED of any of claims 1-7, wherein the electron-transporting host comprises at least one of Compounds EH3-1 to EH3-102 below:

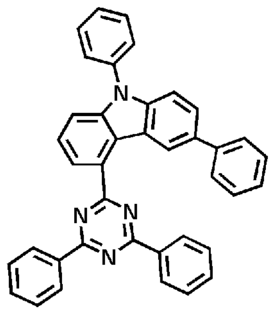

EH3-1

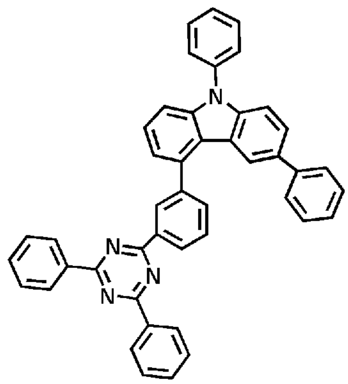

EH3-2

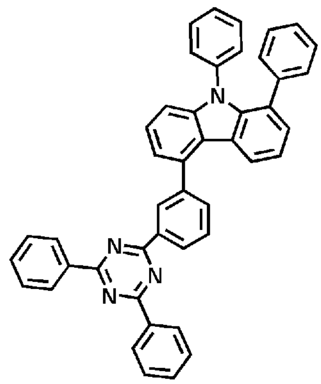

EH3-3

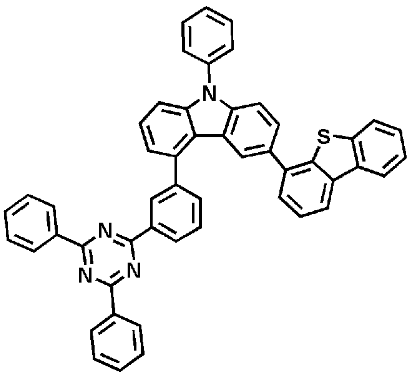

EH3-4

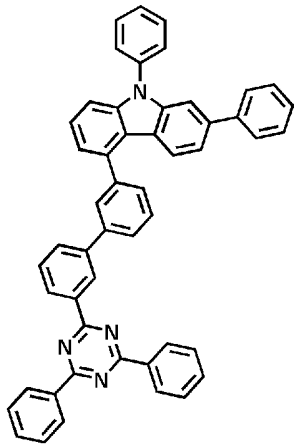

EH3-5

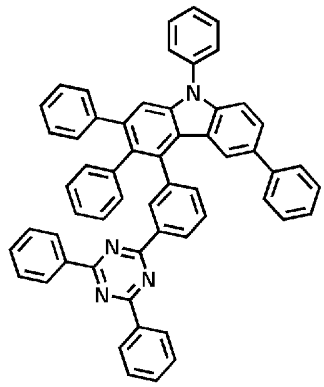

EH3-6

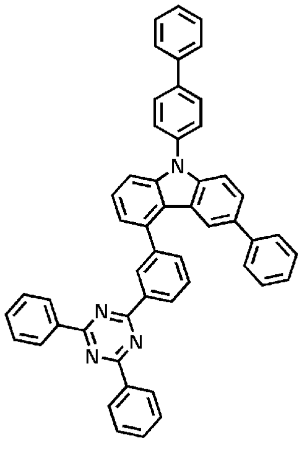

EH3-7

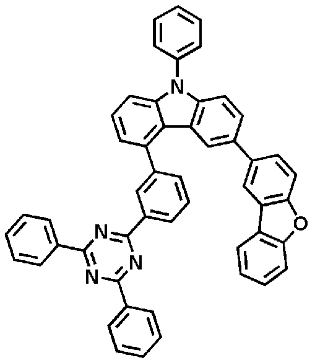

EH3-8

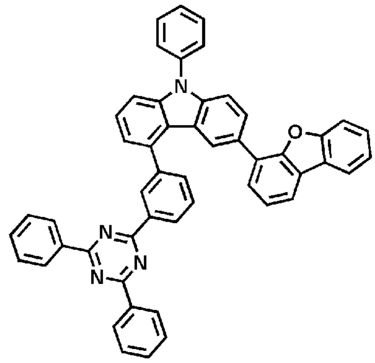

EH3-9

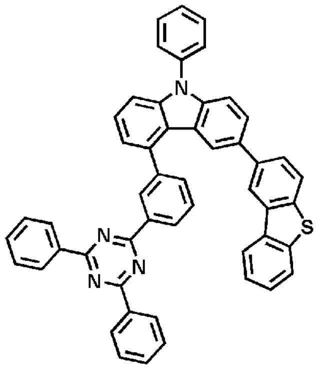

EH3-10

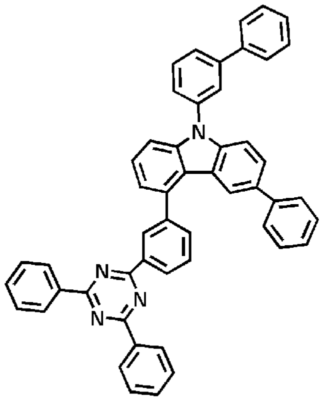

EH3-11

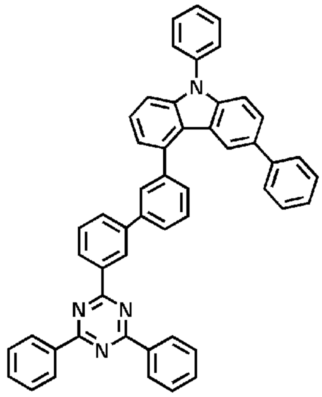

EH3-12

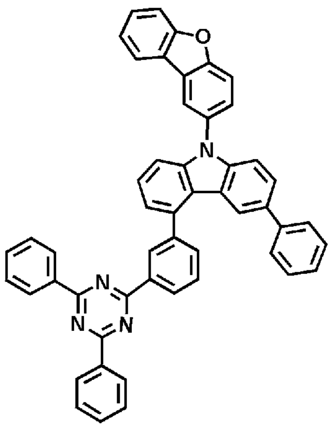

EH3-13

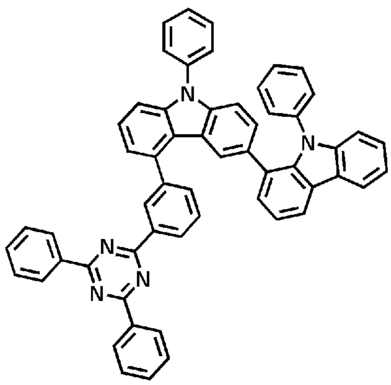

EH3-14

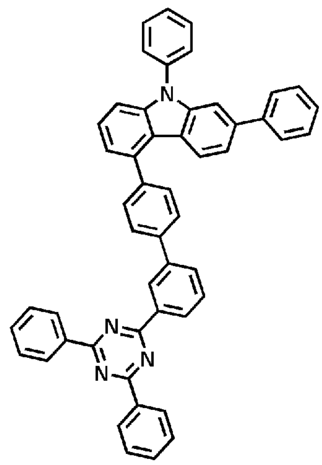

EH3-15

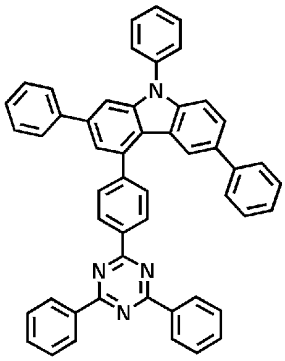

EH3-16

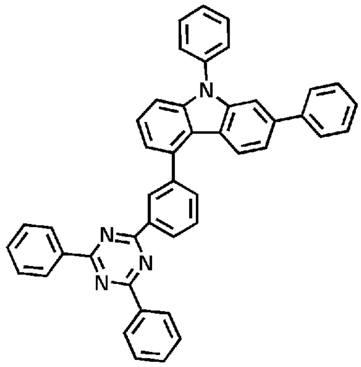

EH3-17

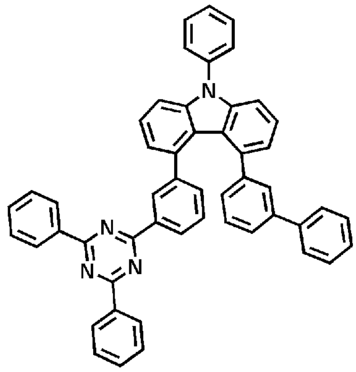

EH3-18

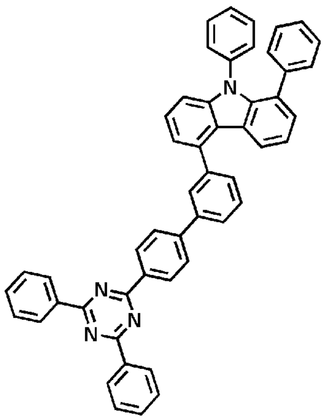

EH3-19

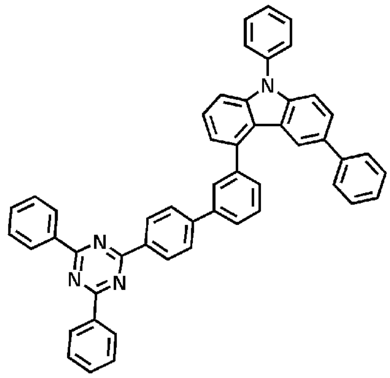

EH3-20

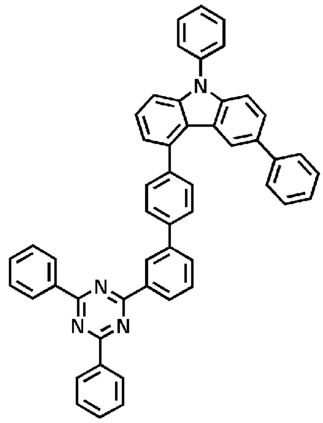

EH3-21

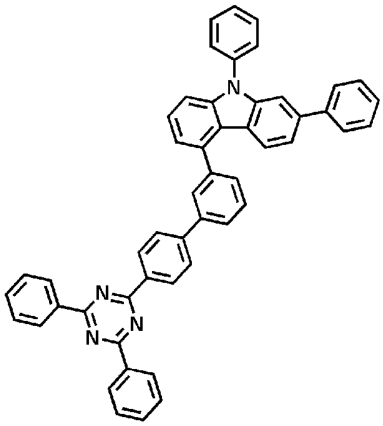

EH3-22

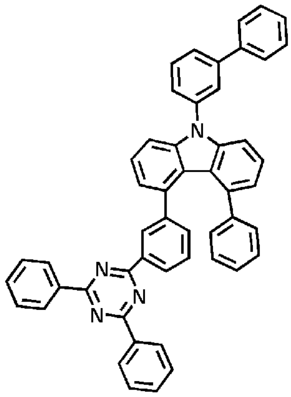

EH3-23

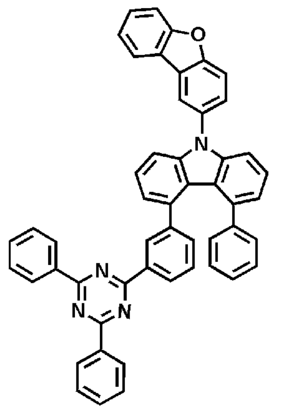

EH3-24

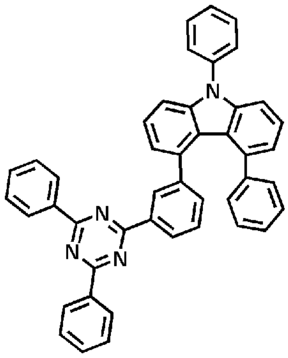

**EH3-25**

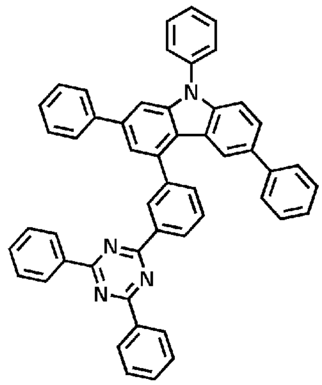

**EH3-26**

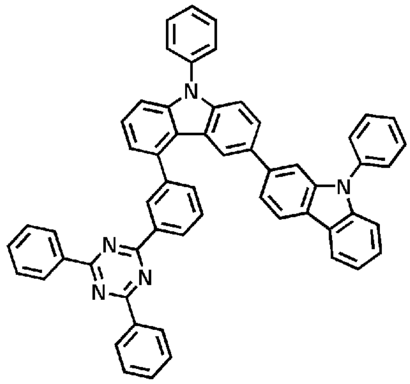

**EH3-27**

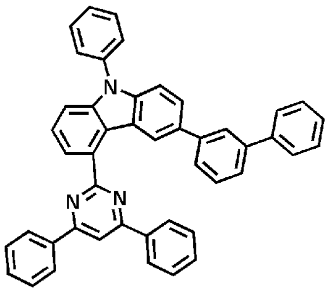

**EH3-28**

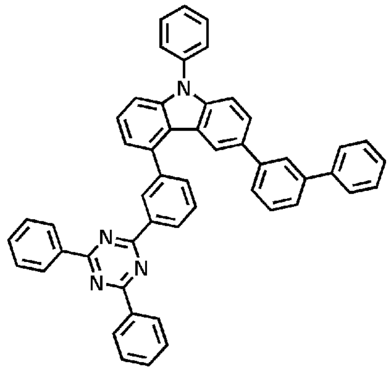

**EH3-29**

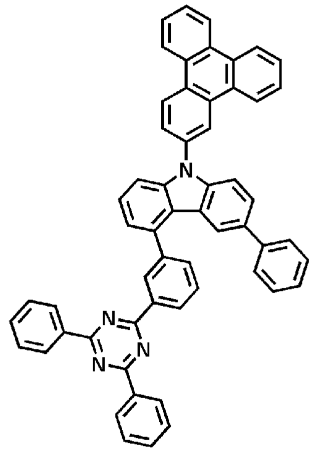

**EH3-30**

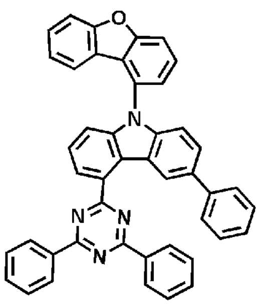

**EH3-31**

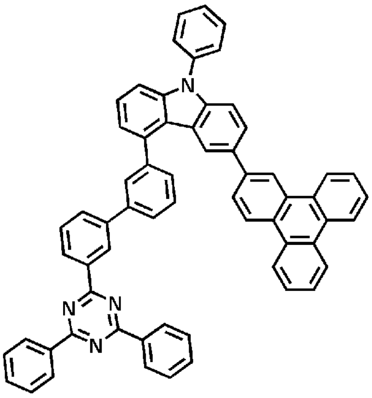

**EH3-32**

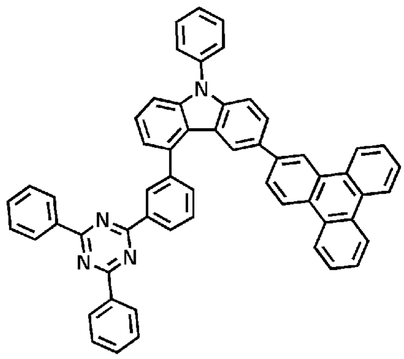

**EH3-33**

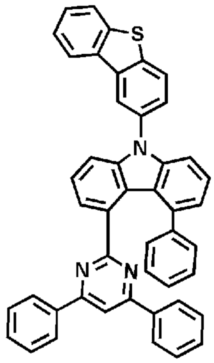

EH3-34

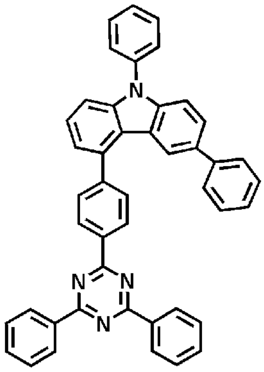

EH3-35

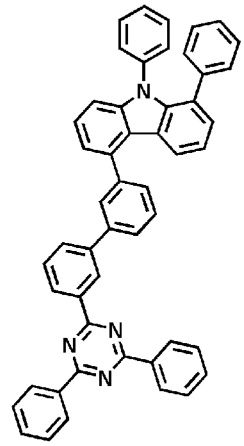

EH3-36

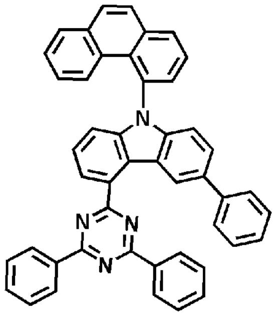

EH3-37

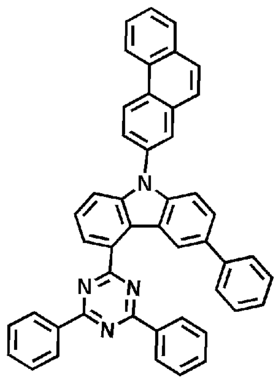

EH3-38

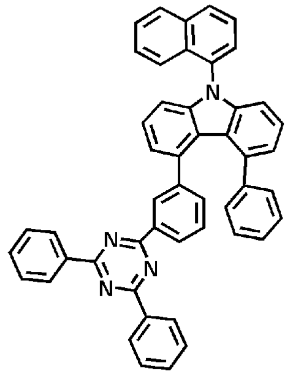

EH3-39

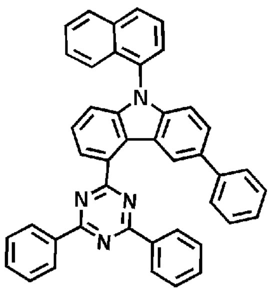

EH3-40

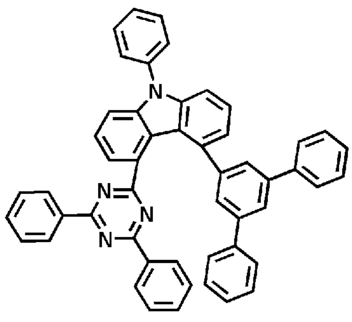

EH3-41

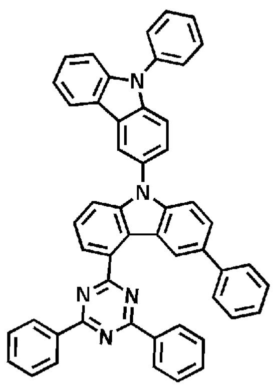

EH3-42

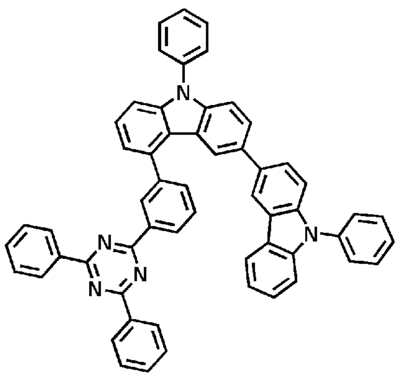

EH3-43

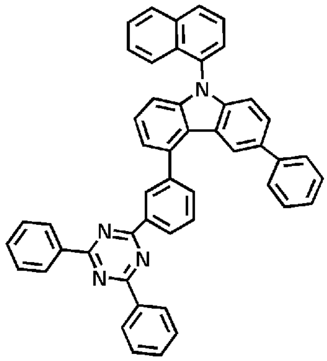

EH3-44

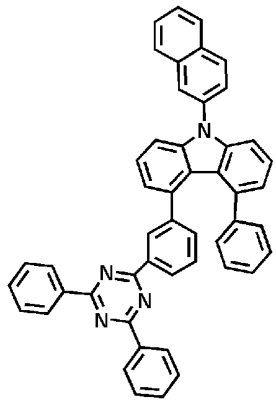

EH3-45

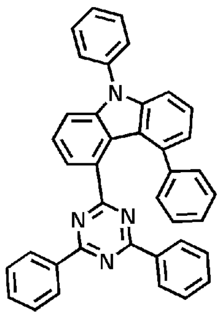

EH3-46

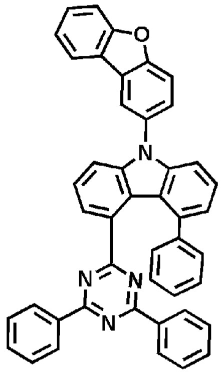

EH3-47

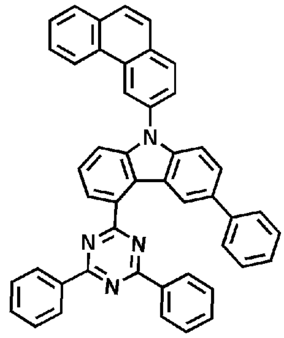

EH3-48

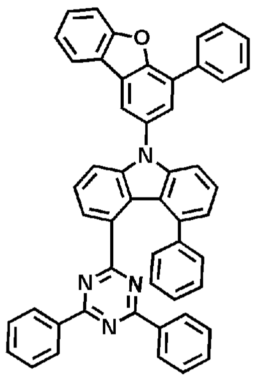

EH3-49

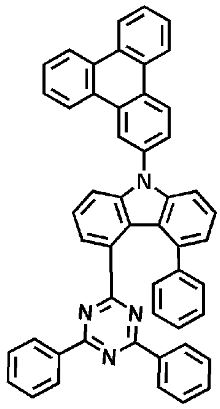

EH3-50

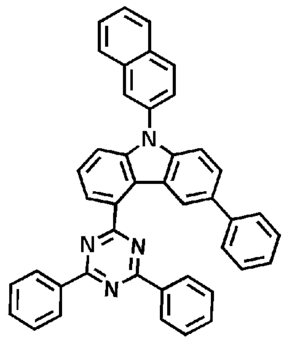

EH3-51

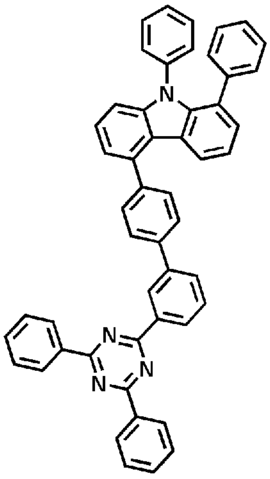

EH3-52

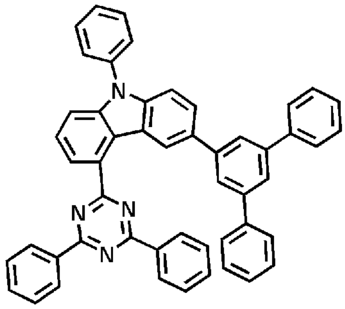

EH3-53

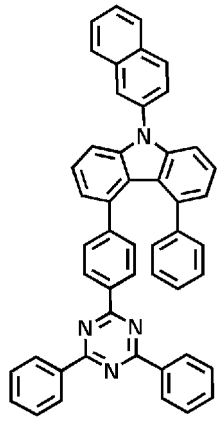

EH3-54

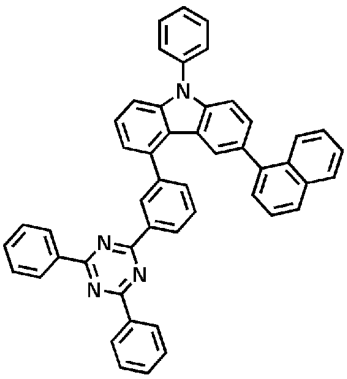

EH3-55

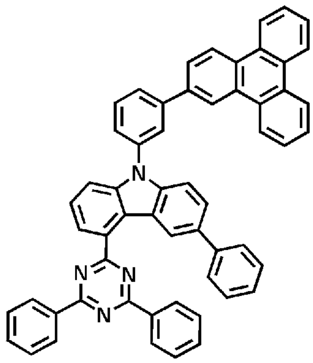

EH3-56

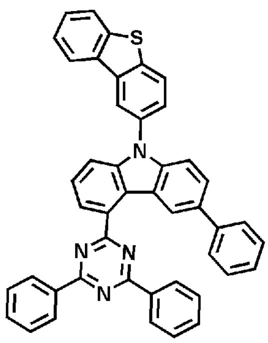

EH3-57

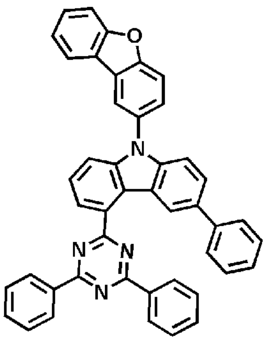

EH3-58

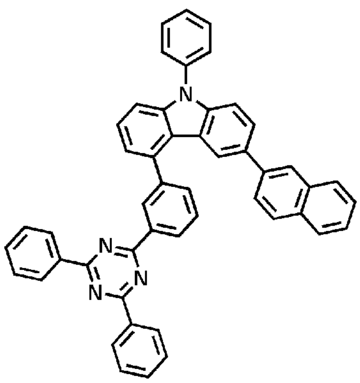

EH3-59

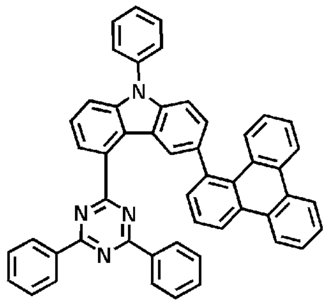

EH3-60

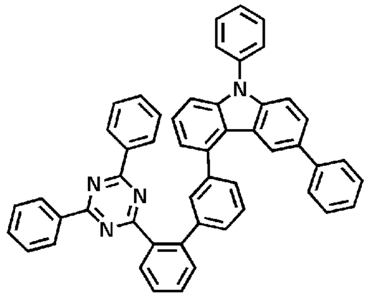

**EH3-61**

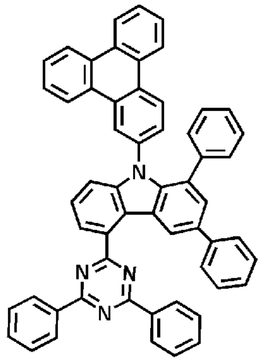

**EH3-62**

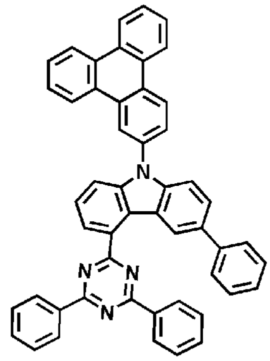

**EH3-63**

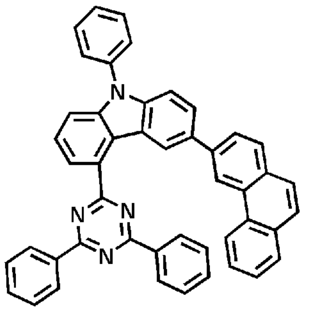

**EH3-64**

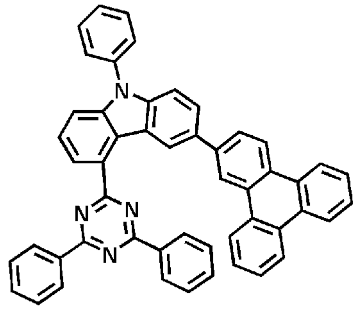

**EH3-65**

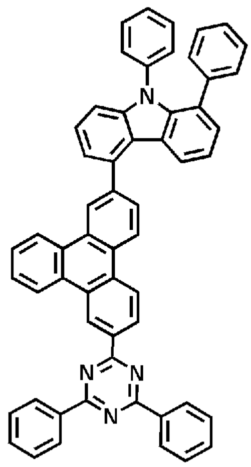

**EH3-66**

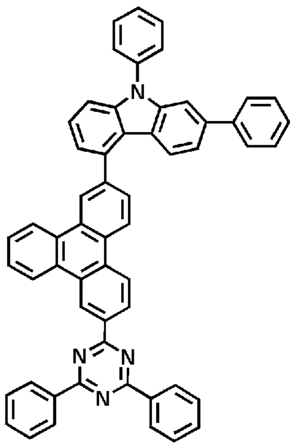

**EH3-67**

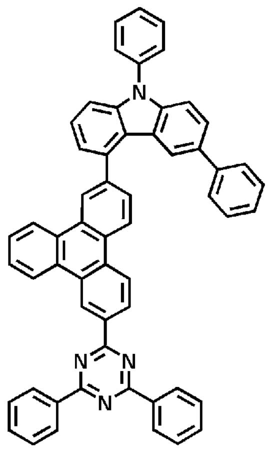

**EH3-68**

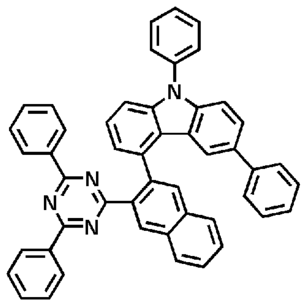

**EH3-69**

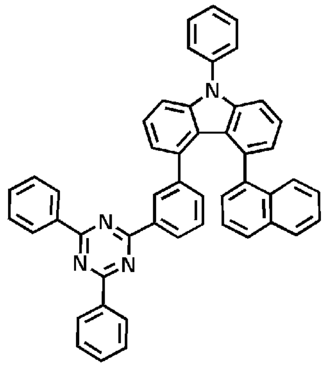

**EH3-70**

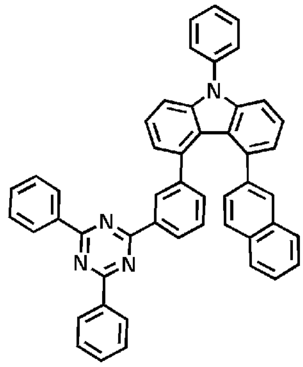

**EH3-71**

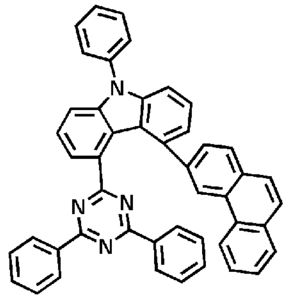

**EH3-72**

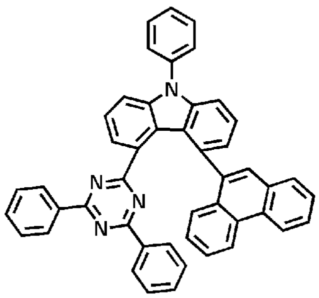

**EH3-73**

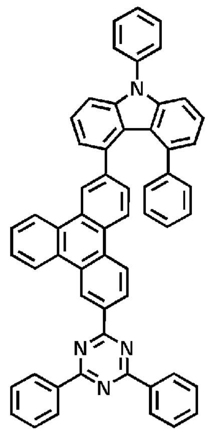

**EH3-74**

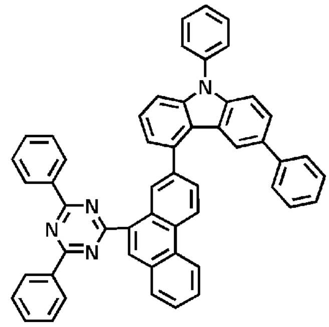

**EH3-75**

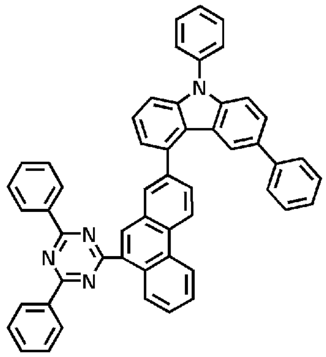

**EH3-76**

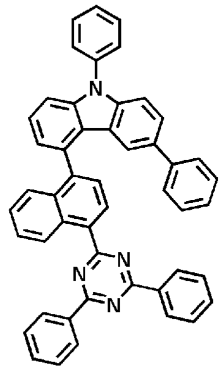

**EH3-77**

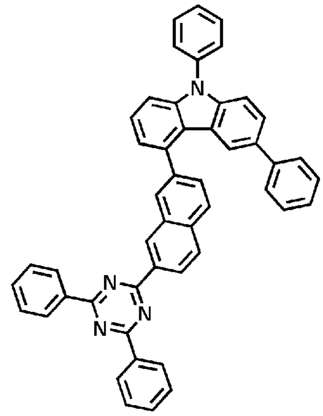

**EH3-78**

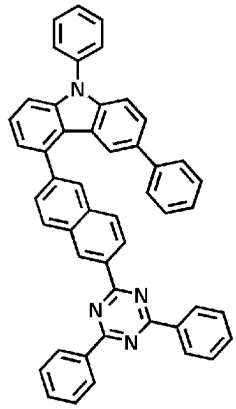

EH3-79

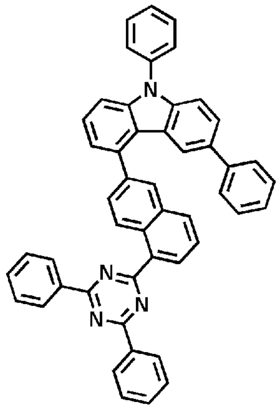

EH3-80

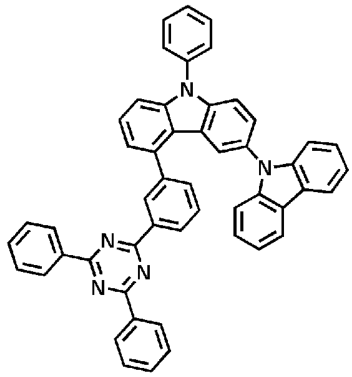

EH3-81

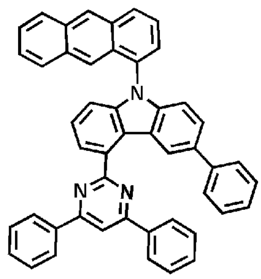

EH3-82

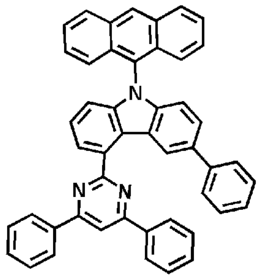

EH3-83

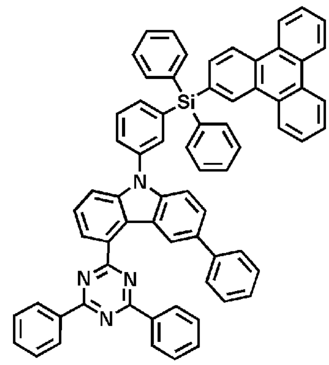

EH3-84

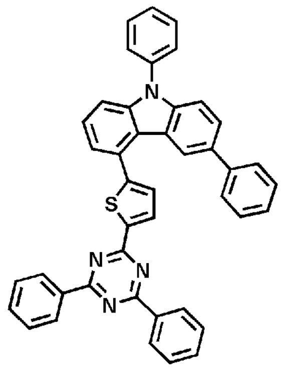

EH3-85

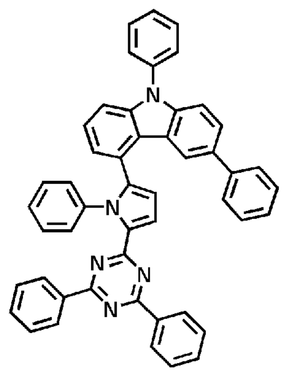

EH3-86

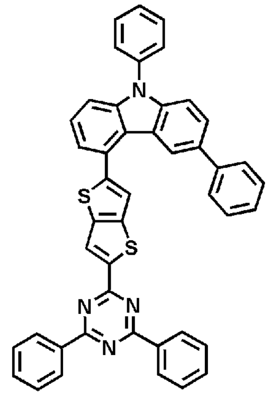

EH3-87

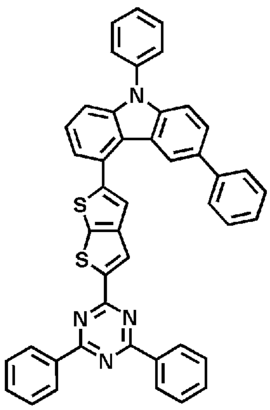
**EH3-88**

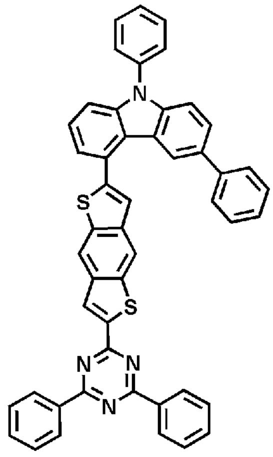
**EH3-89**

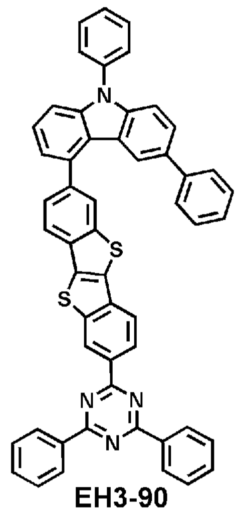
**EH3-90**

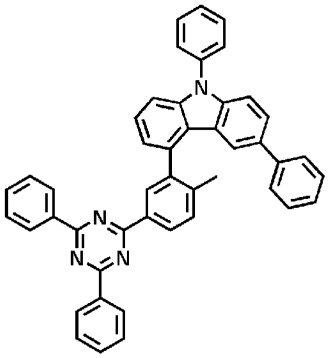
**EH3-91**

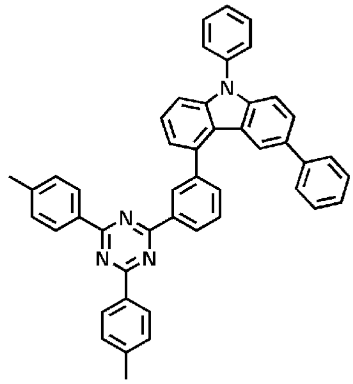
**EH3-92**

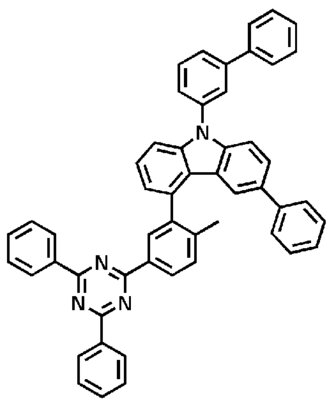
**EH3-93**

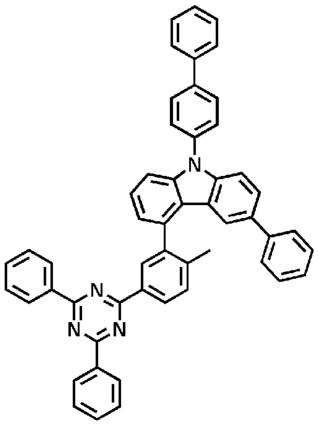
**EH3-94**

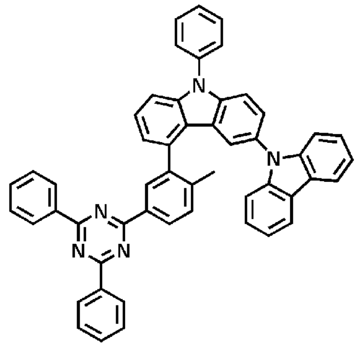
**EH3-95**

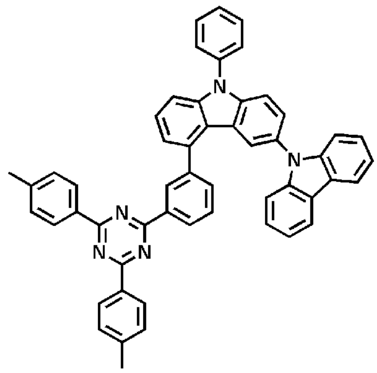
**EH3-96**

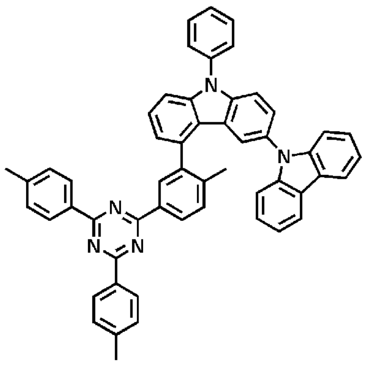

EH3-97

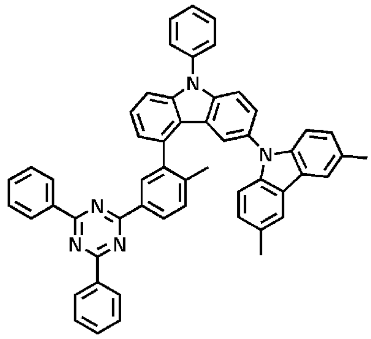

EH3-98

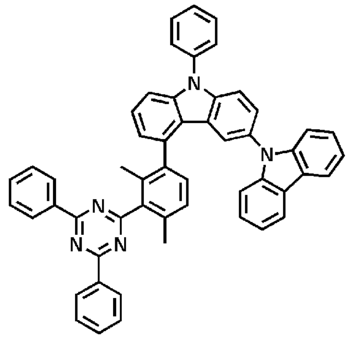

EH3-99

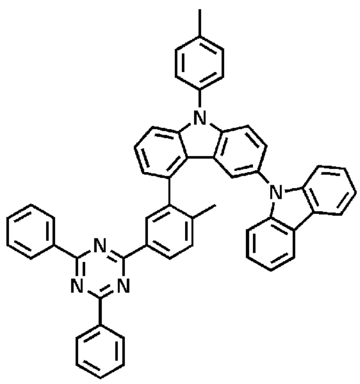

EH3-100

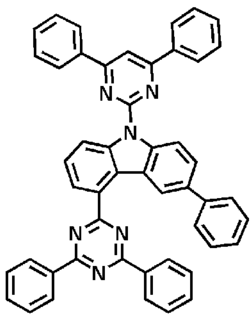

EH3-101

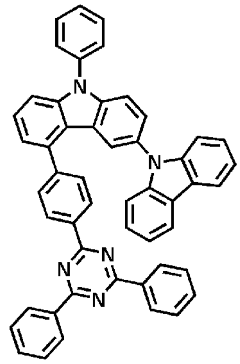

EH3-102

**12.** The OLED of any of claims 1-11, wherein the hole-transporting host comprises a compound represented by Formula 20 below:

<Formula 20>

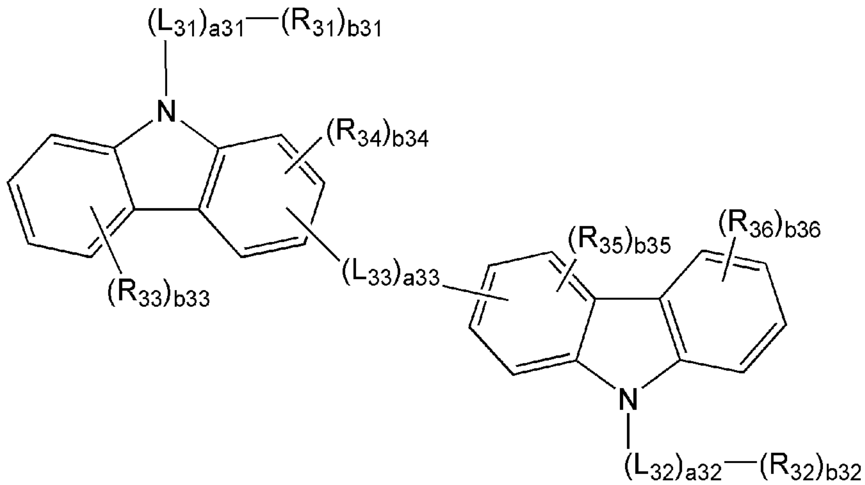

wherein in Formula 20,

$L_{31}$ to $L_{33}$ are each independently selected from a substituted or unsubstituted $C_3$-$C_{10}$ cycloalkylene group, a substituted or unsubstituted $C_3$-$C_{10}$ cycloalkenylene group, a substituted or unsubstituted $C_6$-$C_{60}$ arylene group, and a substituted or unsubstituted divalent non-aromatic condensed polycyclic group;

a31 to a33 are each independently an integer of 0 to 5;
$R_{31}$ and $R_{32}$ are each independently a substituted or unsubstituted $C_3$-$C_{10}$ cycloalkyl group, a substituted or unsubstituted $C_3$-$C_{10}$ cycloalkenyl group, a substituted or unsubstituted $C_6$-$C_{60}$ aryl group, and a substituted or unsubstituted monovalent non-aromatic condensed polycyclic group;
$R_{33}$ to $R_{36}$ are each independently a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_3$-$C_{10}$ cycloalkenyl group, a substituted or unsubstituted $C_6$-$C_{60}$ aryl group, and a substituted or unsubstituted monovalent non-aromatic condensed polycyclic group;
b31 to b36 are each independently an integer of 1 to 3;
at least one of substituents of the substituted $C_3$-$C_{10}$ cycloalkylene group, the substituted $C_3$-$C_{10}$ cycloalkenylene group, the substituted $C_6$-$C_{60}$ arylene group, the substituted divalent non-aromatic condensed polycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_3$-$C_{10}$ cycloalkenyl group, the substituted $C_6$-$C_{60}$ aryl group, and the substituted monovalent non-aromatic condensed polycyclic group is selected from a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_6$-$C_{60}$ aryl group, and a monovalent non-aromatic condensed polycyclic group; and
the hole-transporting host excludes Compound HH1-1 below

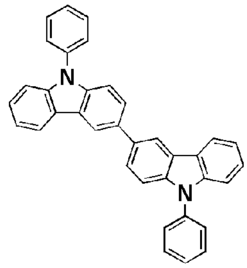

HH1-1 ,

preferably wherein:

$L_{31}$ to $L_{33}$ are each independently selected from:

a phenylene group, a naphthylene group, a fluorenylene group, a spiro-fluorenylene group, a phenalenylene group, a phenanthrenylene group, an anthracenylene group, a fluoranthrenylene group, a triphenylenylene group, a pyrenylene group, and a chrysenylene group; and
a phenylene group, a naphthylene group, a fluorenylene group, a spiro-fluorenylene group, a phenalenylene group, a phenanthrenylene group, an anthracenylene group, a fluoranthrenylene group, a triphenylenylene group, a pyrenylene group, and a chrysenylene group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a phenyl group substituted with a phenyl group (i.e., a biphenyl group), a naphthyl group, a fluorenyl group, a spiro-fluorenyl group, a phenalenyl group, a phenanthrenyl group, an anthracenyl group, a fluoranthrenyl group, a triphenylenyl group, a pyrenyl group, and a chrysenyl group;
a31 to a33 are each independently 0, 1, or 2;
$R_{31}$ and $R_{32}$ are each independently selected from
a phenyl group, a naphthyl group, a fluorenyl group, a spiro-fluorenyl group, a phenalenyl group, a

phenanthrenyl group, an anthracenyl group, a fluoranthrenyl group, a triphenylenyl group, a pyrenyl group, and a chrysenyl group; and

a phenyl group, a naphthyl group, a fluorenyl group, a spiro-fluorenyl group, a phenalenyl group, a phenanthrenyl group, an anthracenyl group, a fluoranthrenyl group, a triphenylenyl group, a pyrenyl group, and a chrysenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a phenyl group substituted with a phenyl group (i.e., a biphenyl group), a naphthyl group, a fluorenyl group, a spiro-fluorenyl group, a phenalenyl group, a phenanthrenyl group, an anthracenyl group, a fluoranthrenyl group, a triphenylenyl group, a pyrenyl group, and a chrysenyl group;

$R_{33}$ to $R_{36}$ are each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, and a phenyl group, a naphthyl group; and

b31 to b36 are each independently 1 or 2.

**13.** The OLED of any of claims 1-11, wherein the hole-transporting host comprises a compound represented by one of Formulae 20-1 to 20-7 below:

<Formula 20-1>

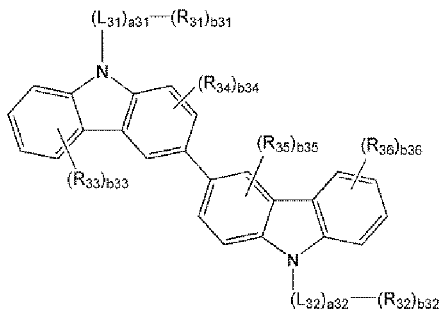

<Formula 20-2>

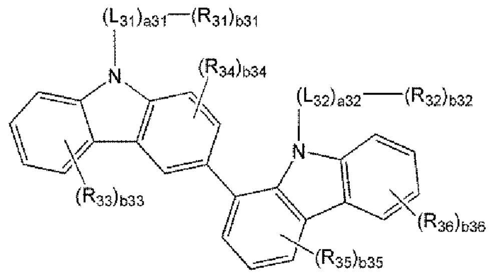

<Formula 20-3>

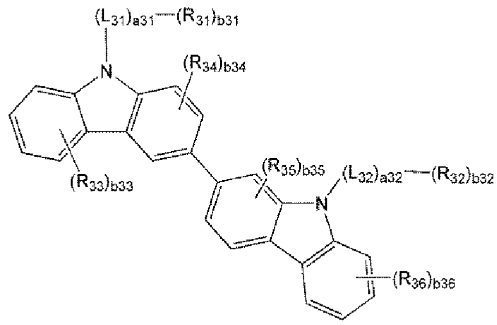

<Formula 20-4>

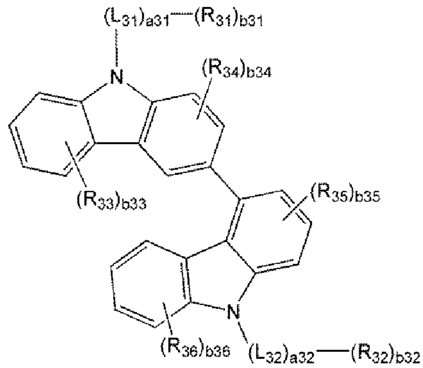

<Formula 20-5>

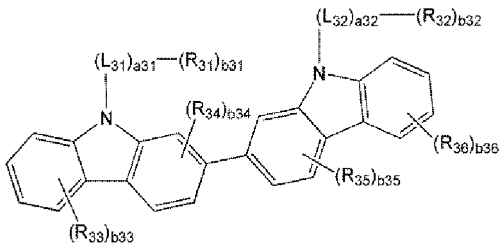

<Formula 20-6>

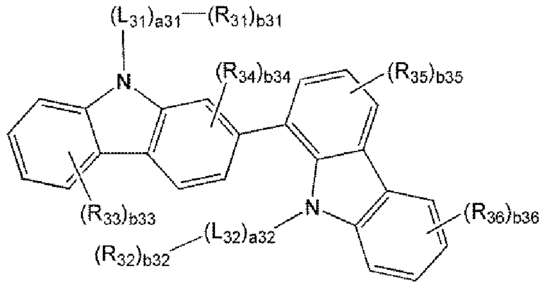

<Formula 20-7>

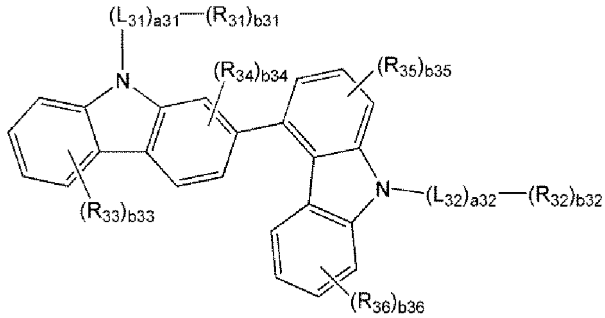

,

preferably wherein the hole-transporting host comprises at least one of Compounds HH1-2 to HH1-51 below:

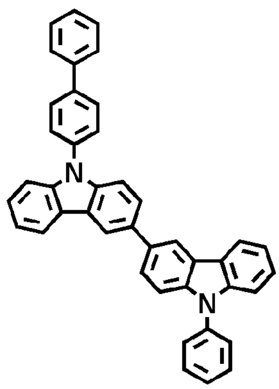

**HH1-2**

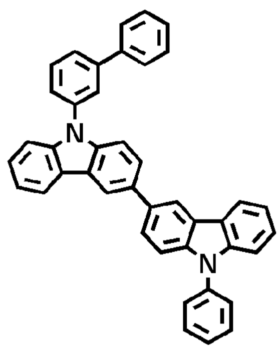

**HH1-3**

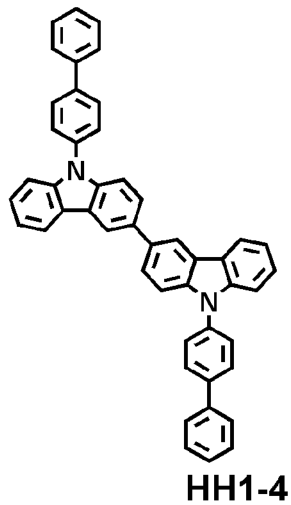

**HH1-4**

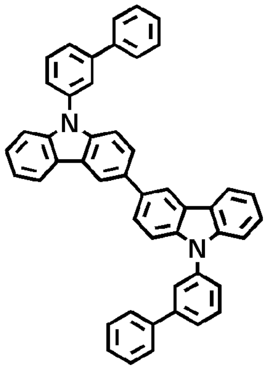

HH1-5

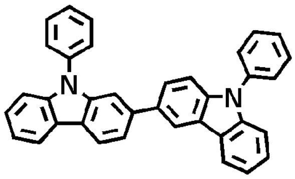

HH1-6

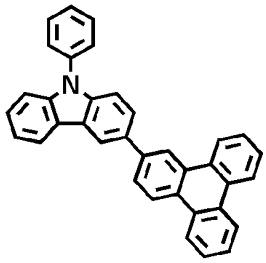

HH1-7

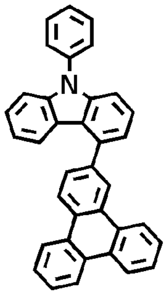

HH1-8

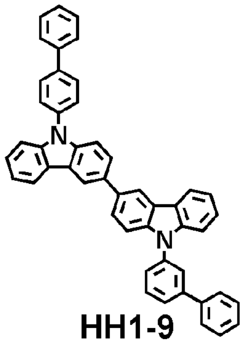

HH1-9

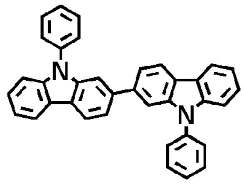

HH1-10

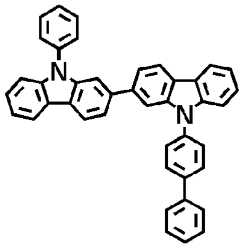

HH1-11

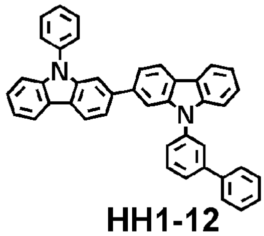

HH1-12

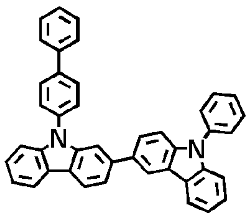

HH1-13

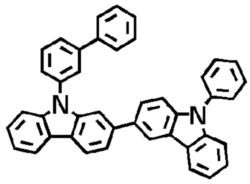

HH1-14

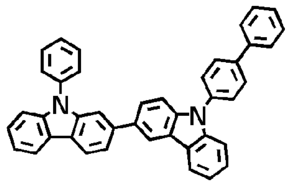

HH1-15

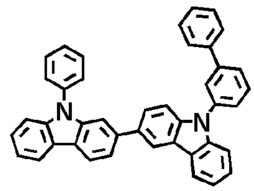

HH1-16

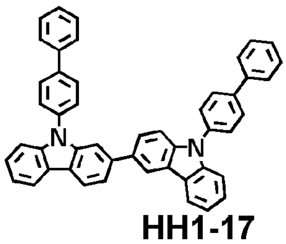

HH1-17

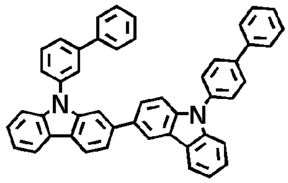

HH1-18

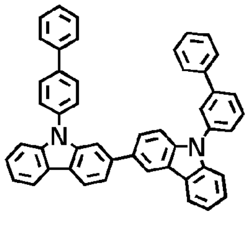

HH1-19

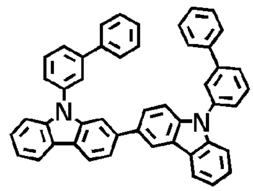

HH1-20

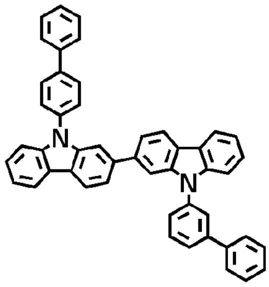

HH1-21

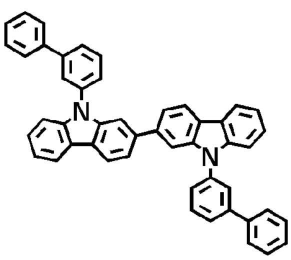

HH1-22

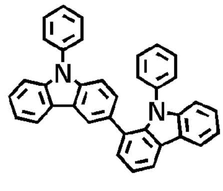

HH1-23

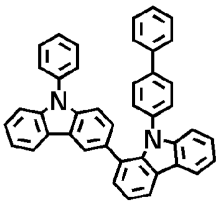

HH1-24

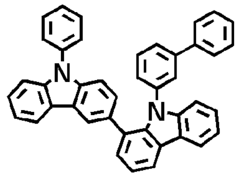

HH1-25

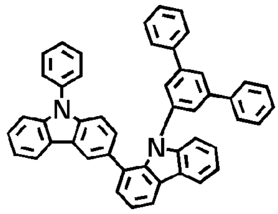

HH1-26

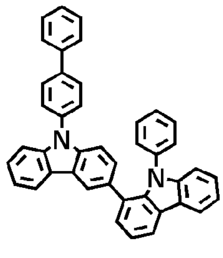

HH1-27

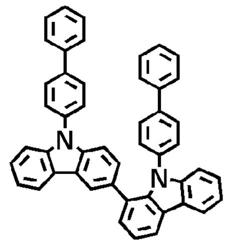

HH1-28

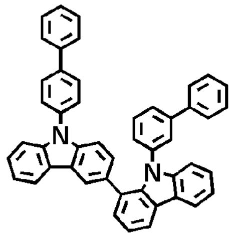

HH1-29

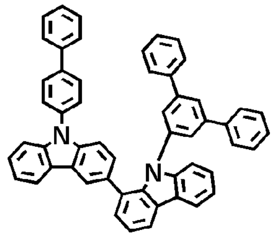

HH1-30

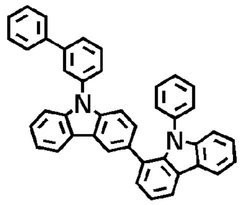

HH1-31

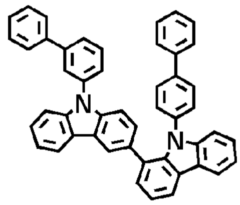

HH1-32

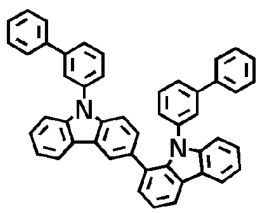

HH1-33

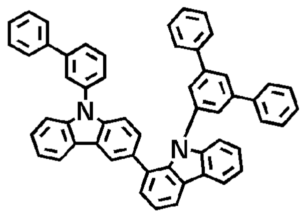

HH1-34

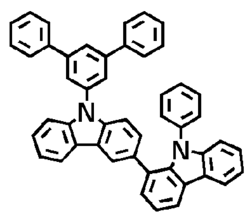

HH1-35

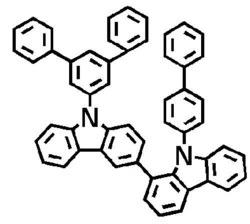

HH1-36

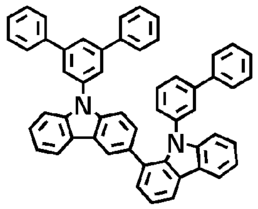

HH1-37

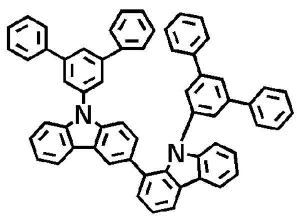

HH1-38

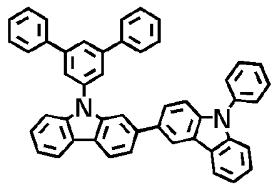

HH1-39

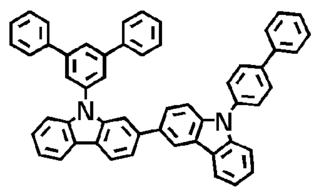

HH1-40

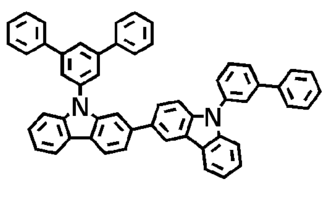

HH1-41

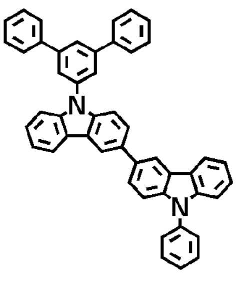

HH1-42

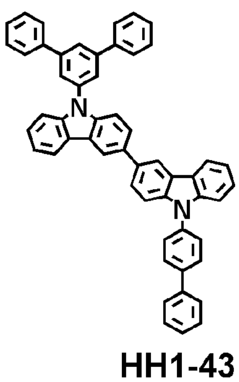

HH1-43

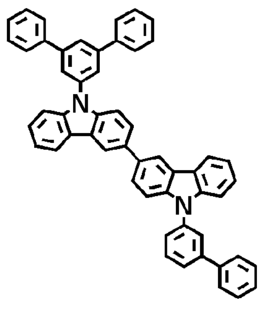

HH1-44

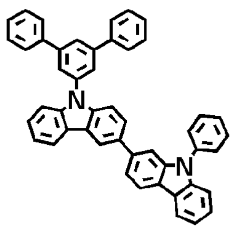

HH1-45

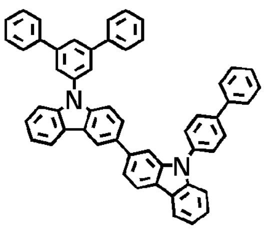

HH1-46

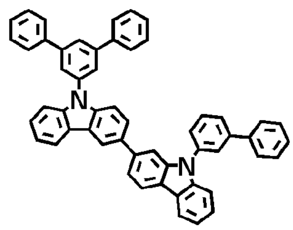

HH1-47

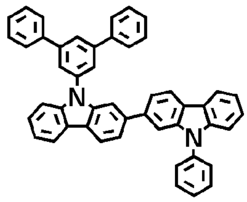

HH1-48

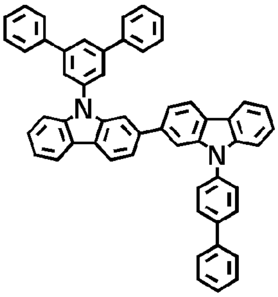

HH1-49

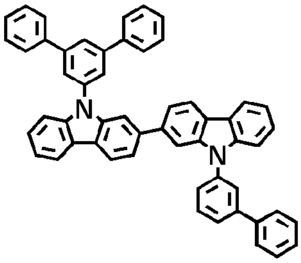

HH1-50

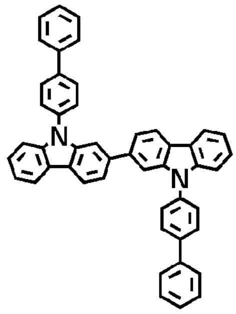

HH1-51

**14.** The OLED of any of claims 1-3, wherein:

the electron-transporting host is Compound EH1-401 below,
the hole-transporting host comprises a compound satisfying $-0.1 \leq$ Type(Compound EH1-401) $\leq 0.6$,
a volume ratio of the electron-transporting host to the hole-transporting host is within a range satisfying $-0.1 \leq$ Type(Compound EH1-401) $\leq 0.6$,
wherein Type(Compound EH1-401) is defined by Equation 10 below:

<Equation 10>

$$\text{Type(Compound EH1-401)} = \log(J_{HOD}(\text{at } 11.5V) / J_{EOD}(\text{at } 4V))$$

wherein in Equation 10,

$J_{HOD}$ (at 11.5 V) refers to a current density value (mA/cm$^2$) at a voltage of 11.5 V of a hole-only device having a structure of ITO (150 nm (1,500 Å)) / Compound HT3:TCNPQ (3 wt%) (10 nm (100 A)) / Compound HT3 (100 nm (1,000 A)) / host:Compound PD79 (10 wt%) (60 nm (600 A)) / Compound ET1 (10 nm (100 Å)) / Al (10 nm (100 Å)) (wherein the host consists of the Compound EH1-401 and the hole-transporting host), and
$J_{EOD}$ (at 4 V) refers to a current density value (mA/cm$^2$) at a voltage of 4 V of an electron-only device having a structure of ITO (150 nm (1,500 Å)) / Mg:Ag (10 wt%) (30 nm (300 Å)) / Liq (1 nm (10 Å)) / Compound ET16:Liq (50 wt%) (20 nm (200 Å)) / host:Compound PD79 (10 wt%) (60 nm (600 Å)) / Compound ET16:Liq (50 wt%) (20 nm (200 Å)) / Liq (1nm (10 Å)) / Mg:Ag (10 wt%) (30 nm (300 Å)) (wherein the host consists of the Compound EH1-401 and the hole-transporting host).

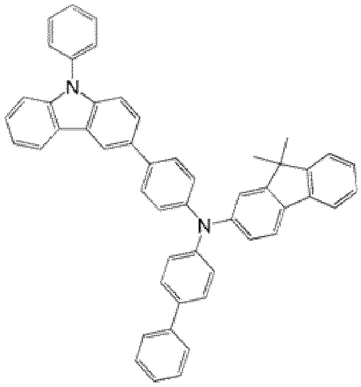

HT3

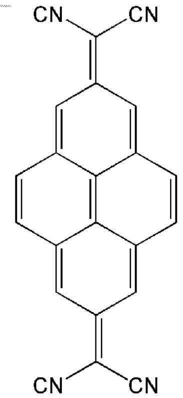

TCNPQ

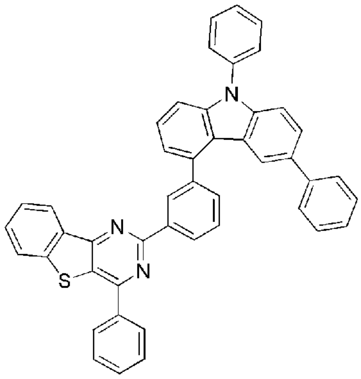

EH1-401

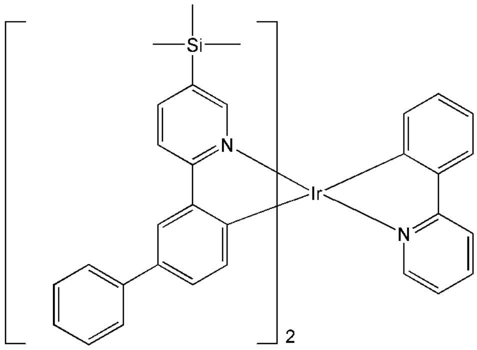

PD79

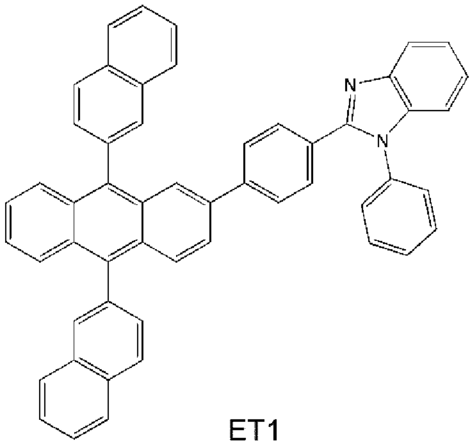

ET1

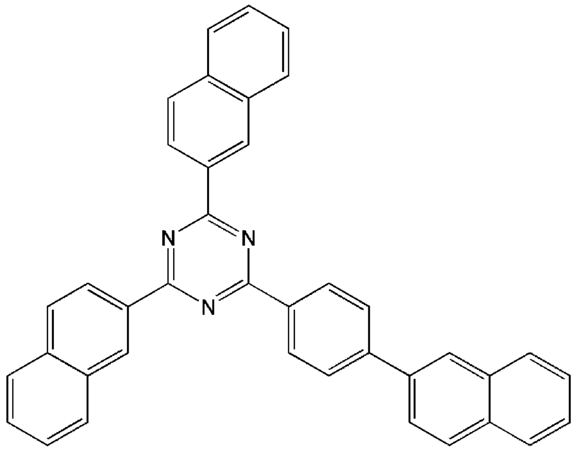

ET16

**15.** The OLED of any of claims 1-3, wherein:
the electron-transporting host is Compound EH3-81 below,
the hole-transporting host comprises a compound satisfying 0.1 ≤ Type(Compound EH3-81) ≤ 1.2,
a volume ratio of the electron-transporting host to the hole-transporting host is within a range satisfying 0.1 ≤ Type(Compound E3-81) ≤ 1.2,
wherein Type(Compound EH3-81) is defined by Equation 11 below:

<Equation 11>

$$\text{Type(Compound EH3-81)} = \log(J_{HOD}(\text{at } 11.5\text{V}) / J_{EOD}(\text{at } 4\text{V}))$$

wherein in Equation 11

$J_{HOD}$ (at 11.5 V) refers to a current density value (mA/cm$^2$) at a voltage of 11.5 V of a hole-only device having a structure of ITO (150 nm (1,500 Å)) / Compound HT3:TCNPQ (3 wt%) (10 nm (100 Å)) / Compound HT3 (100 nm (1,000 Å)) / host:Compound PD79 (10 wt%) (60 nm (600 Å)) / Compound ET1 (10 nm(100 Å)) / Al (10 nm (100 Å)) (wherein the host consists of Compound EH3-81 and the hole-transporting host), and

$J_{EOD}$ (at 4 V) refers to a current density value (mA/cm$^2$) at a voltage of 4 V of an electron-only device having a structure of ITO (150 nm (1,500 Å)) / Mg:Ag (10 wt%) (30 nm (300 Å)) / Liq (1 nm (10 Å)) / Compound ET16:Liq (50 wt%) (20 nm (200 Å)) / host:Compound PD79 (10 wt%) (60 nm (600 Å)) / Compound ET16:Liq (50 wt%) (20 nm (200 Å)) / Liq (1 nm (10 Å)) / Mg:Ag (10 wt%) (30 nm (300 Å)) (wherein the host consists of Compound EH3-81 and the hole-transporting host)

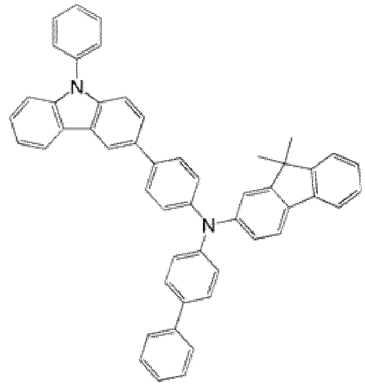

**HT3**

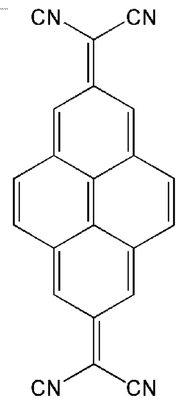

TCNPQ

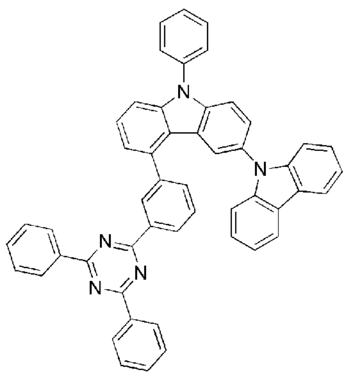

**EH3-81**

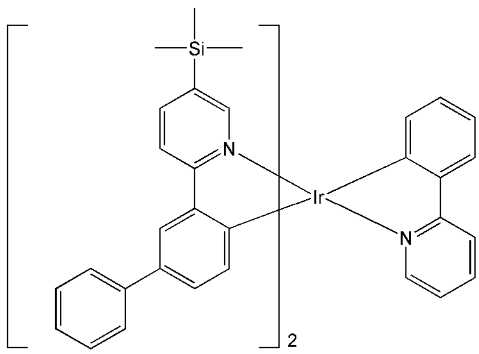

PD79

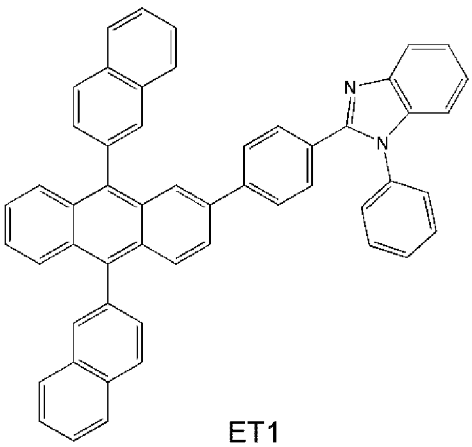

ET1

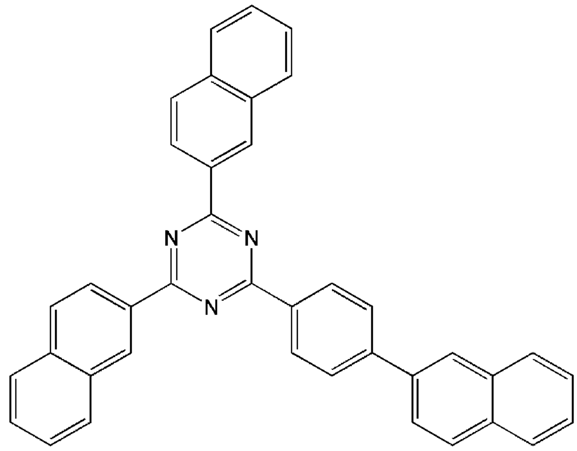

ET16

16. The OLED of any of claims 1-13, wherein the hole transport material comprises a compound represented by Formula 201 below:

<Formula 201>

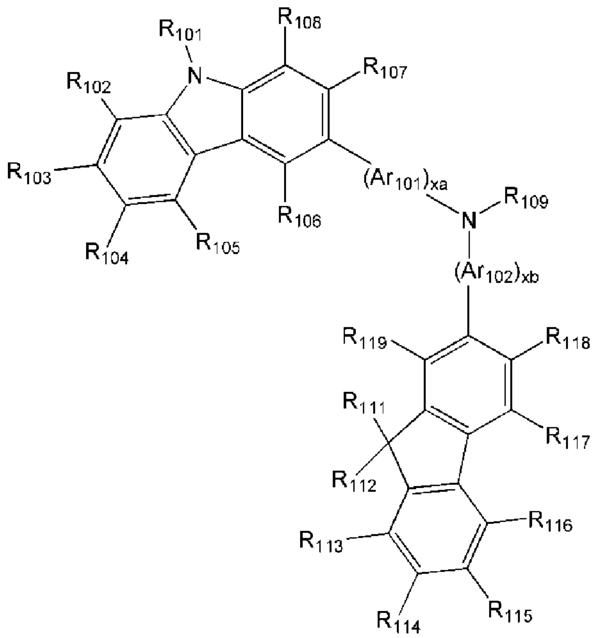

wherein in Formula 201,

$Ar_{101}$ and $Ar_{102}$ are each independently selected from

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one of a deuterium, -F, -Cl, -Br, -I, a hydroxyl group, a

cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

xa and xb are each independently an integer of 0 to 5;

$R_{101}$ to $R_{108}$ and $R_{111}$ to $R_{119}$ are each independently selected from

a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group;

a $C_1$-$C_{10}$ alkyl group and a $C_1$-$C_{10}$ alkoxy group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof; a phenyl group, a naphthyl group, an anthracenyl group, a fluorenyl group, and a pyrenyl group; and

a phenyl group, a naphthyl group, an anthracenyl group, a fluorenyl group, and a pyrenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group; and

$R_{109}$ is selected from

a phenyl group, a naphthyl group, an anthracenyl group, and a pyridinyl group; and a phenyl group, a naphthyl group, an anthracenyl group, and a pyridinyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and $C_1$-$C_{20}$ alkoxy group, preferably wherein the hole transport material comprises a compound represented by Formula 201A below:

<Formula 201A>

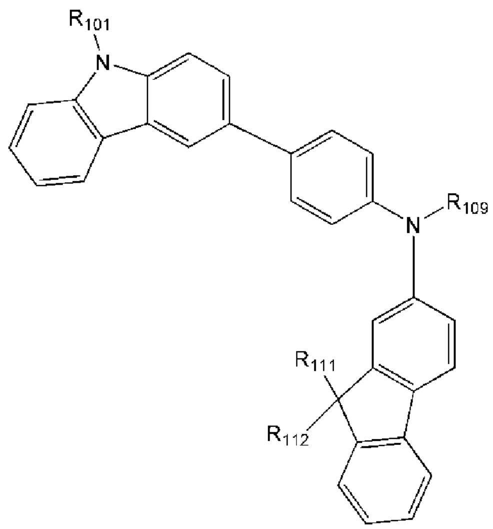

wherein in Formula 201A, descriptions of $R_{101}$, $R_{111}$, $R_{112}$, and $R_{109}$ are defined the same as in Formula 201.

**17.** The OLED of any of claims 1-13, wherein the hole transport material comprises at least one of Compounds HT1 to HT12 below:

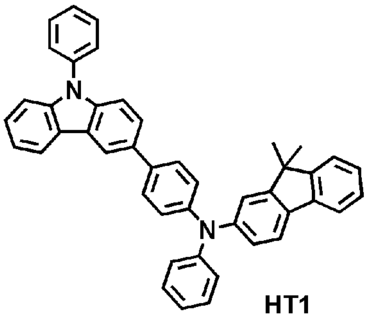
HT1

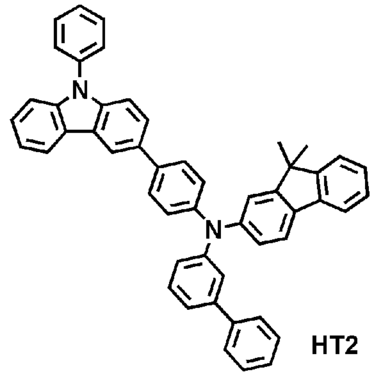
HT2

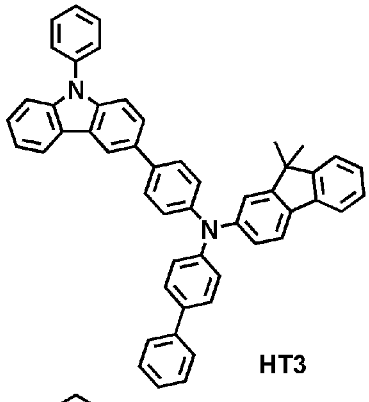
HT3

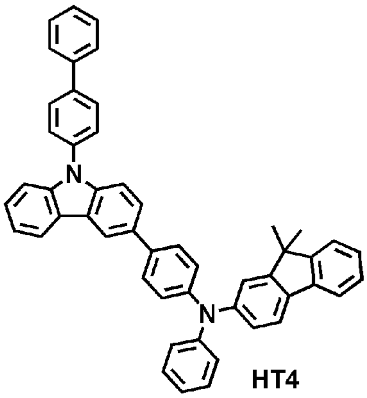
HT4

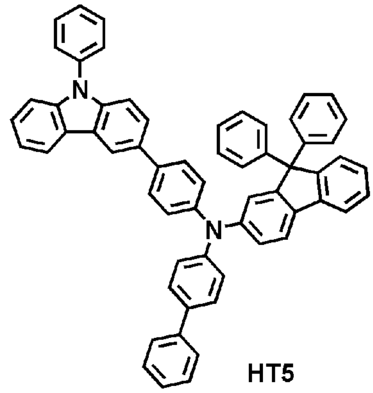
HT5

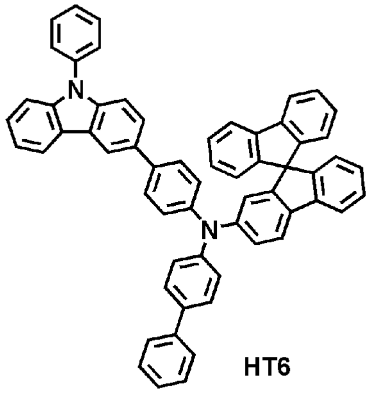
HT6

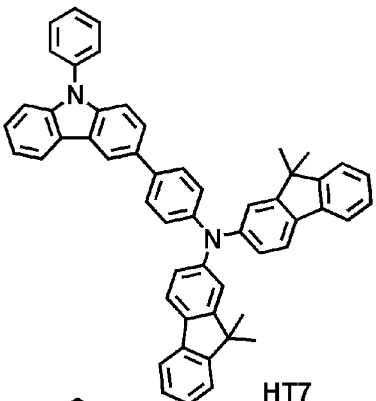
HT7

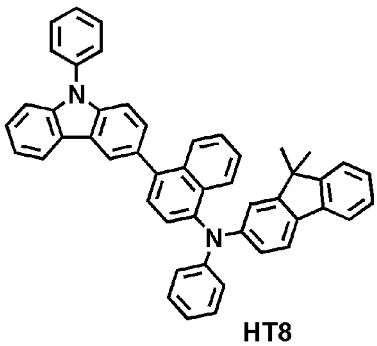
HT8

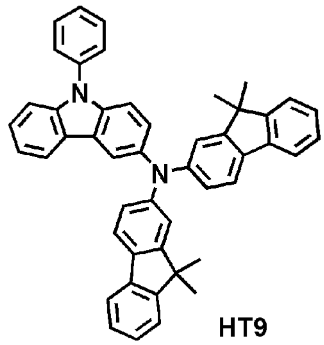
HT9

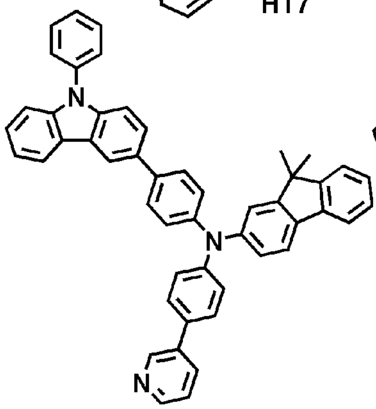
HT10

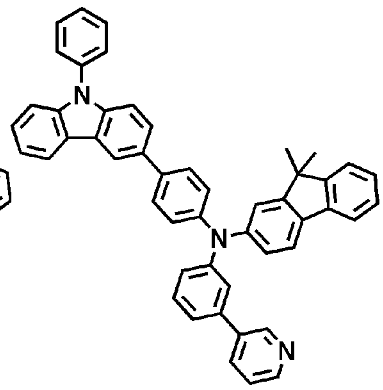
HT11

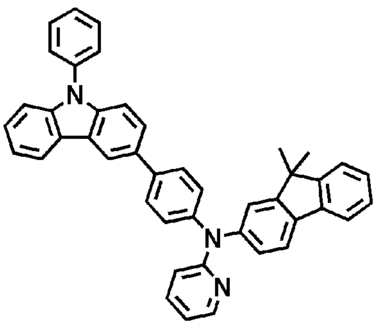
HT12

**18.** The OLED of any of claims 1-13, 16 or 17, wherein the electron transport material comprises a compound represented by Formulae 40 or 41 below:

<Formula 40>

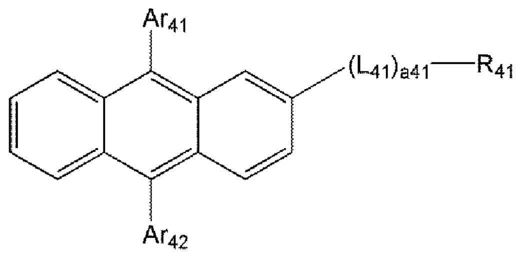

<Formula 41>

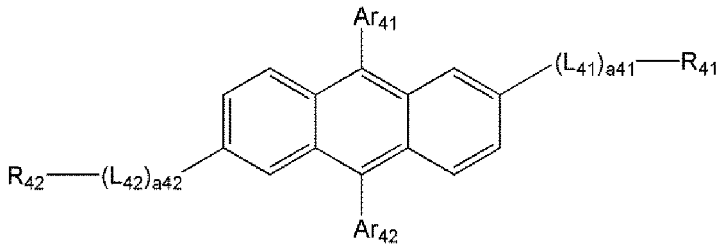

wherein in Formulae 40 and 41,

$L_{41}$ and $L_{42}$ are each independently selected from
a $C_6$-$C_{60}$ arylene group, a $C_1$-$C_{60}$ heteroarylene group, a divalent non-aromatic condensed polycyclic group, and a divalent non-aromatic condensed heteropolycyclic group; and
a $C_6$-$C_{60}$ arylene group, a $C_1$-$C_{60}$ heteroarylene group, a divalent non-aromatic condensed polycyclic group, and a divalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group;
a41 and a42 are each independently an integer of 0 to 5;
$Ar_{41}$ and $Ar_{42}$ are each independently selected from
a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group; and
$R_{41}$ and $R_{42}$ are each independently selected from
a benzoimidazolyl group, a benzoxazolyl group, a benzothiazolyl group, a benzopyrimidinyl group, an imidazopyridinyl group, a quinolinyl group, an isoquinolinyl group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group; and
a benzoimidazolyl group, a benzoxazolyl group, a benzothiazolyl group, a benzopyrimidinyl group, an imidazopyridinyl group, a quinolinyl group, an isoquinolinyl group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a benzoimidazolyl group, a benzoxazolyl group, a benzothiazolyl group, a benzopyrimidinyl group, an imidazopyridinyl group, a quinolinyl group, an isoquinolinyl

group, a quinazolinyl group, a pyridinyl group, a pyrimidinyl group, a pyrazinyl group, a phenyl group, a naphthyl group, a pyrenyl group, a chrysenyl group, a fluorenyl group, and a phenanthrenyl group, or wherein the electron transport material comprises a compound represented by Formula 42 below:

<Formula 42>

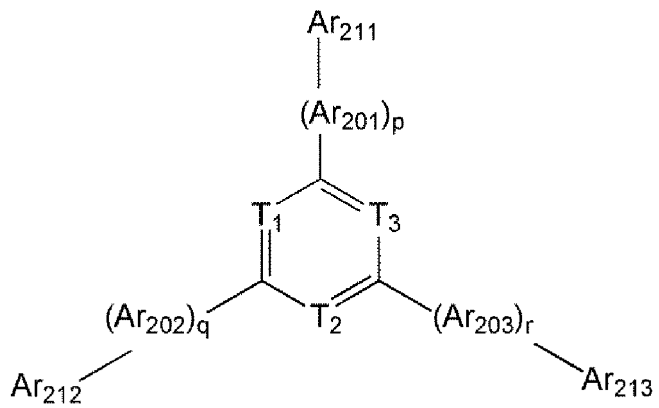

wherein in Formula 42,

$T_1$ is N or $C(R_{201})$, $T_2$ is N or $C(R_{202})$, and $T_3$ is N or $C(R_{203})$, wherein at least one of $T_1$ to $T_3$ is N;
$R_{201}$ to $R_{203}$ are each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group;
$Ar_{201}$ to $Ar_{203}$ are each independently selected from
a $C_6$-$C_{60}$ arylene group, a $C_1$-$C_{60}$ heteroarylene group, a divalent non-aromatic condensed polycyclic group, and a divalent non-aromatic condensed heteropolycyclic group; and
a $C_6$-$C_{60}$ arylene group, a $C_1$-$C_{60}$ heteroarylene group, a divalent non-aromatic condensed polycyclic group, and a divalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a pyridinyl group, a pyrimidinyl group, and a triazinyl group;
p, q, and r are each independently 0, 1, or 2; and
$Ar_{211}$ and $Ar_{213}$ are each independently selected from
a $C_6$-$C_{60}$ aryl group, a $C_1$-$C_{60}$ heteroaryl group, a monovalent non-aromatic condensed polycyclic group, and a monovalent non-aromatic condensed heteropolycyclic group; and
a $C_6$-$C_{60}$ aryl group, a $C_1$-$C_{60}$ heteroaryl group, a monovalent non-aromatic condensed polycyclic group, and a monovalent non-aromatic condensed heteropolycyclic group, each substituted with at least one of a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a pyrenyl group, a chrysenyl group, a phenanthrenyl group, a

pyridinyl group, a pyrimidinyl group, and a triazinyl group.

**19.** The OLED of any of claims 1-13, 16 or 17, wherein the electron transport material comprises at least one of Compounds ET1 to ET16 below:

<Compound ET1>

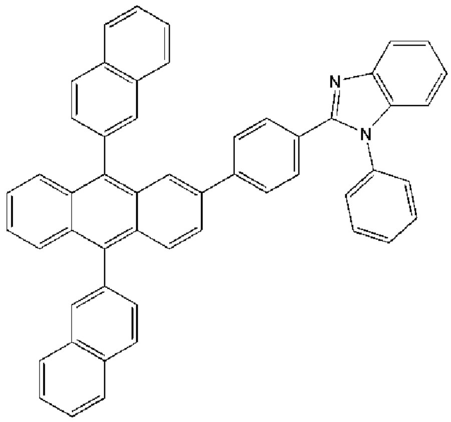

<Compound ET2>

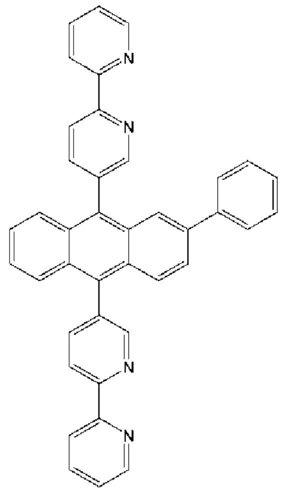

<Compound ET3>

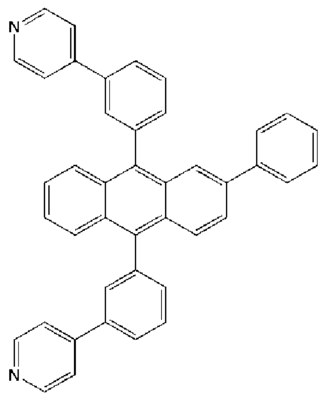

<Compound ET4>

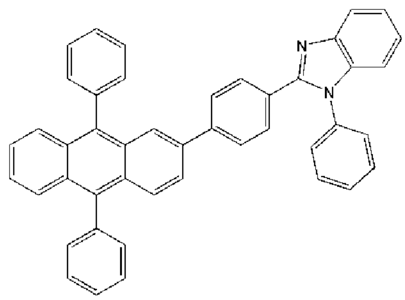

<Compound ET5>

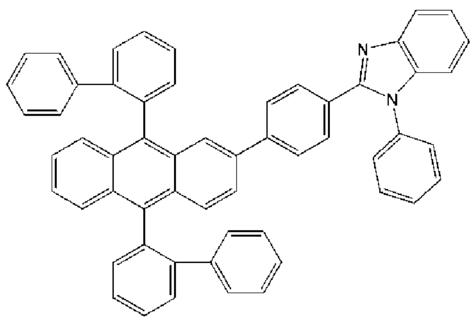

<Compound ET6>

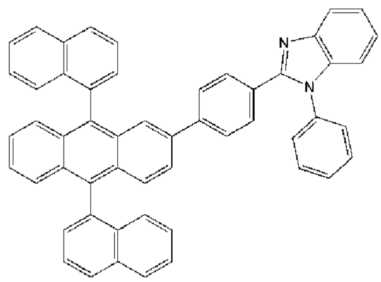

<Compound ET7> <Compound ET8>

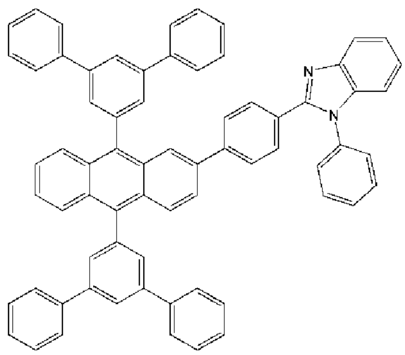

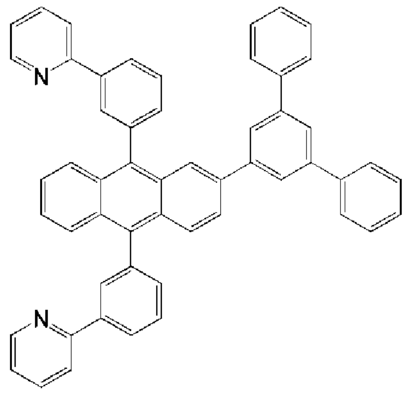

<Compound ET8> <Compound ET10>

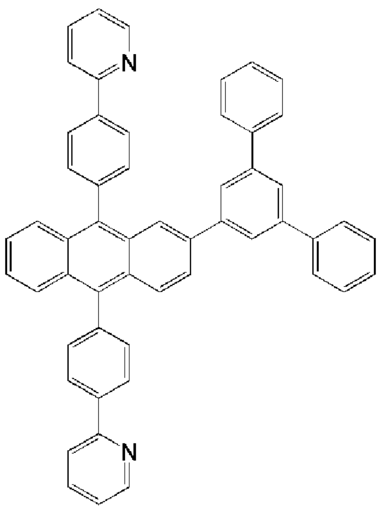

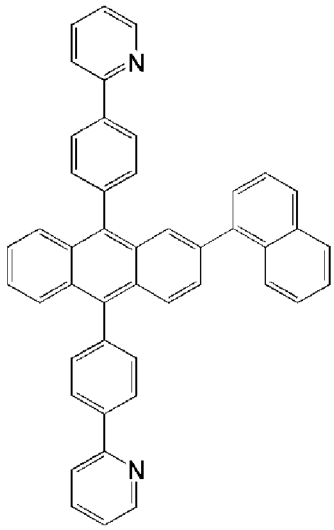

<Compound ET11> <Compound ET12>

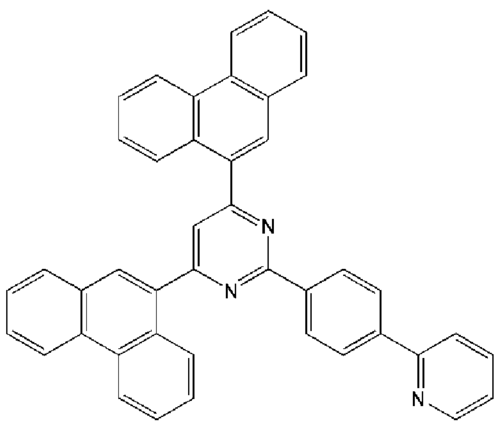

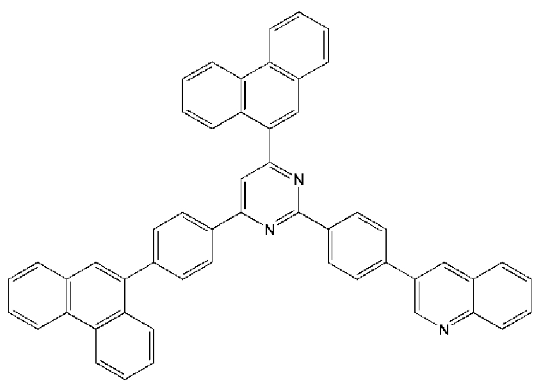

<Compound ET13> <Compound ET14>

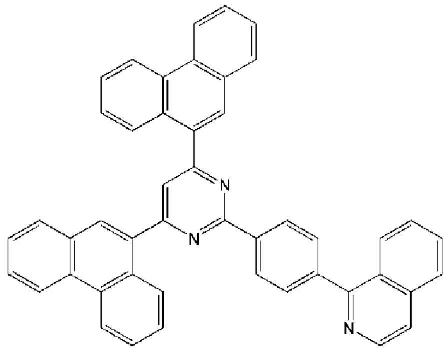

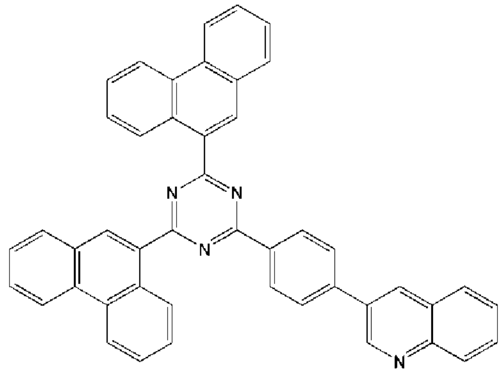

<Compound ET15> <Compound ET16>

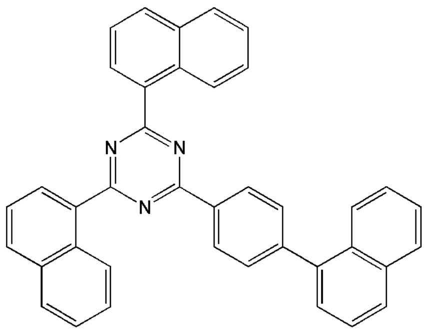

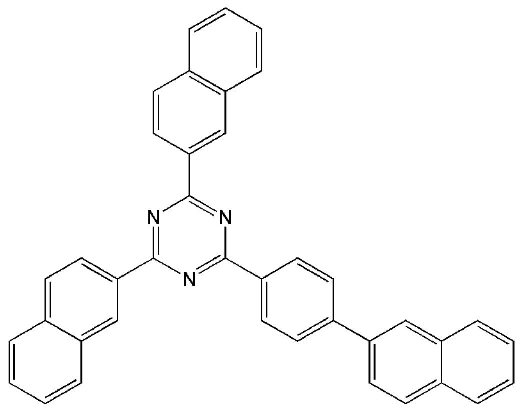

## Patentansprüche

1. Organische lichtemittierende Vorrichtung (OLED), umfassend
eine erste Elektrode;
eine zweite Elektrode;
eine Emissionsschicht, die zwischen der ersten Elektrode und der zweiten Elektrode angeordnet ist;
einen Lochleitungsbereich, der zwischen der ersten Elektrode und der Emissionsschicht angeordnet ist und eine Lochleitungsschicht umfasst; und
einen Elektronenleitungsbereich, der zwischen der Emissionsschicht und der zweiten Elektrode angeordnet ist und eine Elektronenleitungsschicht umfasst,
wobei die Emissionsschicht einen elektronenleitenden Host und einen lochleitenden Host umfasst,
die Lochleitungsschicht ein Lochleitungsmaterial umfasst,
die Elektronenleitungsschicht ein Elektronenleitungsmaterial umfasst, und
die OLED nachstehende Gleichungen 1 und 2 erfüllt:

<Gleichung 1>

$$0{,}75\ \text{eV} \leq |\ \text{LUMO}_{H(ET)} - \text{LUMO}_{H(HT)}\ | \leq 0{,}90\ \text{eV}$$

<Gleichung 2>

$$|\ E(S_{1,\ H(ET)}) - E(S_{1,\ H(HT)})\ | < 0{,}15\ \text{eV}$$

wobei in Gleichungen 1 und 2

$LUMO_{H(ET)}$ sich auf ein Energieniveau eines niedrigsten unbesetzten Molekülorbitals (LUMO) des elektronenleitenden Hosts bezieht,
$LUMO_{H(HT)}$ sich auf ein LUMO-Energieniveau des lochleitenden Hosts bezieht,
$E(S_{1,\ H(ET)})$ sich auf ein Singulett-Energieniveau des elektronenleitenden Hosts bezieht, und
$E(S_{1,\ H(HT)})$ sich auf ein Singulett-Energieniveau des lochleitenden Hosts bezieht.

**2.** OLED nach Anspruch 1, wobei die OLED nachstehende Gleichungen 3 und 4 erfüllt:

<Gleichung 3>

$$| HOMO_{H(HT)} - HOMO_{HTL} | < 0{,}3\ eV$$

<Gleichung 4>

$$0{,}15\ eV \leq | HOMO_{H(HT)} - HOMO_{H(ET)} | \leq 2{,}0\ eV$$

wobei in Gleichungen 3 und 4

$HOMO_{H(HT)}$ sich auf ein höchstes besetztes Molekülorbital des lochleitenden Hosts bezieht,
$HOMO_{HTL}$ sich auf ein HOMO-Energieniveau des Lochleitungsmaterials bezieht, und
$HOMO_{H(ET)}$ sich auf ein HOMO-Energieniveau des elektronenleitenden Hosts bezieht;
und/oder wobei die OLED nachstehende Gleichung 5 erfüllt:

<Gleichung 5>

$$| LUMO_{H(ET)} - LUMO_{ETL} | < 0{,}2\ eV$$

wobei sich in Gleichung 5 $LUMO_{ETL}$ auf ein LUMO-Energieniveau des Elektronenleitungsmaterials bezieht.

**3.** OLED nach Anspruch 1 oder 2, wobei die OLED nachstehende Gleichungen 6 und 7 erfüllt:

<Gleichung 6>

$$\min\{E(S_{1,H(HT)}), E(S_{1,H(ET)})\} - E(S_{1,EX}) > 0{,}15\ eV$$

<Gleichung 7>

$$E(S_{1,EX}) - E(T_{1,EX}) < 0{,}15\ eV$$

wobei in Gleichungen 6 und 7

$E(S_{1,H(HT)})$ sich auf ein Singulett-Energieniveau des lochleitenden Hosts bezieht,
$E(S_{1,H(ET)})$ sich auf ein Singulett-Energieniveau des elektronenleitenden Hosts bezieht,
$\min\{E(S_{1,H(HT)}), E(S_{1,H(ET)})\}$ sich auf den kleinsten Wert von $E(S_{1,H(HT)})$ und $E(S_{1,H(ET)})$ bezieht,
$E(S_{1,EX})$ sich auf ein Singulett-Energieniveau eines Exciplexes bezieht, der durch den lochleitenden Host und den elektronenleitenden Host gebildet ist, und
$E(T_{1,EX})$ sich auf ein Triplett-Energieniveau des Exciplexes bezieht, der durch den elektronenleitenden Host und den lochleitenden Host gebildet ist.

**4.** OLED nach einem der Ansprüche 1-3, wobei der elektronenleitende Host eine Verbindung umfasst, die durch nachstehende Formel 1 dargestellt wird:

<Formel 1>

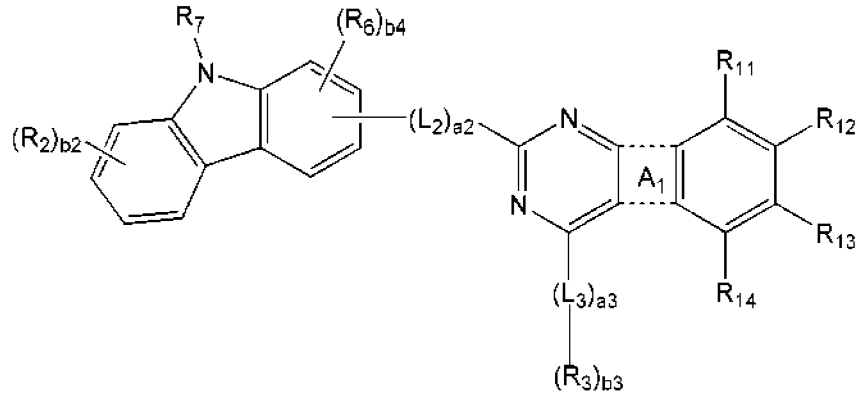

<Formel 1A>

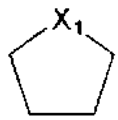

wobei ein Ring $A_1$ in Formel 1 durch vorstehende Formel 1A dargestellt wird;

$X_1$ in Formel 1A für N-[$(L_1)_{a1}$-$(R_1)_{b1}$], S, O, S(=O), $S(=O)_2$, C(=O), $Si(R_4)(R_5)$, $P(R_4)$, $P(=O)(R_4)$ oder $C=N(R_4)$ steht;

$L_1$ bis $L_3$ in Formel 1 jeweils unabhängig ausgewählt sind aus einer substituierten oder unsubstituierten $C_3$-$C_{10}$-Cycloalkylengruppe, einer substituierten oder unsubstituierten $C_1$-$C_{10}$-Heterocycloalkylengruppe, einer substituierten oder unsubstituierten $C_3$-$C_{10}$-Cycloalkenylengruppe, einer substituierten oder unsubstituierten $C_1$-$C_{10}$-Heterocycloalkenylengruppe, einer substituierten oder unsubstituierten $C_6$-$C_{60}$-Arylengruppe, einer substituierten oder unsubstituierten $C_1$-$C_{60}$-Heteroarylengruppe, einer substituierten oder unsubstituierten divalenten nicht aromatischen kondensierten polycylischen Gruppe und einer substituierten oder unsubstituierten divalenten nicht aromatischen kondensierten heteropolycylischen Gruppe;

a1 bis a3 in Formel 1 jeweils unabhängig für eine ganze Zahl von 1 bis 5 stehen, wenn a1 für 2 oder mehr steht, 2 oder mehr $L_1$s miteinander identisch oder voneinander unterschiedlich sind, wenn a2 für 2 oder mehr steht, 2 oder mehr $L_2$s miteinander identisch oder voneinander unterschiedlich sind, wenn a3 für 2 oder mehr steht, 2 oder mehr $L_3$s miteinander identisch oder voneinander unterschiedlich sind;

$R_1$ bis $R_7$ und $R_{11}$ bis $R_{14}$ in Formel 1 jeweils unabhängig ausgewählt sind aus einem Wasserstoff, einem Deuterium, einer Fluorgruppe (-F), einer Chlorgruppe (-Cl), einer Bromgruppe (-Br), einer Iodgruppe (-1), einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkynylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_1$-$C_{60}$-Heteroarylgruppe, einer substituierten oder unsubstituierten monovalenten nicht aromatischen kondensierten polycylischen Gruppe, einer substituierten oder unsubstituierten monovalenten nicht aromatischen kondensierten heteropolycylischen Gruppe, $-N(Q_1)(Q_2)$, $-Si(Q_3)(Q_4)(Q_5)$ und $-B(Q_6)(Q_7)$;

b1 bis b4 in Formel 1 jeweils unabhängig für eine ganze Zahl von 1 bis 3 stehen; und mindestens einer von Substituenten aus der substituierten $C_3$-$C_{10}$-Cycloalkylengruppe, der substituierten $C_1$-$C_{10}$-Heterocycloalky-

lengruppe, der substituierten $C_3$-$C_{10}$-Cycloalkenylengruppe, der substituierten $C_1$-$C_{10}$-Heterocycloalkenylengruppe, der substituierten $C_6$-$C_{60}$-Arylengruppe, der substituierten $C_1$-$C_{60}$-Heteroarylengruppe, der substituierten divalenten nicht aromatischen kondensierten polycylischen Gruppe, der substituierten divalenten nicht aromatischen kondensierten heteropolycylischen Gruppe, der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nicht aromatischen kondensierten polycylischen Gruppe und der substituierten monovalenten nicht aromatischen kondensierten heteropolycylischen Gruppe ausgewählt ist aus

einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe,

einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe, einer monovalenten nicht aromatischen kondensierten heteropolycylischen Gruppe, -N($Q_{11}$)($Q_{12}$), -Si($Q_{13}$)($Q_{14}$)($Q_{15}$) und -B($Q_{16}$)($Q_{17}$);

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe, einer monovalenten nicht aromatischen kondensierten heteropolycylischen Gruppe, -N($Q_{21}$)($Q_{22}$), -Si($Q_{23}$)($Q_{24}$)($Q_{25}$) und -B($Q_{26}$)($Q_{27}$); und

-N($Q_{31}$)($Q_{32}$), -Si($Q_{33}$)($Q_{34}$)($Q_{35}$) und -B($Q_{36}$)($Q_{37}$),

wobei $Q_1$ bis $Q_7$, $Q_{11}$ bis $Q_{17}$, $Q_{21}$ bis $Q_{27}$ und $Q_{31}$ bis $Q_{37}$ jeweils unabhängig ausgewählt sind aus einem Wasserstoff, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe.

**5.** OLED nach Anspruch 4, wobei $L_1$ bis $L_3$ in Formel 1 jeweils unabhängig eine kondensierte cyclische Verbindung sind, die aus Gruppen ausgewählt ist, die durch nachstehende Formeln 2-1 bis 2-17 dargestellt werden:

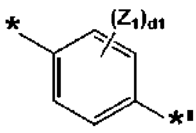
Formel 2-1

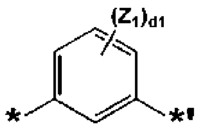
Formel 2-2

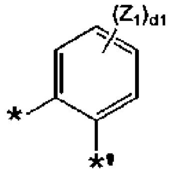
Formel 2-3

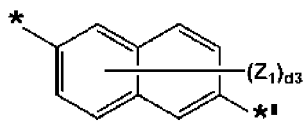
Formel 2-4

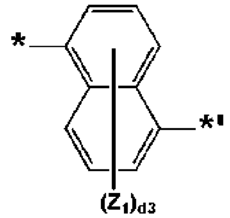
Formel 2-5

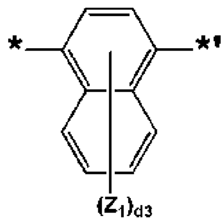
Formel 2-6

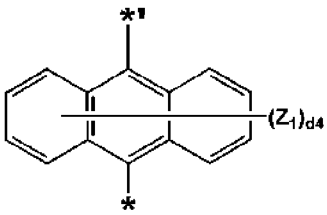
Formel 2-7

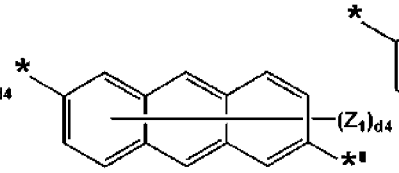
Formel 2-8

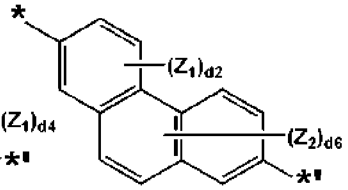
Formel 2-9

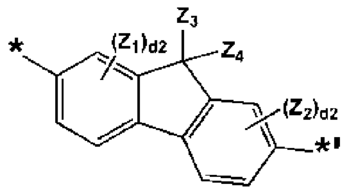
Formel 2-10

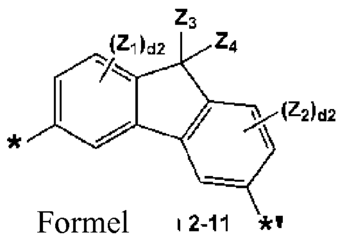
Formel 2-11

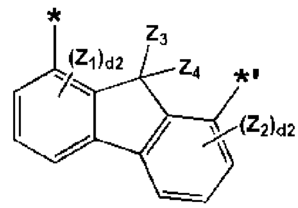
Formel 2-12

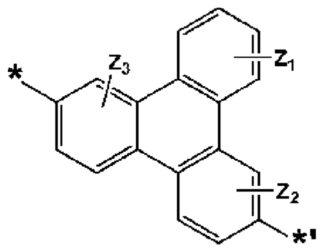
Formel 2-13

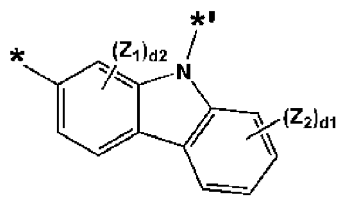
Formel 2-14

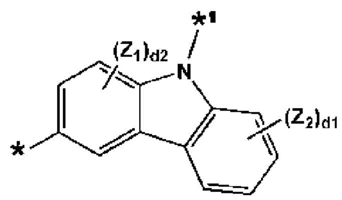
Formel 2-15

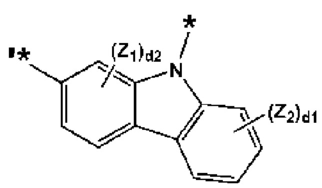
Formel 2-16

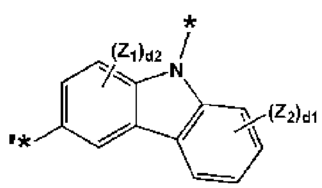
Formel 2-17

wobei in Formeln 2-1 bis 2-17

$Z_1$ bis $Z_4$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Anthracenylgruppe, einer Triphenylenylgruppe, einer Pyrenylgruppe, einer Phenanthrenylgruppe, einer Fluorenylgruppe, einer Chrysenylgruppe, einer Carbazolylgruppe, einer Benzocarbazolylgruppe, einer Dibenzocarbazolylgruppe, einer Dibenzofuranylgruppe, einer Dibenzothiophenylgruppe, einer Pyridinylgruppe, einer Pyrimidinylgruppe, einer Triazinylgruppe, einer Chinolinylgruppe, einer Isochinolinylgruppe, einer Chinazolinylgruppe, einer Chinoxalinylgruppe, einer Biphenylgruppe und $-Si(Q_{33})(Q_{34})(Q_{35})$, wobei $Q_{33}$ bis $Q_{35}$ jeweils unabhängig ausgewählt sind aus einem Wasserstoff, einer $C_1$-$C_{20}$-Alkylgruppe, einer $C_1$-$C_{20}$-Alkoxygruppe, einer Phenylgruppe, einer Naphthylgruppe, einer Anthracenylgruppe, einer Pyrenylgruppe, einer Phenanthrenylgruppe, einer Fluorenylgruppe, einer Chrysenylgruppe, einer Carbazolylgruppe, einer Benzocarbazolylgruppe, einer Dibenzocarbazolylgruppe, einer Dibenzofuranylgruppe, einer Dibenzothiophenylgruppe, einer Pyridinylgruppe, einer Pyrimidinylgruppe, einer Triazinylgruppe, einer Chinolinylgruppe, einer Isochinolinylgruppe, einer Chinazolinylgruppe und einer Chinoxalinylgruppe; und

d1 für eine ganze Zahl von 1 bis 4 steht, d2 für eine ganze Zahl von 1 bis 3 steht, d3 für eine ganze Zahl von 1 bis 6 steht, d4 für eine ganze Zahl von 1 bis 8 steht und d6 für eine ganze Zahl von 1 bis 5 steht und * und *' jeweils eine Bindungsstelle an ein Nachbaratom anzeigen.

**6.** OLED nach Anspruch 4, wobei i) mindestens eines aus $R_2$ und $R_3$ und ii) $R_1$ und $R_7$ jeweils unabhängig ausgewählt sind aus:

einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; und

einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, $-Si(Q_{33})(Q_{34})(Q_{35})$, einer Phenylgruppe, einer Pentalenylgruppe, einer Indenylgruppe, einer Naphthylgruppe, einer Azulenylgruppe, einer Heptalenylgruppe, einer Indacenylgruppe,

einer Acenaphthylgruppe, einer Fluorenylgruppe, einer Spiro-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe, einer Imidazopyrimidinylgruppe und einer Biphenylgruppe.

**7.** OLED nach Anspruch 4, wobei $R_1$ bis $R_7$ jeweils unabhängig ausgewählt sind aus:

einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe und einer $C_1$-$C_{20}$-Alkoxygruppe;
einer $C_1$-$C_{20}$-Alkylgruppe und einer $C_1$-$C_{20}$-Alkoxygruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon und einer Phosphorsäuregruppe oder einem Salz davon;
einer der Gruppen, die durch nachstehende Formeln 4-1 bis 4-31 dargestellt werden; und
$-Si(Q_3)(Q_4)(Q_5)$, (aber $R_4$ bis $R_5$ stehen nicht für $-Si(Q_3)(Q_4)(Q_5)$), und
wobei i) mindestens eines aus $R_2$ und $R_3$ und ii) $R_1$ und $R_7$ jeweils unabhängig durch eine der nachstehende Formeln 4-1 bis 4-31 dargestellt werden:

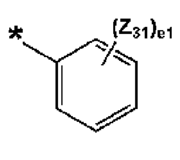
Formel 4-1

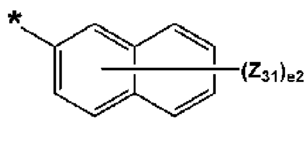
Formel 4-2

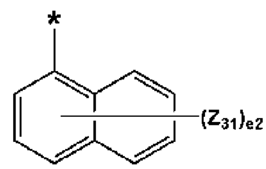
Formel 4-3

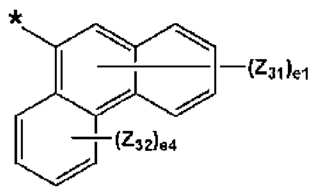
Formel 4-4

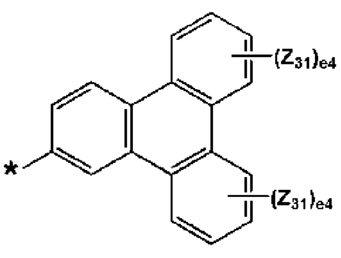
Formel 4-5

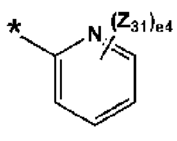
Formel 4-6

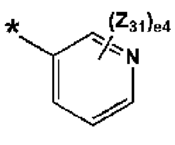
Formel 4-7

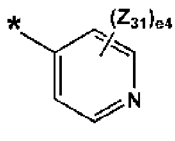
Formel 4-8

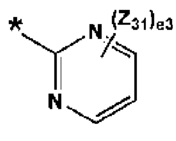
Formel 4-9

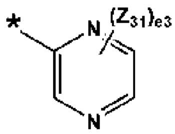
Formel 4-10

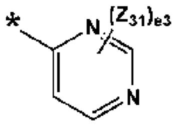
Formel 4-11

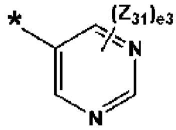
Formel 4-12

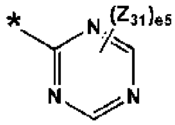
Formel 4-13

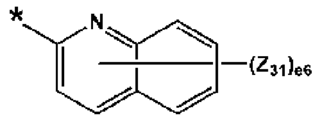
Formel 4-14

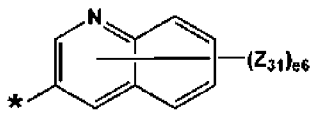
Formel 4-15

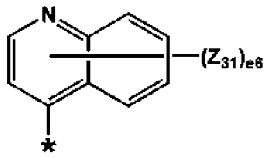
Formel 4-16

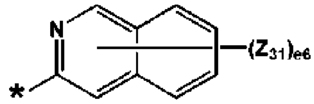
Formel 4-17

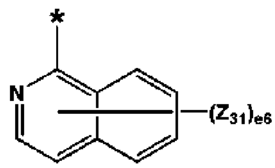
Formel 4-18

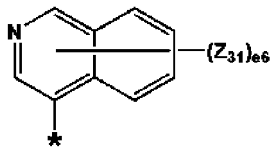
Formel 4-19

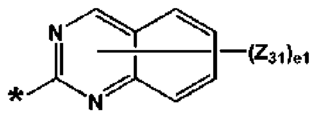
Formel 4-20

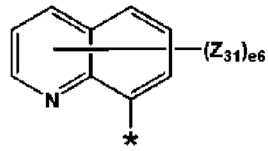
Formel 4-21

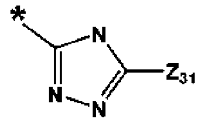
Formel 4-22

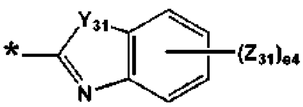
Formel 4-23

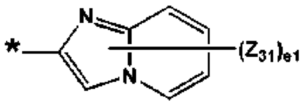
Formel 4-24

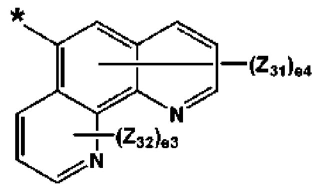
Formel 4-25

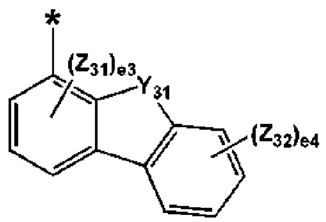
Formel 4-26

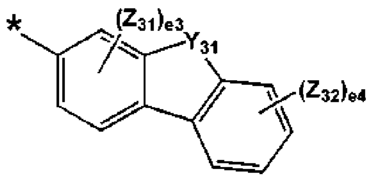
Formel 4-27

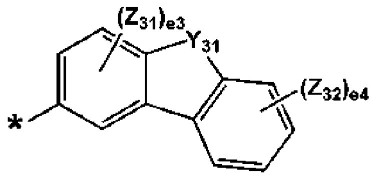
Formel 4-28

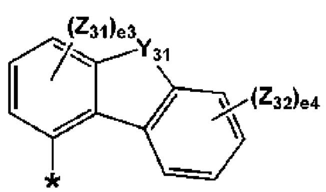
Formel 4-29

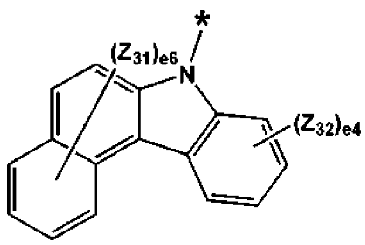
Formel 4-30

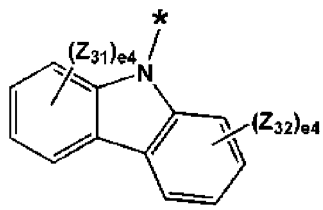
Formel 4-31

wobei in Formeln 4-1 bis 4-31

$Y_{31}$ für O, S, $C(Z_{33})(Z_{34})$, $N(Z_{35})$ oder $Si(Z_{36})(Z_{37})$ steht (unter der Maßgabe, dass $Y_{31}$ in Formel 4-23 nicht für NH steht);

$Z_{31}$ bis $Z_{37}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Anthracenylgruppe, einer Pyrenylgruppe, einer Phenanthrenylgruppe, einer Fluorenylgruppe, einer Chrysenylgruppe, einer Benzocarbazolylgruppe, einer Dibenzocarbazolylgruppe, einer Dibenzofuranylgruppe, einer Dibenzothiophenylgruppe, einer Pyridinylgruppe, einer Pyrimidinylgruppe, einer Triazinylgruppe, einer Chinolinylgruppe, einer Isochinolinylgruppe, einer Chinazolinylgruppe, einer Chinoxalinylgruppe, einer Biphenylgruppe und -Si($Q_{33}$)($Q_{34}$)($Q_{35}$), wobei $Q_3$ bis $Q_5$ und $Q_{33}$ bis $Q_{35}$ jeweils unabhängig ausgewählt sind aus einem Wasserstoff, einer $C_1$-$C_{20}$-Alkylgruppe, einer $C_1$-$C_{20}$-Alkoxygruppe, einer Phenylgruppe, einer Naphthylgruppe, einer Anthracenylgruppe, einer Pyrenylgruppe, einer Phenanthrenylgruppe, einer Fluorenylgruppe, einer Chrysenylgruppe, einer Carbazolylgruppe, einer Benzocarbazolylgruppe, einer Dibenzocarbazolylgruppe, einer Dibenzofuranylgruppe, einer Dibenzothiophenylgruppe, einer Pyridinylgruppe, einer Pyrimidinylgruppe, einer Triazinylgruppe, einer Chinolinylgruppe, einer Isochinolinylgruppe, einer Chinazolinylgruppe und einer Chinoxalinylgruppe; und

e1 für eine ganze Zahl von 1 bis 5 steht, e2 für eine ganze Zahl von 1 bis 7 steht, e3 für eine ganze Zahl von 1 bis 3 steht, e4 für eine ganze Zahl von 1 bis 4 steht, e5 für eine ganze Zahl von 1 oder 2 steht und e6 für eine ganze Zahl von 1 bis 6 steht und * für eine Bindungsstelle an ein Nachbaratom steht.

**8.** OLED nach einem der Ansprüche 1-7, wobei der elektronenleitende Host mindestens eine der nachstehenden Verbindungen EH1-401 bis EH1-415 und EH2-1 bis EH2-30 umfasst:

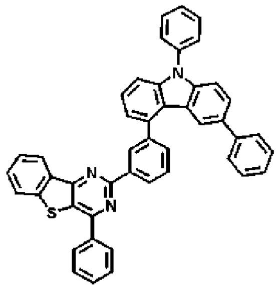

EH1-401

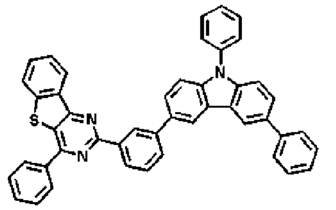

EH1-402

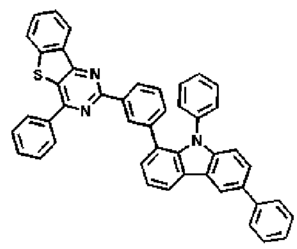

EH1-403

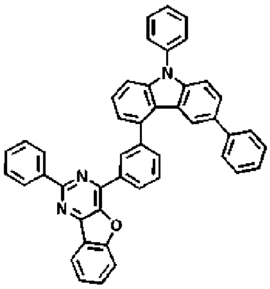

EH1-404

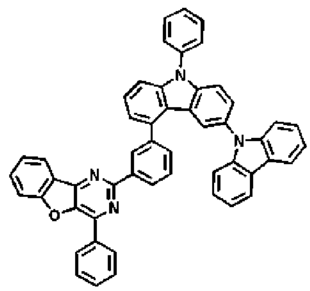

EH1-405

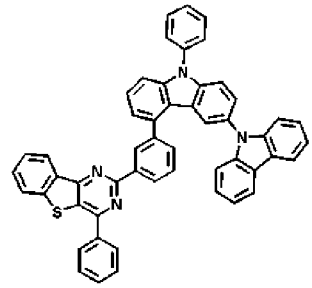

EH1-406

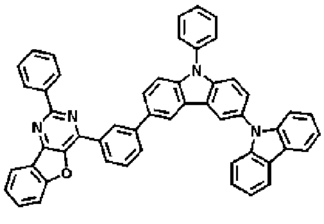

EH1-407

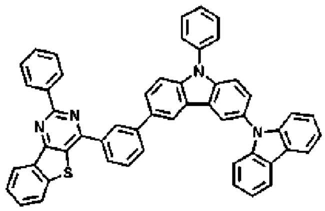

EH1-408

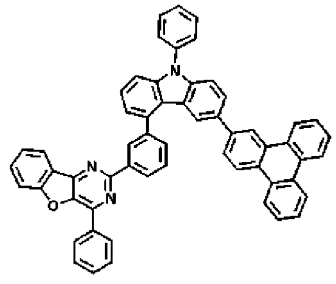

EH1-409

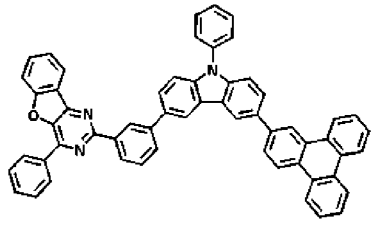

EH1-410

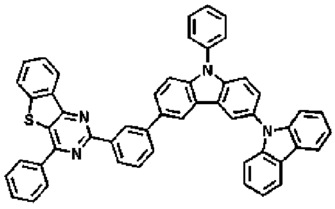

EH1-411

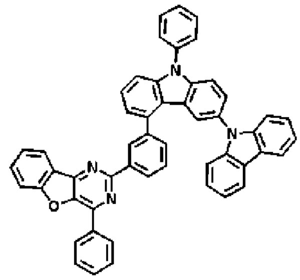

EH1-412

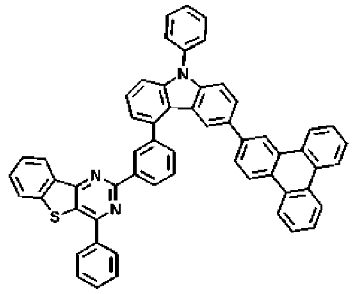

EH1-413

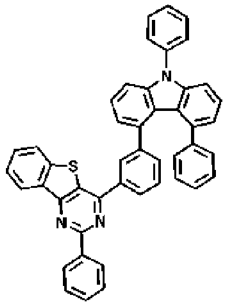

EH1-414

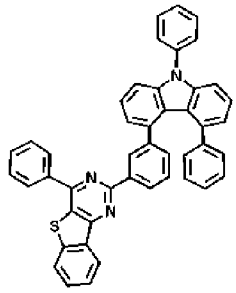

EH1-415

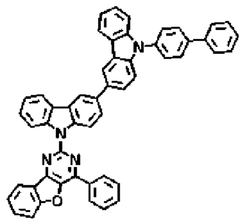

EH2-1

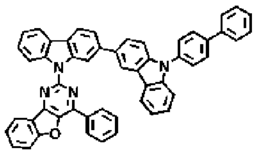

EH2-2

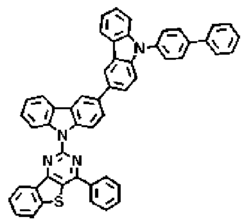

EH2-3

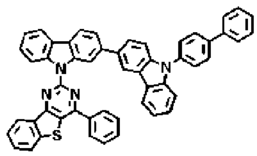

EH2-4

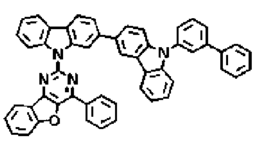

EH2-5

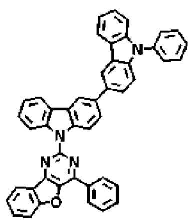

EH2-6

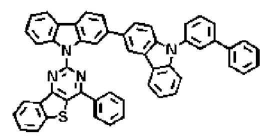

EH2-7

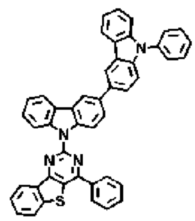

EH2-8

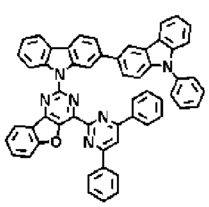

EH2-9

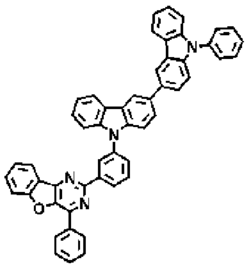

EH2-10

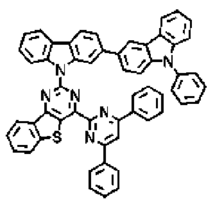

EH2-11

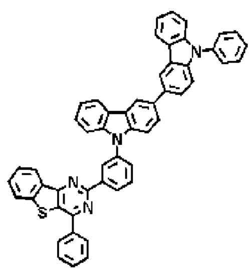

EH2-12

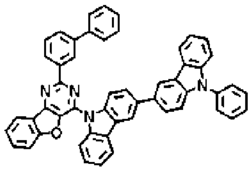

EH2-13

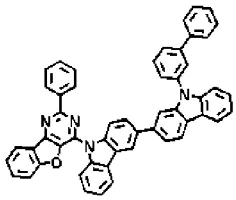

EH2-14

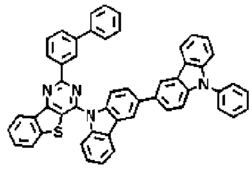

EH2-15

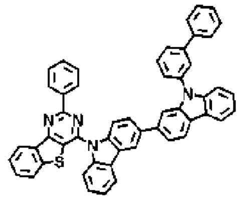

EH2-16

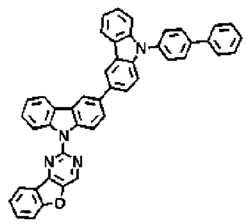

EH2-17

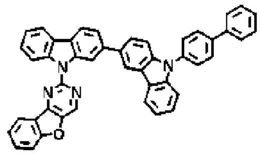

EH2-18

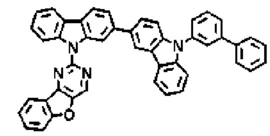

EH2-19

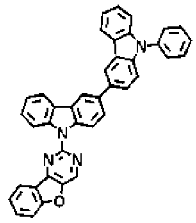

EH2-20

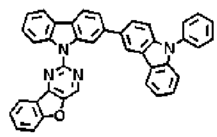

EH2-21

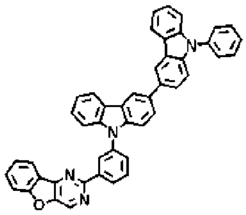

EH2-22

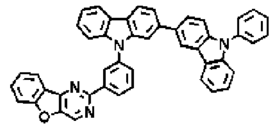

EH2-23

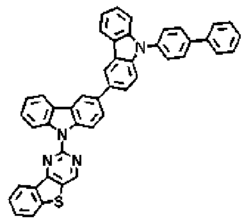

EH2-24

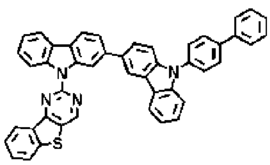

EH2-25

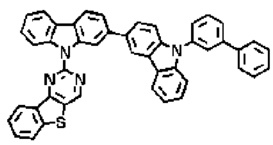

EH2-26

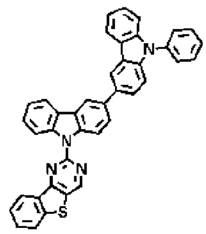

EH2-27

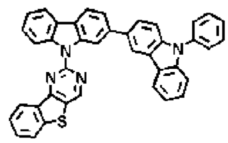

EH2-28

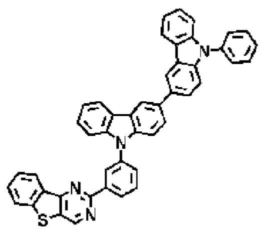

EH2-29

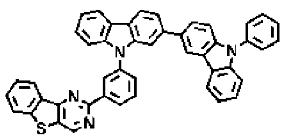

EH2-30

**9.** OLED nach einem der Ansprüche 1-7, wobei der elektronenleitende Host eine Verbindung umfasst, die durch nachstehende Formel 10 dargestellt wird:

<Formel 10>

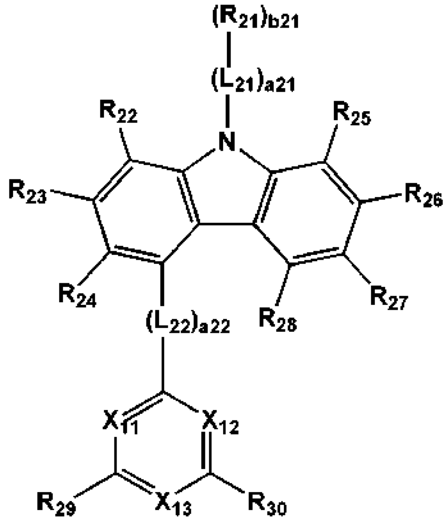

wobei in Formel 10

$L_{21}$ bis $L_{22}$ jeweils unabhängig ausgewählt sind aus einer substituierten oder unsubstituierten $C_3$-$C_{10}$-Cycloalkylengruppe, einer substituierten oder unsubstituierten $C_1$-$C_{10}$-Heterocycloalkylengruppe, einer substituierten oder unsubstituierten $C_3$-$C_{10}$-Cycloalkenylengruppe, einer substituierten oder unsubstituierten $C_1$-$C_{10}$-Heterocycloalkenylengruppe, einer substituierten oder unsubstituierten $C_6$-$C_{60}$-Arylengruppe, einer substituierten oder unsubstituierten $C_1$-$C_{60}$-Heteroarylengruppe, einer substituierten oder unsubstituierten divalenten nicht aromatischen kondensierten polycylischen Gruppe und einer substituierten oder unsubstituierten divalenten nicht aromatischen kondensierten heteropolycylischen Gruppe;

a21 und a22 jeweils unabhängig für eine ganze Zahl von 0 bis 3 stehen;

$X_{11}$ für N oder $C(R_{51})$ steht, $X_{12}$ für N oder $C(R_{52})$ steht, $X_{13}$ für N oder $C(R_{53})$ steht und mindestens zwei aus $X_{11}$ bis $X_{13}$ für N stehen,

$R_{21}$ bis $R_{30}$ und $R_{51}$ bis $R_{53}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkynylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_1$-$C_{60}$-Heteroarylgruppe, einer substituierten oder unsubstituierten monovalenten nicht aromatischen kondensierten polycylischen Gruppe, einer substituierten oder unsubstituierten monovalenten nicht aromatischen kondensierten heteropolycylischen Gruppe und $-Si(Q_{41})(Q_{42})(Q_{43})$,

b21 und b22 jeweils unabhängig für eine ganze Zahl von 1 bis 5 stehen;

mindestens eines aus $R_{25}$ bis $R_{28}$ ausgewählt ist aus einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_1$-$C_{60}$-Heteroarylgruppe, einer substituierten oder unsubstituierten monovalenten nicht aromatischen kondensierten polycylischen Gruppe und einer substituierten oder unsubstituierten monovalenten nicht aromatischen kondensierten heteropolycylischen Gruppe; und

mindestens einer von Substituenten aus der substituierten $C_3$-$C_{10}$-Cycloalkylengruppe, der substituierten $C_1$-$C_{10}$-Heterocycloalkylengruppe, der substituierten $C_3$-$C_{10}$-Cycloalkenylengruppe, der substituierten $C_1$-$C_{10}$-Heterocycloalkenylengruppe, der substituierten $C_6$-$C_{60}$-Arylengruppe, der substituierten $C_1$-$C_{60}$-Hete-

roarylengruppe, der substituierten divalenten nicht aromatischen kondensierten polycylischen Gruppe, der substituierten divalenten nicht aromatischen kondensierten heteropolycylischen Gruppe, der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nicht aromatischen kondensierten polycylischen Gruppe und der substituierten monovalenten nicht aromatischen kondensierten heteropolycylischen Gruppe ausgewählt ist aus:

einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;

einer $C_1$-$C_{60}$-Alkylgruppe, einer $C_2$-$C_{60}$-Alkenylgruppe, einer $C_2$-$C_{60}$-Alkynylgruppe und $C_1$-$C_{60}$-Alkoxygruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe, einer monovalenten nicht aromatischen kondensierten heteropolycylischen Gruppe, $-Si(Q_{51})(Q_{52})(Q_{53})$ und $-B(Q_{54})(Q_{55})$;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe, einer monovalenten nicht aromatischen kondensierten heteropolycylischen Gruppe, $-Si(Q_{61})(Q_{62})(Q_{63})$ und $-B(Q_{64})(Q_{65})$; und

$-Si(Q_{71})(Q_{72})(Q_{73})$ und $-B(Q_{74})(Q_{75})$,

wobei $Q_{41}$ bis $Q_{43}$, $Q_{51}$ bis $Q_{55}$, $Q_{61}$ bis $Q_{65}$ und $Q_{71}$ bis $Q_{75}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe, wobei bevorzugt:

$L_{21}$ und $L_{22}$ in Formel 10 jeweils unabhängig ausgewählt sind aus:

einer Phenylengruppe, einer Naphthylengruppe, einer Phenalenylengruppe, einer Phenanthrenylengruppe, einer Triphenylenylengruppe, einer Anthracenylengruppe, einer Pyrrolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Furanylengruppe, einer Benzofuranylengruppe, einer Thiophenylengruppe, einer Benzothiophenylengruppe und einer Triazinylengruppe;

einer Phenylengruppe, einer Naphthylengruppe, einer Phenalenylengruppe, einer Phenanthrenylengruppe, einer Triphenylenylengruppe, einer Anthracenylengruppe, einer Pyrrolylengruppe, einer Pyridinylengruppe, einer

Pyrazinylengruppe, einer Pyrimidinylengruppe, einer Pyridazinylengruppe, einer Isoindolylengruppe, einer Indolylengruppe, einer Furanylengruppe, einer Benzofuranylengruppe, einer Thiophenylengruppe, einer Benzothiophenylengruppe und einer Triazinylengruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Anthracenylgruppe, einer Pyrenylgruppe, einer Phenanthrenylgruppe, einer Triphenylenylgruppe, einer Fluorenylgruppe, einer Carbazolylgruppe, einer Benzocarbazolylgruppe, einer Dibenzocarbazolylgruppe, einer Pyridinylgruppe, einer Pyrimidinylgruppe, einer Pyrazinylgruppe, einer Pyridazinylgruppe, einer Triazinylgruppe, einer Chinolinylgruppe, einer Isochinolinylgruppe, einer Phthalazinylgruppe, einer Chinoxalinylgruppe, einer Cinnolinylgruppe und einer Chinazolinylgruppe; und
Gruppen, die durch nachstehende Formeln 11-1 bis 11-6 dargestellt werden:

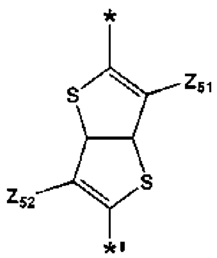
Formel 11-1

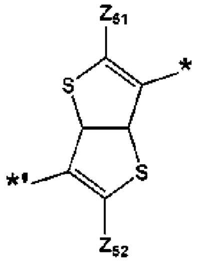
Formel 11-2

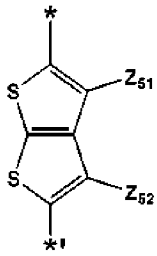
Formel 11-3

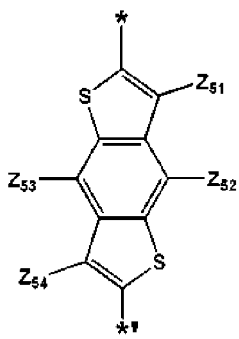
Formel 11-4

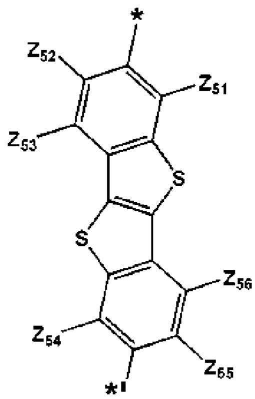
Formel 11-5

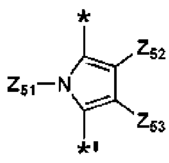
Formel 11-6

wobei in Formeln 11-1 bis 11-6

$Z_{51}$ bis $Z_{56}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Anthracenylgruppe, einer Pyrenylgruppe, einer Phenanthrenylgruppe, einer Triphenylenylgruppe, einer Fluorenylgruppe, einer Carbazolylgruppe, einer Benzocarbazolylgruppe, einer Dibenzocarbazolylgruppe, einer Pyridinylgruppe, einer Pyrimidinylgruppe, einer Pyrazinylgruppe, einer Pyridazinylgruppe, einer Triazinylgruppe, einer Chinolinylgruppe, einer Isochinolinylgruppe, einer Phthalazinylgruppe, einer Chinoxalinylgruppe, einer Cinnolinylgruppe und einer Chinazolinylgruppe, und
* eine Bindungsstelle an ein Nachbaratom anzeigt; und/oder
$R_{21}$ aus Gruppen, die durch Formeln 15-1 bis 15-40 dargestellt werden, und -Si($Q_{41}$)($Q_{42}$)($Q_{43}$) ausgewählt ist (wobei $Q_{41}$ bis $Q_{43}$ jeweils unabhängig ausgewählt sind aus einem Wasserstoff, einer $C_1$-$C_{20}$-Alkylgruppe, einer $C_1$-$C_{20}$-Alkoxygruppe, einer Phenylgruppe, einer Naphthylgruppe, einer Anthracenylgruppe, einer Pyrenylgruppe, einer Phenanthrenylgruppe, einer Triphenylenylgruppe, einer Fluorenylgruppe, einer Carbazolylgruppe, einer Benzocarbazolylgruppe, einer Dibenzocarbazolylgruppe, einer Pyridinylgruppe, einer Pyrimidinylgruppe, einer Pyrazinylgruppe, einer Pyridazinylgruppe, einer Triazinylgruppe, einer Chinolinylgruppe, einer Isochinolinylgruppe, einer Phthalazinylgruppe, einer Chinoxalinylgruppe, einer Cinnolinyl-

gruppe und einer Chinazolinylgruppe);
$R_{22}$ bis $R_{24}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe und einer $C_1$-$C_{20}$-Alkoxygruppe;
$R_{25}$ bis $R_{30}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe und Gruppen, die durch nachstehende Formeln 15-1 bis 15-40 dargestellt werden;
mindestens eines aus $R_{25}$ bis $R_{28}$ ausgewählt ist aus Gruppen, die durch nachstehende Formeln 15-1 bis 15-40 dargestellt werden; und
mindestens eines aus $R_{29}$ und $R_{30}$ ausgewählt ist aus Gruppen, die durch nachstehende Formeln 15-1 bis 15-40 dargestellt werden:

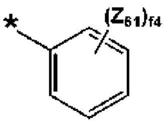
Formel 15-1

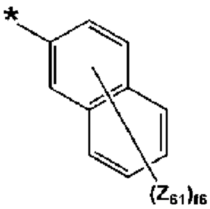
Formel 15-2

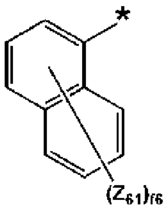
Formel 15-3

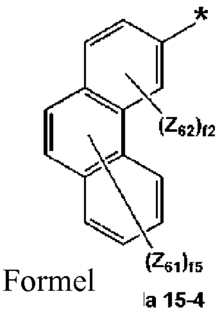
Formel 15-4

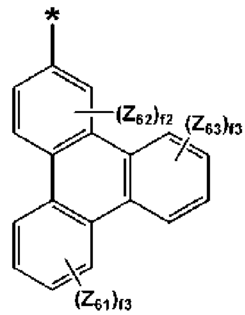
Formel 15-5

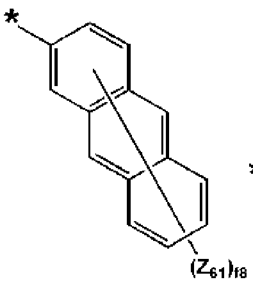
Formel 15-6

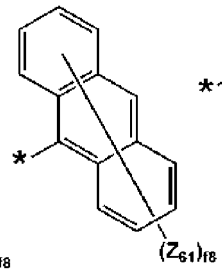
Formel 15-7

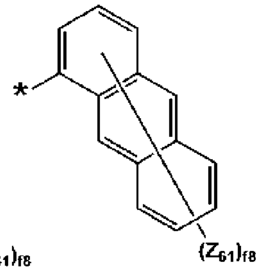
Formel 15-8

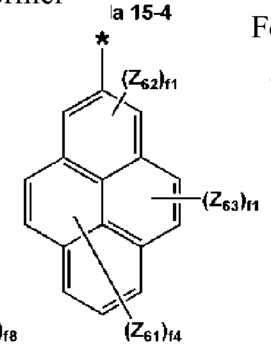
Formel 15-9

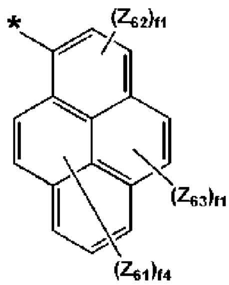
Formel 15-10

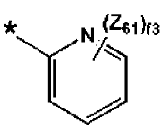
Formel 15-11

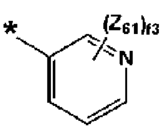
Formel 15-12

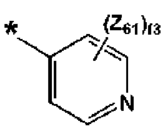
Formel 15-13

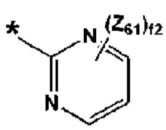
Formel 15-14

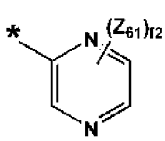
Formel 15-15

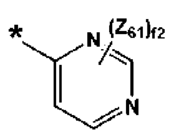
Formel 15-16

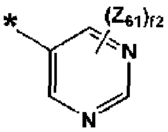
Formel 15-17

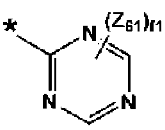
Formel 15-18

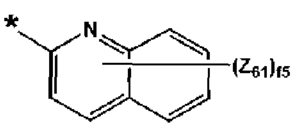
Formel 15-19

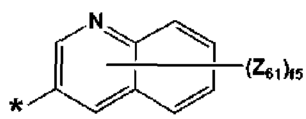
Formel 15-20

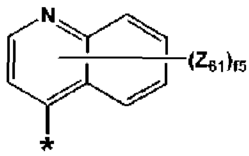
Formel 15-21

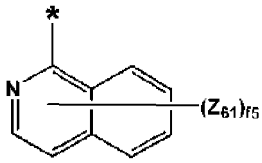
Formel 15-22

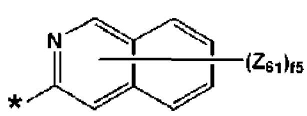
Formel 15-23

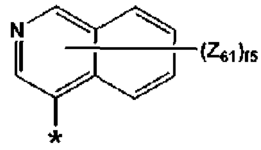
Formel 15-24

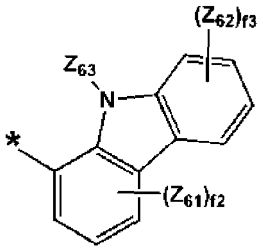
Formel 15-25

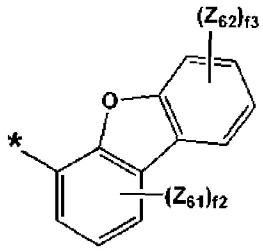
Formel 15-26

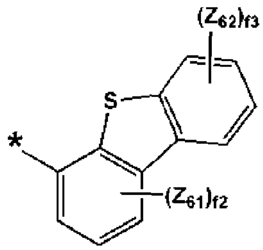
Formel 15-27

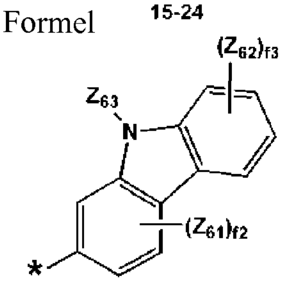
Formel 15-28

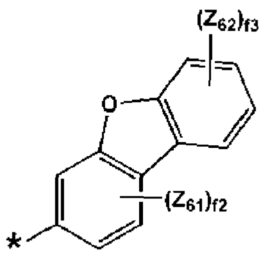
Formel 15-29

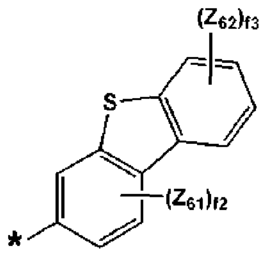
Formel 15-30

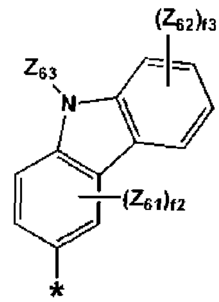
Formel 15-31

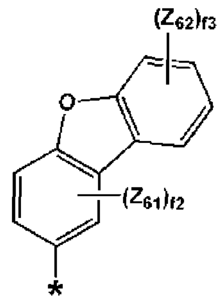
Formel 15-32

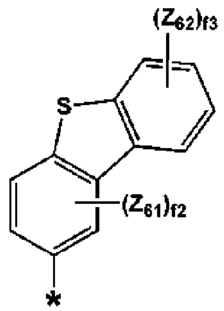
Formel 15-33

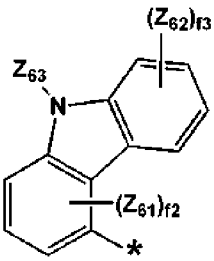
Formel 15-34

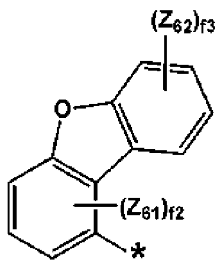
Formel 15-35

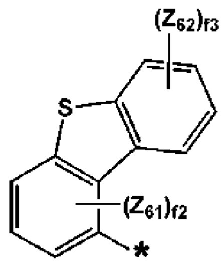
Formel 15-36

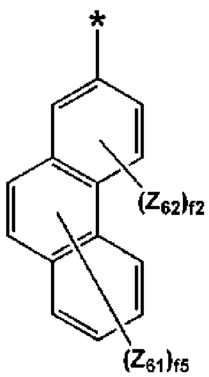
Formel 15-37

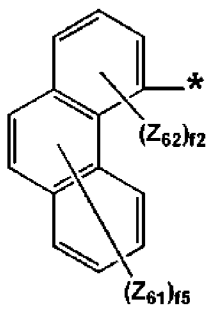
Formel 15-38

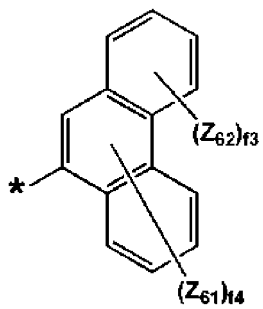
Formel 15-39

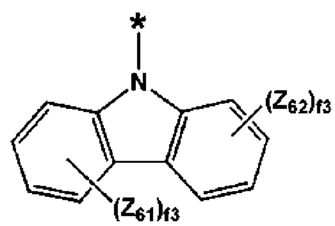
Formel 15-40

wobei in Formeln 15-1 bis 15-40

$Z_{61}$ bis $Z_{63}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_2$-$C_{20}$-Alkenylgruppe, einer $C_2$-$C_{20}$-Alkynylgruppe, einer $C_1$-$C_{20}$-Alkoxygruppe, einer Phenylgruppe, einer Naphthylgruppe, einer Anthracenylgruppe, einer Pyrenylgruppe, einer Phenanthrenylgruppe, einer Fluorenylgruppe, einer Carbazolylgruppe, einer Benzocarbazolylgruppe, einer Dibenzocarbazolylgruppe, einer Pyridinylgruppe, einer Pyrimidinylgruppe, einer Pyrazinylgruppe, einer Pyridazinylgruppe, einer Triazinylgruppe, einer Chinolinylgruppe, einer Isochinolinylgruppe, einer Phthalazinylgruppe, einer Chinoxalinylgruppe, einer Cinnolinylgruppe und einer Chinazolinylgruppe;
f1 für 1 oder 2 steht, f2 für eine ganze Zahl von 1 bis 3 steht, f3 für eine ganze Zahl von 1 bis 4 steht, f4 für eine ganze Zahl von 1 bis 5 steht, f5 für eine ganze Zahl von 1 bis 6 steht, f6 für eine ganze Zahl von 1 bis 7 steht, f7 für eine ganze Zahl von 1 bis 8 steht und f8 für eine ganze Zahl von 1 bis 9 steht; und
* eine Bindungsstelle an ein Nachbaratom anzeigt.

**10.** OLED nach Anspruch 9, wobei $L_{21}$ und $L_{22}$ jeweils unabhängig aus Gruppen ausgewählt sind, die durch nachstehende Formeln 12-1 bis 12-15 dargestellt werden;

$X_{11}$ bis $X_{13}$ für N stehen;
a21 und a22 jeweils unabhängig für 0 oder 1 stehen;
$R_{22}$ bis $R_{26}$ und $R_{28}$ für einen Wasserstoff stehen;
$R_{27}$, $R_{29}$ und $R_{30}$ jeweils unabhängig ausgewählt sind aus Gruppen, die durch vorstehende Formeln 15-1 bis 15-40 dargestellt werden:

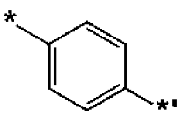
Formel 12-1

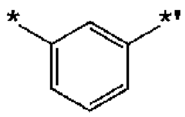
Formel 12-2

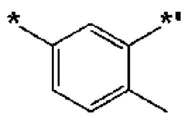
Formel 12-3

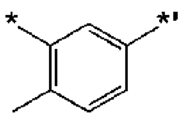
Formel 12-4

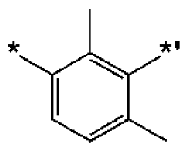
Formel 12-5

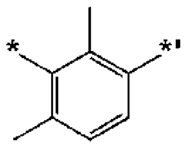
Formel 12-6

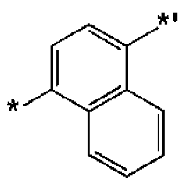
Formel 12-7

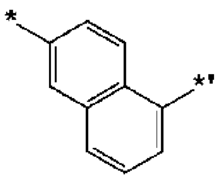
Formel 12-8

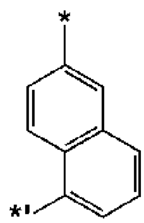
Formel 12-9

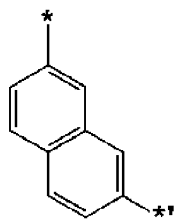
Formel 12-10

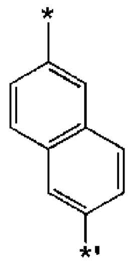
Formel 12-11

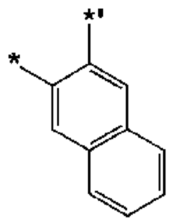
Formel 12-12

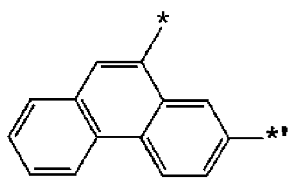
Formel 12-13

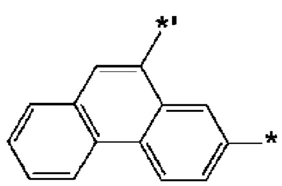
Formel 12-14

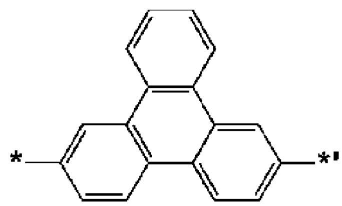
Formel 12-15

wobei in Formeln 12-1 bis 12-15 * und *' jeweils unabhängig eine Bindungsstelle an ein Nachbaratom anzeigen.

**11.** OLED nach einem der Ansprüche 1-7, wobei der elektronenleitende Host mindestens eine der nachstehenden Verbindungen EH3-1 bis EH3-102 umfasst:

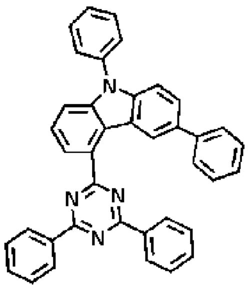

**EH3-1**

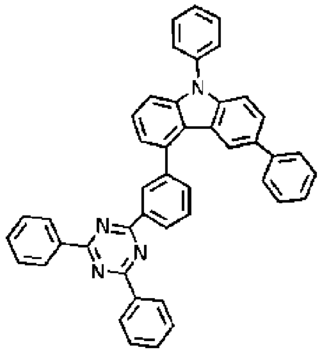

**EH3-2**

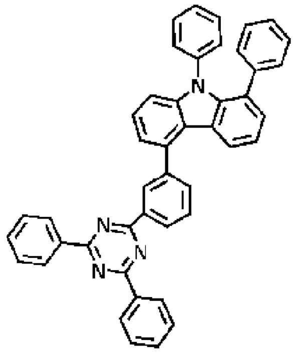

**EH3-3**

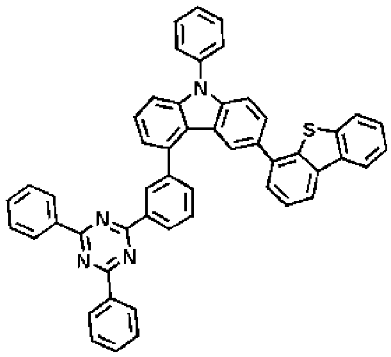

**EH3-4**

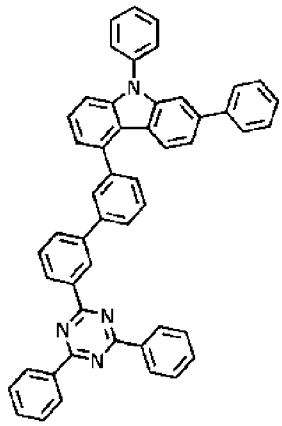

**EH3-5**

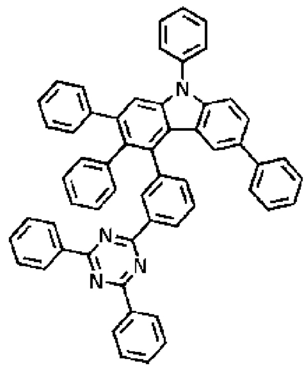

**EH3-6**

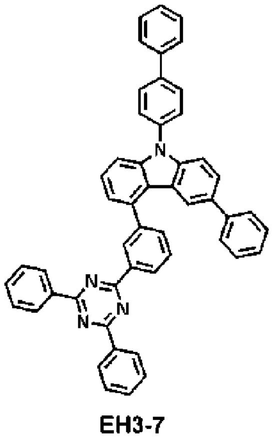

**EH3-7**

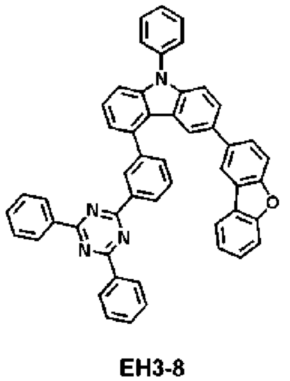

**EH3-8**

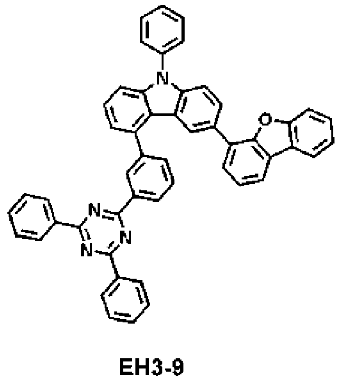

**EH3-9**

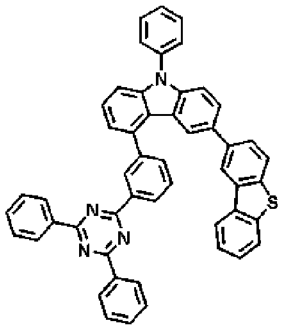

EH3-10

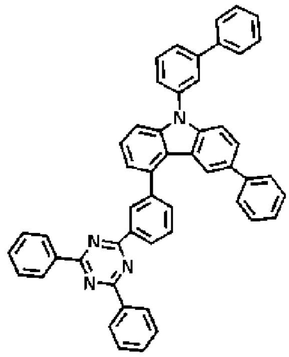

EH3-11

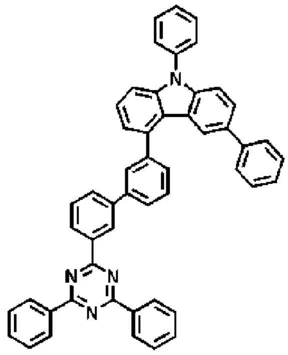

EH3-12

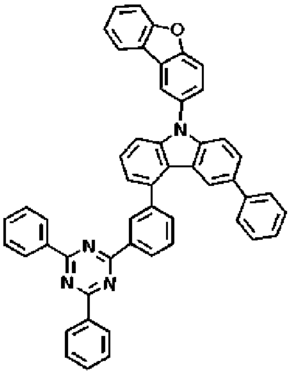

EH3-13

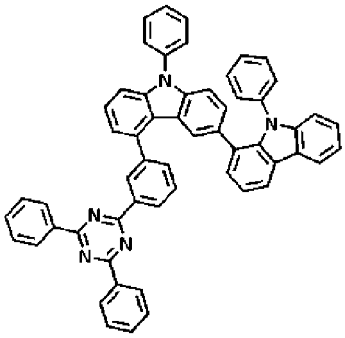

EH3-14

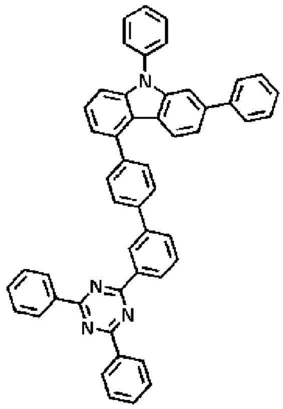

EH3-15

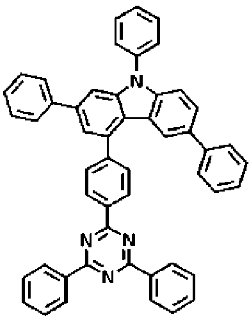

EH3-16

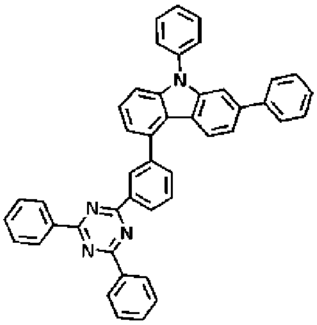

EH3-17

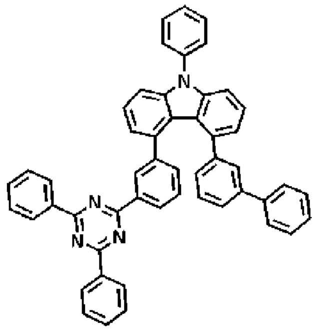

EH3-18

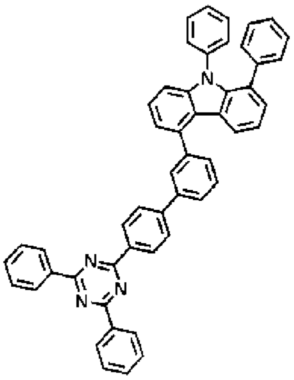

EH3-19

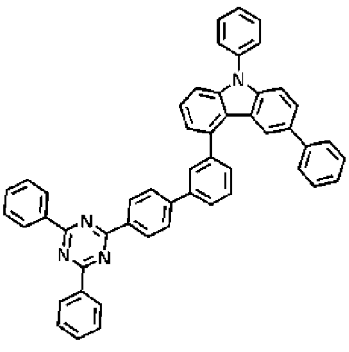

EH3-20

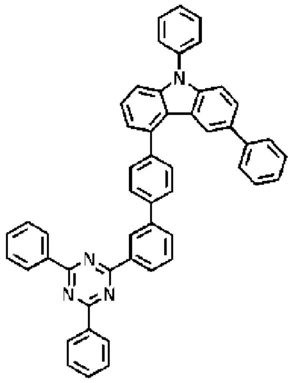

EH3-21

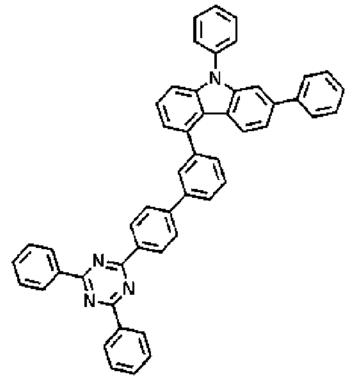

**EH3-22**

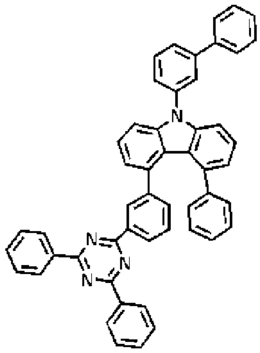

**EH3-23**

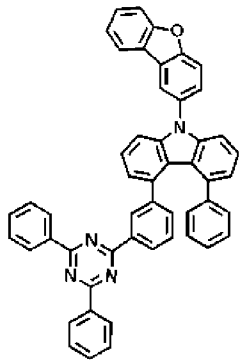

**EH3-24**

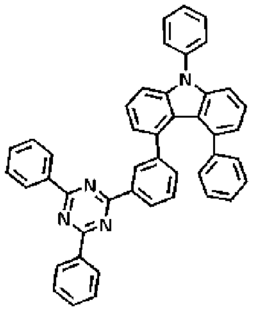

**EH3-25**

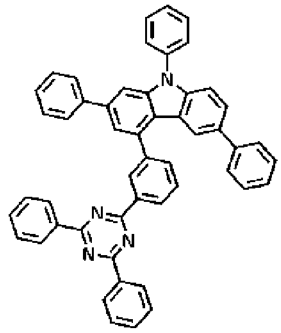

**EH3-26**

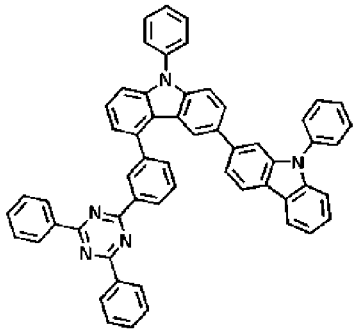

**EH3-27**

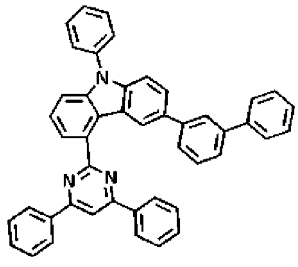

**EH3-28**

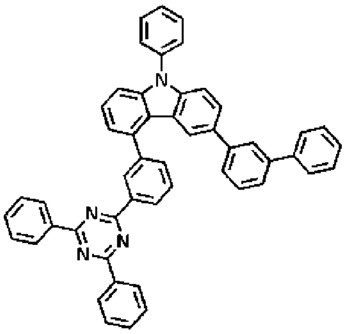

**EH3-29**

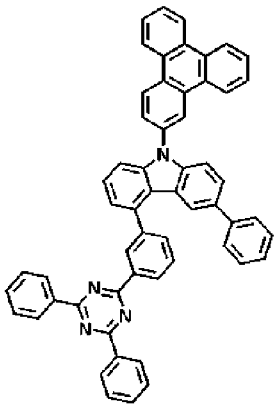

**EH3-30**

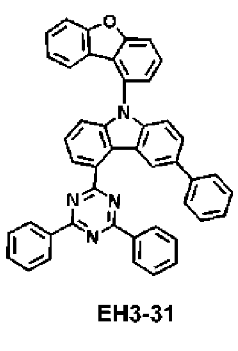

**EH3-31**

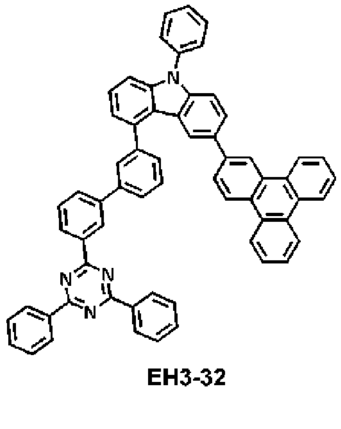

**EH3-32**

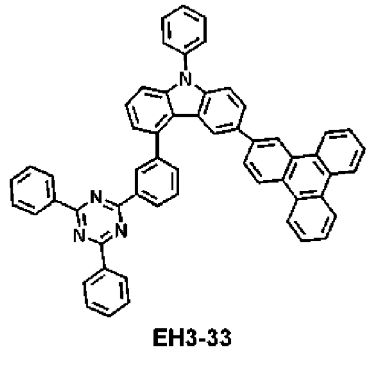

**EH3-33**

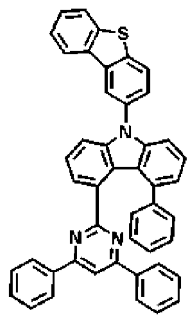

EH3-34

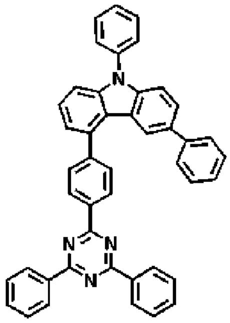

EH3-35

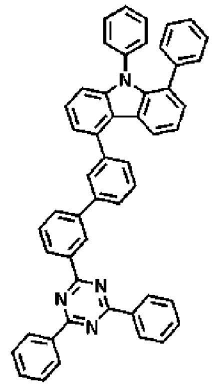

EH3-36

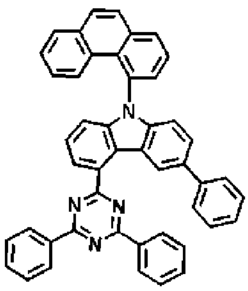

EH3-37

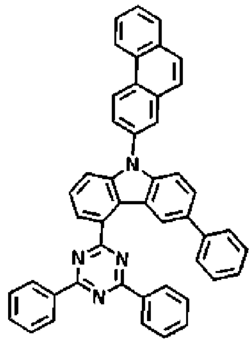

EH3-38

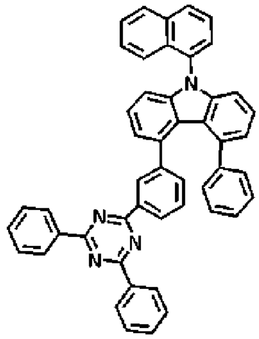

EH3-39

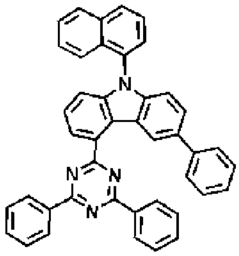

EH3-40

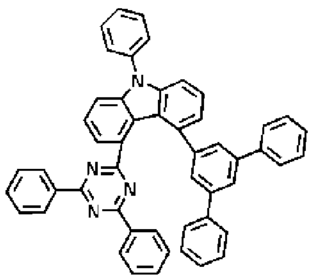

EH3-41

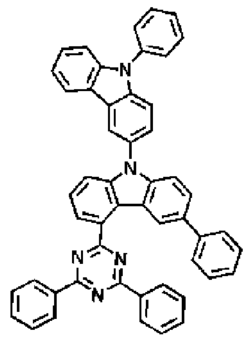

EH3-42

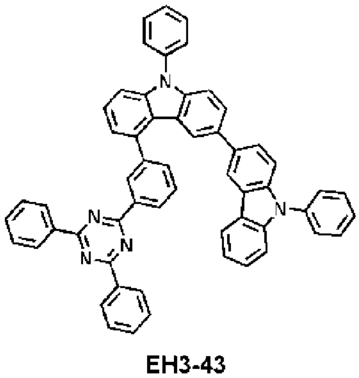

EH3-43

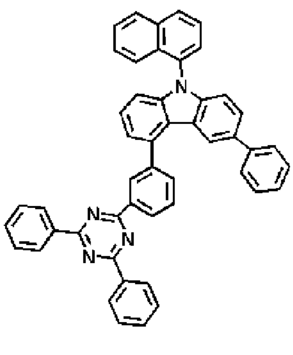

EH3-44

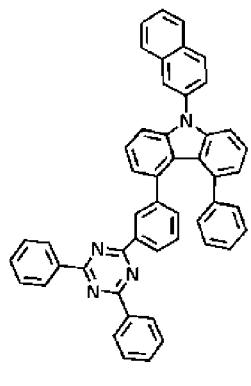

EH3-45

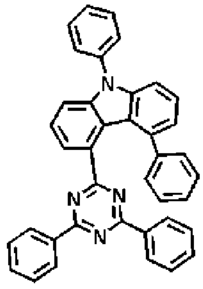

EH3-46

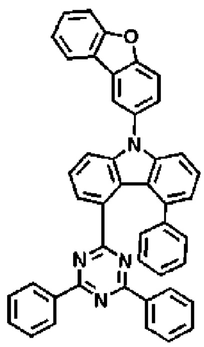

EH3-47

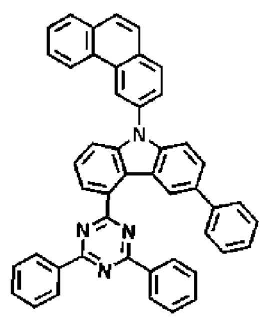

EH3-48

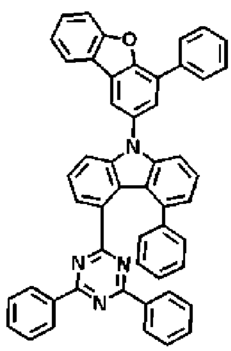

EH3-49

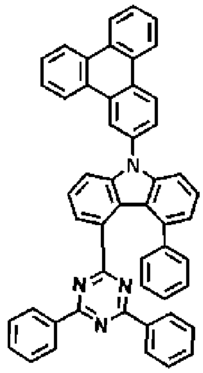

EH3-50

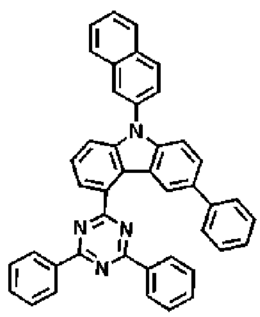

EH3-51

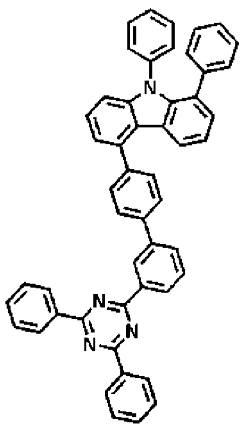

EH3-52

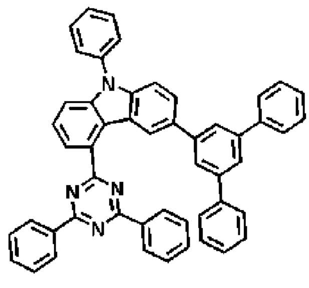

EH3-53

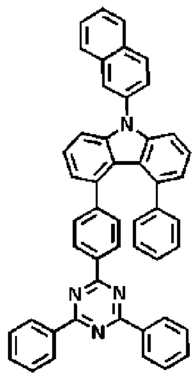

EH3-54

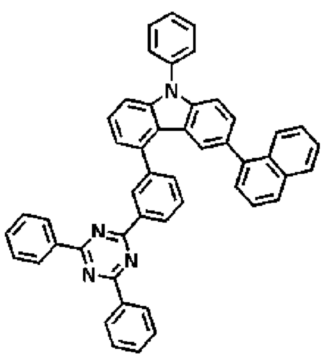

EH3-55

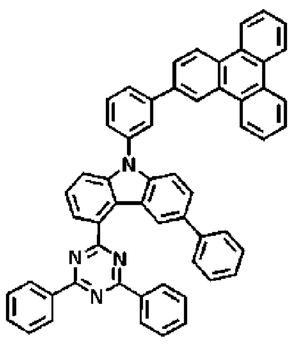

EH3-56

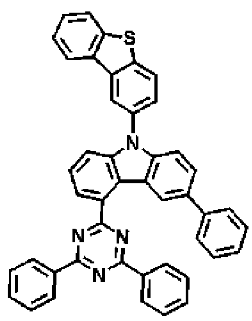

EH3-57

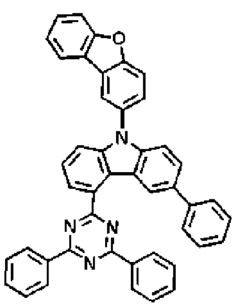

EH3-58

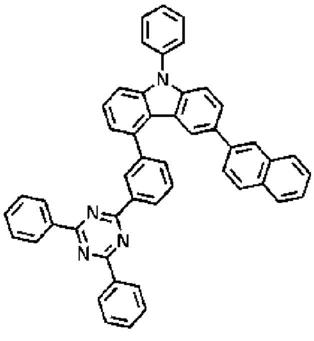

EH3-59

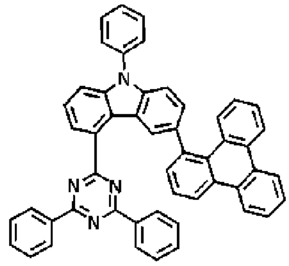

EH3-60

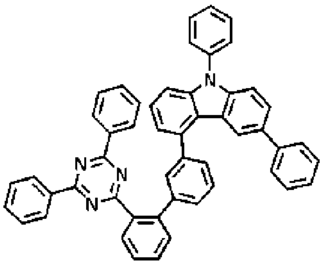

EH3-61

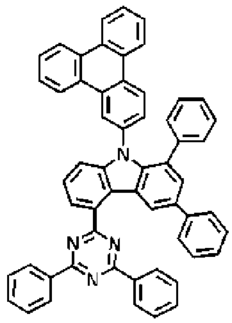

EH3-62

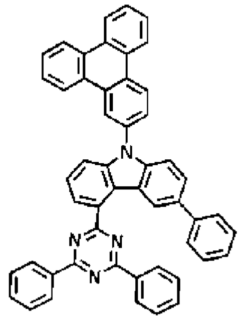

EH3-63

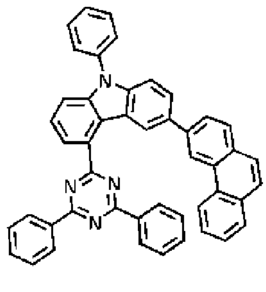

EH3-64

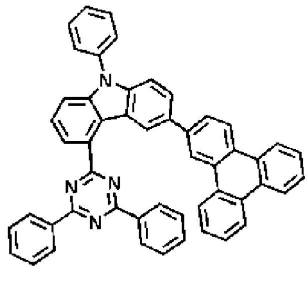

EH3-65

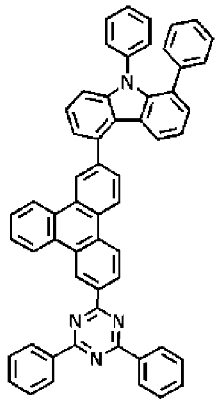

EH3-66

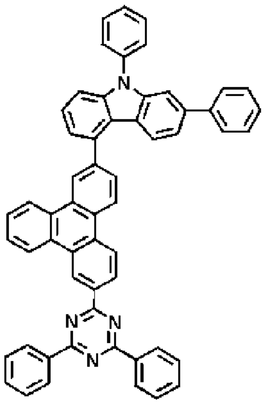

EH3-67

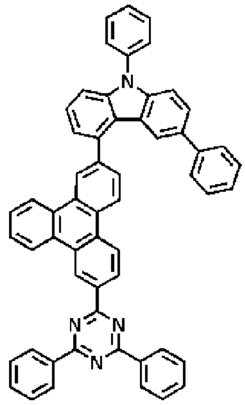

EH3-68

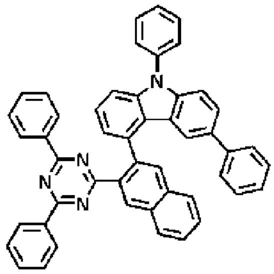

EH3-69

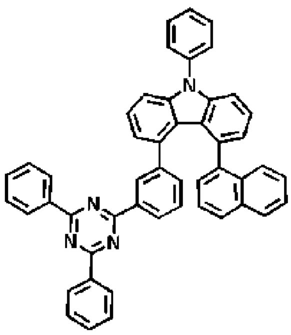
EH3-70

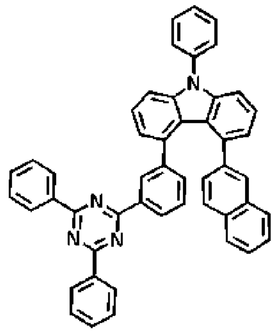
EH3-71

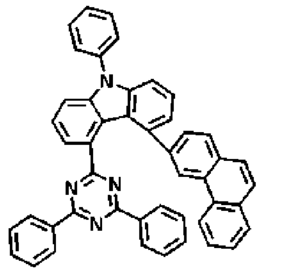
EH3-72

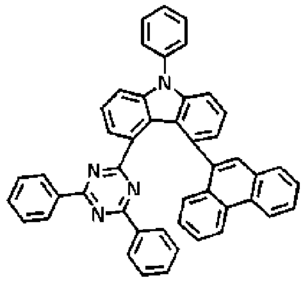
EH3-73

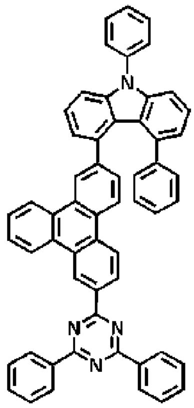
EH3-74

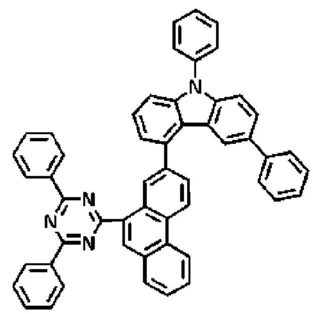
EH3-75

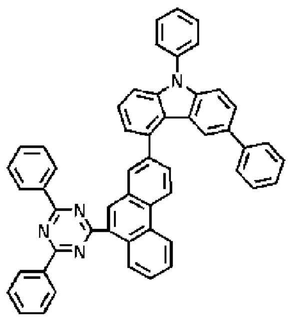
EH3-76

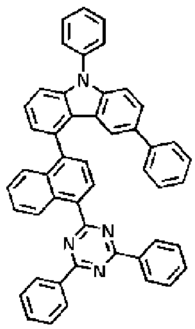
EH3-77

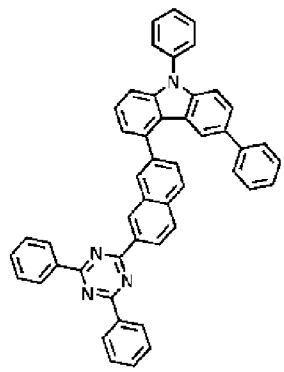
EH3-78

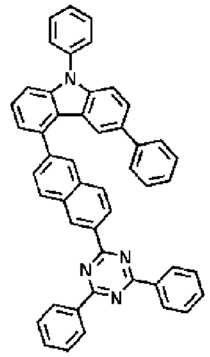
EH3-79

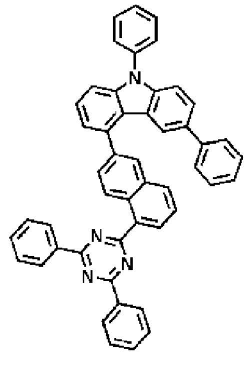
EH3-80

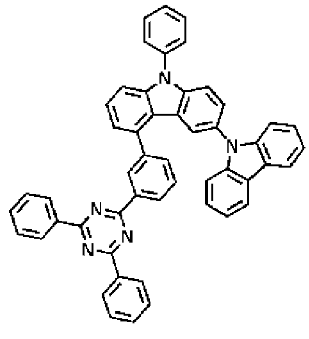
EH3-81

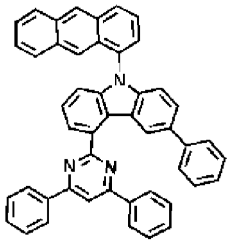

EH3-82

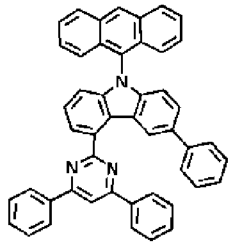

EH3-83

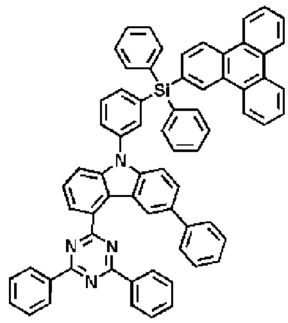

EH3-84

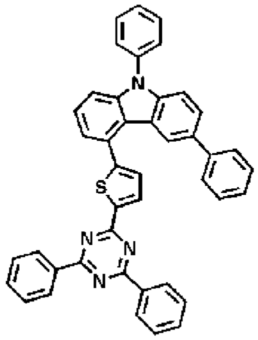

EH3-85

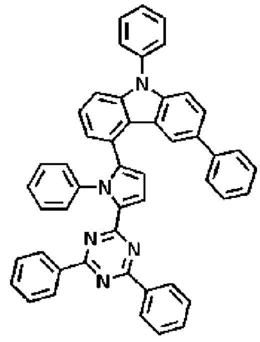

EH3-86

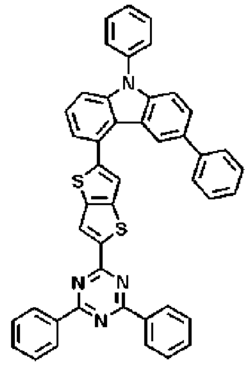

EH3-87

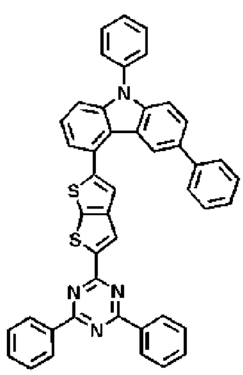

EH3-88

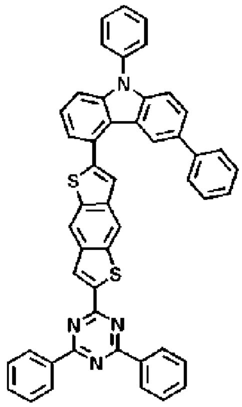

EH3-89

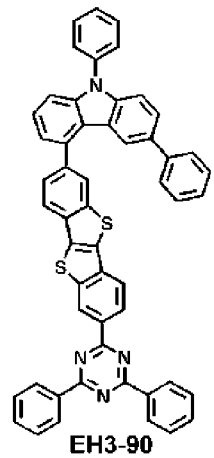

EH3-90

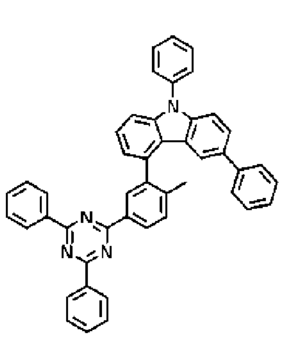

EH3-91

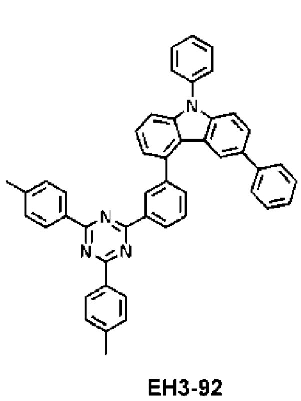

EH3-92

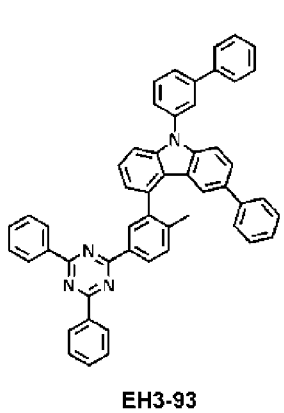

EH3-93

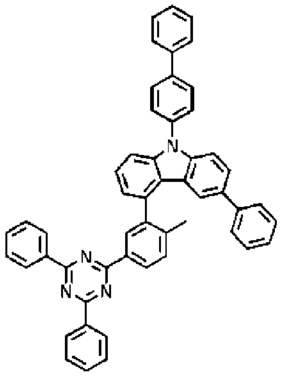

**EH3-94**

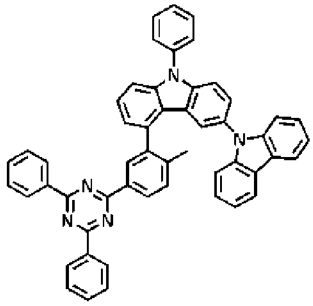

**EH3-95**

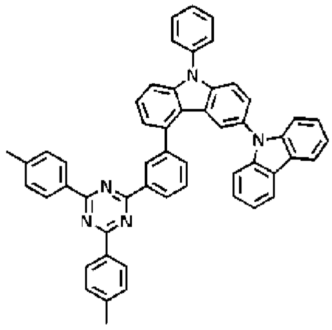

**EH3-96**

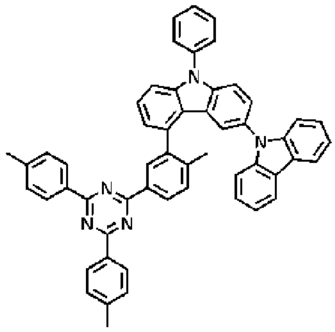

**EH3-97**

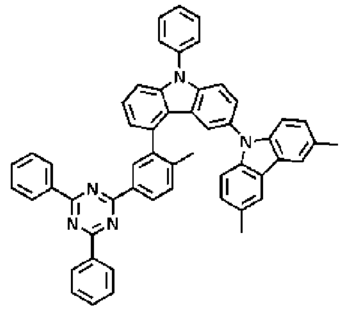

**EH3-98**

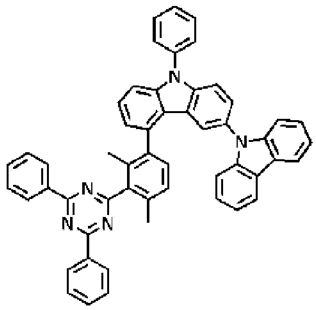

**EH3-99**

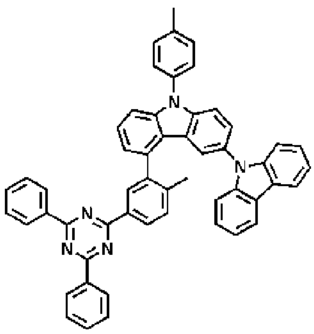

**EH3-100**

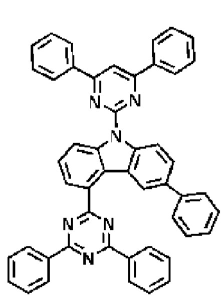

**EH3-101**

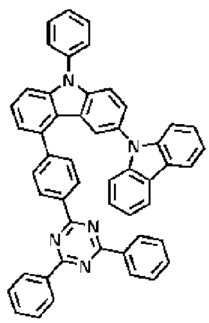

**EH3-102**

**12.** OLED nach einem der Ansprüche 1-11, wobei der lochleitende Host eine Verbindung umfasst, die durch nachstehende Formel 20 dargestellt wird:

<Formel 20>

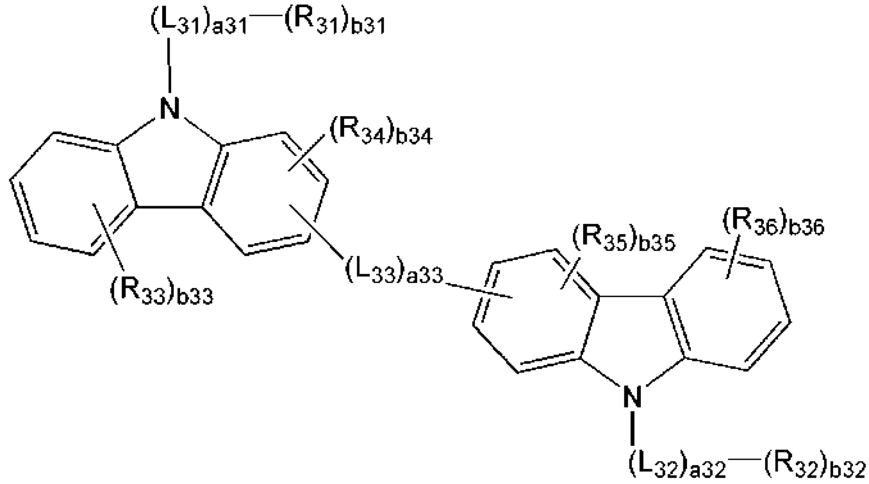

wobei in Formel 20

$L_{31}$ bis $L_{33}$ jeweils unabhängig ausgewählt sind aus einer substituierten oder unsubstituierten $C_3$-$C_{10}$-Cycloalkylengruppe, einer substituierten oder unsubstituierten $C_3$-$C_{10}$-Cycloalkenylengruppe, einer substituierten oder unsubstituierten $C_6$-$C_{60}$-Arylengruppe und einer substituierten oder unsubstituierten divalenten nicht aromatischen kondensierten polycylischen Gruppe;
a31 bis a33 jeweils unabhängig für eine ganze Zahl von 0 bis 5 stehen;
$R_{31}$ und $R_{32}$ jeweils unabhängig für eine substituierte oder unsubstituierte $C_3$-$C_{10}$-Cycloalkylgruppe, eine substituierte oder unsubstituierte $C_3$-$C_{10}$-Cycloalkenylgruppe, eine substituierte oder unsubstituierte $C_6$-$C_{60}$-Arylgruppe und eine substituierte oder unsubstituierte monovalente nicht aromatische kondensierte polycylische Gruppe stehen;
$R_{33}$ bis $R_{36}$ jeweils unabhängig für einen Wasserstoff, ein Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkynylgruppe, eine substituierte oder unsubstituierte $C_1$-$C_{60}$-Alkoxygruppe, eine substituierte oder unsubstituierte $C_3$-$C_{10}$-Cycloalkylgruppe, eine substituierte oder unsubstituierte $C_3$-$C_{10}$-Cycloalkenylgruppe, eine substituierte oder unsubstituierte $C_6$-$C_{60}$-Arylgruppe und eine substituierte oder unsubstituierte monovalente nicht aromatische kondensierte polycylische Gruppe stehen;
b31 bis b36 jeweils unabhängig für eine ganze Zahl von 1 bis 3 stehen;
mindestens einer von Substituenten aus der substituierten $C_3$-$C_{10}$-Cycloalkylengruppe, der substituierten $C_3$-$C_{10}$-Cycloalkenylengruppe, der substituierten $C_6$-$C_{60}$-Arylengruppe, der substituierten divalenten nicht aromatischen kondensierten polycylischen Gruppe, der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_3$-$C_{10}$-Cycloalkenylengruppe, der substituierten $C_6$-$C_{60}$-Arylgruppe und der substituierten monovalenten nicht aromatischen kondensierten polycylischen Gruppe ausgewählt ist aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_3$-$C_{10}$-Cycloalkenylengruppe, einer $C_6$-$C_{60}$-Arylgruppe und einer monovalenten nicht aromatischen kondensierten polycylischen Gruppe; und der lochleitende Host nachstehende Verbindung HH1-1 ausschließt

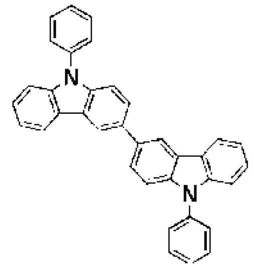

HH1-1 ,

wobei bevorzugt:

$L_3$, bis $L_{33}$ jeweils unabhängig ausgewählt sind aus:
einer Phenylengruppe, einer Naphthylengruppe, einer Fluorenylengruppe, einer Spiro-Fluorenylengruppe, einer Phenalenylengruppe, einer Phenanthrenylengruppe, einer Anthracenylengruppe, einer Fluoranthrenylengruppe, einer Triphenylenylengruppe, einer Pyrenylengruppe und einer Chrysenylengruppe; und
einer Phenylengruppe, einer Naphthylengruppe, einer Fluorenylengruppe, einer Spiro-Fluorenylengruppe, einer Phenalenylengruppe, einer Phenanthrenylengruppe, einer Anthracenylengruppe, einer Fluoranthrenylengruppe, einer Triphenylenylengruppe, einer Pyrenylengruppe und einer Chrysenylengruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer mit einer Phenylgruppe substituierten Phenylgruppe (d. h. einer Biphenylgruppe), einer Naphthylgruppe, einer Fluorenylgruppe, einer Spiro-Fluorenylgruppe, einer Phenalenylgruppe, einer Phenanthrenylgruppe, einer Anthracenylgruppe, einer Fluoranthrenylengruppe, einer Triphenylenylgruppe, einer Pyrenylgruppe und einer Chrysenylgruppe;
a31 bis a33 jeweils unabhängig für 0, 1 oder 2 stehen;
$R_{31}$ und $R_{32}$ jeweils unabhängig ausgewählt sind aus
einer Phenylgruppe, einer Naphthylgruppe, einer Fluorenylgruppe, einer Spiro-Fluorenylgruppe, einer Phenalenylgruppe, einer Phenanthrenylgruppe, einer Anthracenylgruppe, einer Fluoranthrenylgruppe, einer Triphenylenylgruppe, einer Pyrenylgruppe und einer Chrysenylgruppe; und
einer Phenylgruppe, einer Naphthylgruppe, einer Fluorenylgruppe, einer Spiro-Fluorenylgruppe, einer Phenalenylgruppe, einer Phenanthrenylgruppe, einer Anthracenylgruppe, einer Fluoranthrenylgruppe, einer Triphenylenylgruppe, einer Pyrenylgruppe und einer Chrysenylgruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer mit einer Phenylgruppe substituierten Phenylgruppe (d. h. einer Biphenylgruppe), einer Naphthylgruppe, einer Fluorenylgruppe, einer Spiro-Fluorenylgruppe, einer Phenalenylgruppe, einer Phenanthrenylgruppe, einer Anthracenylgruppe, einer Fluoranthrenylengruppe, einer Triphenylenylgruppe, einer Pyrenylgruppe und einer Chrysenylgruppe;
$R_{33}$ bis $R_{36}$ jeweils unabhängig ausgewählt sind aus einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe und einer Phenylgruppe, einer Naphthylgruppe; und b31 bis b36 jeweils unabhängig für 1 oder 2 stehen.

**13.** OLED nach einem der Ansprüche 1-11, wobei der lochleitende Host eine Verbindung umfasst, die durch eine der nachstehenden Formeln 20-1 bis 20-7 dargestellt wird:

<Formel 20-1> <Formel 20-2>

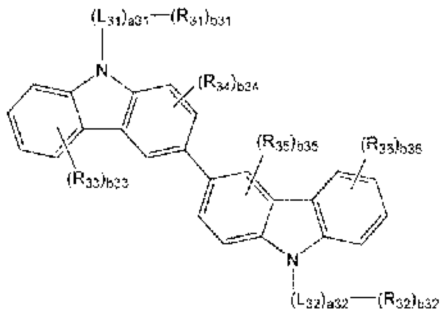

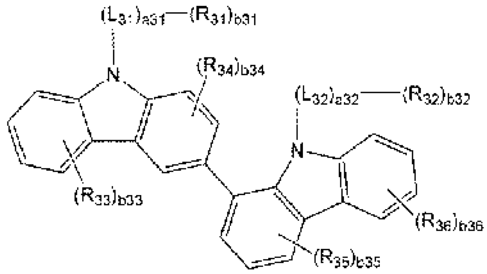

<Formel 20-3>

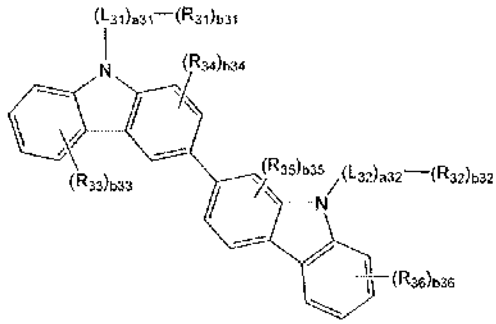

<Formel 20-4>

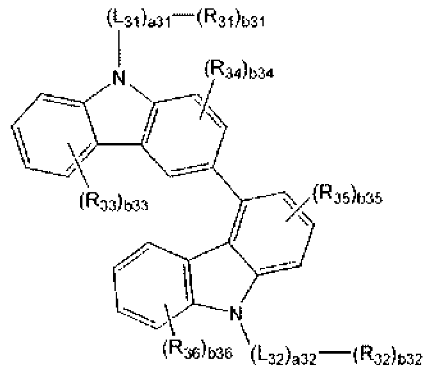

<Formel 20-5>

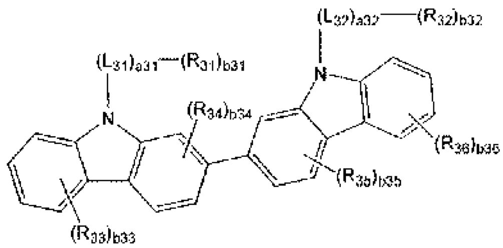

<Formel 20-6>

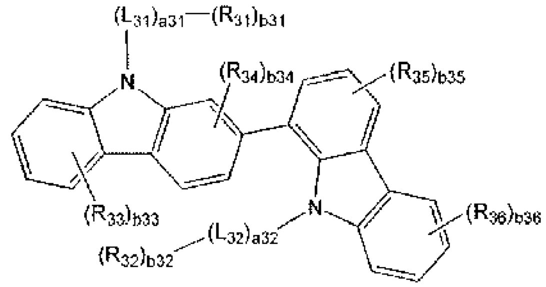

<Formel 20-7>

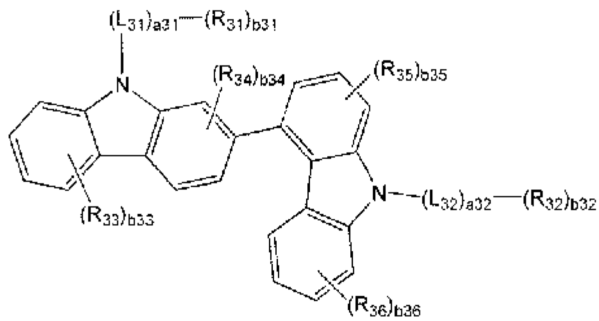

,

wobei der lochleitende Host bevorzugt mindestens eine der nachstehenden Verbindungen HH1-2 bis HH1-51 umfasst:

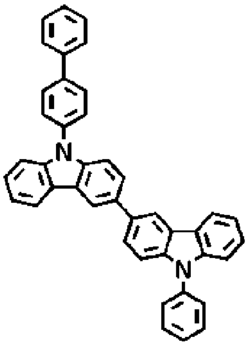

HH1-2

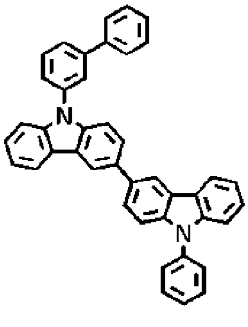

HH1-3

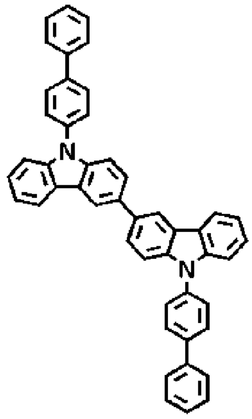

HH1-4

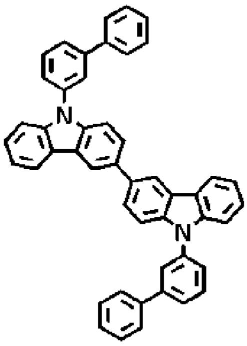

HH1-5

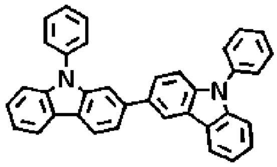

HH1-6

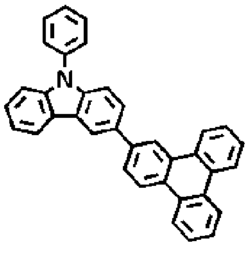

HH1-7

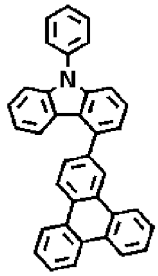

HH1-8

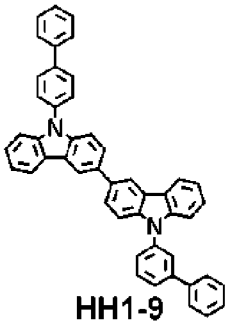

HH1-9

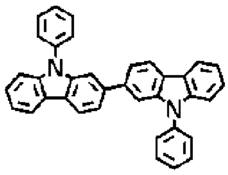

HH1-10

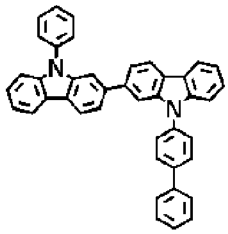

HH1-11

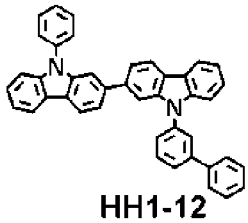

HH1-12

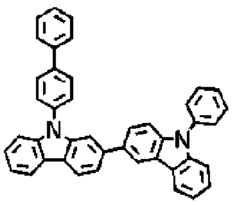

HH1-13

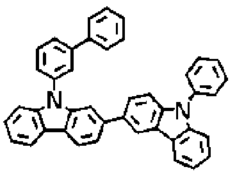

HH1-14

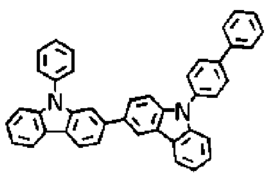

HH1-15

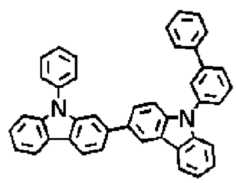

HH1-16

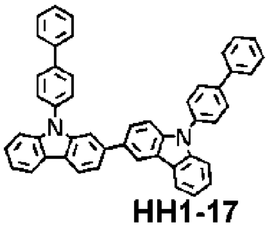
HH1-17

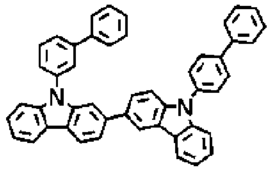
HH1-18

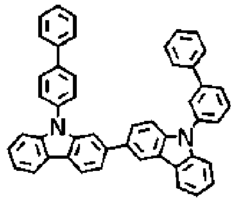
HH1-19

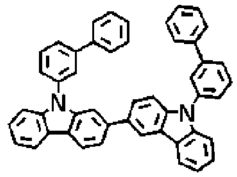
HH1-20

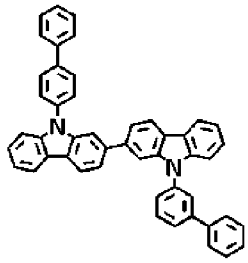
HH1-21

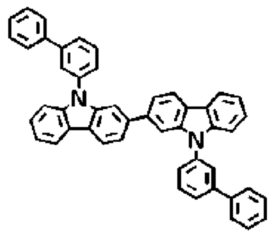
HH1-22

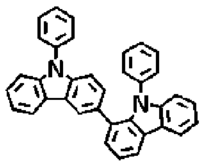
HH1-23

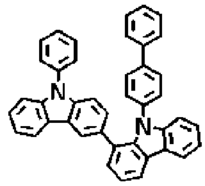
HH1-24

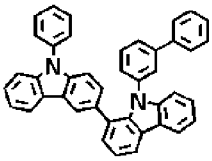
HH1-25

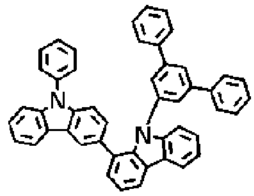
HH1-26

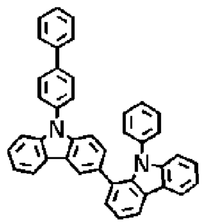
HH1-27

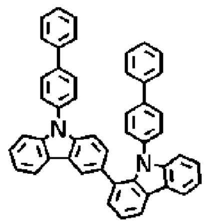
HH1-28

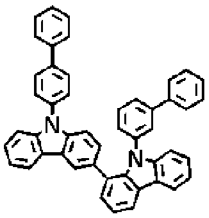
HH1-29

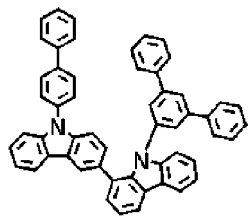
HH1-30

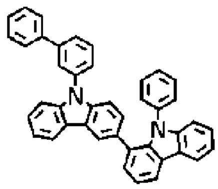
HH1-31

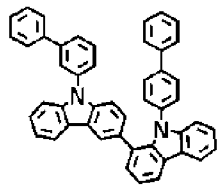
HH1-32

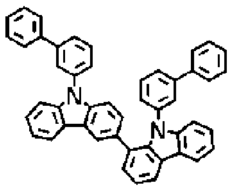
HH1-33

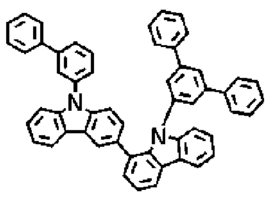
HH1-34

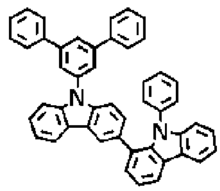
HH1-35

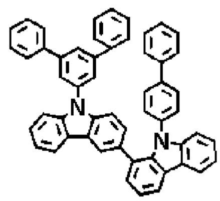
HH1-36

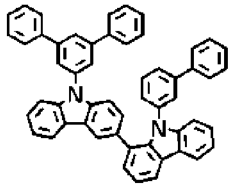
HH1-37

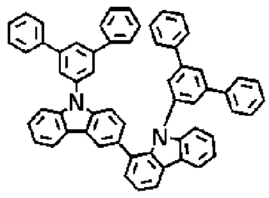
HH1-38

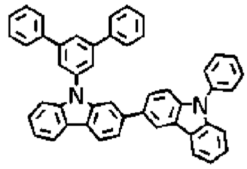
HH1-39

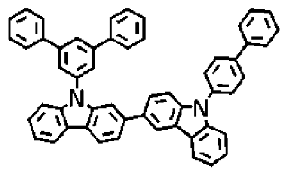
HH1-40

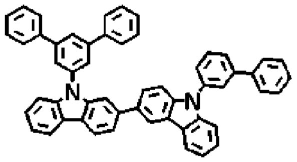
HH1-41

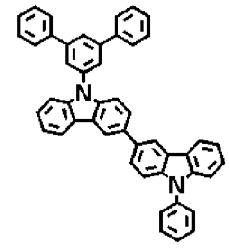
HH1-42

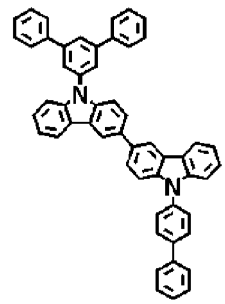
HH1-43

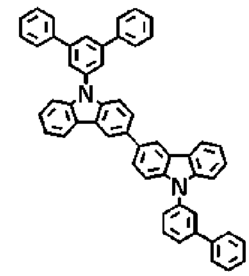
HH1-44

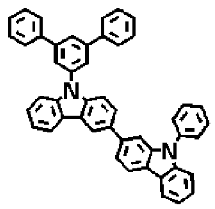
HH1-45

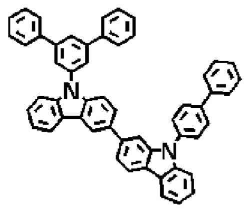
HH1-46

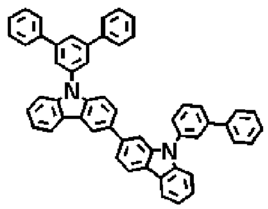
HH1-47

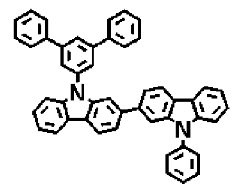
HH1-48

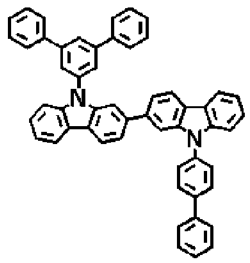
HH1-49

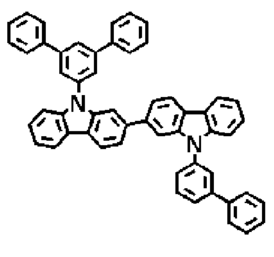
HH1-50

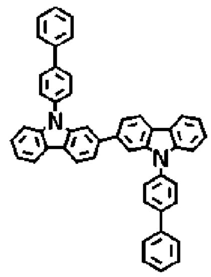
HH1-51

**14.** OLED nach einem der Ansprüche 1-3, wobei:

der elektronenleitende Host nachstehende Verbindung EH1-401 ist,
der lochleitende Host eine Verbindung umfasst, die -0,1 ≤ Typ(Verbindung EH1-401) ≤ 0,6 erfüllt,
ein Volumenverhältnis des elektronenleitenden Hosts zu dem lochleitenden Host innerhalb eines Bereichs liegt, der -0,1 ≤ Typ(Verbindung EH1-401) ≤ 0,6 erfüllt,
wobei Typ(Verbindung EH1-401) durch nachstehende Gleichung 10 definiert ist:

<Gleichung 10>

$$\text{Typ(Verbindung EH1-401)} = \log(J_{HOD}(\text{bei } 11{,}5\text{ V}) / J_{EOD}(\text{bei } 4\text{ V}))$$

wobei in Gleichung 10

$J_{HOD}$ (bei 11,5 V) sich auf einen Stromdichtewert (mA/cm$^2$) bei einer Spannung von 11,5 V einer Nur-Loch-Vorrichtung bezieht, die eine Struktur von ITO (150 nm (1.500Å)) / Verbindung HT3:TCNPQ (3 Gew.-%) (10 nm (100 Å)) / Verbindung HT3 (100 nm (1.000 Å)) / Host:Verbindung PD79 (10 Gew.-%) (60 nm (600 Å)) / Verbindung ET1 (10 nm (100 Å)) / A1 (10 nm (100 Å)) aufweist (wobei der Host aus der Verbindung EH1-401 und dem lochleitenden Host besteht), und

$J_{EOD}$ (bei 4 V) sich auf einen Stromdichtewert (mA/$cm^2$) bei einer Spannung von 4 V einer Nur-Elektron-Vorrichtung bezieht, die eine Struktur von ITO (150 nm (1.500 Å)) / Mg:Ag (10 Gew.-%) (30 nm (300 Å)) / Liq (1 nm (10 Å)) / Verbindung ET16:Liq (50 Gew.-%) (20 nm (200 Å)) / Host:Verbindung PD79 (10 Gew.-%) (60 nm (600 Å)) / Verbindung ET16:Liq (50 Gew.-%) (20 nm (200 Å)) / Liq (1nm (10 Å)) / Mg:Ag (10 Gew.-%) (30 nm (300 Å)) aufweist (wobei der Host aus der Verbindung EH1-401 und dem lochleitenden Host besteht).

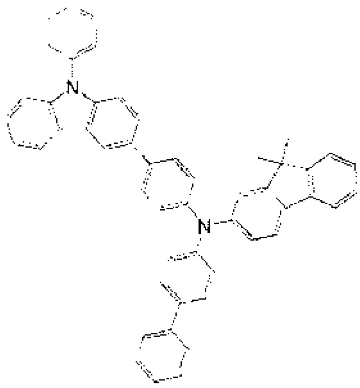
HT3

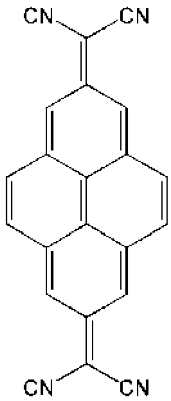
TCNPQ

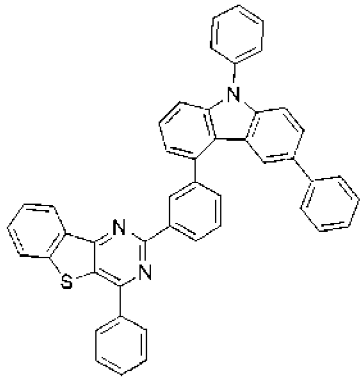
EH1-401

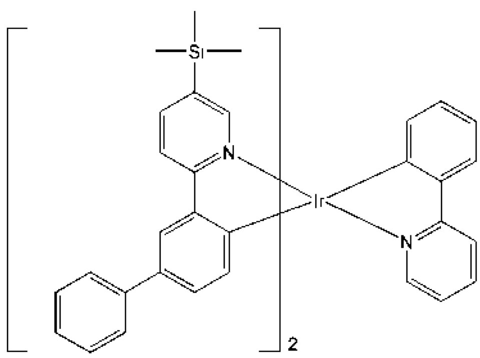
PD79

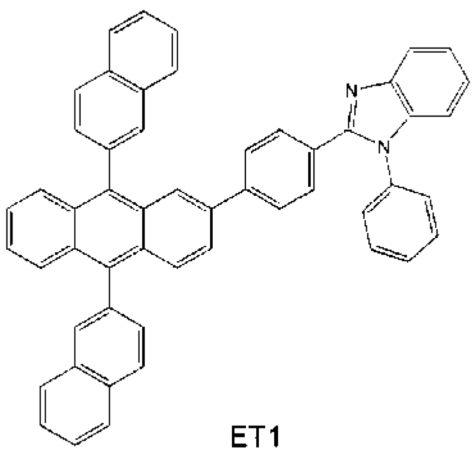
ET1

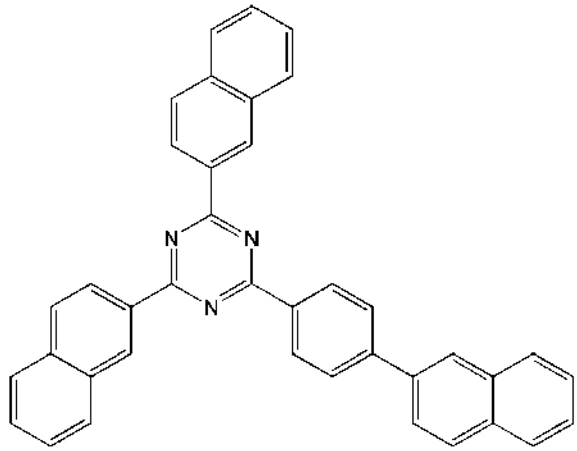

ET16

**15.** OLED nach einem der Ansprüche 1-3, wobei:

der elektronenleitende Host nachstehende Verbindung EH3-81 ist,
der lochleitende Host eine Verbindung umfasst, die $0,1 \leq$ Typ(Verbindung EH3-81) $\leq 1,2$ erfüllt,
ein Volumenverhältnis des elektronenleitenden Hosts zu dem lochleitenden Host innerhalb eines Bereichs liegt, der $0,1 \leq$ Typ(Verbindung EH3-81) $\leq 1,2$ erfüllt,
wobei Typ(Verbindung EH3-81) durch nachstehende Gleichung 11 definiert ist:

<Gleichung 11>

$$\text{Typ(Verbindung EH3-81)} = \log(J_{HOD}(\text{bei } 11{,}5\text{ V}) / J_{EOD}(\text{bei } 4\text{ V}))$$

wobei in Gleichung 11

$J_{HOD}$ (bei 11,5 V) sich auf einen Stromdichtewert (mA/cm$^2$) bei einer Spannung von 11,5 V einer Nur-Loch-Vorrichtung bezieht, die eine Struktur von ITO (150 nm (1.500Å)) / Verbindung HT3:TCNPQ (3 Gew.-%) (10 nm (100 Å)) / Verbindung HT3 (100 nm (1.000 Å)) / Host:Verbindung PD79 (10 Gew.-%) (60 nm (600 Å)) / Verbindung ET1 (10 nm (100 Å)) / A1 (10 nm (100 Å)) aufweist (wobei der Host aus Verbindung EH3-81 und dem lochleitenden Host besteht), und
$J_{EOD}$ (bei 4 V) sich auf einen Stromdichtewert (mA/cm$^2$) bei einer Spannung von 4 V einer Nur-Elektron-Vorrichtung bezieht, die eine Struktur von ITO (150 nm (1.500 Å)) / Mg:Ag (10 Gew.-%) (30 nm (300 Å)) / Liq (1 nm (10 Å)) / Verbindung ET16:Liq (50 Gew.-%) (20 nm (200 Å)) / Host:Verbindung PD79 (10 Gew.-%) (60 nm (600 Å)) / Verbindung ET16:Liq (50 Gew.-%) (20 nm (200 Å)) / Liq (1 nm (10 Å)) / Mg:Ag (10 Gew.-%) (30 nm (300 Å)) aufweist (wobei der Host aus Verbindung EH3-81 und dem lochleitenden Host besteht)

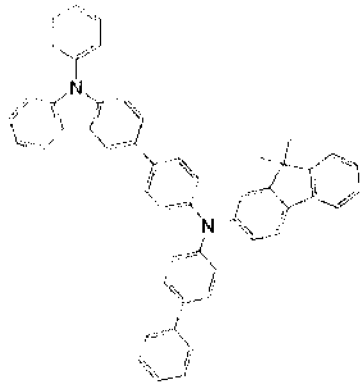
HT3

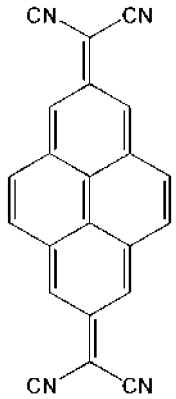
TCNPQ

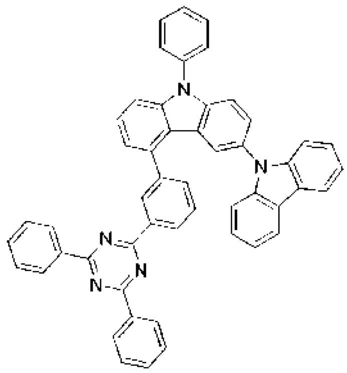
EH3-81

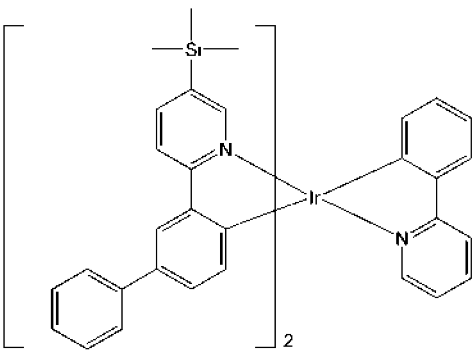
PD79

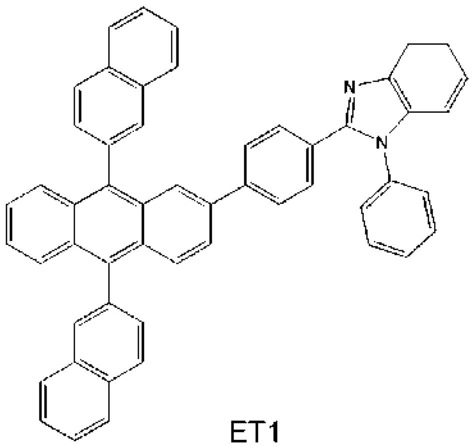
ET1

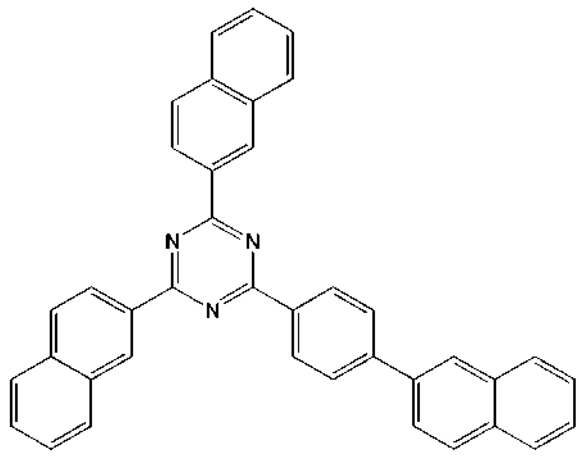
ET16

**16.** OLED nach einem der Ansprüche 1-13, wobei das Lochleitungsmaterial eine Verbindung umfasst, die durch nachstehende Formel 201 dargestellt wird:

<Formel 201>

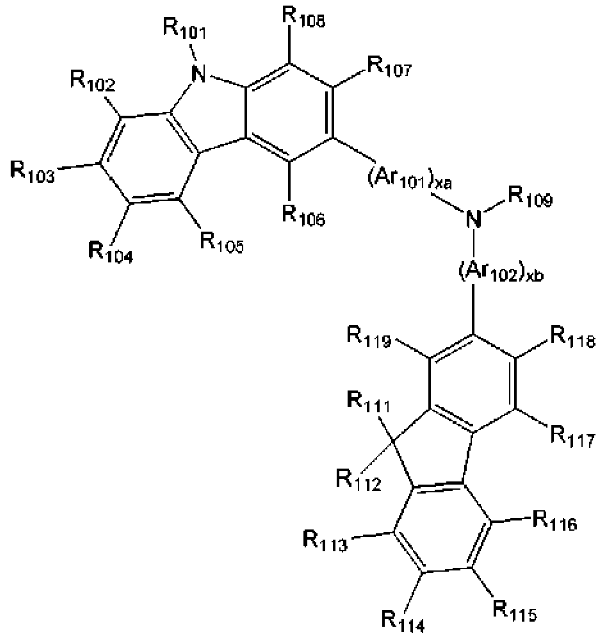

wobei in Formel 201

$Ar_{101}$, und $Ar_{102}$ jeweils unabhängig ausgewählt sind aus
einer Phenylengruppe, einer Pentalenylengruppe, einer Indenylengruppe, einer Naphthylengruppe, einer Azulenylengruppe, einer Heptalenylengruppe, einer Acenaphthylengruppe, einer Fluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylenylengruppe, einer Naphthacenylengruppe, einer Picenylengruppe, einer Perylenylengruppe und einer Pentacenylengruppe; und
einer Phenylengruppe, einer Pentalenylengruppe, einer Indenylengruppe, einer Naphthylengruppe, einer Azulenylengruppe, einer Heptalenylengruppe, einer Acenaphthylengruppe, einer Fluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylenylengruppe, einer Naphthacenylengruppe, einer Picenylengruppe, einer Perylenylengruppe und einer Pentacenylengruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_3$-$C_{10}$-Cycloalkenylgruppe, einer $C_1$-$C_{10}$-Heterocycloalkylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe;
xa und xb jeweils unabhängig für eine ganze Zahl von 0 bis 5 stehen;
$R_{101}$ bis $R_{108}$ und $R_{111}$ bis $R_{119}$ jeweils unabhängig ausgewählt sind aus
einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe und einer $C_1$-$C_{10}$-Alkoxygruppe;
einer $C_1$-$C_{10}$-Alkylgruppe und einer $C_1$-$C_{10}$-Alkoxygruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon und einer Phosphorsäuregruppe oder einem Salz davon; einer Phenylgruppe, einer Naphthylgruppe, einer Anthracenylgruppe, einer Fluorenylgruppe und einer Pyrenylgruppe; und

einer Phenylgruppe, einer Naphthylgruppe, einer Anthracenylgruppe, einer Fluorenylgruppe und einer Pyrenylgruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe und einer $C_1$-$C_{10}$-Alkoxygruppe; und

$R_{109}$ ausgewählt ist aus

einer Phenylgruppe, einer Naphthylgruppe, einer Anthracenylgruppe und einer Pyridinylgruppe; und einer Phenylgruppe, einer Naphthylgruppe, einer Anthracenylgruppe und einer Pyridinylgruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe und $C_1$-$C_{20}$-Alkoxygruppe, wobei das Lochleitungsmaterial bevorzugt eine Verbindung umfasst, die durch nachstehende Formel 201A dargestellt wird:

<Formel 201A>

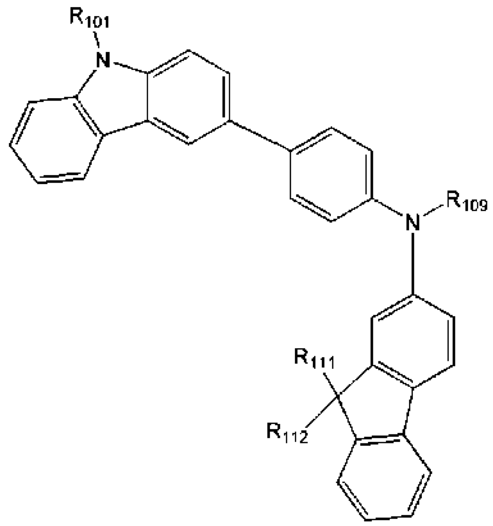

wobei in Formel 201A Beschreibungen von $R_{101}$, $R_{111}$, $R_{112}$ und $R_{109}$ auf die gleiche Weise definiert sind wie in Formel 201.

**17.** OLED nach einem der Ansprüche 1-13, wobei das Lochleitungsmaterial mindestens eine der nachstehenden Verbindungen HT1 bis HT12 umfasst:

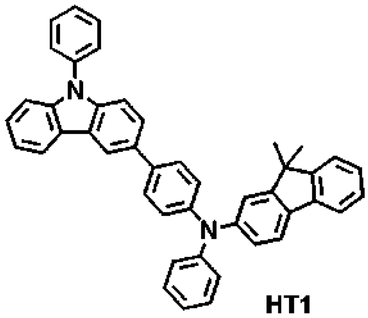

**HT1**

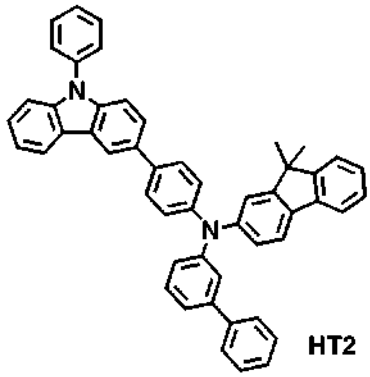

**HT2**

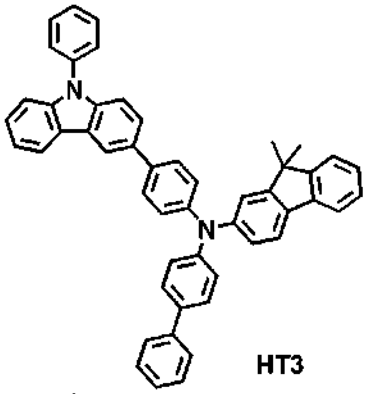

**HT3**

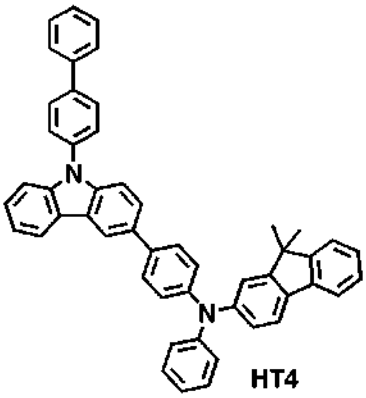

**HT4**

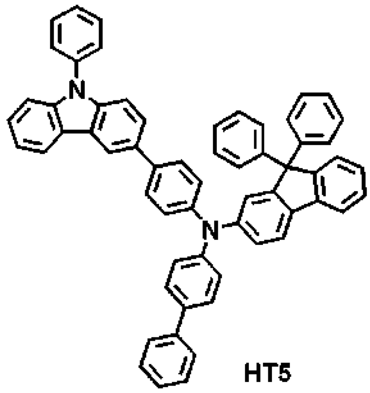

**HT5**

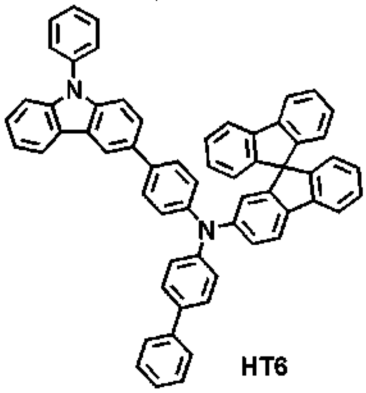

**HT6**

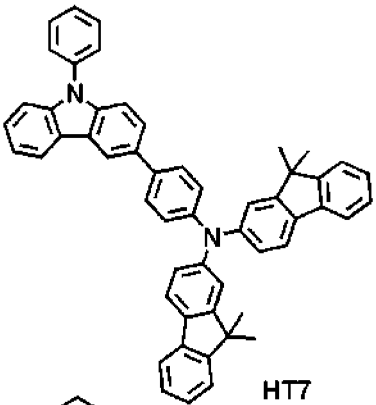

**HT7**

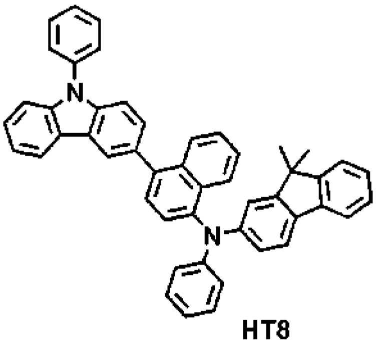

**HT8**

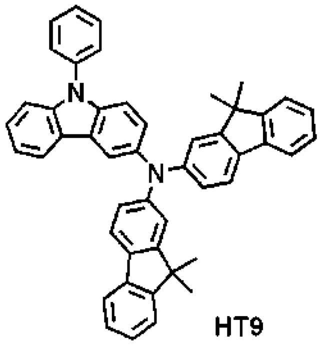

**HT9**

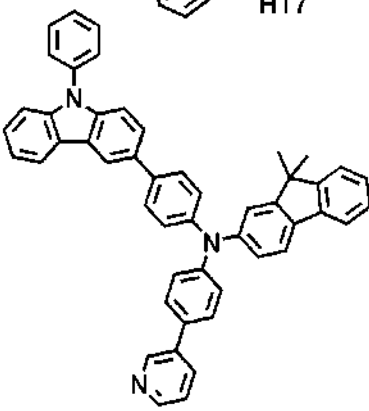

**HT10**

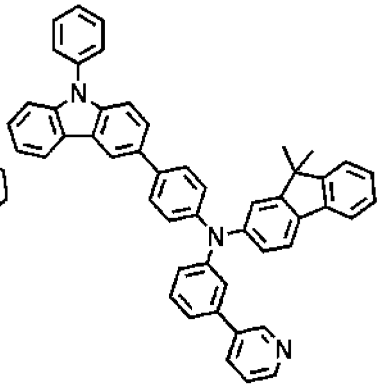

**HT11**

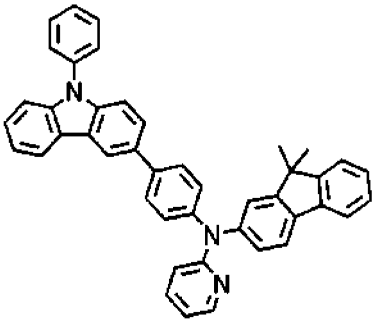

**HT12**

**18.** OLED nach einem der Ansprüche 1-13, 16 oder 17, wobei das Elektronenleitungsmaterial eine Verbindung umfasst, die durch nachstehende Formeln 40 oder 41 dargestellt wird:

<Formel 40>

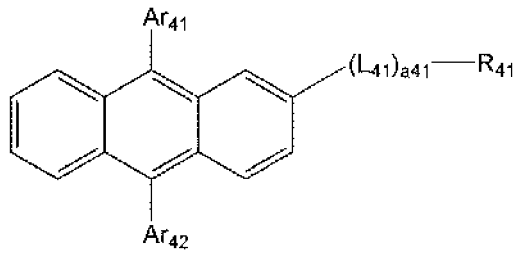

<Formel 41>

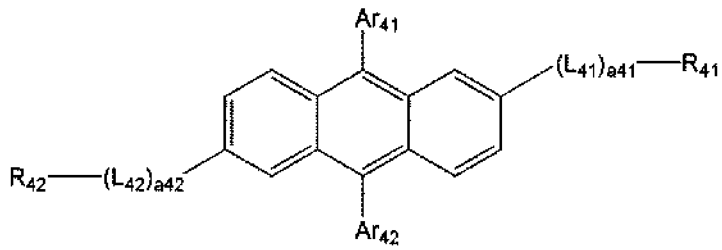

wobei in Formeln 40 und 41

$L_{41}$ und $L_{42}$ jeweils unabhängig ausgewählt sind aus
einer $C_6$-$C_{60}$-Arylengruppe, einer $C_1$-$C_{60}$-Heteroarylengruppe, einer divalenten nicht aromatischen kondensierten polycylischen Gruppe und einer divalenten nicht aromatischen kondensierten heteropolycylischen Gruppe; und
einer $C_6$-$C_{60}$-Arylengruppe, einer $C_1$-$C_{60}$-Heteroarylengruppe, einer divalenten nicht aromatischen kondensierten polycylischen Gruppe und einer divalenten nicht aromatischen kondensierten heteropolycylischen Gruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Fluorenylgruppe, einer Pyrenylgruppe, einer Chrysenylgruppe, einer Phenanthrenylgruppe, einer Pyridinylgruppe, einer Pyrimidinylgruppe und einer Triazinylgruppe;
a41 und a42 jeweils unabhängig für eine ganze Zahl von 0 bis 5 stehen;
$Ar_{41}$ und $Ar_{42}$ jeweils unabhängig ausgewählt sind aus
einer $C_6$-$C_{60}$-Arylgruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe; und
einer $C_6$-$C_{60}$-Arylgruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Fluorenylgruppe, einer Pyrenylgruppe, einer Chrysenylgruppe, einer Phenanthrenylgruppe, einer Pyridinylgruppe, einer Pyrimidinylgruppe und einer Triazinylgruppe; und
$R_{41}$ und $R_{42}$ jeweils unabhängig ausgewählt sind aus
einer Benzoimidazolylgruppe, einer Benzoxazolylgruppe, einer Benzothiazolylgruppe, einer Benzopyrimidinylgruppe, einer Imidazopyridinylgruppe, einer Chinolinylgruppe, einer Isochinolinylgruppe, einer Chinazolinylgruppe, einer Pyridinylgruppe, einer Pyrimidinylgruppe, einer Pyrazinylgruppe, einer Phenylgruppe, einer Naphthylgruppe, einer Pyrenylgruppe, einer Chrysenylgruppe, einer Fluorenylgruppe und einer Phenanthrenylgruppe; und
einer Benzoimidazolylgruppe, einer Benzoxazolylgruppe, einer Benzothiazolylgruppe, einer Benzopyrimidinylgruppe, einer Imidazopyridinylgruppe, einer Chinolinylgruppe, einer Isochinolinylgruppe, einer Chinazolinylgruppe, einer Pyridinylgruppe, einer Pyrimidinylgruppe, einer Pyrazinylgruppe, einer Phenylgruppe, einer Naphthylgruppe, einer Pyrenylgruppe, einer Chrysenylgruppe, einer Fluorenylgruppe und einer Phenanthrenylgruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Benzoimidazolylgruppe, einer Benzoxazolylgruppe, einer Benzothiazolylgruppe, einer Benzopyrimidinylgruppe, einer Imidazopyridinylgruppe, einer Chinolinylgruppe, einer Isochinolinylgruppe, einer Chinazolinylgruppe, einer Pyridinylgruppe, einer Pyrimidinylgruppe, einer Pyrazinylgruppe, einer Phenylgruppe, einer Naphthylgruppe, einer Pyrenylgruppe, einer Chrysenylgruppe, einer Fluorenylgruppe und einer Phenanthrenylgruppe, oder wobei das Elektronenleitungsmaterial eine Verbindung umfasst, die durch nachstehende Formel 42 dargestellt wird:

<Formel 42>

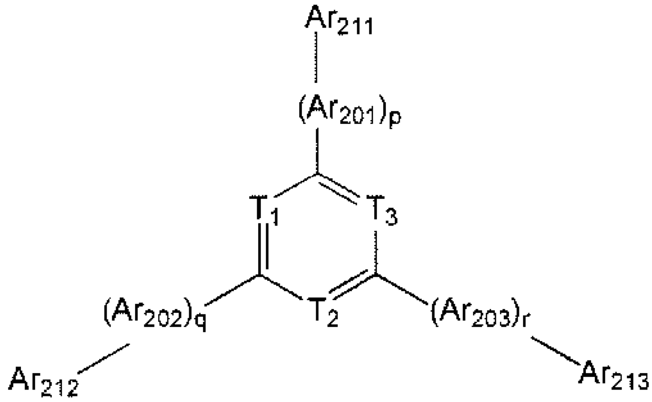

wobei in Formel 42

$T_1$ für N oder $C(R_{201})$ steht, $T_2$ für N oder $C(R_{202})$ steht und $T_3$ für N oder $C(R_{203})$ steht, wobei mindestens eines aus $T_1$ bis $T_3$ für N steht;
$R_{201}$ bis $R_{203}$ jeweils unabhängig ausgewählt sind aus
einem Wasserstoff, einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer $C_6$-$C_{60}$-Arylgruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe; und
einer $C_6$-$C_{60}$-Arylgruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Fluorenylgruppe, einer Pyrenylgruppe, einer Chrysenylgruppe, einer Phenanthrenylgruppe, einer Pyridinylgruppe, einer Pyrimidinylgruppe und einer Triazinylgruppe;
$Ar_{201}$ bis $Ar_{203}$ jeweils unabhängig ausgewählt sind aus
einer $C_6$-$C_{60}$-Arylengruppe, einer $C_1$-$C_{60}$-Heteroarylengruppe, einer divalenten nicht aromatischen kondensierten polycylischen Gruppe und einer divalenten nicht aromatischen kondensierten heteropolycylischen Gruppe; und
einer $C_6$-$C_{60}$-Arylengruppe, einer $C_1$-$C_{60}$-Heteroarylengruppe, einer divalenten nicht aromatischen kondensierten polycylischen Gruppe und einer divalenten nicht aromatischen kondensierten heteropolycylischen Gruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Fluorenylgruppe, einer Pyrenylgruppe, einer Chrysenylgruppe, einer Phenanthrenylgruppe, einer Pyridinylgruppe, einer Pyrimidinylgruppe und einer Triazinylgruppe;
p, q und r jeweils unabhängig für 0, 1 oder 2 stehen; und
$Ar_{211}$ und $Ar_{213}$ jeweils unabhängig ausgewählt sind aus
einer $C_6$-$C_{60}$-Arylgruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe; und
einer $C_6$-$C_{60}$-Arylgruppe, einer $C_1$-$C_{60}$-Heteroarylgruppe, einer monovalenten nicht aromatischen kondensierten polycylischen Gruppe und einer monovalenten nicht aromatischen kondensierten heteropolycylischen Gruppe, jeweils substituiert mit mindestens einem aus einem Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Fluorenylgruppe, einer Pyrenylgruppe, einer Chrysenylgruppe, einer Phenanthrenylgruppe, einer Pyridinylgruppe, einer Pyrimidinylgruppe und einer Triazinylgruppe.

**19.** OLED nach einem der Ansprüche 1-13, 16 oder 17, wobei das Elektronenleitungsmaterial mindestens eine der nachstehenden Verbindungen ET1 bis ET16 umfasst:

<Verbindung ET1>

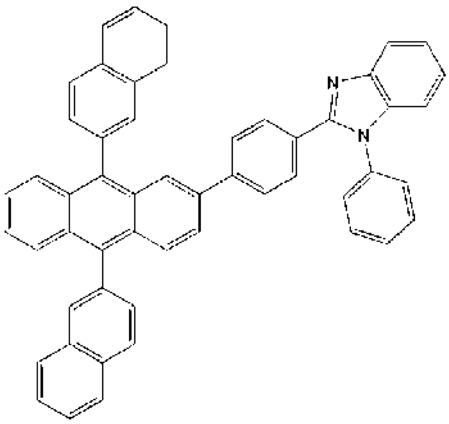

<Verbindung ET2>

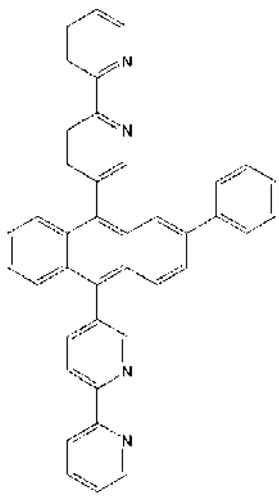

<Verbindung ET3>

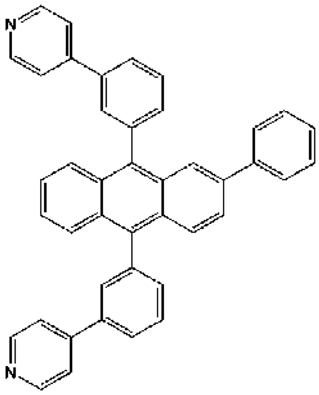

<Verbindung ET4>

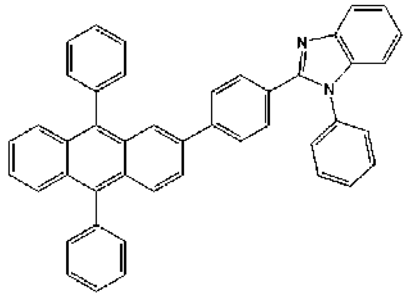

<Verbindung ET5>

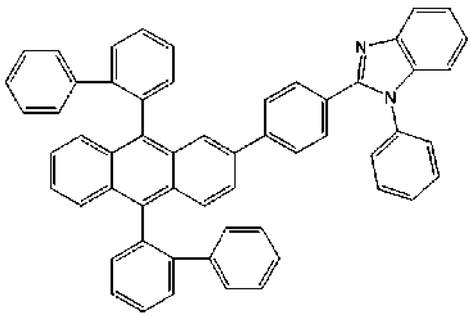

<Verbindung ET6>

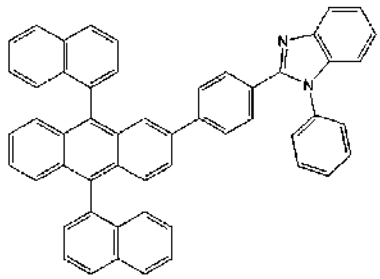

<Verbindung ET7>

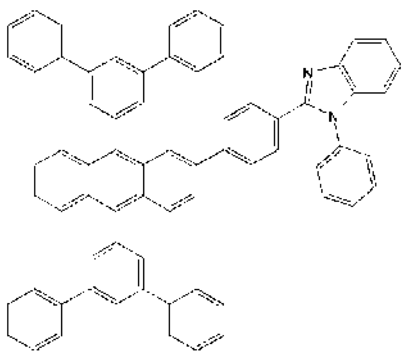

<Verbindung ET8>

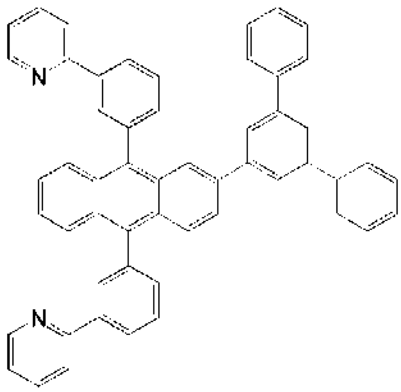

<Verbindung ET8>

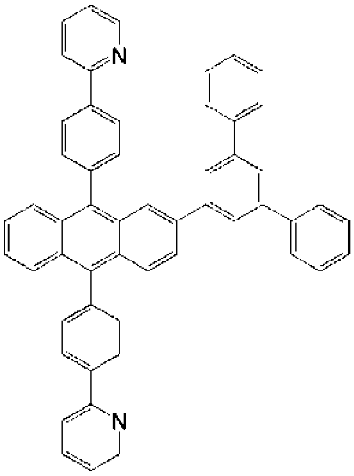

<Verbindung ET10>

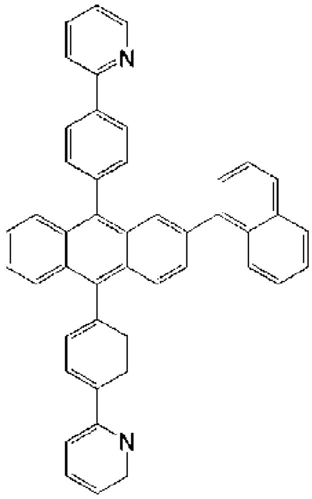

<Verbindung ET11>

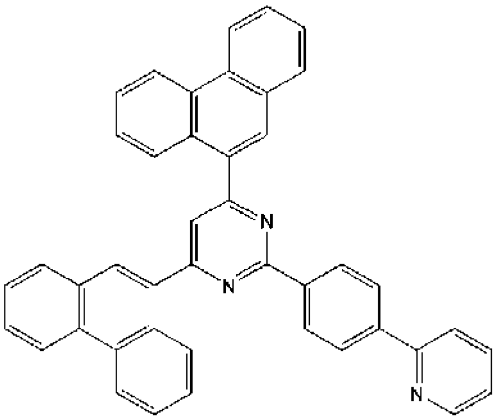

<Verbindung ET12>

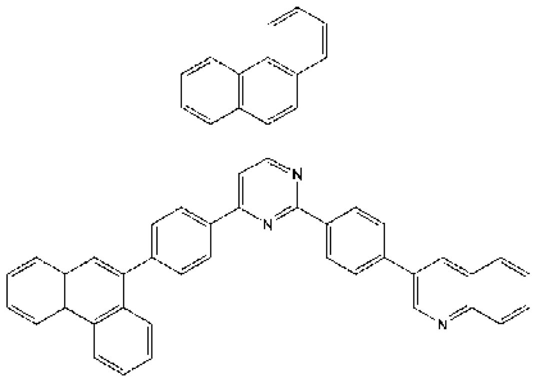

<Verbindung ET13>

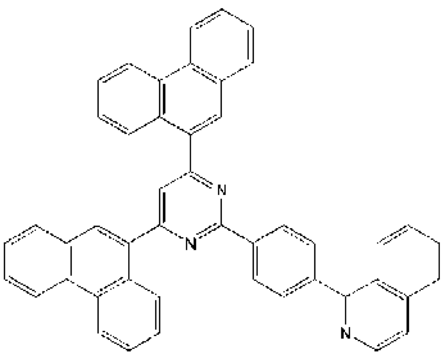

<Verbindung ET14>

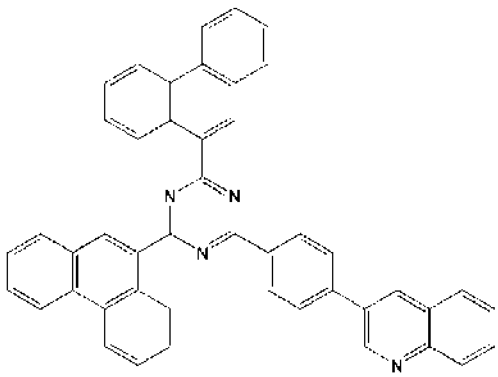

<Verbindung ET15>

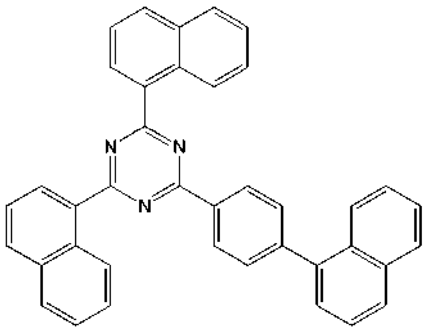

<Verbindung ET16>

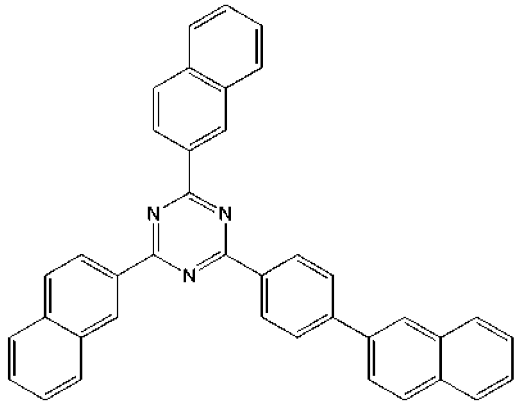

**Revendications**

1. Dispositif électroluminescent organique (OLED), comprenant :

   une première électrode ;
   une deuxième électrode ;
   une couche d'émission disposée entre la première électrode et la deuxième électrode ;
   une zone de transport d'électrons-trous disposée entre la première électrode et la couche d'émission et comprenant une couche de transport d'électrons-trous ; et
   une zone de transport d'électrons disposée entre la couche d'émission et la deuxième électrode et comprenant une couche de transport d'électrons,
   la couche d'émission comprenant un hôte de transport d'électrons et un hôte de transport d'électrons-trous,
   la couche de transport d'électrons-trous comprenant un matériau de transport d'électrons-trous,
   la couche de transport d'électrons comprenant un matériau de transport d'électrons, et l'OLED satisfaisant les équations 1 et 2 ci-dessous :

   <Equation 1>

   $$0{,}75\text{eV} \leq |\ \text{LUMO}_{\text{H(ET)}} - \text{LUMO}_{\text{H(HT)}}\ | \leq 0{,}90\text{eV}$$

   <Equation 2>

   $$|\ E(S_{1,\ \text{H(ET)}}) - E(S_{1,\ \text{H(HT)}})\ | < 0{,}15\text{eV}$$

   où, dans les équations 1 et 2,

   $\text{LUMO}_{\text{H(ET)}}$ désigne le niveau d'énergie de l'orbitale moléculaire inoccupée la plus basse (LUMO) de l'hôte de transport d'électrons,
   $\text{LUMO}_{\text{H(HT)}}$ désigne un niveau d'énergie LUMO de l'hôte de transport d'électrons-trous,
   $E(S_{1,\ \text{H(ET)}})$ désigne un niveau d'énergie singulet de l'hôte de transport d'électrons, et
   $E(S_{1,\ \text{H(HT)}})$ désigne un niveau d'énergie singulet de l'hôte de transport d'électrons-trous.

2. OLED selon la revendication 1, l'OLED satisfaisant les équations 3 et 4 ci-dessous :

   <Equation 3>

   $$|\ \text{HOMO}_{\text{H(HT)}} - \text{HOMO}_{\text{HTL}}\ | < 0.3\text{eV}$$

<Equation 4>

$$0{,}15eV \leq | HOMO_{H(HT)} - HOMO_{H(ET)} | \leq 2{,}0eV$$

où, dans les équations Equations 3 et 4,

$HOMO_{H(HT)}$ désigne une orbitale moléculaire occupée la plus haute de l'hôte de transport d'électrons-trous,
$HOMO_{HTL}$ désigne un niveau d'énergie HOMO du matériau de transport d'électrons-trous, et
$HOMO_{H(ET)}$ désigne un niveau d'énergie HOMO de l'hôte de transport d'électrons ;
et/ou où l'OLED satisfait l'équation 5 ci-dessous :

<Equation 5>

$$| LUMO_{H(ET)} - LUMO_{ETL} | < 0{,}2eV$$

où, dans l'équation 5, $LUMO_{ETL}$ désigne un niveau d'énergie LUMO du matériau de transport d'électrons.

**3.** OLED selon la revendication 1 ou 2, l'OLED satisfaisant les équations 6 et 7 ci-dessous :

<Equation 6>

$$\min\{E(S_{1,H(HT)}), E(S_{1,H(ET)})\} - E(S_{1,EX}) > 0{,}15eV$$

<Equation 7>

$$E(S_{1,EX}) - E(T_{1,EX}) < 0{,}15eV$$

où, dans les équations 6 et 7,

$E(S_{1,H(HT)})$ désigne un niveau d'énergie singulet de l'hôte de transport d'électrons-trous,
$E(S_{1,H(ET)})$ désigne un niveau d'énergie singulet de l'hôte de transport d'électrons,
$\min\{E(S_{1,H(HT)}), E(S_{1,H(ET)}\}$ désigne la plus petite valeur de $E(S_{1,H(HT)})$ et $E(S_{1,H(ET)})$,
$E(S_{1,EX})$ désigne un nieau d'énergie singulet d'un exciplexe formé par l'hôte de transport d'électrons-trous et l'hôte de transport d'électrons, et
$E(T_{1,EX})$ désigne un niveau d'énergie triplet de l'exciplexe formé par l'hôte de transport d'électrons et l'hôte de transport d'électrons-trous.

**4.** OLED selon l'une quelconque des revendications 1-3, dans lequel l'hôte de transport d'électrons comprend un composé représenté par la formule 1 ci-dessous :

<Formule 1>

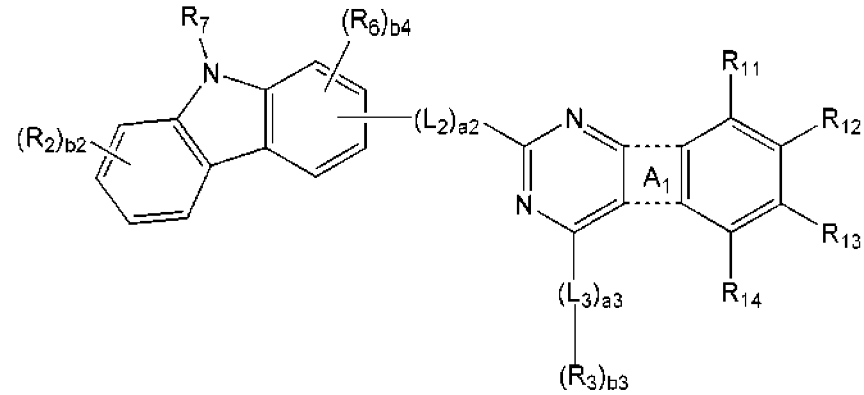

<Formule 1A>

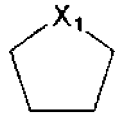

où un anneau $A_1$ dans la formule 1 est représenté par la formule 1A ci-dessus ;
$X_1$ dans la formule 1A est N-[$(L_1)_{a1}$-$(R_1)_{b1}$], S, O, S(=O), $S(=O)_2$, C(=O), $Si(R_4)(R_5)$, $P(R_4)$, $P(=O)(R_4)$, ou $C=N(R_4)$;
$L_1$ à $L_3$ dans la formule 1 sont chacun indépendamment sélectionnés entre un groupe cycloalkylène $C_3$-$C_{10}$ substitué ou non substitué, un groupe hétérocycloalkylène $C_1$-$C_{10}$ substitué ou non substitué, un groupe cycloalkylène $C_3$-$C_{10}$ substitué ou non substitué, un groupe hétérocycloalkénylène $C_1$-$C_{10}$ substitué ou non substitué, un groupe arylène $C_6$-$C_{60}$ substitué ou non substitué, un groupe hétéroarylène $C_1$-$C_{60}$ substitué ou non substitué, un groupe polycyclique condensé non aromatique bivalent substitué ou non substitué, et un groupe hétéropolycyclique condensé non aromatique bivalent substitué ou non substitué ;
a1 à a3 dans la formule 1 sont chacun indépendamment un nombre entier de 1 à 5, lorsque a1 est 2 ou plus, 2 $L_1$ ou plus sont identiques ou différents l'un de l'autre, lorsque a2 est 2 ou plus, 2 $L_2$ ou plus sont identiques ou différents l'un de l'autre, et lorsque a3 est 2 ou plus, 2 $L_3$ ou plus sont identiques ou différents l'un de l'autre ;
$R_1$ à $R_7$ et $R_{11}$ à $R_{14}$ dans la formule 1 sont chacun sélectionnés indépendamment entre un hydrogène, un deutérium, un groupe fluoro (-F), un groupe chloro (-Cl), un groupe bromo (-Br), un groupe iodo (-I), un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substityé, un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe hétéroaryle $C_1$-$C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, et $-B(Q_6)(Q_7)$,
b1 à b4 dans la formule 1 sont chacun indépendamment un nombre entier de 1 à 3 ; et
au moins l'un des substituants du groupe cycloalkylène $C_3$-$C_{10}$ substitué, du groupe hétérocycloalkylène $C_1$-$C_{10}$ substitué, du groupe cycloalkénylène $C_3$-$C_{10}$ substitué, du groupe hétérocycloalénylène $C_1$-$C_{10}$ substitué, du groupe arylène $C_6$-$C_{60}$ substitué, du groupe hétéroarylène $C_1$-$C_{60}$ substitué, du groupe polycyclique condensé non aromatique bivalent substitué, du groupe hétéropolycyclique condensé non aromatique bivalent substitué, du groupe alkyle $C_1$-$C_{60}$ substitué, du groupe alkényle $C_2$-$C_{60}$ substitué, du groupe alkynyle $C_2$-$C_{60}$ substitué, du groupe alkoxy $C_1$-$C_{60}$ substitué, du groupe cycloalkyle $C_3$-$C_{10}$ substitué, du groupe hétérocycloalkyle $C_1$-$C_{10}$

substitué, du groupe cycloalkényle $C_3$-$C_{10}$ substitué, du groupe hétérocycloalkényle $C_1$-$C_{10}$ substitué, du groupe aryle $C_6$-$C_{60}$ substitué, du groupe aryloxy $C_6$-$C_{60}$ substitué, du groupe arylthio $C_6$-$C_{60}$ substitué, du groupe hétéroaryle $C_1$-$C_{60}$ substitué, du groupe polycyclique condensé non aromatique monovalent substitué, et du groupe hétéropolycyclique condensé non aromatique monovalent substitué est sélectionné entre

un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$ ;

un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, un groupe hétéropolycyclique condensé non aromatique monovalent, -N($Q_{11}$)($Q_{12}$), -Si($Q_{13}$)($Q_{14}$)($Q_{15}$), et -B($Q_{16}$)($Q_{17}$) ;

un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, et un groupe hétéropolycyclique condensé non aromatique monovalent ;

un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkénle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, et un groupe hétéropolycyclique condensé non aromatique monovalent, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, un groupe hétéropolycyclique condensé non aromatique monovalent, -N($Q_{21}$)($Q_{22}$), -Si($Q_{23}$)($Q_{24}$)($Q_{25}$), et -B($Q_{26}$)($Q_{27}$) ; et

-N($Q_{31}$)($Q_{32}$), -Si($Q_{33}$)($Q_{34}$)($Q_{35}$), et -B($Q_{36}$)($Q_{37}$),

où $Q_1$ à $Q_7$, $Q_{11}$ à $Q_{17}$, $Q_{21}$ à $Q_{27}$, et $Q_{31}$ à $Q_{37}$ sont chacun indépendamment sélectionnés entre un hydrogène, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, et un groupe hétéropolycyclique condensé non aromatique monovalent.

**5.** OLED selon la revendication 4, dans lequel $L_1$ à $L_3$ dans la formule 1 sont chacun indépendamment un composé cyclique condensé sélectionné dans les groupes représentés par les formules 2-1 à 2-17 ci-dessous :

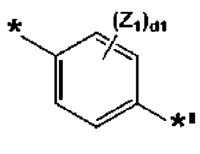
Formule 2-1

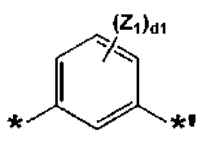
Formule 2-2

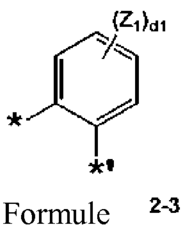
Formule 2-3

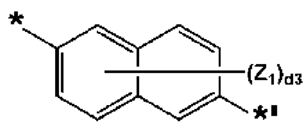
Formule 2-4

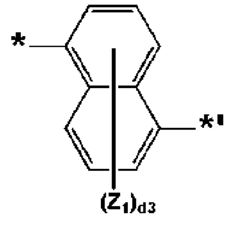
Formule 2-5

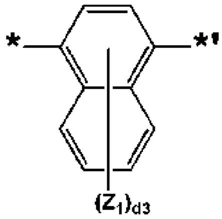
Formule 2-6

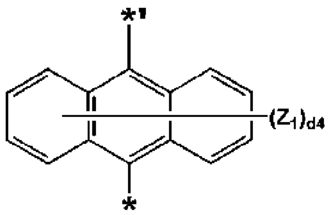
Formule 2-7

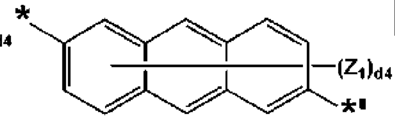
Formule 2-8

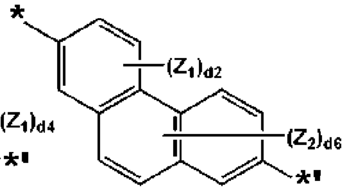
Formule 2-9

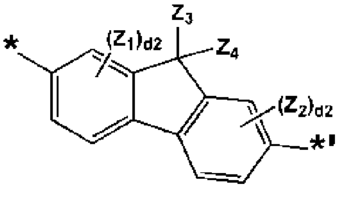
Formule 2-10

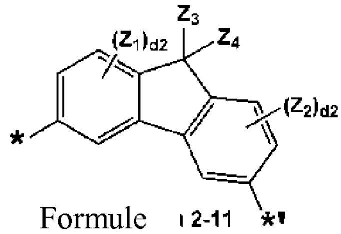
Formule 2-11

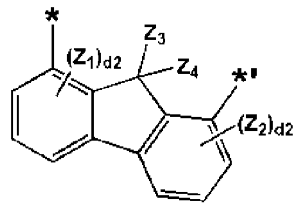
Formule 2-12

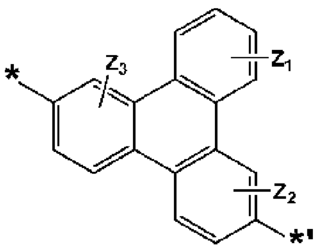
Formule 2-13

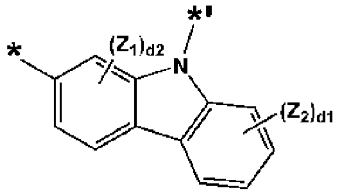
Formule 2-14

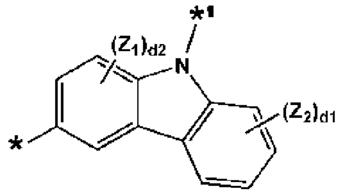
Formule 2-15

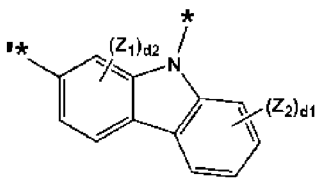
Formule 2-16

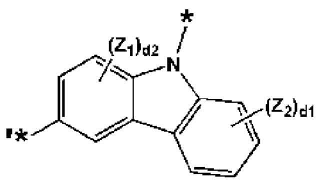
Formule 2-17

où, dans les formules 2-1 à 2-17,

$Z_1$ à $Z_4$ sont chacun indépendamment sélectionnés entre un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_{10}$-$C_{20}$, un groupe phényle, un groupe naphthyle, un groupe anthracényle, un groupe triphénylényle, un groupe pyrényle, un groupe phénanthrényle, un groupe fluorényle, un groupe chrysényle, un groupe carbazolyle, un groupe benzocarbazolyle, un groupe dibenzocarbazolyle, un groupe dibenzofuranyle, un groupe dibenzothiophényle, un groupe pyridinyle, un groupe pyrimidinyle, un groupe triazinyle, un groupe quinolinyle, un groupe isoquinolinyle, un groupe quinazolinyle, un groupe quinoxalinyle, un groupe biphényle, et $-Si(Q_{33})(Q_{34})(Q_{35})$, où $Q_{33}$ à $Q_{35}$ sont chacun indépendamment sélectionnés entre : un hydrogène, un groupe alkyle $C_1$-$C_{20}$, un groupe alkoxy $C_1$-$C_{20}$, un groupe phényle, un groupe naphthyle, un groupe anthracényle, un groupe pyrényle, un groupe phénanthrényle, un groupe fluorényle, un groupe chrysényle, un groupe carbazolyle, un groupe benzocarbazolyle, un groupe dibenzocarbazolyle, un groupe dibenzofuranyle, un groupe dibenzothiophényle, un groupe pyridinyle, un groupe pyrimidinyle, un groupe triazinyle, un groupe quinolinyle, un groupe isoquinolinyle, un groupe quinazolinyle, et un groupe quinoxalinyle ; et

d1 est un nombre entier de 1 à 4, d2 est un nombre entier de 1 à 3, d3 est un nombre entier de 1 à 6, d4 est

un nombre entier de 1 à 8, et d6 est un nombre entier de 1 à 5, et * et *' indiquent chacun un site de liaison à un atome voisin.

**6.** OLED selon la revendication 4, dans lequel i) au moins l'un de $R_2$ et $R_3$ et ii) $R_1$ et $R_7$ sont sélectionnés chacun indépendamment entre :

un groupe phényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ; et

un groupe phényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, -Si($Q_{33}$)($Q_{34}$)($Q_{35}$), un groupe phényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzoïmidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle,

un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, et un groupe biphényle.

**7.** OLED selon la revendication 4, dans lequel $R_1$ à $R_7$ sont chacun indépendamment sélectionnés entre :

un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, et un groupe alkoxy $C_1$-$C_{20}$ ;
un groupe alkyle $C_1$-$C_{20}$ et un groupe alkoxy $C_1$-$C_{20}$, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, et un groupe acide phosphorique ou un sel de celui-ci ;
l'un des groupes représentés par les formules 4-1 à 4-31 ci-dessous ; et
-Si($Q_3$)($Q_4$)($Q_5$), (mais $R_4$ à $R_5$ ne sont pas -Si($Q_3$)($Q_4$)($Q_5$)), et
où i) au moins l'un de $R_2$ et $R_3$ et ii) $R_1$ et $R_7$ sont chacun indépendamment représentés par l'une des formules 4-1 à 4-31 ci-dessous :

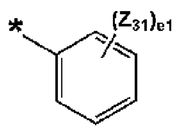
Formule 4-1

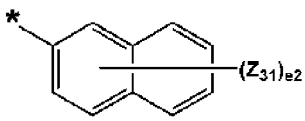
Formule 4-2

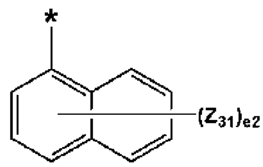
Formule 4-3

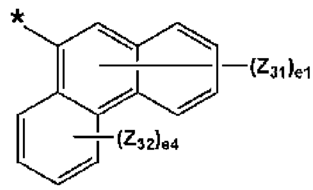
Formule 4-4

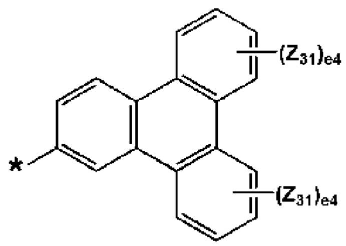
Formule 4-5

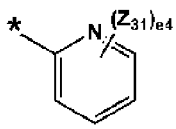
Formule 4-6

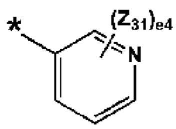
Formule 4-7

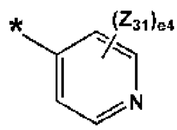
Formule 4-8

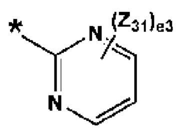
Formule 4-9

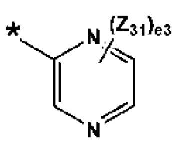
Formule 4-10

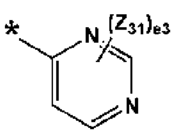
Formule 4-11

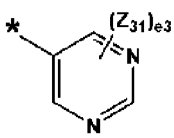
Formule 4-12

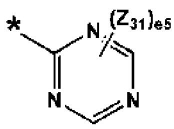
Formule 4-13

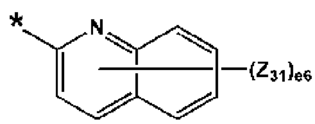
Formule 4-14

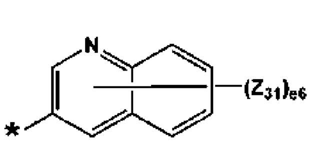
Formule 4-15

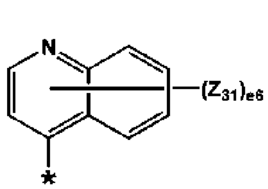
Formule 4-16

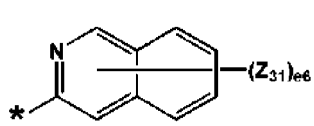
Formule 4-17

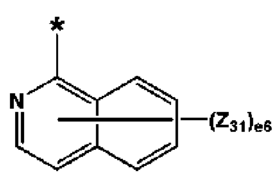
Formule 4-18

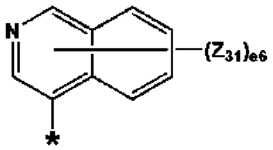
Formule 4-19

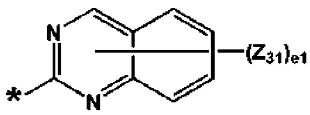
Formule 4-20

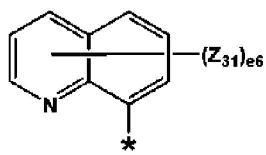
Formule 4-21

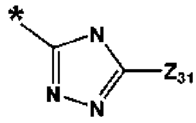
Formule 4-22

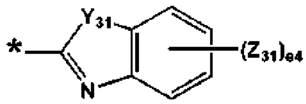
Formule 4-23

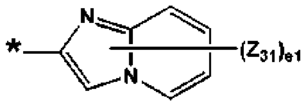
Formule 4-24

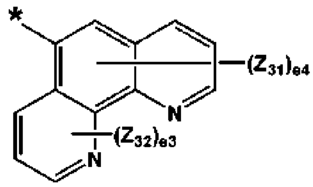
Formule 4-25

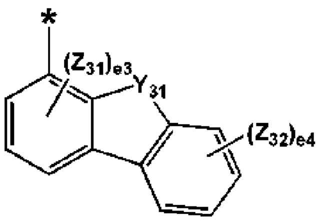
Formule 4-26

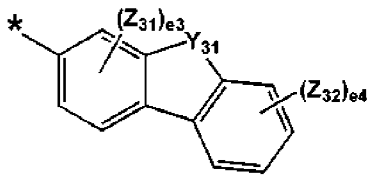
Formule 4-27

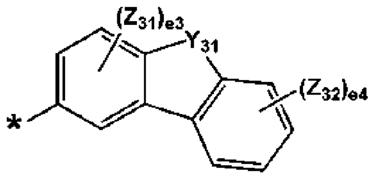
Formule 4-28

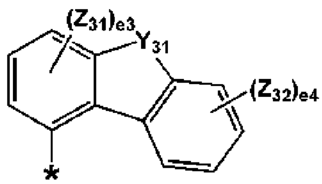
Formule 4-29

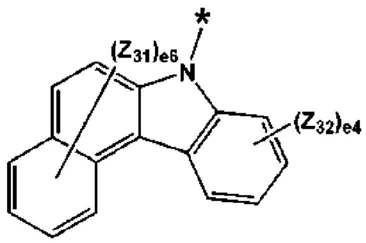
Formule 4-30

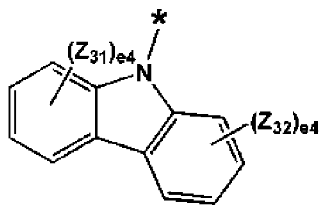
Formule 4-31

où, dans les formules 4-1 à 4-31,

$Y_{31}$ est O, S, $C(Z_{33})(Z_{34})$, $N(Z_{35})$, ou $Si(Z_{36})(Z_{37})$ (étant entendu que $Y_{31}$, dans la formule 4-23 n'est pas NH); $Z_{31}$ à $Z_{37}$ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe anthracényle, un groupe pyrényle, un groupe phénanthrényle, un groupe fluorényle, un groupe chrysényle, un groupe benzocarbazolyle, un groupe dibenzocarbazolyle, un groupe dibenzofuranyle, un groupe dibenzothiophényle, un groupe pyridinyle, un groupe pyrimidinyle, un groupe triazinyle, un groupe quinolinyle, un groupe isoquinolinyle, un groupe quinazolinyle, un groupe quinoxalinyle, un groupe biphényle, et $-Si(Q_{33})(Q_{34})(Q_{35})$, où $Q_3$ à $Q_5$ et $Q_{33}$ à $Q_{35}$ sont chacun sélectionnés indépendamment entre : un hydrogène, un groupe alkyle $C_1$-$C_{20}$, un groupe alkoxy $C_1$-$C_{20}$, un groupe phényle, un groupe naphthyle, un groupe anthracényle, un groupe pyrényle, un groupe phénanthrényle, un groupe fluorényle, un groupe chrysényle, un groupe carbazolyle, un groupe benzocarbazolyle, un groupe dibenzocarbazolyle, un groupe dibenzofuranyle, un groupe dibenzothiophényle, un groupe pyridinyle, un groupe pyrimidinyle, un groupe triazinyle, un groupe quinolinyle, un groupe isoquinolinyle, un groupe quinazolinyle, et un groupe quinoxalinyle; et

e1 est un nombre entier de 1 à 5, e2 est un nombre entier de 1 à 7, e3 est un nombre entier de 1 à 3, e4 est un nombre entier de 1 à 4, e5 est un nombre entier de 1 ou 2, et e6 est un nombre entier de 1 à 6, et

* est un site de liaison à un atome voisin.

8. OLED selon l'une quelconque des revendications 1-7, dans lequel l'hôte de transport d'électrons comprend au moins l'un des composés EH1-401 à EH1-415 et EH2-1 à EH2-30 ci-dessous :

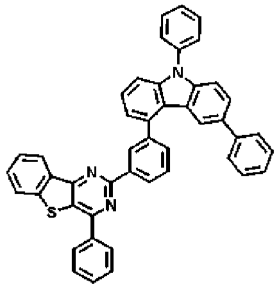

EH1-401

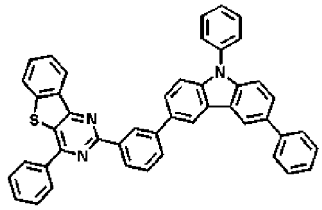

EH1-402

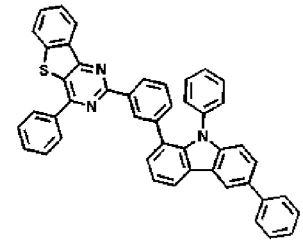

EH1-403

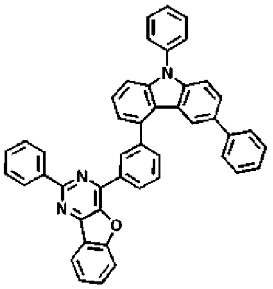

EH1-404

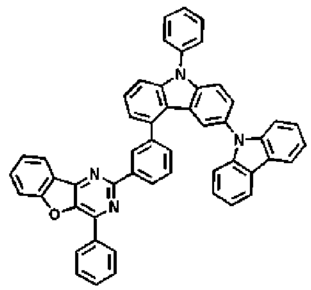

EH1-405

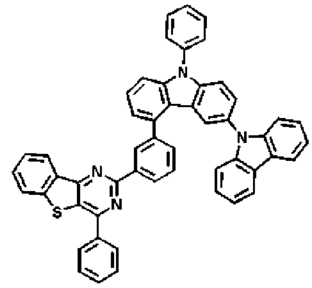

EH1-406

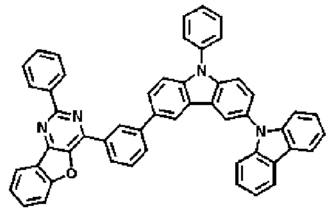

EH1-407

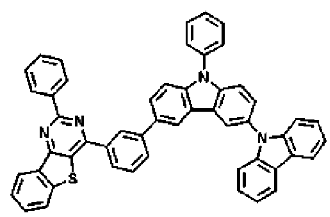

EH1-408

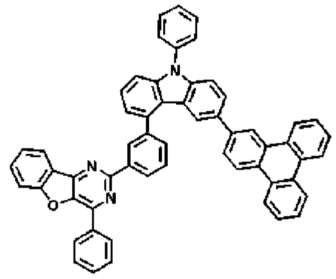

EH1-409

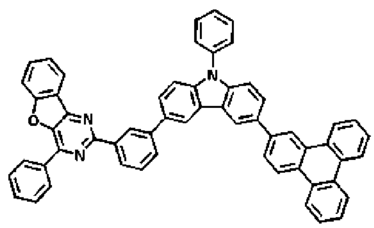

EH1-410

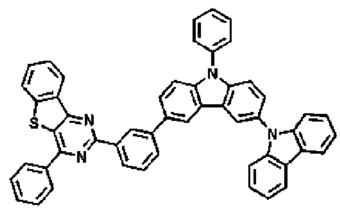

EH1-411

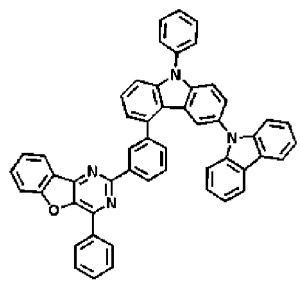

EH1-412

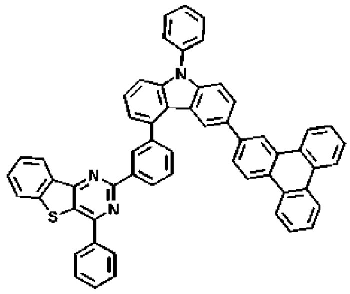

EH1-413

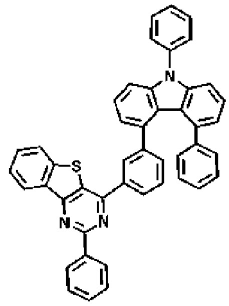

EH1-414

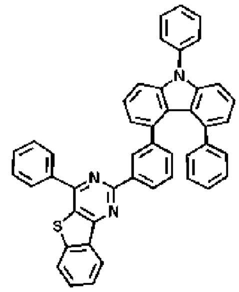

EH1-415

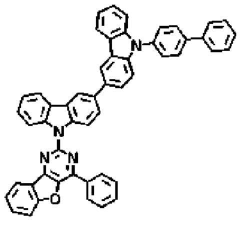

EH2-1

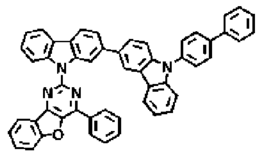

EH2-2

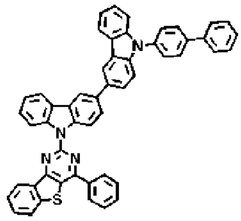

EH2-3

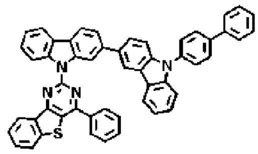

EH2-4

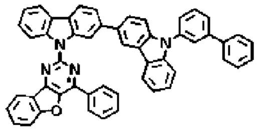

EH2-5

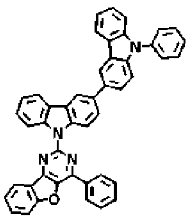

EH2-6

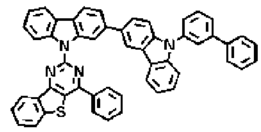

EH2-7

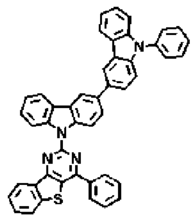

EH2-8

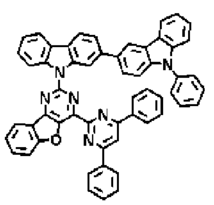

EH2-9

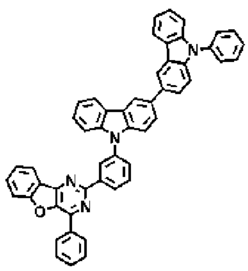

EH2-10

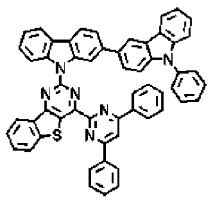

EH2-11

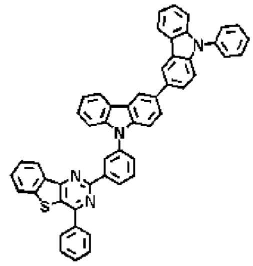

EH2-12

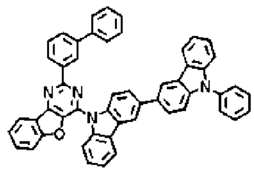

EH2-13

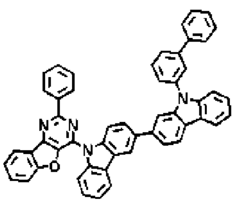

EH2-14

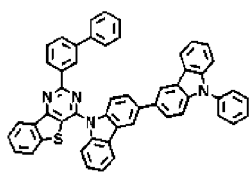

EH2-15

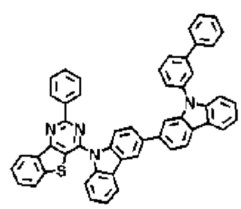

EH2-16

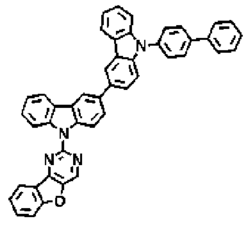

EH2-17

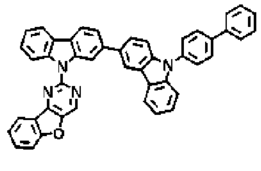

EH2-18

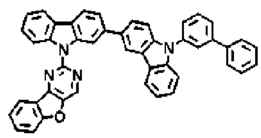

EH2-19

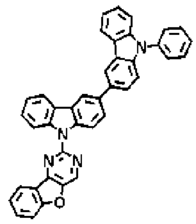

EH2-20

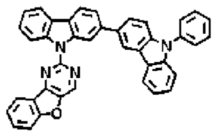

EH2-21

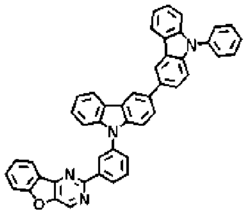

EH2-22

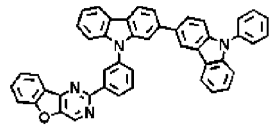

EH2-23

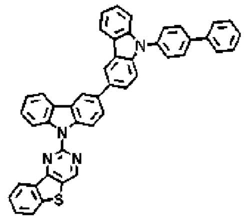

EH2-24

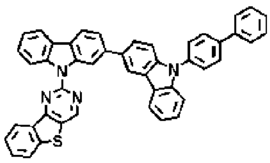

EH2-25

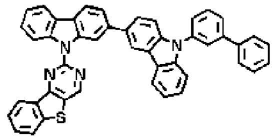

EH2-26

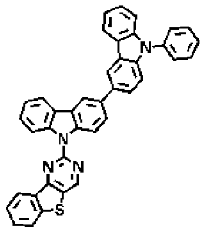

EH2-27

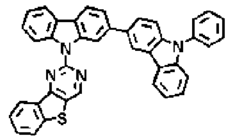

EH2-28

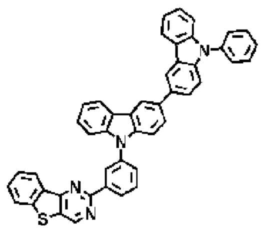

EH2-29

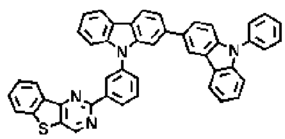

EH2-30

**9.** OLED selon l'une quelconque des revendications 1-7, dans lequel l'hôte de transport d'électrons comprend un composé représenté par la formule 10 ci-dessous :

<Formule 10>

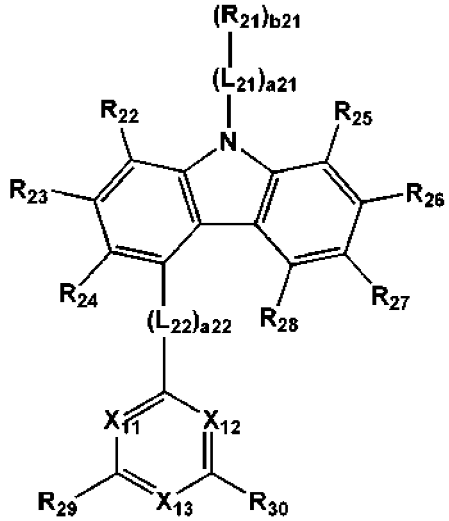

où, dans la formule 10,

$L_{21}$ et $L_{22}$ sont chacun indépendamment sélectionnés entre un groupe cycloalkylène $C_3$-$C_{10}$ substitué ou non substitué, un groupe hétérocycloalkylène $C_1$-$C_{10}$ substitué ou non substitué, un groupe cycloalkénylène $C_3$-$C_{10}$ substitué ou non substitué, un groupe hétérocycloalkénylène $C_1$-$C_{10}$ substitué ou non substitué, un groupe arylène $C_6$-$C_{60}$ substitué ou non substitué, un groupe hétéroarylène $C_1$-$C_{60}$ substitué ou non substitué, un groupe polycyclique condensé non aromatique bivalent substitué ou non substitué, et un groupe hétéropolycyclique condensé non aromatique bivalent substitué ou non substitué ;

a21 et a22 sont chacun indépendamment un nombre entier de 0 à 3 ;

$X_{11}$ est N ou $C(R_{51})$, $X_{12}$ est N ou $C(R_{52})$, $X_{13}$ est N ou $C(R_{53})$, et au moins deux de $X_{11}$ à $X_{13}$ sont N,

$R_{21}$ à $R_{30}$ et $R_{51}$ à $R_{53}$ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe hétéroaryle $C_1$-$C_{60}$ substitué ou non substitué, un groupe polycyclique condensé non aromatique monovalent substitué ou non substitué, un groupe hétéropolycyclique condensé non aromatique monovalent substitué ou non substitué, et $-Si(Q_{41})(Q_{42})(Q_{43})$ ;

b21 et b22 sont chacun indépendamment un nombre entier de 1 à 5 ;

au moins l'un de $R_{25}$ à $R_{28}$ est sélectionné entre un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe hétéroaryle $C_1$-$C_{60}$ substitué ou non substitué, un groupe polycyclique condensé non aromatique monovalent substitué ou non substitué, et un groupe hétéropolycyclique condensé non aromatique monovalent substitué ou non substitué ; et

au moins l'un des substituants du groupe cycloalkylène $C_3$-$C_{10}$ substitué, du groupe hétérocycloalkylène $C_1$-$C_{10}$ substitué, du groupe cycloalkénylène $C_3$-$C_{10}$ substitué, du groupe hétérocycloalkénylène $C_1$-$C_{10}$ substitué, du groupe arylène $C_6$-$C_{60}$ substitué, du groupe hétéroarylène $C_1$-$C_{60}$ substitué, du groupe polycyclique condensé non aromatique bivalent substitué, du groupe hétéropolycyclique condensé non aromatique bivalent substitué, du groupe alkyle $C_1$-$C_{60}$ substitué, du groupe alkényle $C_2$-$C_{60}$ substitué, du groupe alkynyle $C_2$-$C_{60}$ substitué, du groupe cycloalkyle $C_3$-$C_{10}$ substitué, du groupe hétérocycloalkyle $C_1$-$C_{10}$ substitué, du groupe cycloalkényle $C_3$-$C_{10}$ substitué, du groupe hétérocycloalkényle $C_1$-$C_{10}$ substitué, du groupe aryle $C_6$-$C_{60}$ substitué, du groupe aryloxy $C_6$-$C_{60}$ substitué, du groupe arylthio $C_6$-$C_{60}$ substitué, du groupe hétéroaryle $C_1$-$C_{60}$ substitué, du

groupe polycyclique condensé non aromatique monovalent substitué, et du groupe hétéropolycyclique condensé non aromatique monovalent substitué est sélectionné entre :

un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$,
un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, un groupe hétéropolycyclique condensé non aromatique monovalent, -Si($Q_{51}$)($Q_{52}$)($Q_{53}$), et -B($Q_{54}$)($Q_{55}$);
un groupe cycloalkyle $C_3$-$C_{10}$, un groupe hétérocycloalkyle $C_1$-$C_{10}$, un groupe cycloalkényle $C_3$-$C_{10}$ un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, et un groupe hétéropolycyclique condensé non aromatique monovalent ;
un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, et un groupe hétéropolycyclique condensé non aromatique monovalent, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, un groupe hétéropolycyclique condensé non aromatique monovalent, -Si($Q_{61}$)($Q_{62}$)($Q_{63}$), et -B($Q_{64}$)($Q_{65}$) ; et
-Si($Q_{71}$)($Q_{72}$)($Q_{73}$), et -B($Q_{74}$)($Q_{75}$),
où $Q_{41}$ à $Q_{43}$, $Q_{51}$ à $Q_{55}$, $Q_{61}$ à $Q_{65}$, et $Q_{71}$ à $Q_{75}$ sont chacun indépendamment sélectionnés entre : hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe hétéroaryle $C_1$-$C_{60}$, un groupe polycyclique condensé non aromatique monovalent, et un groupe hétéropolycyclique condensé non aromatique monovalent, où de préférence :

$L_{21}$ et $L_{22}$ dans la formule 10 sont chacun sélectionnés indépendamment entre :

un groupe phénylène, un groupe naphtylène, un groupe phénalénylène, un groupe phénanthrénylène, un groupe triphénylénylène, un groupe anthracénylène, un groupe pyrrolylène, un groupe pyridinylène, un groupe pyrazinylène, un groupe pyrimidinylène, un groupe pyridazinylène, un groupe isoindolylène, un groupe indolylène, un groupe furanylène, un groupe benzofuranylène, un groupe thiophénylène, un groupe benzothiophénylène, et un groupe triazinylène ;
un groupe phénylène, un groupe naphtylène, un groupe phénalénylène, un groupe phénanthrénylène, un groupe triphénylénylène, un groupe anthracénylène, un groupe pyrrolylène, un groupe pyridinylène, un groupe pyrazinylène, un groupe pyrimidinylène, un groupe pyridazinylène, un groupe isoindolylène, un groupe indolylène, un groupe furanylène, un groupe benzofuranylène, un groupe thiophénylène, un groupe benzothiophénylène, et un groupe triazinylène, chacun substitué avec au moins l'un de : un deutérium, -F, -Cl, -Br, -I, un groupe hydroxyle, un groupe cyano,

un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe anthracényle, un groupe pyrényle, un groupe phénanthrényle, un groupe triphénylényle, un groupe fluorényle, un groupe carbazolyle, un groupe benzocarbazolyle, un groupe dibenzocarbazolyle, un groupe pyridinyle, un groupe pyrimidinyle, un groupe pyrazinyle, un groupe pyridazinyle, un groupe triazinyle, un groupe quinolinyle, un groupe isoquinolinyle, un groupe phthalazinyle, un groupe quinoxalinyle, un groupe cinnolinyle, et un groupe quinazolinyle ; et les groupes représentés par les formules 11-1 à 11-6 ci-dessous :

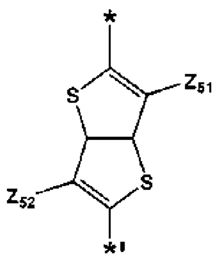
Formule 11-1

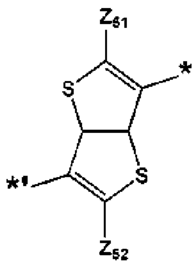
Formule 11-2

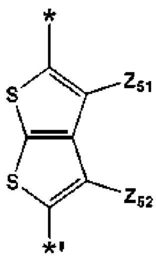
Formule 11-3

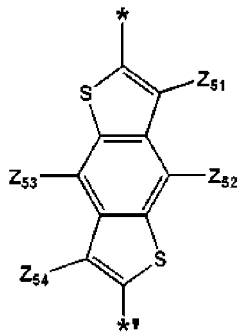
Formule 11-4

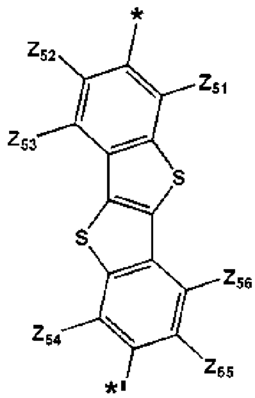
Formule 11-5

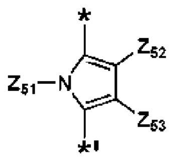
Formule 11-6

où, dans les formules 11-1 à 11-6,

$Z_{51}$ à $Z_{56}$ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe anthracényle, un groupe pyrényle, un groupe phénanthrényle, un groupe triphénylényle, un groupe fluorényle, un groupe carbazolyle, un groupe benzocarbazolyle, un groupe dibenzocarbazolyle, un groupe pyridinyle, un groupe pyrimidinyle, un groupe pyrazinyle, un groupe pyridazinyle, un groupe triazinyle, un groupe quinolinyle, un groupe isoquinolinyle, un groupe phthalazinyle, un groupe quinoxalinyle, un groupe cinnolinyle, et un groupe quinazolinyle, et

*indique un site de liaison à un atome voisin ; et/ou

$R_{21}$ est sélectionné entre les groupes représentés par les formules 15-1 à 15-40 et -Si($Q_{41}$)($Q_{42}$)($Q_{43}$) (où $Q_{41}$ à $Q_{43}$ sont chacun indépendamment sélectionnés entre : un hydrogène, un groupe alkyle $C_1$-$C_{20}$, un groupe alkoxy $C_1$-$C_{20}$, un groupe phényle, un groupe naphthyle, un groupe anthracényle, un groupe pyrényle, un groupe phénanthrényle, un groupe triphénylényle, un groupe fluorényle, un groupe carbazolyle, un groupe benzocarbazolyle, un groupe dibenzocarbazolyle, un groupe pyridinyle, un groupe pyrimidinyle, un groupe pyrazinyle, un groupe pyridazinyle, un groupe triazinyle, un groupe quinolinyle, un groupe isoquinolinyle, un groupe phthalazinyle, un groupe quinoxalinyle, un groupe cinnolinyle, et un groupe quinazolinyle) ;

$R_{22}$ à $R_{24}$ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, et un groupe alkoxy $C_1$-$C_{20}$ ;

$R_{25}$ à $R_{30}$ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, et les groupes représentés par les formules 15-1 à 15-40 ci-dessous ;

au moins l'un de $R_{25}$ à $R_{28}$ est sélectionné entre les groupes représentés par les formules 15-1 à 15-40 ci-dessous ; et

au moins l'un de $R_{29}$ et $R_{30}$ est sélectionné entre les groupes représentés par les formules 15-1 à 15-40 ci-dessous :

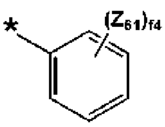
Formule 15-1
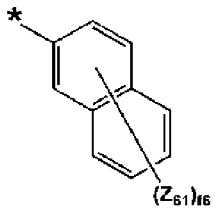
Formule 15-2
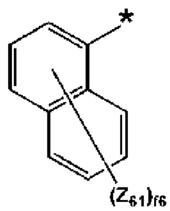
Formule 15-3
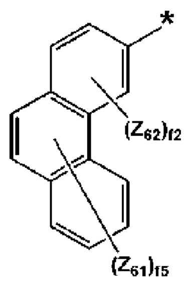
Formule 15-4
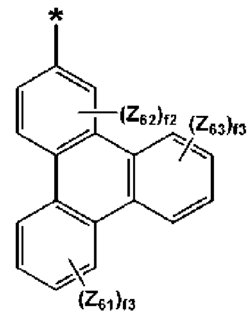
Formule 15-5

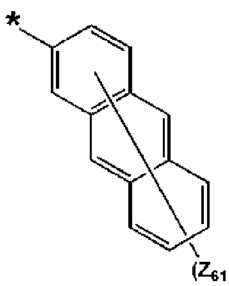
Formule 15-6
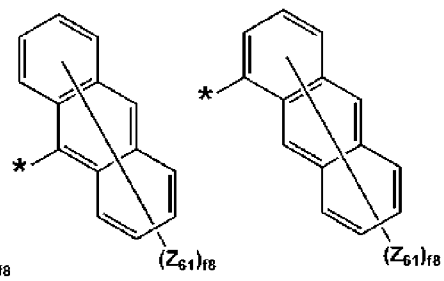
Formule 15-7 Formule 15-8
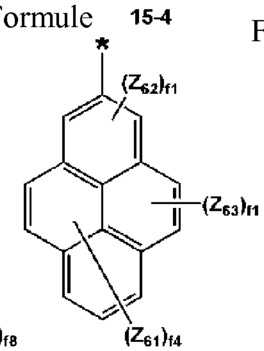
Formule 15-9
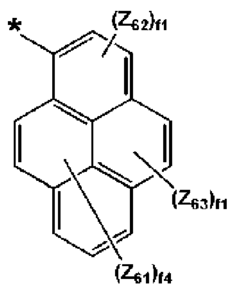
Formule 15-10

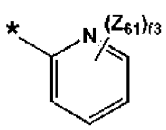
Formule15-11
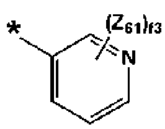
Formule15-12
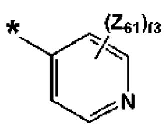
Formule15-13
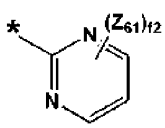
Formule 15-14
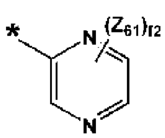
Formule15-15
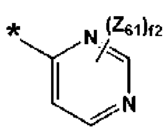
Formule15-16

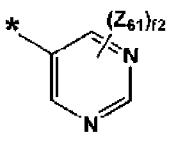
Formule 15-17
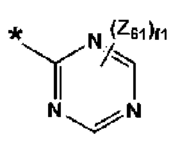
Formule 15-18
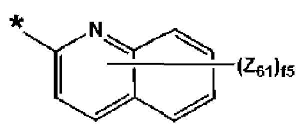
Formule 15-19
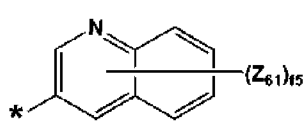
Formule 15-20

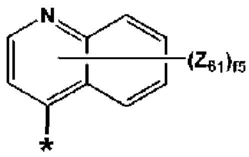

Formule 15-21

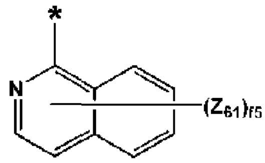

Formule 15-22

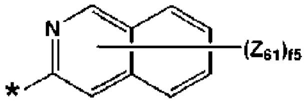

Formule 15-23

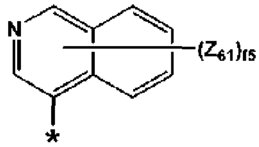

Formule 15-24

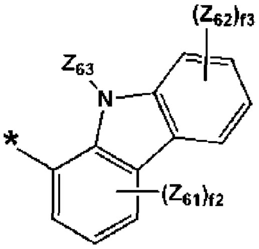

Formule 15-25

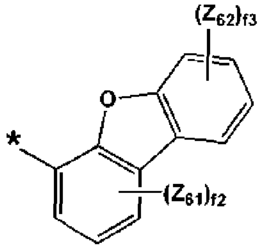

Formule 15-26

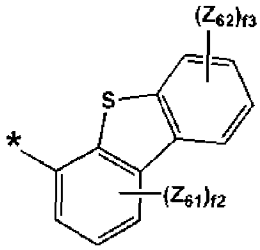

Formule 15-27

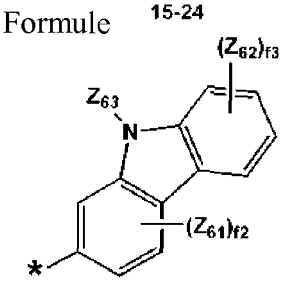

Formule 15-28

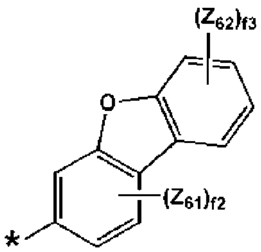

Formule 15-29

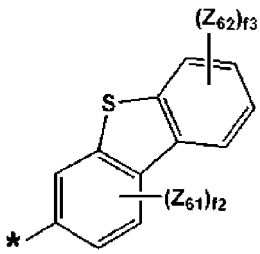

Formule 15-30

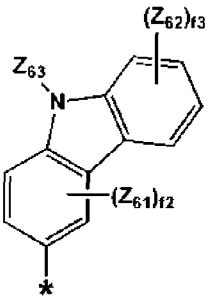

Formule 15-31

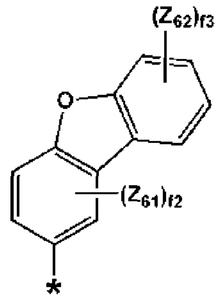

Formule 15-32

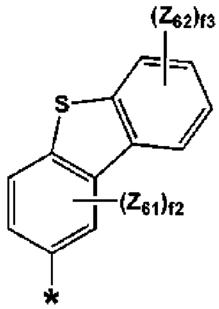

Formule 15-33

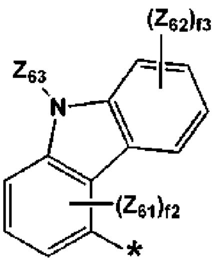

Formule 15-34

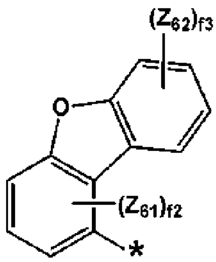

Formule 15-35

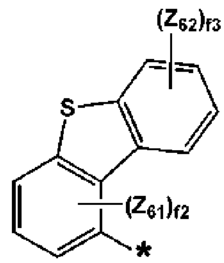

Formule 15-36

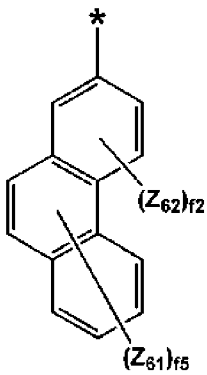

Formule 15-37

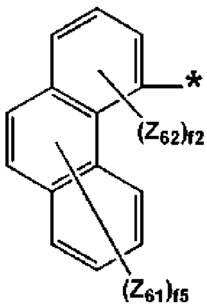

Formule 15-38

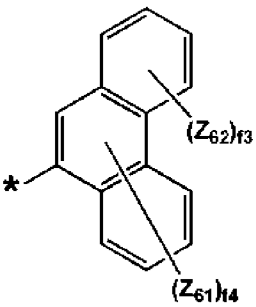

Formule 15-39

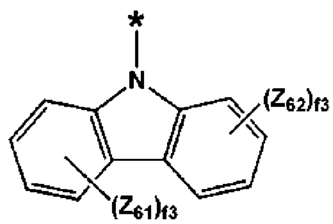

Formule 15-40

où, dans les formules 15-1 à 15-40,

$Z_{61}$ à $Z_{63}$ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de ce dernier, un groupe acide sulfonique ou un sel de celui-ci, un groupe acide phosphorique ou un sel de celui-ci, un groupe alkyle $C_1$-$C_{20}$, un groupe alkény $C_2$-$C_{20}$, un groupe alkynyle $C_2$-$C_{20}$, un groupe alkoxy $C_1$-$C_{20}$, un groupe phényle, un groupe naphthyle, un groupe anthracényle, un groupe pyrényle, un groupe phénanthrényle, un groupe fluorényle, un groupe carbazolyle, un groupe benzocarbazolyle, un groupe dibenzocarbazolyle, un groupe pyridinyle, un groupe pyrimidinyle, un groupe pyrazinyle, un groupe pyridazinyle, un groupe triazinyle, un groupe quinolinyle, un groupe isoquinolinyle, un groupe phthalazinyle, un groupe quinoxalinyle, un groupe cinnolinyle, et un groupe quinazolinyle ;
f1 est 1 ou 2, f2 est un nombre entier de 1 à 3, f3 est un nombre entier de 1 à 4, f4 est un nombre entier de 1 à 5, f5 est un nombre entier de 1 à 6, f6 est un nombre entier de 1 à 7, f7 est un nombre entier de 1 à 8, et f8 est un nombre entier de 1 à 9; et
*indique un site de liaison à un atome voisin.

**10.** OLED selon la revendication 9, dans lequel $L_{21}$ et $L_{22}$ sont chacun indépendamment sélectionnés entre les groupes représentés par les formules 12-1 à 12-15 ci-dessous ;
$X_{11}$ à $X_{13}$ sont N ;
a21 et a22 sont chacun indépendamment 0 ou 1 ;
$R_{22}$ à $R_{26}$ et $R_{28}$ sont un hydrogène ;
$R_{27}$, $R_{29}$, et $R_{30}$ sont chacun indépendamment sélectionnés entre les groupes représentés par les formules 15-1 à 15-40 ci-dessus :

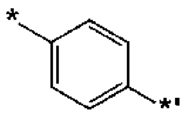
Formule12-1

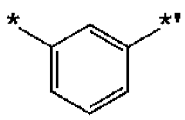
Formule12-2

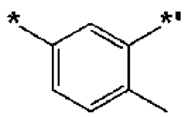
Formule 12-3

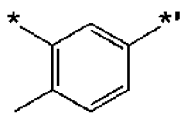
Formule 12-4

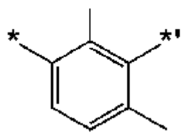
Formule 12-5

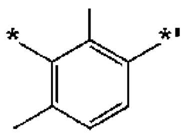
Formule 12-6

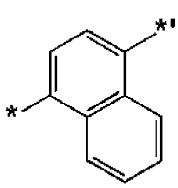
Formule 12-7

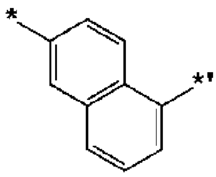
Formule 12-8

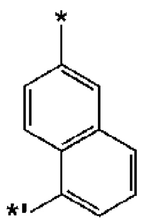
Formule 12-9

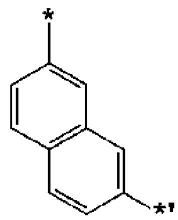
Formule 12-10

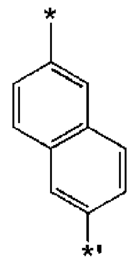
Formule12-11

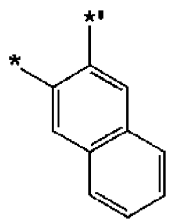
Formule12-12

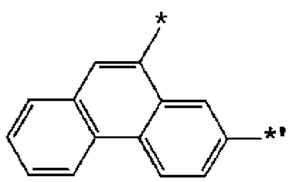
Formule 12-13

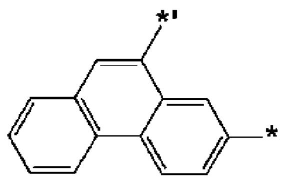
Formule 12-14

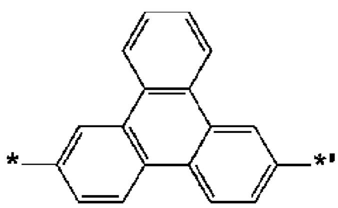
Formule 12-15

où, dans les formules 12-1 à 12-15, * et *' indiquent chacun indépendamment un site de liaison à un atome voisin.

**11.** OLED selon l'une quelconque des revendications 1-7, dans lequel l'hôte de transport d'électrons comprend au

moins l'un des composés EH3-1 to EH3-102 ci-dessous :

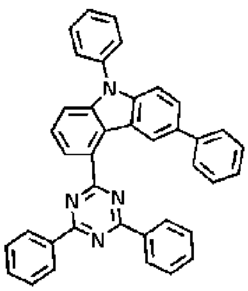

**EH3-1**

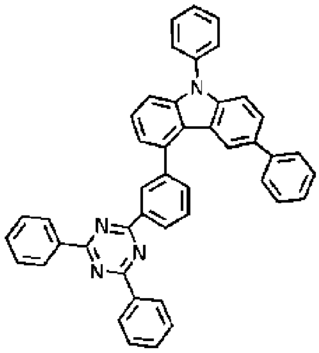

**EH3-2**

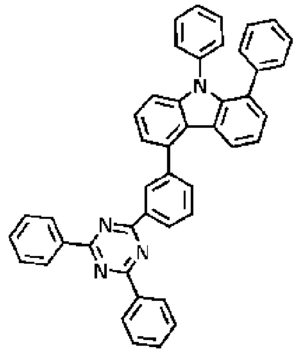

**EH3-3**

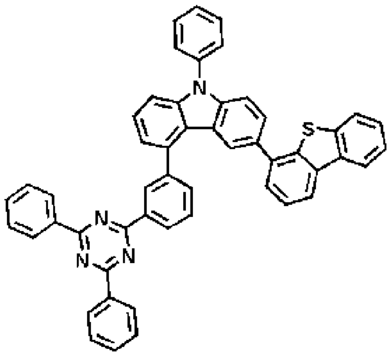

**EH3-4**

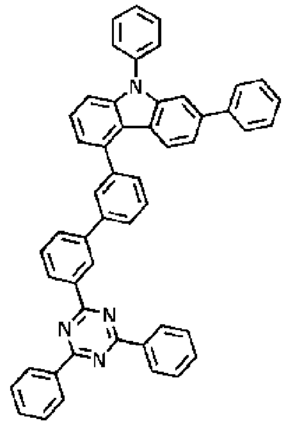

**EH3-5**

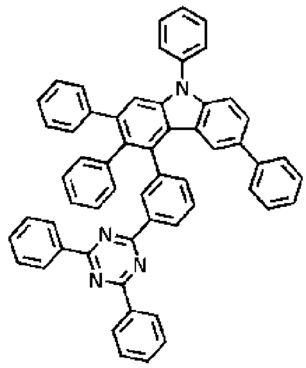

**EH3-6**

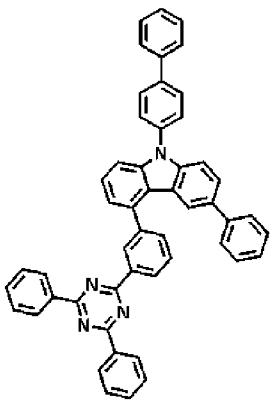

**EH3-7**

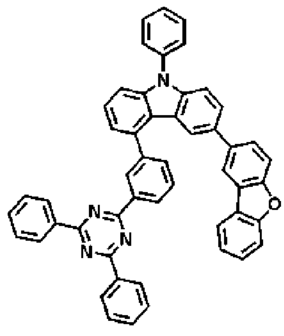

**EH3-8**

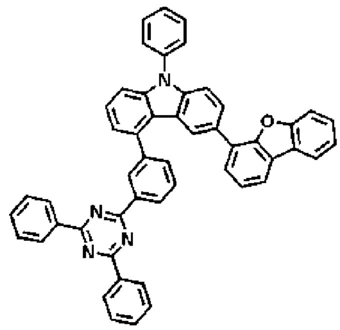

**EH3-9**

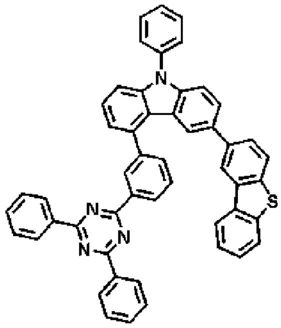

EH3-10

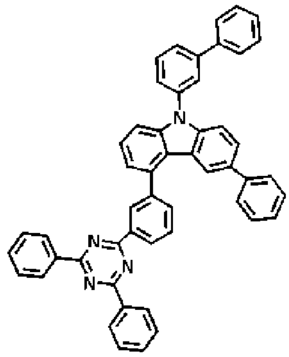

EH3-11

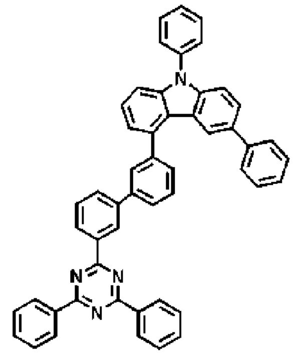

EH3-12

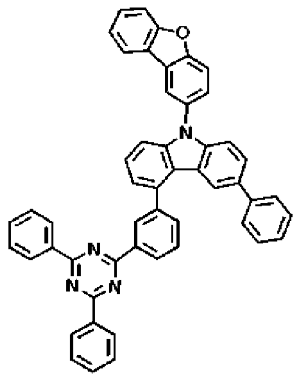

EH3-13

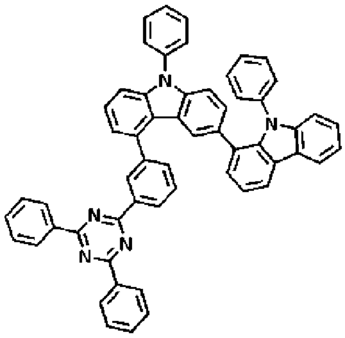

EH3-14

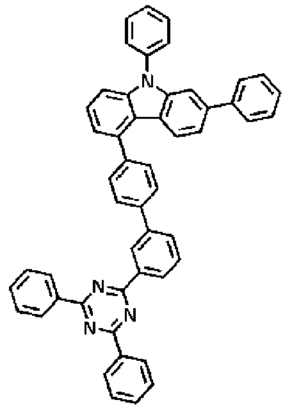

EH3-15

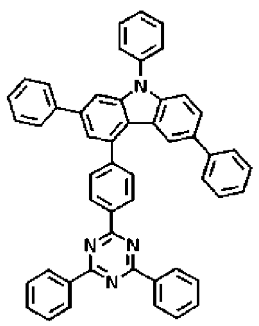

EH3-16

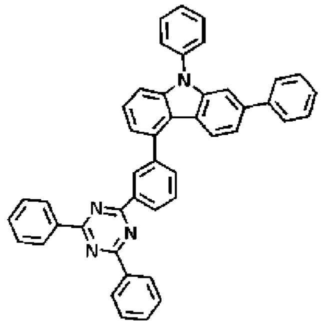

EH3-17

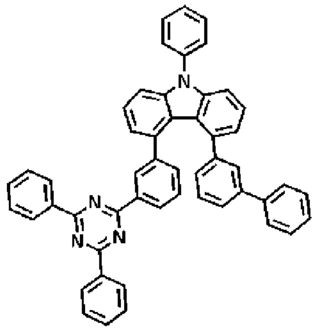

EH3-18

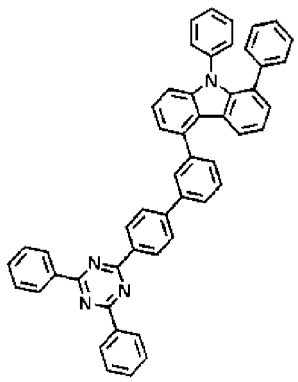

EH3-19

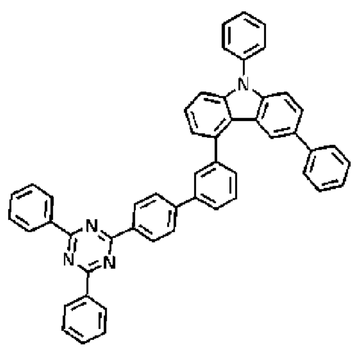

EH3-20

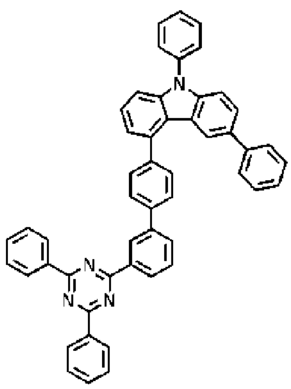

EH3-21

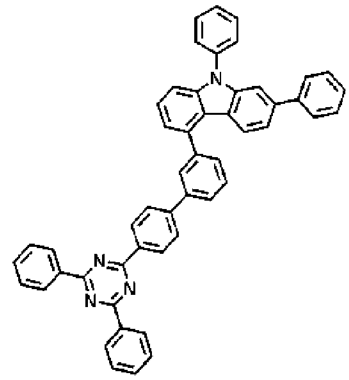

**EH3-22**

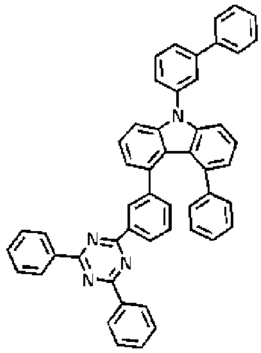

**EH3-23**

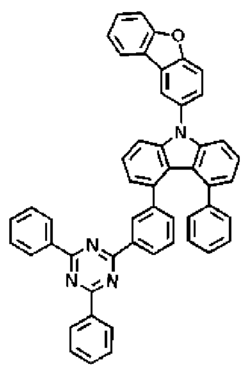

**EH3-24**

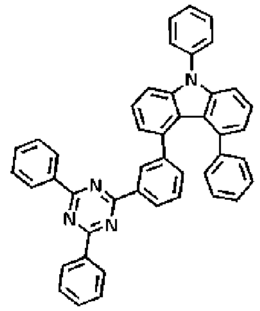

**EH3-25**

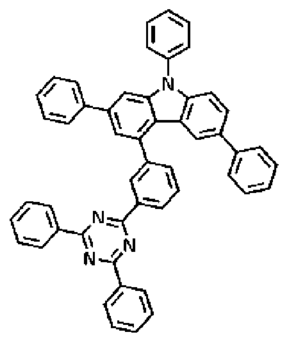

**EH3-26**

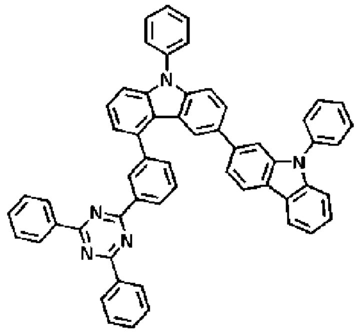

**EH3-27**

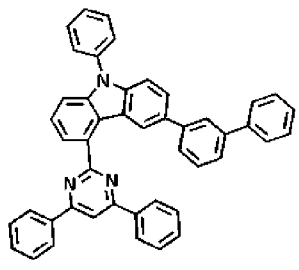

**EH3-28**

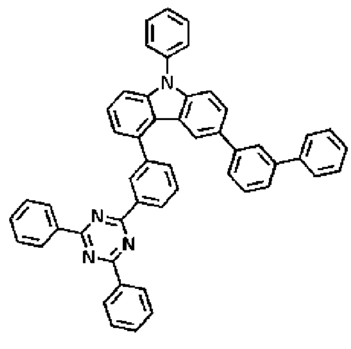

**EH3-29**

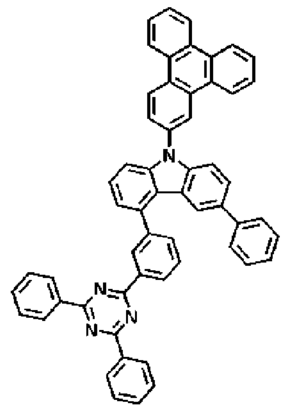

**EH3-30**

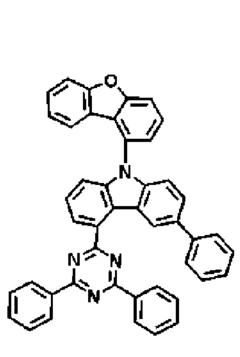

**EH3-31**

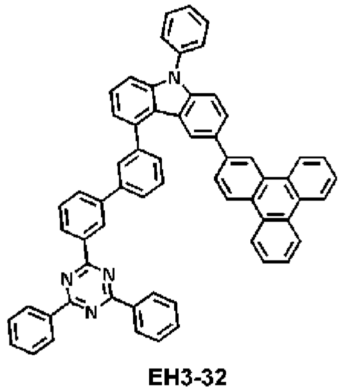

**EH3-32**

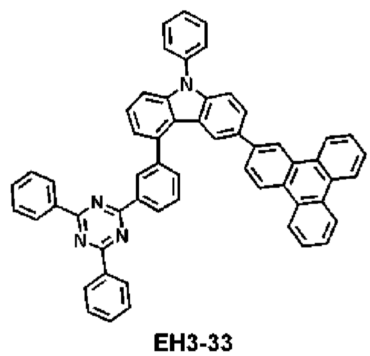

**EH3-33**

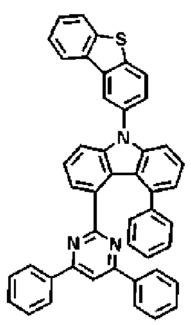

EH3-34

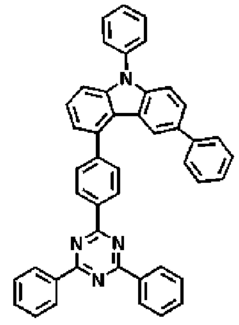

EH3-35

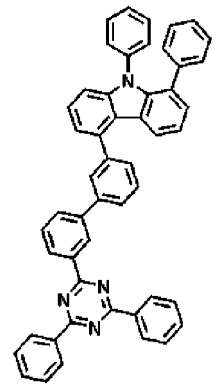

EH3-36

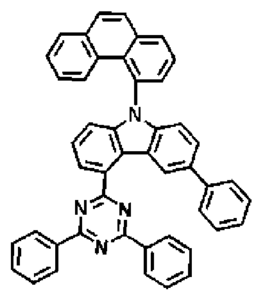

EH3-37

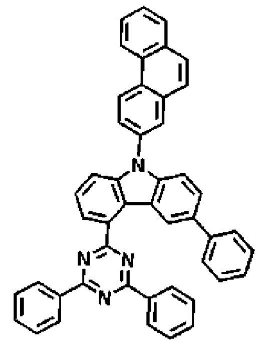

EH3-38

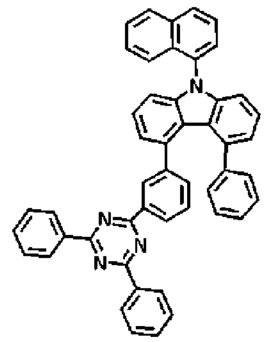

EH3-39

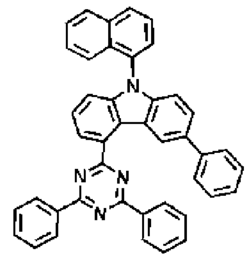

EH3-40

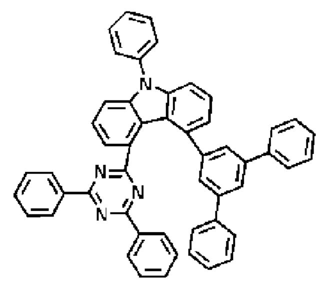

EH3-41

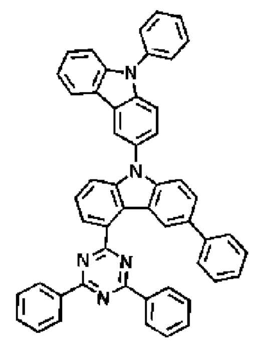

EH3-42

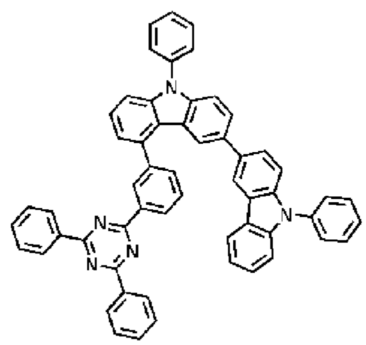

EH3-43

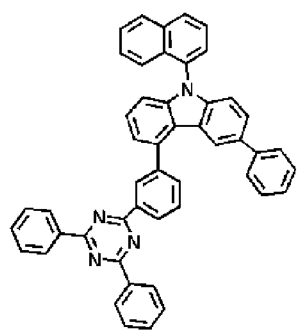

EH3-44

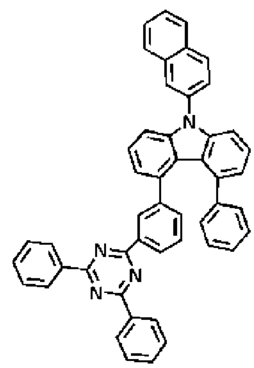

EH3-45

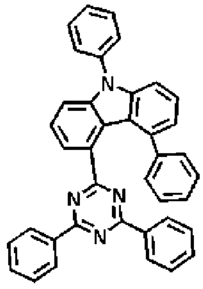

**EH3-46**

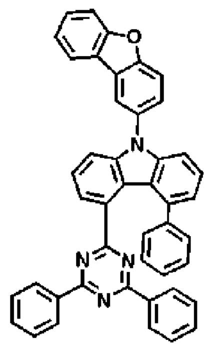

**EH3-47**

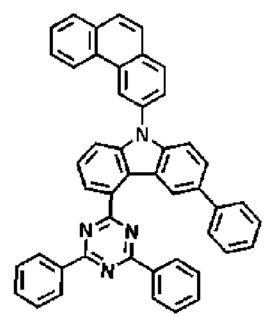

**EH3-48**

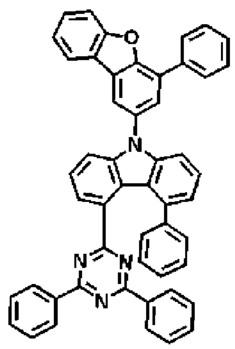

**EH3-49**

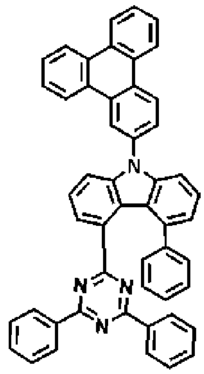

**EH3-50**

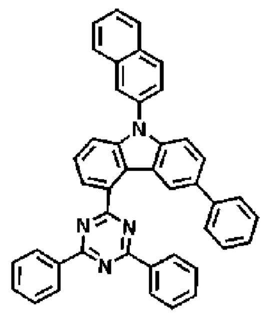

**EH3-51**

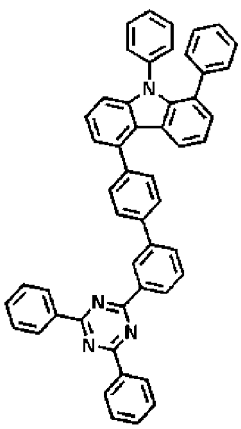

**EH3-52**

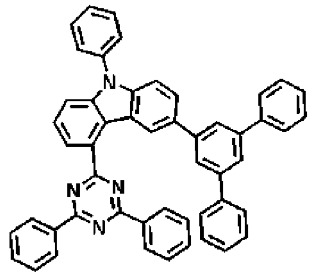

**EH3-53**

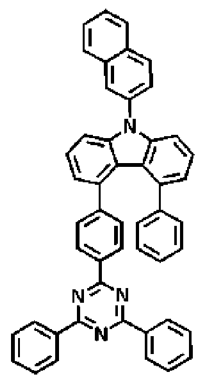

**EH3-54**

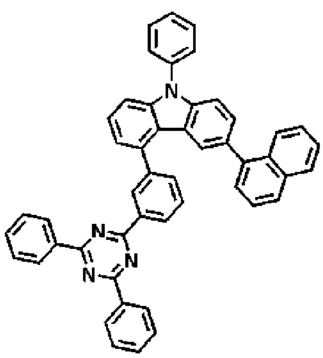

**EH3-55**

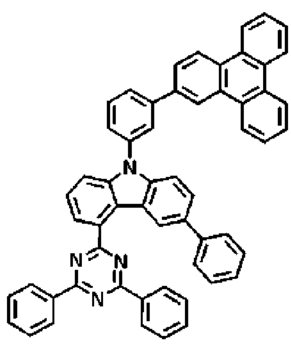

**EH3-56**

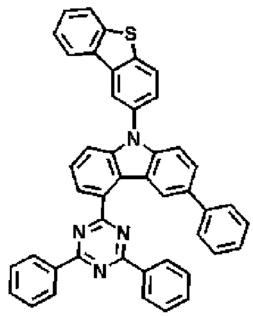

**EH3-57**

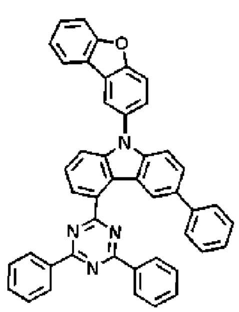

EH3-58

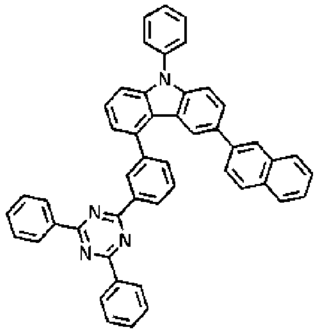

EH3-59

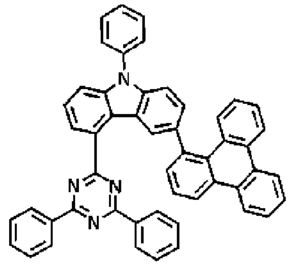

EH3-60

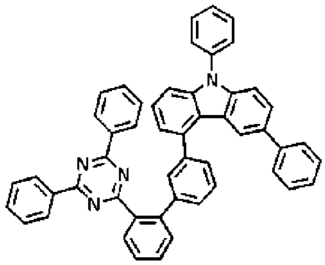

EH3-61

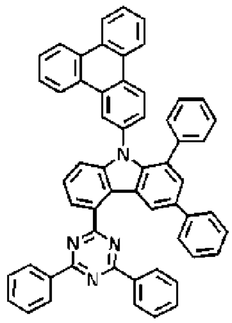

EH3-62

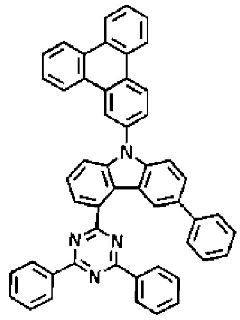

EH3-63

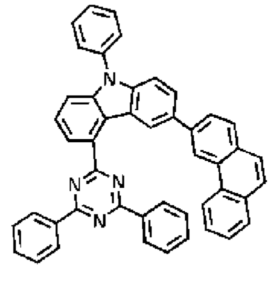

EH3-64

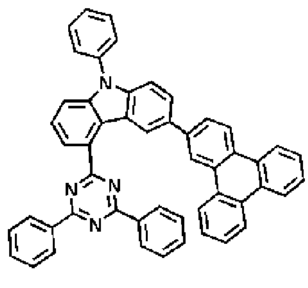

EH3-65

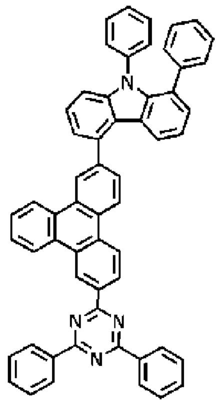

EH3-66

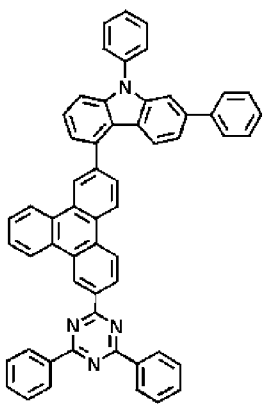

EH3-67

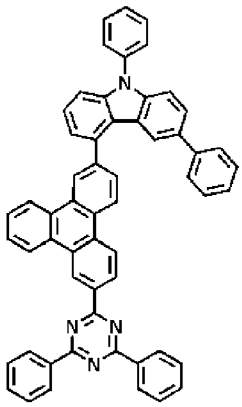

EH3-68

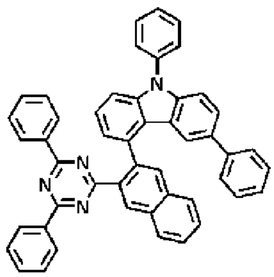

EH3-69

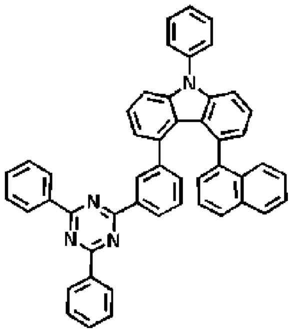
EH3-70

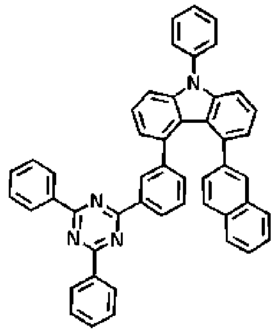
EH3-71

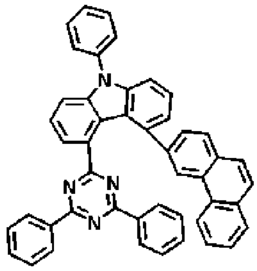
EH3-72

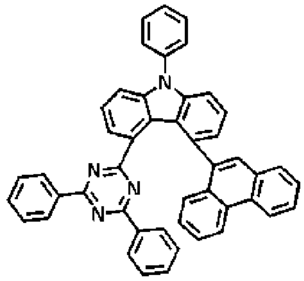
EH3-73

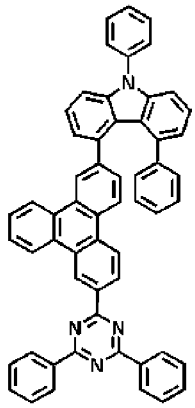
EH3-74

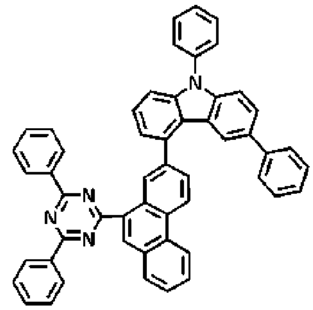
EH3-75

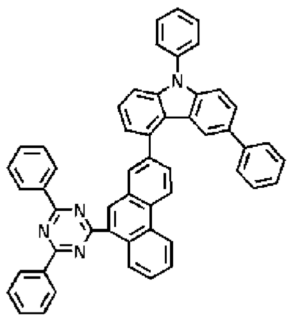
EH3-76

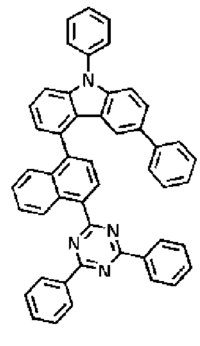
EH3-77

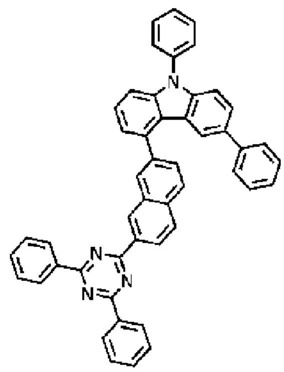
EH3-78

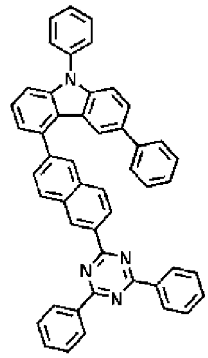
EH3-79

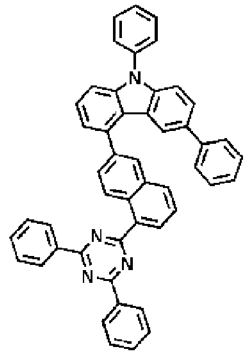
EH3-80

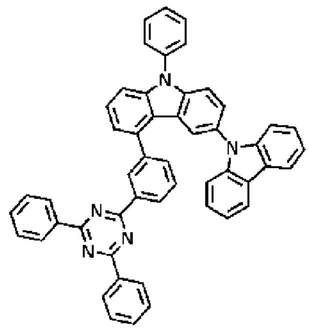
EH3-81

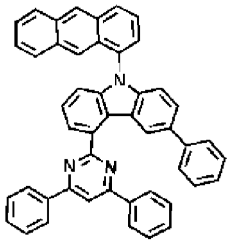

EH3-82

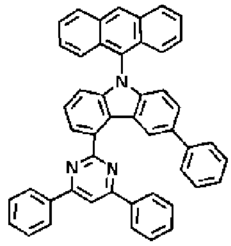

EH3-83

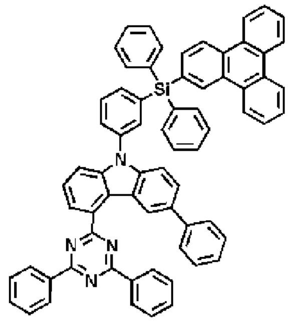

EH3-84

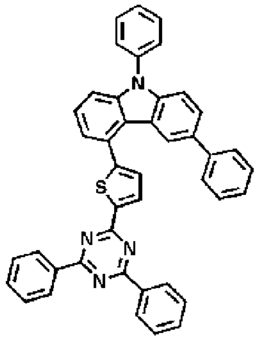

EH3-85

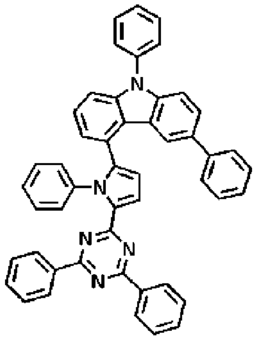

EH3-86

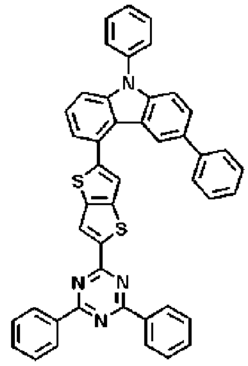

EH3-87

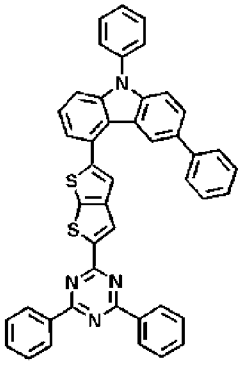

EH3-88

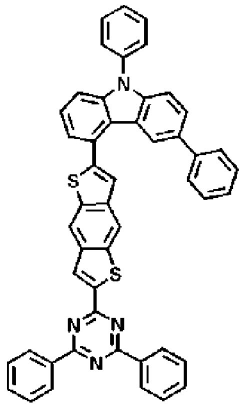

EH3-89

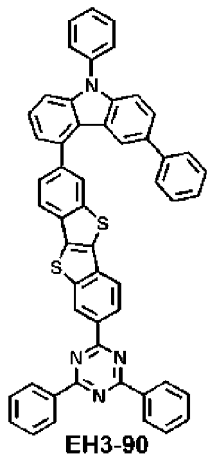

EH3-90

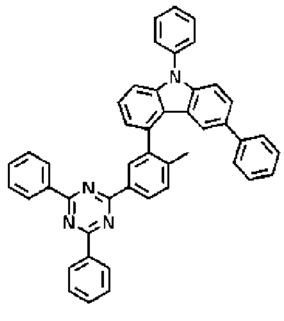

EH3-91

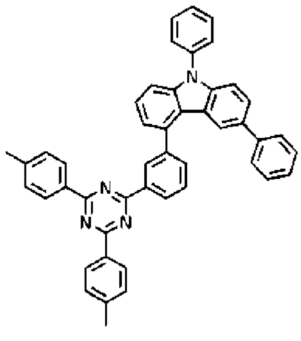

EH3-92

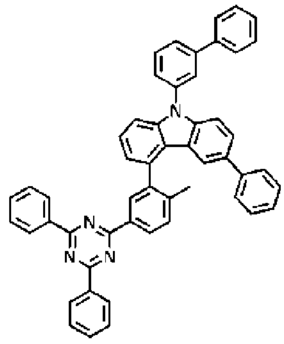

EH3-93

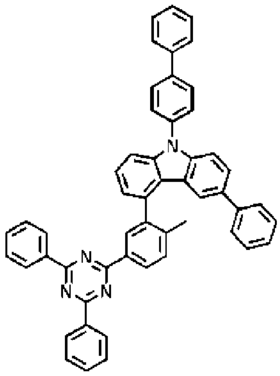

EH3-94

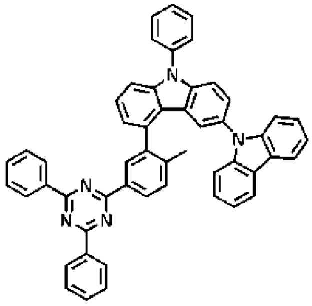

EH3-95

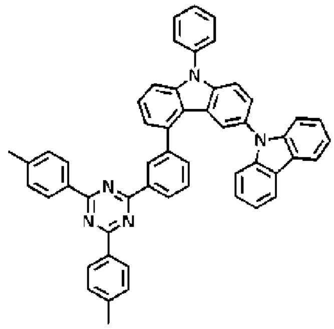

EH3-96

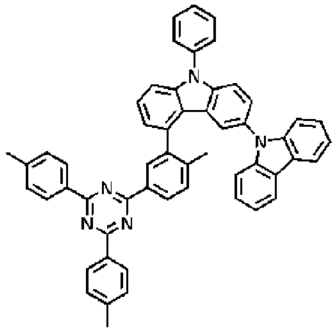

EH3-97

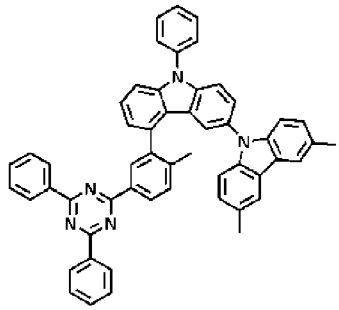

EH3-98

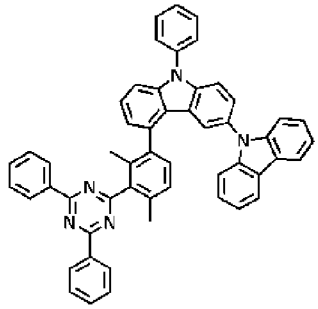

EH3-99

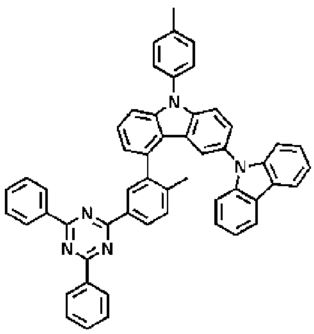

EH3-100

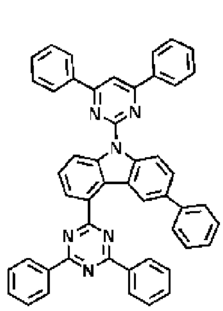

EH3-101

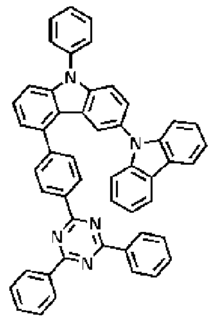

EH3-102

**12.** OLED selon l'une quelconque des revendications 1-11, dans lequel l'hôte de transport d'électrons-trous comprend un composé représenté par la formule 20 ci-dessous :

<Formule 20>

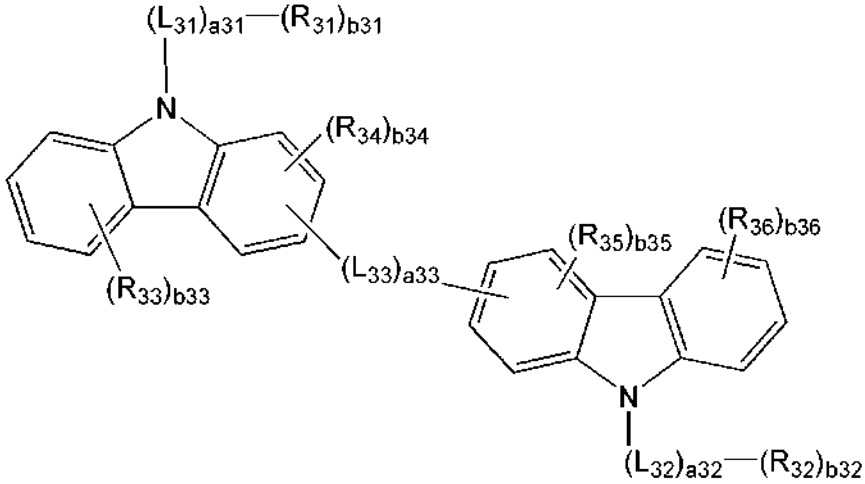

où ; dans la formule 20,

$L_{31}$ à $L_{33}$ sont chacun indépendamment sélectionnés entre : un groupe cycloalkylène $C_3$-$C_{10}$ substitué ou non substitué, un groupe cycloalkénylène $C_3$-$C_{10}$ substitué ou non substitué, un groupe arylène $C_6$-$C_{60}$ substitué ou non substitué, et un groupe polycyclique condensé non aromatique bivalent substitué ou non substitué ;
a31 à a33 sont chacun indépendamment un nombre entier de 0 à 5 ;
$R_3$, et $R_{32}$ sont chacun indépendamment un groupe cycloalkyle $C_3$-$C_{10}$ substitué ou non substitué, un groupe cycloalkényle $C_3$-$C_{10}$ substitué ou non substitué, un groupe aryle $C_6$-$C_{60}$ substitué ou non substitué, et un groupe polycyclique condensé non aromatique monovalent substitué ou non ;
$R_{33}$ à $R_{36}$ sont chacun indépendamment : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{10}$ substitué ou non substitué, un groupe cycloalkényle $C_3$-$C_{10}$ substitué ou non substitué, un groupe aryle $C_6$-$C_{60}$ substitué ou non substitué, et un groupe polycyclique condensé non aromatique monovalent substitué ou non substitué ;
b31 à b36 sont chacun indépendamment un nombre entier de 1 à 3 ;
au moins l'un des substituants du groupe cycloalkylène $C_3$-$C_{10}$ substitué, du groupe cycloalkénylène $C_3$-$C_{10}$ substitué, du groupe arylène $C_6$-$C_{60}$ substitué, du groupe polycyclique condensé non aromatique bivalent substitué, du groupe alkyle $C_1$-$C_{60}$ substitué, du groupe alkényle $C_2$-$C_{60}$ substitué, du groupe alkynyle $C_2$-$C_{60}$ substitué, du groupe alkoxy $C_1$-$C_{60}$ substitué, du groupe cycloalkyle $C_3$-$C_{10}$ substitué, du groupe cycloalkényle $C_3$-$C_{10}$ substitué, du groupe aryle $C_6$-$C_{60}$ substitué et du groupe polycyclique condensé non aromatique monovalent substitué est choisi entre : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe cycloalkényle $C_3$-$C_{10}$, un groupe aryle $C_6$-$C_{60}$, et un groupe polycyclique condensé non aromatique monovalent ; et
l'hôte de transport d'électrons-trous exclut le composé HH1-1 ci-dessous

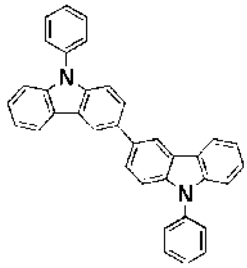

HH1-1,

où, de préférence :

$L_{31}$ à $L_{33}$ sont chacun indépendamment sélectionnés entre :

un groupe phénylène, un groupe naphthylène, un groupe fluorénylène, un groupe spiro-fluorénylène, un groupe phénalénylène, un groupe phénanthrénylène, un groupe anthracénylène, un groupe fluoranthrénylène, un groupe triphénylénylène, un groupe pyrénylène, et un groupe chrysénylène ; et
un groupe phénylène, un groupe naphtylène, un groupe fluorénylène, un groupe spiro-fluorénylène, un groupe phénalénylène, un groupe phénanthrénylène, un groupe anthracénylène, un groupe fluoranthrénylène, un groupe triphénylénylène, un groupe pyrénylène, et un groupe chrysénylène, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe phényle substitué avec un groupe phényle (c.-à-d. un groupe biphényle), un groupe naphthyle, un groupe fluorényle, un groupe spiro-fluorényle, un groupe phénalényle, un groupe phénanthrényle, un groupe anthracényle, un groupe fluoranthrényle, un groupe triphénylényle, un groupe pyrényle, et un groupe chrysényle ;
a31 à a33 sont chacun indépendamment 0, 1, ou 2;
$R_{31}$ et $R_{32}$ sont chacun indépendamment sélectionnés entre
un groupe phényle, un groupe naphthyle, un groupe fluorényle, un groupe spiro-fluorényle, un groupe phénalényle, un groupe phénanthrényle, un groupe anthracényle, un groupe fluoranthrényle, un groupe triphénylényle, un groupe pyrényle, et un groupe chrysényle ; et
un groupe phényle, un groupe naphthyle, un groupe fluorényle, un groupe spiro-fluorényle, un groupe phénalényle, un groupe phénanthrényle, un groupe anthracényle, un groupe fluoranthrényle, un groupe triphénylényle, un groupe pyrényle, et un groupe chrysényle, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe phényle substitué avec un groupe phényle (c.-à-d. un groupe biphényle), un groupe naphthyle, un groupe fluorényle, un groupe spiro-fluorényle, un groupe phénalényle, un groupe phénanthrényle, un groupe anthracényle, un groupe fluoranthrényle, un groupe triphénylényle, un groupe pyrényle, et un groupe chrysényle ;
$R_{33}$ à $R_{36}$ sont chacun indépendamment sélectionnés entre : un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, et un groupe phényle, un groupe naphthyle ; et
b31 à b36 sont chacun indépendamment 1 ou 2.

**13.** OLED selon l'une quelconque des revendications 1-11, dans lequel l'hôte de transport d'électrons-trous comprend un composé représenté par l'une des formules 20-1 à 20-7 ci-dessous :

<Formule 20-1 > <Formule 20-2>

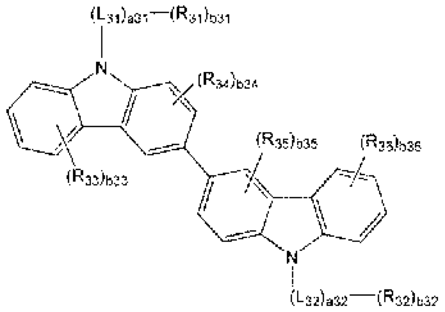

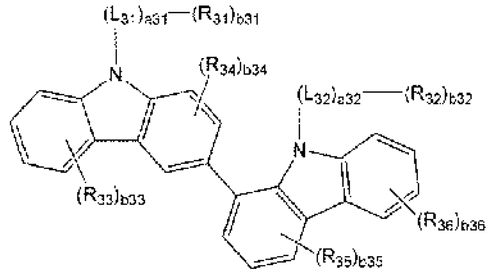

<Formule 20-3> <Formule 20-4>

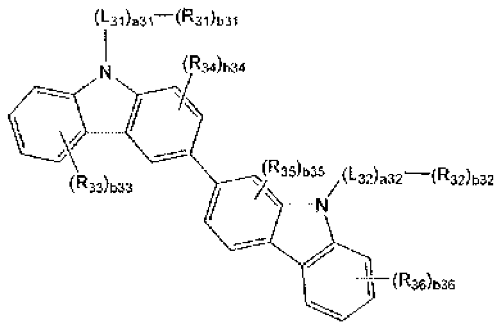

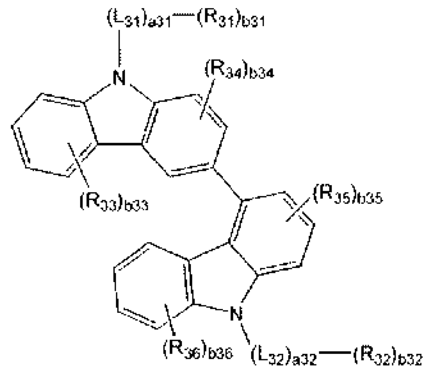

<Formule 20-5> <Formule 20-6>

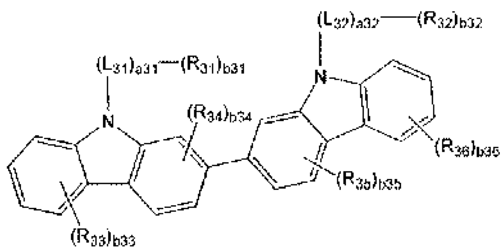

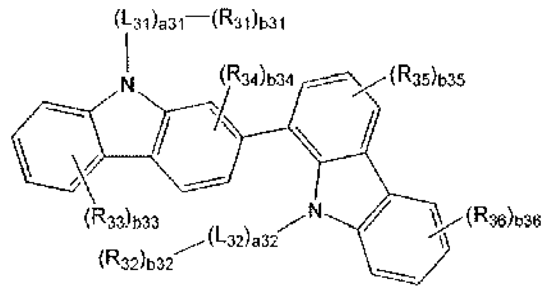

<Formule 20-7>

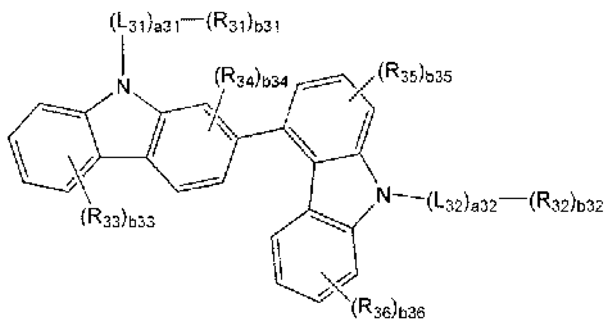

,

où, de préférence, l'hôte de transport d'électrons-trous comprend au moins l'un des composés HH1-2 à HH1-51 ci-dessous :

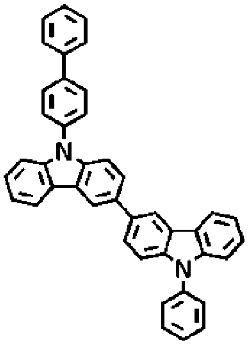
HH1-2

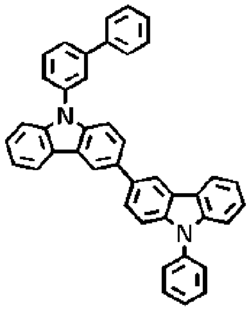
HH1-3

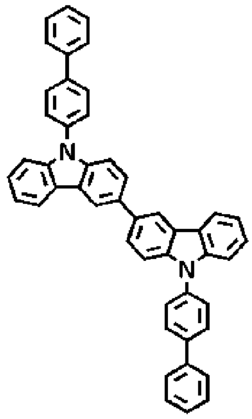
HH1-4

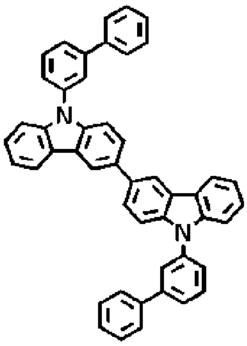
HH1-5

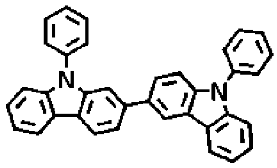
HH1-6

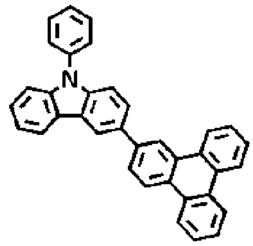
HH1-7

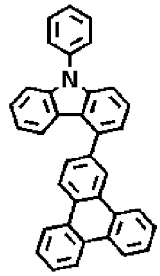
HH1-8

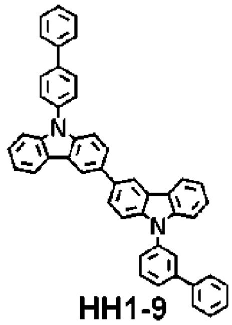
HH1-9

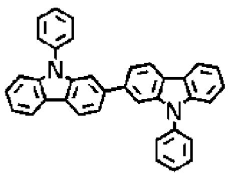
HH1-10

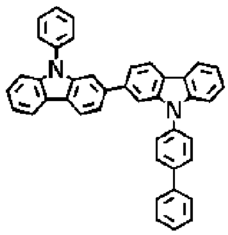
HH1-11

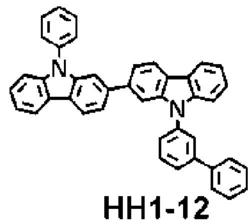
HH1-12

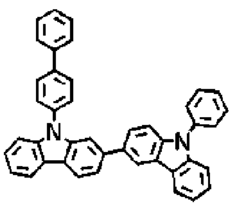
HH1-13

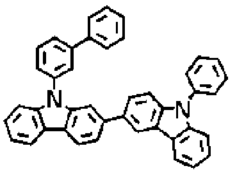
HH1-14

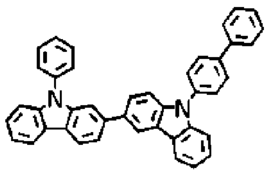
HH1-15

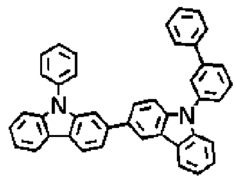
HH1-16

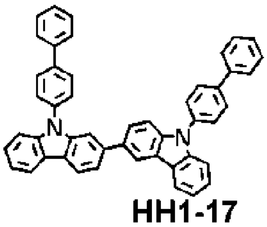

HH1-17

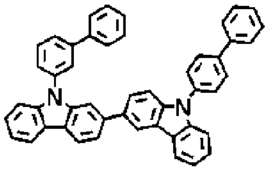

HH1-18

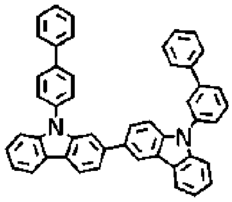

HH1-19

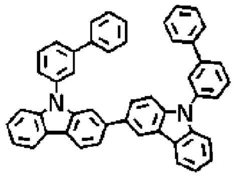

HH1-20

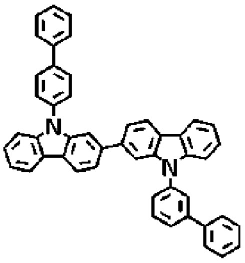

HH1-21

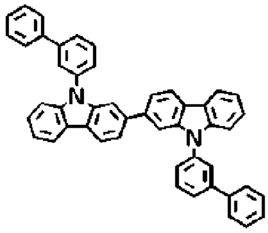

HH1-22

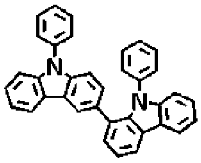

HH1-23

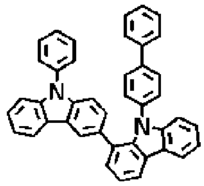

HH1-24

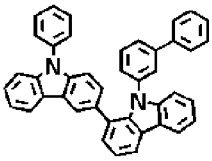

HH1-25

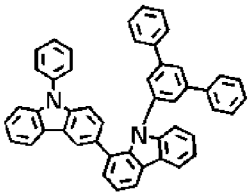

HH1-26

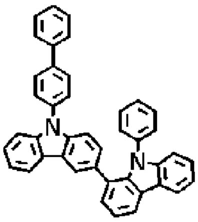

HH1-27

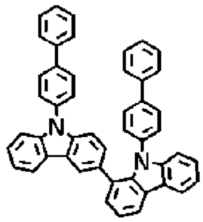

HH1-28

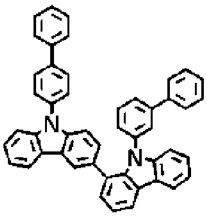

HH1-29

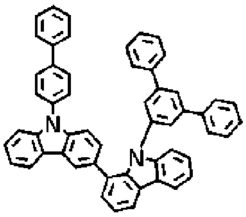

HH1-30

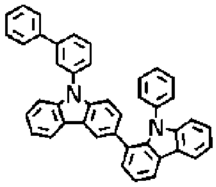

HH1-31

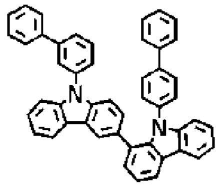

HH1-32

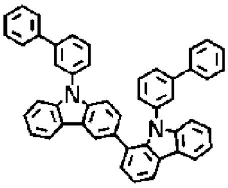

HH1-33

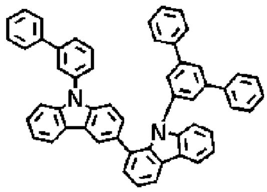

HH1-34

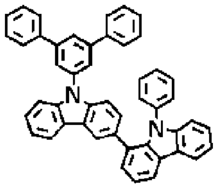

HH1-35

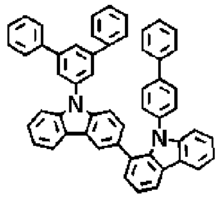

HH1-36

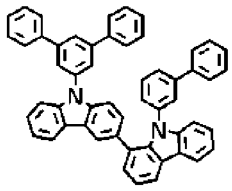
HH1-37

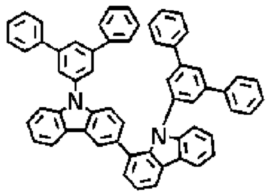
HH1-38

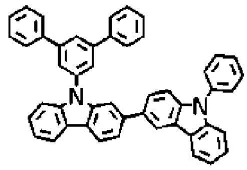
HH1-39

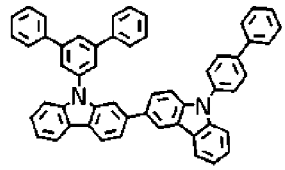
HH1-40

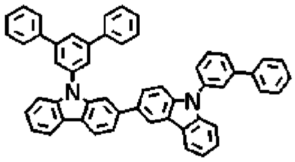
HH1-41

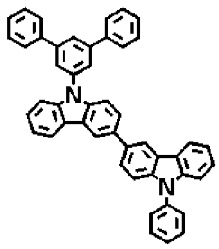
HH1-42

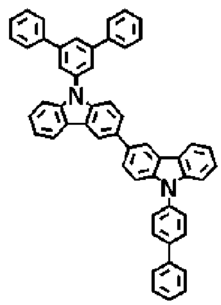
HH1-43

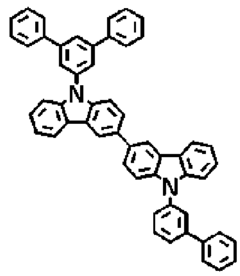
HH1-44

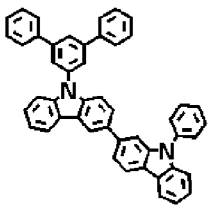
HH1-45

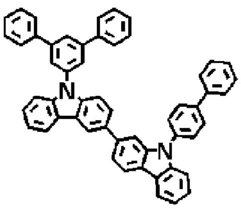
HH1-46

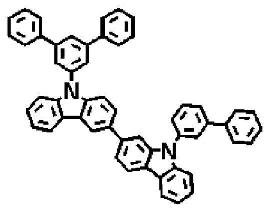
HH1-47

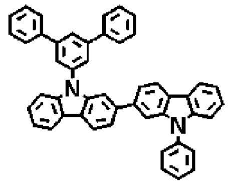
HH1-48

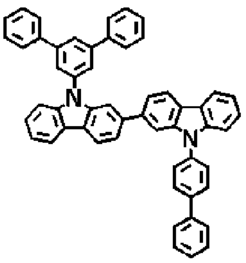
HH1-49

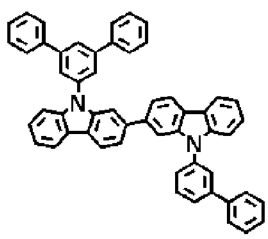
HH1-50

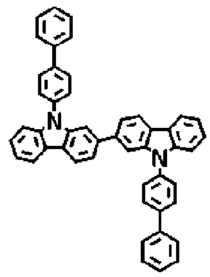
HH1-51

**14.** OLED selon l'une quelconque des revendications 1-3, dans lequel :

l'hôte de transport d'électrons est le composé EH1-401ci-dessous,
l'hôte de transport d'électrons-trous comprend un composé satisfaisant -0,1 ≤ Type(Composé EH1-401) ≤ 0,6,
un rapport volumique de l'hôte de transport d'électrons à l'hôte de transport d'électrons-trous est dans une plage satisfaisant -0,1 ≤ Type(Composé EH1-401) ≤ 0,6,
où Type(Composé EH1-401) est défini par l'équation 10 ci-dessous :

<Equation 10>

$$\text{Type(Composé EH1 -401)} = \log(J_{HOD}(\text{à } 11{,}5\text{V}) / J_{EOD}(\text{à } 4\text{V}))$$

où, dans l'équation 10,

$J_{HOD}$ (à 11,5 V) désigne une valeur de densité de courant (mA/cm$^2$) à une tension de 11,5 V d'un dispositif

à électrons-trous seulement ayant une structure de ITO (150 nm (1 500 Å)) / Composé HT3:TCNPQ (3 wt%) (10 nm (100 Å)) / Composé HT3 (100 nm (1 000 Å)) / hôte:Composé PD79 (10 wt%) (60 nm (600 Å)) / Composé ET1 (10 nm(100 Å)) / A1 (10 nm (100 Å)) (où l'hôte est constitué du composé EH1-401 et de l'hôte de transport d'électrons-trous), et

$J_{EOD}$ (à 4 V) désigne une valeur de densité de courant (mA/cm$^2$) à une tension de 4 V d'un dispositif à électrons seulement ayant une structure de ITO (150 nm (1,500 Å)) / Mg:Ag (10 wt%) (30 nm (300 Å)) / Liq (1 nm (10 Å)) / Composé ET16:Liq (50 wt%) (20 nm (200 Å)) / hôte:Composé PD79 (10 wt%) (60 nm (600 Å)) / Composé ET16:Liq (50 wt%) (20 nm (200 Å)) / Liq (1nm (10 Å)) / Mg:Ag (10 wt%) (30 nm (300 Å)) (où l'hôte est constitué du composé EH1-401 et de l'hôte de transport d'électrons-trous).

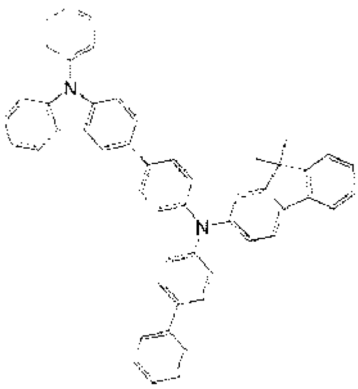

HT3

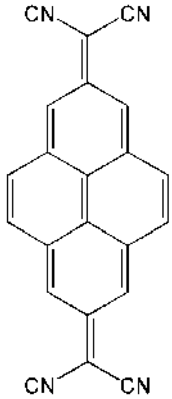

TCNPQ

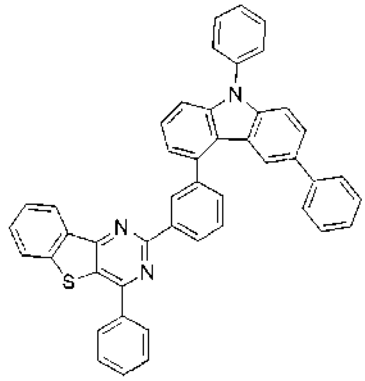

EH1-401

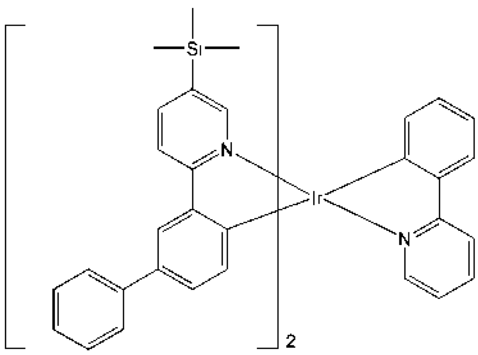

PD79

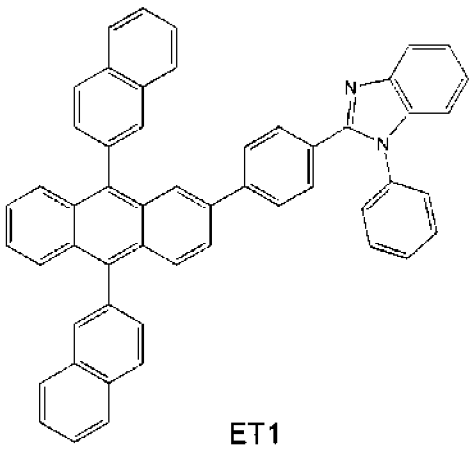

ET1

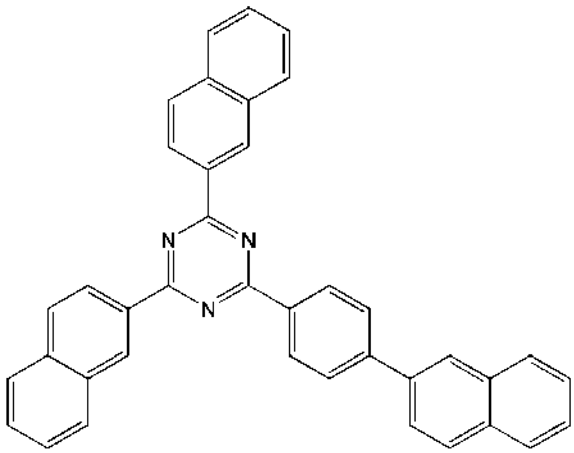

ET16

**15.** OLED selon l'une quelconque des revendications 1-3, dans lequel :

l'hôte de transport d'électrons est le composé EH3-81 ci-dessous,
l'hôte de transport d'électrons-trous comprend un composé satisfaisant 0,1 ≤ Type(Composé EH3-81) ≤ 1,2,
un rapport volumique de l'hôte de transport d'électrons à l'hôte de transport d'électrons-trous est dans la plage satisfaisant 0,1 ≤ Type(Composé EH3-81) ≤ 1,2,
où Type(Composé EH3-81) est défini par l'équation 11 ci-dessous :

<Equation 11>

$$\text{Type(Composé EH3-81)} = \log(J_{HOD}(\text{à } 11{,}5V) / J_{EOD}(\text{à } 4V))$$

où, dans l'équation 11

$J_{HOD}$ (à 11,5 V) désigne une valeur de densité de courant (mA/$cm^2$) à une tension de 11,5 V d'un dispositif à électrons-trous seulement ayant une structure de ITO (150 nm (1 500 Å)) / Composé HT3:TCNPQ (3 wt%) (10 nm (100 Å)) / Composé HT3 (100 nm (1 000 Å)) / hôte:Composé PD79 (10 wt%) (60 nm (600 Å)) / Composé ET1 (10 nm(100 Å)) / A1 (10 nm (100 Å)) (où l'hôte est constitué du composé EH3-81 et de l'hôte de transport d'électrons-trous), et
$J_{EOD}$ (à 4 V) désigne une valeur de densité de courant (mA/$cm^2$) à une tension de 4 V d'un dispositif à électrons seulement ayant une structure de ITO (150 nm (1 500 Å)) / Mg:Ag (10 wt%) (30 nm (300 Å)) / Liq (1nm (10 Å)) / Composé ET16:Liq (50 wt%) (20 nm (200 Å)) / hôte:Composé PD79 (10 wt%) (60 nm (600 Å)) / Composé ET16:Liq (50 wt%) (20 nm (200 Å)) / Liq (1 nm (10 Å)) / Mg:Ag (10 wt%) (30 nm (300 Å)) (où l'hôte est constitué du composé EH3-81 et de l'hôte de transport d'électrons-trous)

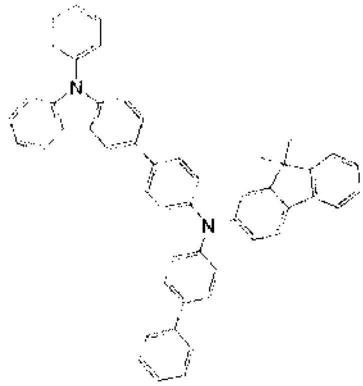 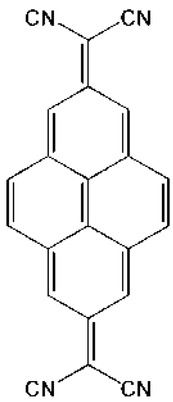 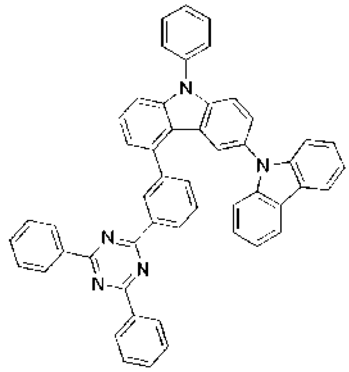

HT3 TCNPQ EH3-81

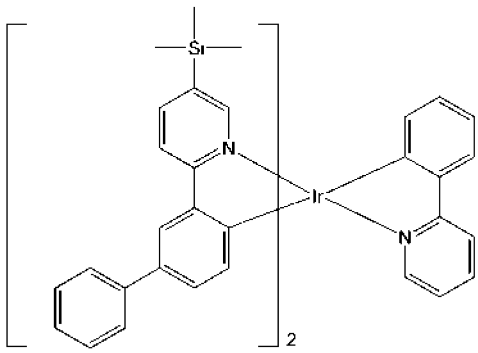 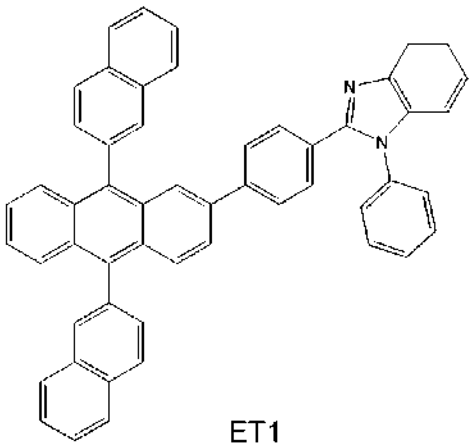

PD79 ET1

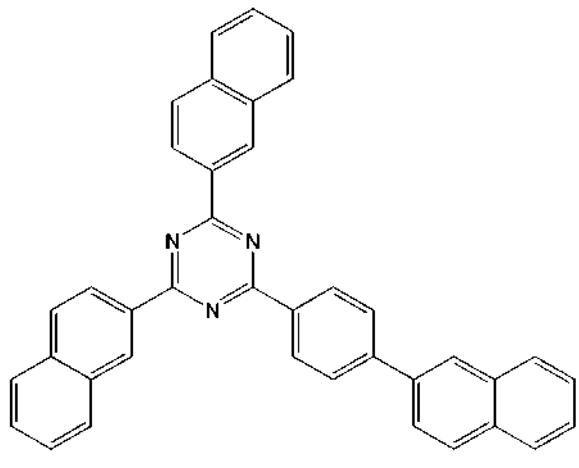

ET16

**16.** OLED selon l'une quelconque des revendications 1-13, dans lequel le matériau de transport d'électrons-trous comprend un composé représenté par la formule 201 ci-dessous :

<Formule 201>

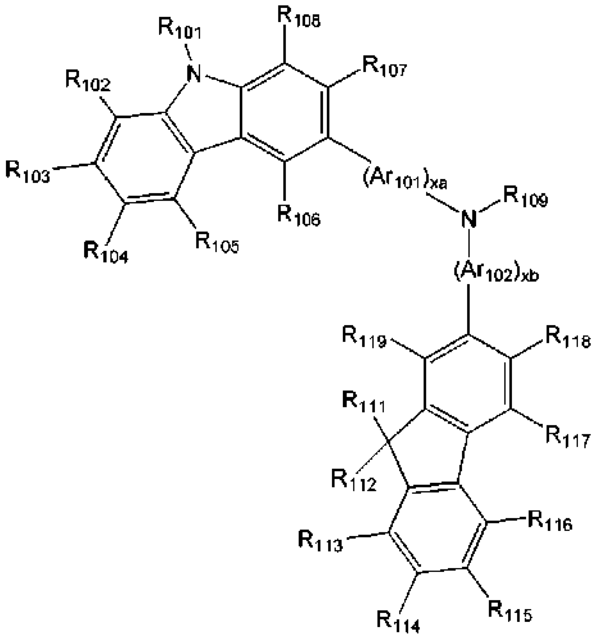

où, dans la formule 201,

$Ar_{101}$ et $Ar_{102}$ sont chacun indépendamment sélectionnés entre
un groupe phénylène, un groupe pentalénylène, un groupe indénylène, un groupe naphtylène, un groupe azulénylène, un groupe heptalénylène, un groupe acénaphtylène, un groupe fluorénylène, un groupe phénalénylène, un groupe phénanthrénylène, un groupe anthracénylène, un groupe fluoranthénylène, un groupe triphénylénylène, un groupe pyrénylène, un groupe chrysénylénylène, un groupe naphthacénylène, un groupe picénylène, un groupe pérylénylène, et un groupe pentacénylène ; et
un groupe phénylène, un groupe pentalénylène, un groupe indénylène, un groupe naphthylène, un groupe azulénylène, un groupe heptalénylène, un groupe acénaphthylène, un groupe fluorénylène, un groupe phénalénylène, un groupe phénanthrénylène, un groupe anthracénylène, un groupe fluoranthénylène, un groupe triphénylénylène, un groupe pyrénylène, un groupe chrysénylénylène, un groupe naphthacénylène, un groupe picénylène, un groupe pérylénylène, et un groupe pentacénylène, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe cycloalkényle $C_3$-$C_{10}$, un groupe hétérocycloalkyle $C_1$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe hétéroaryle $C_1$-$C_{60}$, un groupe polycyclique condensé non aromatique monovalent, et un groupe hétéropolycyclique condensé non aromatique monovalent ;
xa et xb sont chacun indépendamment un nombre entier de 0 à 5 ;
$R_{101}$ à $R_{108}$ et $R_{111}$ à $R_{119}$ sont chacun indépendamment sélectionnés entre :

un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{10}$, et un groupe alkoxy $C_1$-$C_{10}$ ;
un groupe alkyle $C_1$-$C_{10}$ un groupe alkoxy $C_1$-$C_{10}$, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, et un groupe acide phosphorique ou un sel de celui-ci ; un groupe phényle, un groupe naphthyle, un groupe anthracényle, un groupe fluorényle, et un groupe pyrényle ; et
un groupe phényle, un groupe naphthyle, un groupe anthracényle, un groupe fluorényle, et un groupe

pyrényle, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{10}$, et un groupe alkoxy $C_1$-$C_{10}$ ; et

$R_{109}$ est sélectionné entre

un groupe phényle, un groupe naphthyle, un groupe anthracényle, et un groupe pyridinyle ;

et un groupe phényle, un groupe naphthyle, un groupe anthracényle, et un groupe pyridinyle, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, et un groupe alkoxy $C_1$-$C_{20}$, où, de préférence, le matériau de transport d'électrons-trous comprend un composé représenté par la formule 201A ci-dessous :

<Formule 201A>

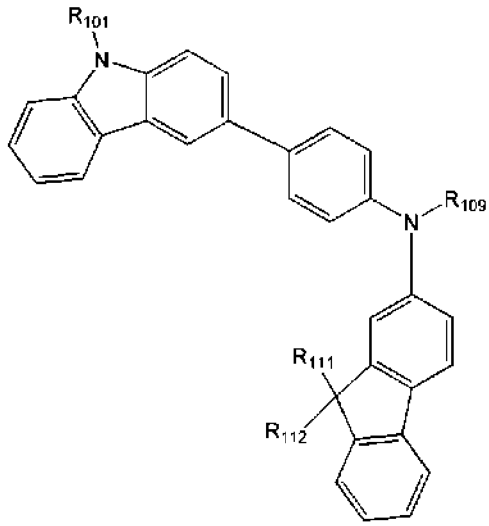

où, dans la formule 201A, les descriptions de $R_{101}$, $R_{111}$, $R_{112}$, et $R_{109}$ sont définies de manière identique à la formule 201.

**17.** OLED selon l'une quelconque des revendications 1-13, dans lequel le matériau de transport d'électrons-trous comprend au moins l'un des composés HT1 à HT12 ci-dessous :

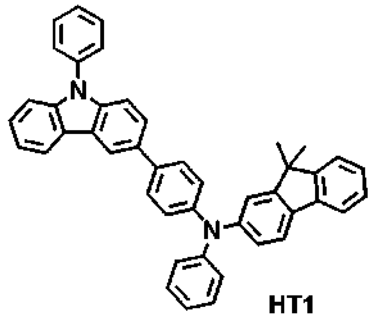
HT1

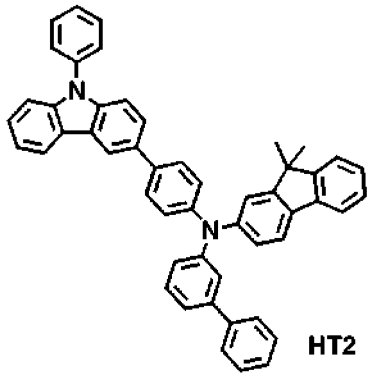
HT2

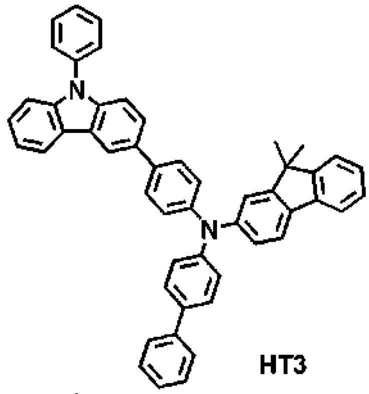
HT3

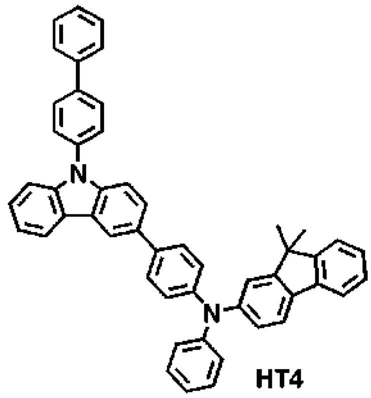
HT4

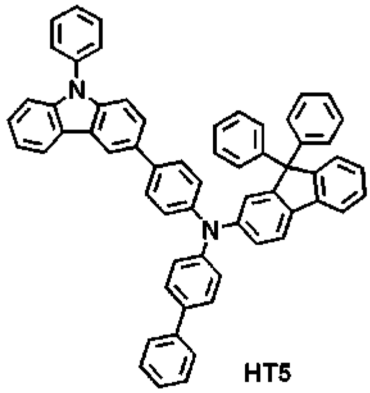
HT5

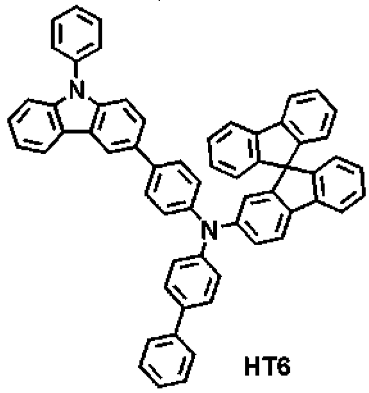
HT6

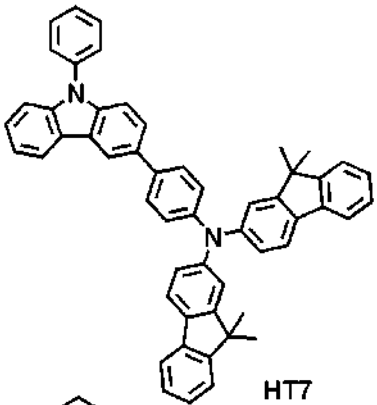
HT7

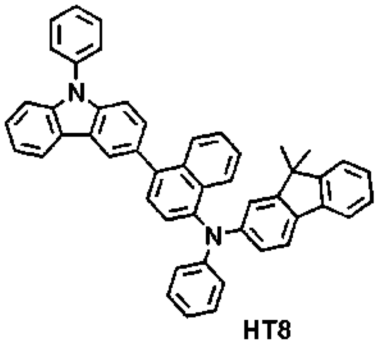
HT8

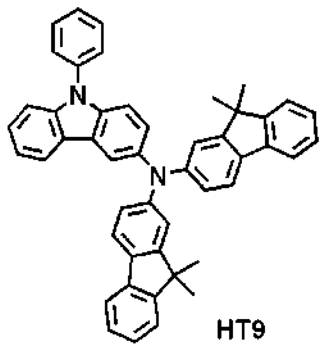
HT9

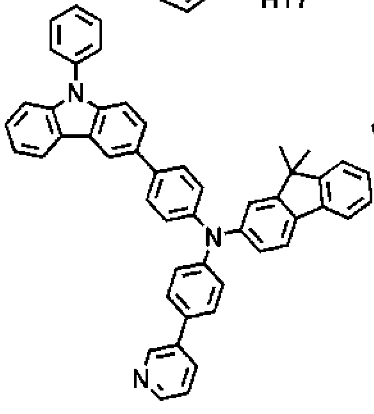
HT10

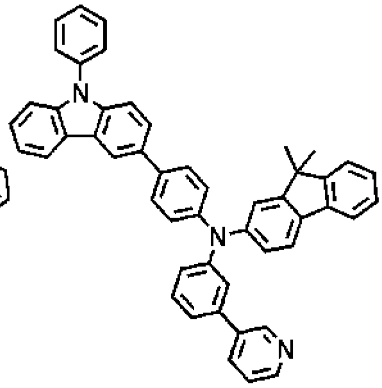
HT11

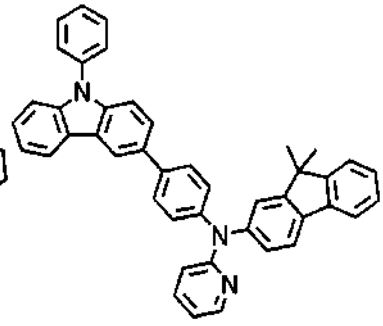
HT12

**18.** OLED selon l'une quelconque des revendications 1-13, 16 ou 17, dans lequel le matériau de transport d'électrons comprend un composé représenté par la formule 40 ou 41 ci-dessous :

<Formule 40>

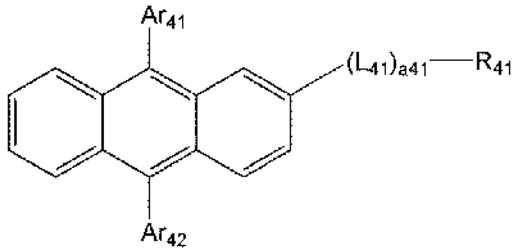

<Formule 41>

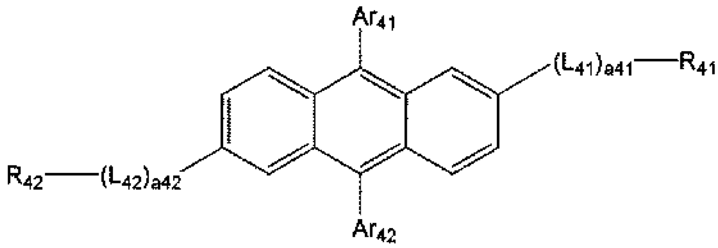

où, dans les formules 40 et 41,

$L_{41}$ et $L_{42}$ sont chacun indépendamment sélectionnés entre
un groupe arylène $C_6$-$C_{60}$, un groupe hétéroarylène $C_1$-$C_{60}$, un groupe polycyclique condensé non aromatique bivalent, et un groupe hétéropolycyclique condensé non aromatique bivalent ; et
un groupe arylène $C_6$-$C_{60}$, un groupe hétéroarylène $C_1$-$C_{60}$, un groupe polycyclique condensé non aromatique bivalent, et un groupe hétéropolycyclique condensé non aromatique bivalent, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe fluorényle, un groupe pyrényle, un groupe chrysényle, un groupe phénanthrényle, un groupe pyridinyle, un groupe pyrimidinyle, et un groupe triazinyle ;
a41 et a42 sont chacun indépendamment un nombre entier de 0 à 5 ;
$Ar_{41}$ et $Ar_{42}$ sont chacun indépendamment sélectionnés entre
un groupe aryle $C_6$-$C_{60}$, un groupe hétéroaryle $C_1$-$C_{60}$, un groupe polycyclique condensé non aromatique monovalent, et un groupe hétéropolycyclique condensé non aromatique monovalent ; et
un groupe aryle $C_6$-$C_{60}$, un groupe hétéroaryle $C_1$-$C_{60}$, un groupe polycyclique condensé non aromatique monovalent, et un groupe hétéropolycyclique condensé non aromatique monovalent, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe fluorényle, un groupe pyrényle, un groupe chrysényle, un groupe phénanthrényle, un groupe pyridinyle, un groupe pyrimidinyle, et un groupe triazinyle ; et
$R_{41}$ et $R_{42}$ sont chacun indépendamment sélectionnés entre
un groupe benzoïmidazolyle, un groupe benzoxazolyle, un groupe benzothiazolyle, un groupe benzopyrimidinyle, un groupe imidazopyridinyle, un groupe quinolinyle, un groupe isoquinolinyle, un groupe quinazolinyle, un groupe pyridinyle, un groupe pyrimidinyle, un groupe pyrazinyle, un groupe phényle, un groupe naphthyle, un groupe pyrényle, un groupe chrysényle, un groupe fluorényle, et un groupe phénanthrényle ; et
un groupe benzoïmidazolyle, un groupe benzoxazolyle, un groupe benzothiazolyle, un groupe benzopyrimidinyle, un groupe imidazopyridinyle, un groupe quinolinyle, un groupe isoquinolinyle, un groupe quinazolinyle, un groupe pyridinyle, un groupe pyrimidinyle, un groupe pyrazinyle, un groupe phényle, un groupe naphthyle, un groupe pyrényle, un groupe chrysenyle, un groupe fluorényle, et un groupe phénanthrényle, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique

ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe benzoïmidazolyle, un groupe benzoxazolyle, un groupe benzothiazolyle, un groupe benzopyrimidinyle, un groupe imidazopyridinyle, un groupe quinolinyle, un groupe isoquinolinyle, un groupe quinazolinyle, un groupe pyridinyle, un groupe pyrimidinyle, un groupe pyrazinyle, un groupe phényle, un groupe naphthyle, un groupe pyrényle, un groupe chrysényle, un groupe fluorényle, et un groupe phénanthrényle, ou dans lequel le matériau de transport d'électrons comprend un composé représenté par la formule 42 ci-dessous :

<Formule 42>

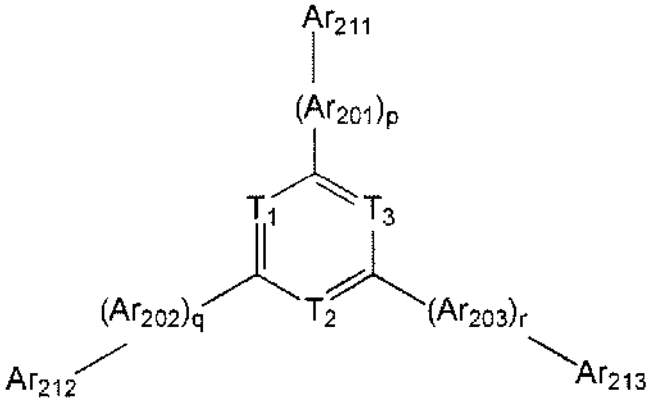

où, dans la formule 42,

$T_1$ est N ou C($R_{201}$), $T_2$ est N ou C($R_{202}$), et $T_3$ set N ou C($R_{203}$), où au moins l'un de $T_1$ à $T_3$ est N ;
$R_{201}$ à $R_{203}$ sont chacun indépendamment sélectionnés entre
un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe aryle $C_6$-$C_{60}$, un groupe hétéroaryle $C_1$-$C_{60}$, un groupe polycyclique condensé non aromatique monovalent, et un groupe hétéropolycyclique condensé non aromatique monovalent ; et
un groupe aryle $C_6$-$C_{60}$, un groupe hétéroaryle $C_1$-$C_{60}$, un groupe polycyclique condensé non aromatique monovalent, et un groupe hétéropolycyclique condensé non aromatique monovalent, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe fluorényle, un groupe pyrényle, un groupe chrysényle, un groupe phénanthrényle, un groupe pyridinyle, un groupe pyrimidinyle, et un groupe triazinyle ;
$Ar_{201}$ à $Ar_{203}$ sont chacun indépendamment sélectionnés entre
un groupe arylène $C_6$-$C_{60}$, un groupe hétéroarylène $C_1$-$C_{60}$, un groupe polycyclique condensé non aromatique bivalent, et un groupe hétéropolycyclique condensé non aromatique bivalent ; et
un groupe arylène $C_6$-$C_{60}$, un groupe hétéroarylène $C_1$-$C_{60}$, un groupe polycyclique condensé non aromatique bivalent, et un groupe hétéropolycyclique condensé non aromatique bivalent, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe fluorényle, un groupe pyrényle, un groupe chrysényle, un groupe phénanthrényle, un groupe pyridinyle, un groupe pyrimidinyle, et un groupe triazinyle ;
p, q, et r sont chacun indépendamment 0, 1 ou 2 ; et
$Ar_{211}$ et $Ar_{213}$ sont chacun indépendamment sélectionnés entre
un groupe aryle $C_6$-$C_{60}$, un groupe hétéroaryle $C_1$-$C_{60}$, un groupe polycyclique condensé non aromatique

monovalent, et un groupe hétéropolycyclique condensé non aromatique monovalent ; et
un groupe aryle $C_6$-$C_{60}$, un groupe hétéroaryle $C_1$-$C_{60}$, un groupe polycyclique condensé non aromatique monovalent, et un groupe hétéropolycyclique condensé non aromatique monovalent, chacun substitué avec au moins l'un de : un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{20}$, un groupe alkoxy $C_1$-$C_{20}$, un groupe phényle, un groupe naphthyle, un groupe fluorényle, un groupe pyrényle, un groupe chrysényle, un groupe phénanthrényle, un groupe pyridinyle, un groupe pyrimidinyle, et un groupe triazinyle.

**19.** OLED selon l'une quelconque des revendications 1-13, 16 ou 17, dans lequel le matériau de transport d'électrons comprend au moins l'un des composés ET1 à ET16 ci-dessous :

<Composé ET1>

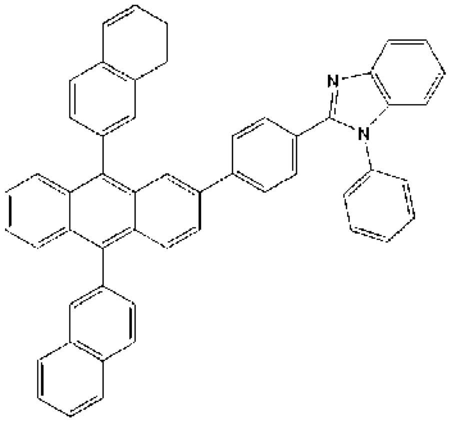

<Composé ET2>

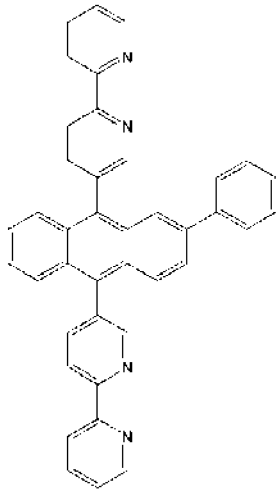

<Composé ET3>

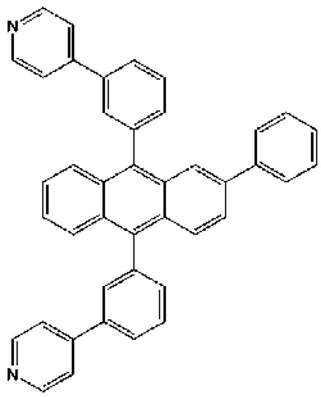

<Composé ET4>

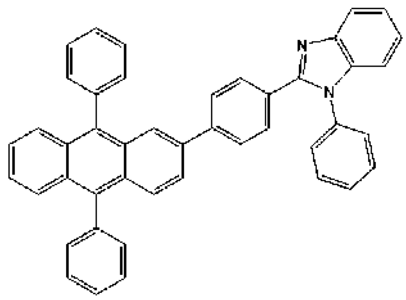

<Composé ET5>

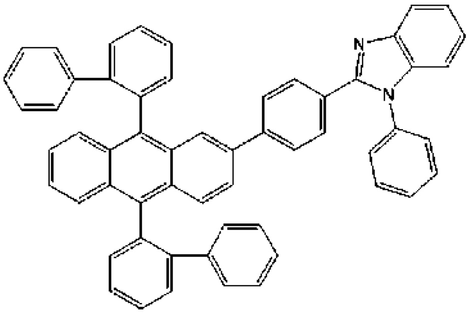

<Composé ET6>

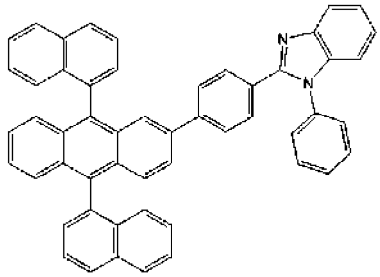

<Composé ET7>

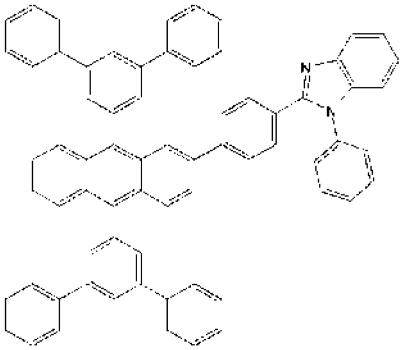

<Composé ET8>

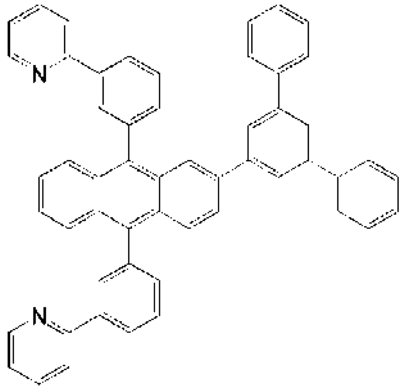

<Composé ET8>

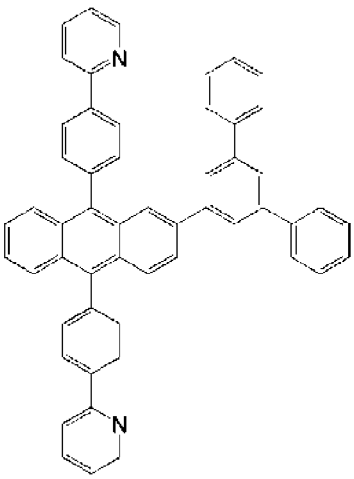

<Compousé ET10>

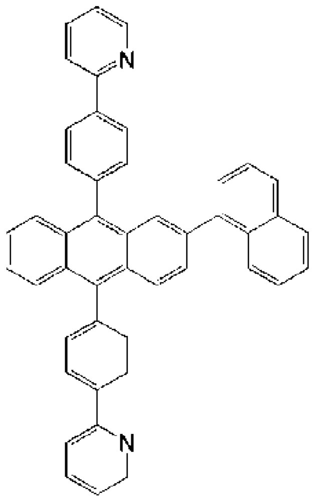

<Composé ET11>

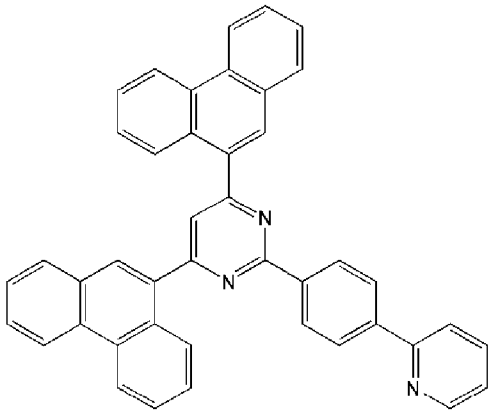

<Composé ET12>

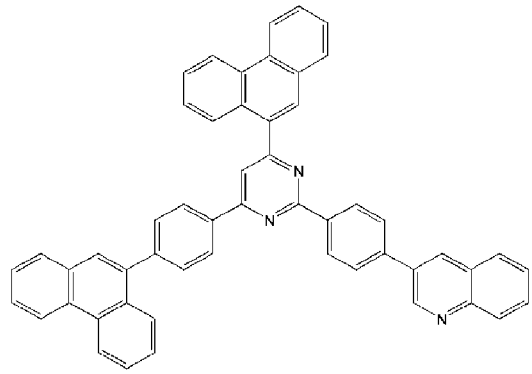

<Composé ET13>

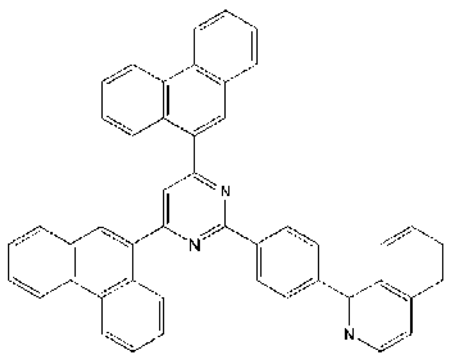

<Composé ET14>

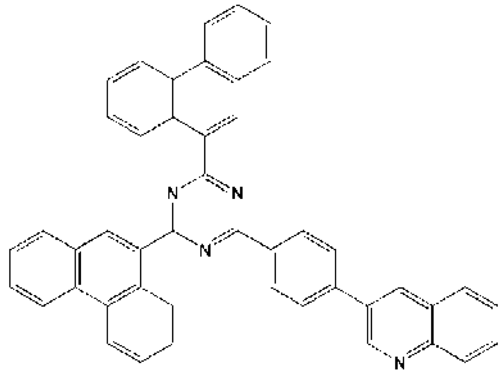

<Composé ET15>

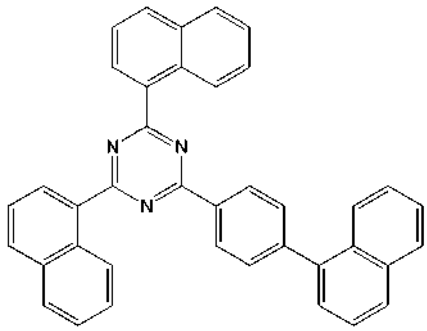

<Composé ET16>

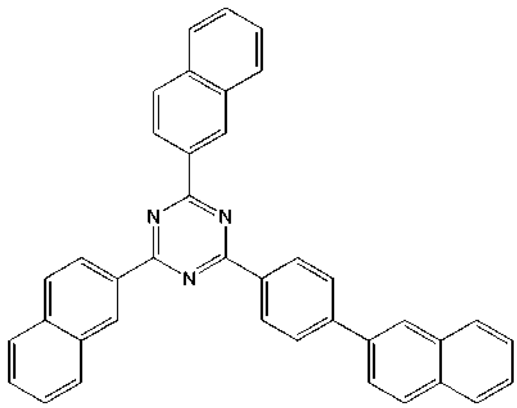

FIG. 1

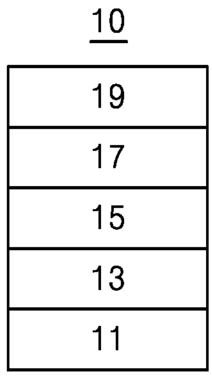
10
19
17
15
13
11

FIG. 2A

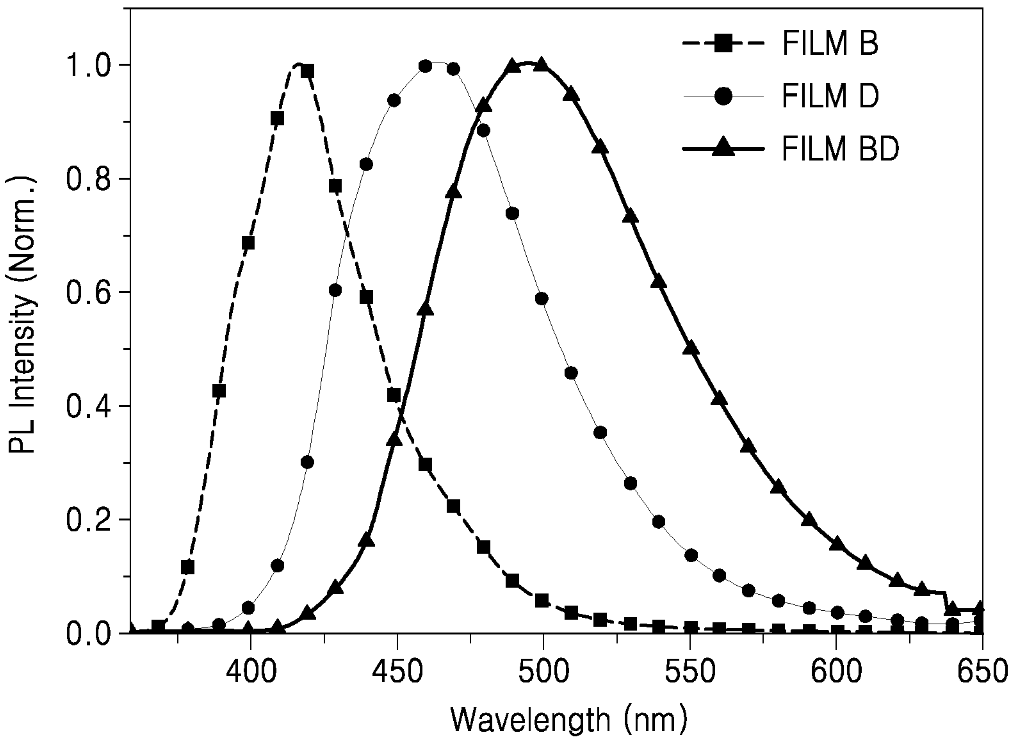
FILM B
FILM D
FILM BD
PL Intensity (Norm.)
1.0
0.8
0.6
0.4
0.2
0.0
400
450
500
550
600
650
Wavelength (nm)

FIG. 2B

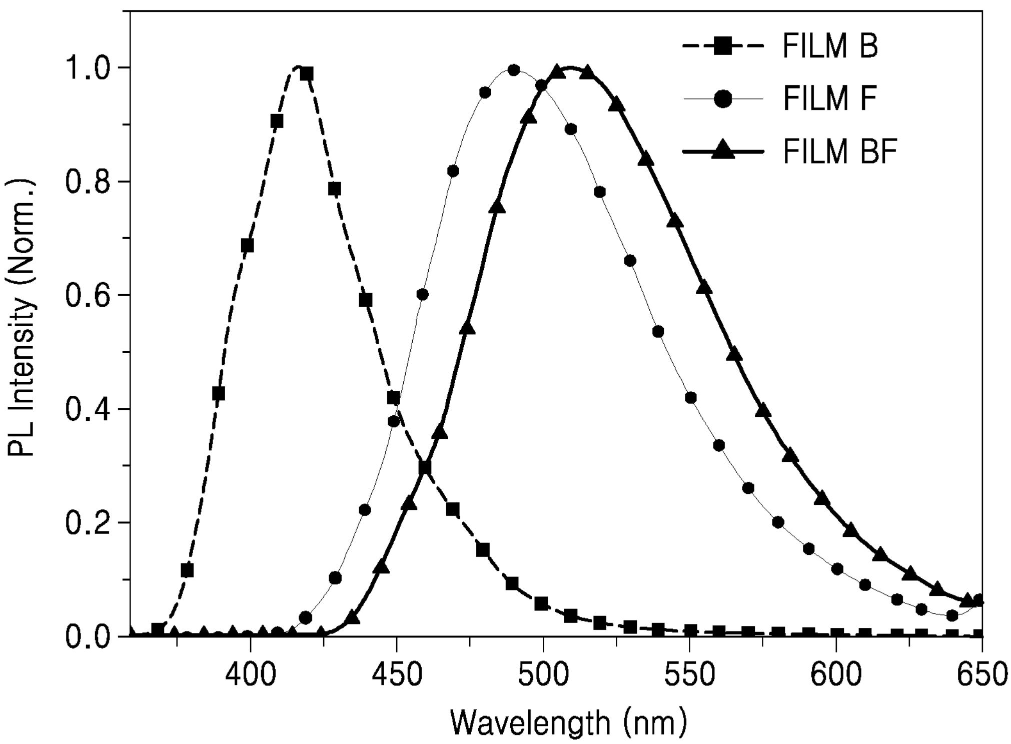
FILM B
FILM F
FILM BF
PL Intensity (Norm.)
0.0
0.2
0.4
0.6
0.8
1.0
400
450
500
550
600
650
Wavelength (nm)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2013154342 A